(19) Europäisches Patentamt
European Patent Office
Office européen des brevets

(11) EP 3 360 945 B1

(12) EUROPEAN PATENT SPECIFICATION

(45) Date of publication and mention of the grant of the patent:
**24.04.2019 Bulletin 2019/17**

(51) Int Cl.:
***C09K 11/06*** *(2006.01)* ***H01L 51/50*** *(2006.01)*

(21) Application number: **18154459.4**

(22) Date of filing: **31.01.2018**

(54) **ORGANIC ELECTROLUMINESCENT DEVICE**

ORGANISCHE ELEKTROLUMINESZENTE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.02.2017 DE 102017102870**

(43) Date of publication of application:
**15.08.2018 Bulletin 2018/33**

(73) Proprietor: **CYNORA GMBH**
**76646 Bruchsal (DE)**

(72) Inventors:
- **GEORGIOS, Liaptsis**
  **68161 Mannheim (DE)**
- **DÜCK, Sebastian**
  **69115 Heidelberg (DE)**

(74) Representative: **Hoppe, Georg Johannes**
**Darani Anwaltskanzlei**
**Beuckestrasse 20**
**14163 Berlin (DE)**

(56) References cited:
**US-A1- 2012 097 937 US-A1- 2016 126 478**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 360 945 B1

## Description

The invention relates to organic electroluminescent devices, such as organic light emitting devices (OLEDs). More specifically, the invention relates organic electroluminescent devices comprising at least one host compound and at least one emitter compound, which emits delayed fluorescence.

## Introduction

Organic electroluminescent devices containing one or more light-emitting layers based on organics such as, e.g., organic light emitting diodes (OLEDs), light emitting electrochemical cells (LECs) and light-emitting transistors, gain increasing economic importance. In particular, OLEDs are promising devices for electronic products such as, for example, screens, displays, and illumination devices. In contrast to most electroluminescent devices essentially based on inorganic compounds, organic electroluminescent devices based on organic compounds are often rather flexible and producible in thin layers. The OLED-based screens and displays show brilliant colors, contrasts and are rather efficient with respect to their energy consumption.

A central element of an organic electroluminescent device for generating light is a light-emitting layer placed between an anode and a cathode. When a voltage is applied to an organic electroluminescent device, holes and electrons are injected from the anode and the cathode, respectively, to the light-emitting layer. Excitons of high energy are then generated by recombination of holes and electrons. The decay of such excited states (e.g., singlet states such as $S_1$ and/or triplet states such as $T_1$) to the ground state ($S_0$) leads to the emission of light. In order to enable both an efficient energy transport and efficient light emission, an organic electroluminescent device comprises an emission layer comprising one or more host compounds and one or more emitter compounds as dopants.

To improve the illumination level achieved in a device per introduced electric energy, host compounds may be used which can transfer energy to the emitter compounds. In the ideal case of such host-emitter systems, the vast majority of excitons are transferred via energy and/or charge transfer from the host compounds to the excited singlet $S_1$ or triplet $T_1$ energy levels of the emitter compounds. Especially suited for the use in highly efficient OLEDs are emitter compounds that emit thermally activated delayed fluorescence (TADF), as both triplet and singlet excitons generated by recombination of holes and electrons can be used. Hence, in contrast to phosphorescence OLEDs in which up to 75 % of the excitons can be utilized for the light emission, and to fluorescence OLEDs in which up to 25 % of the excitons can be utilized for the light emission, 100 % of the excitons can be utilized for the light emission in OLEDs with TADF emitters.

Host compounds may also help to spatially separate emitter compounds from one another and thereby prevent (self-)quenching. In addition, host compounds may help to improve morphology and/or thermal stability of the emitter layer. A variety of host compounds is known in the art. However, many of the known host components carry reactive functional groups that impair the usability, storability and lifespan of the host compounds. Exemplarily, many hosts are particularly sensitive to oxidation. Due to the higher energy levels required, the emission of sky blue and deep blue light is especially demanding regarding the stability of both host compounds and emitter compounds and compositions thereof. Further, many of the host compounds known in the art require rather complicated synthesis steps and are thus quite expensive. Further, it is desired to obtain host compounds that are suitable to provide charge carrier mobility allowing for particularly low driving voltage and/or high brightness.

In the view of the prior art, there is still a need to provide host compounds, emitter compounds and compositions thereof that are easily obtainable, chemically and thermally stable and thus enable long device lifespans. It is furthermore desired that host compounds have high triplet energy levels leading to low triplet quenching, and are able to efficiently transfer energy to the emitter compounds in the range of shorter wavelengths (deep blue, sky blue or green). In particular, the excited state and orbital energy levels of emitter compounds and host compounds of one emission layer must match each other to enable efficient energy transfer.

US2012097937 A1 discloses an organic electroluminescence device comprising a host compound and a phosphorescent dopant.

## Description

The invention relates to an organic electroluminescent device comprising a light-emitting layer B comprising or containing

- at least one host compound H comprising or consisting of a structure of formula I:

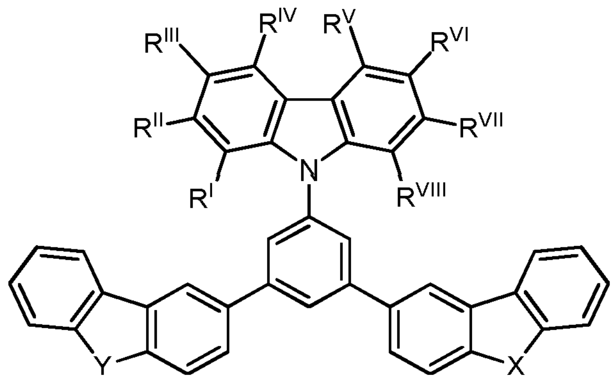

Formula I

wherein

X is O or S;
Y is O or S;
each of $R^I$, $R^{II}$, $R^{III}$, $R^{IV}$, $R^V$, $R^{VI}$, $R^{VII}$ and $R^{VIII}$ is independently from another selected from the group consisting of
hydrogen,
CN,
$CF_3$,
$C_1$-$C_{20}$-alkyl, which is optionally substituted with one or more $R^z$,
$C_6$-$C_{18}$-aryl, which is optionally substituted with one or more $R^z$, $C_3$-$C_{17}$-heteroaryl, which is optionally substituted with one or more $R^z$, and
Si($R^y$)3;
each of $R^y$ and $R^z$ is at each occurrence independently from another selected from the group consisting of
hydrogen,
CN,
$CF_3$,
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl; and

- at least one emitter compound E comprising or consisting of
- a first chemical moiety comprising or consisting of a structure of formula II,

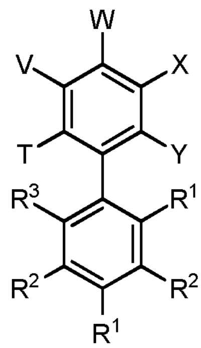

Formula II

and
- two second chemical moieties D independently from another comprising or consisting of a structure of formula III,

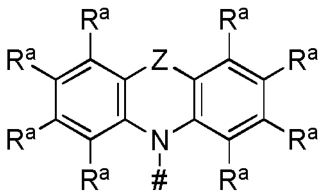

Formula III

wherein the first chemical moiety is linked to each of the two second chemical moieties D via a single bond; wherein

T is the binding site of a single bond linking the first chemical moiety and one of the two second chemical moieties D or is hydrogen;
V is the binding site of a single bond linking the first chemical moiety and one of the two second chemical moieties D or is hydrogen;
W is the binding site of a single bond linking the first chemical moiety and one of the two second chemical moieties D or is selected from the group consisting of hydrogen, CN and $CF_3$;
X is the binding site of a single bond linking the first chemical moiety and one of the two second chemical moieties D or is selected from the group consisting of hydrogen, CN and $CF_3$;
Y is the binding site of a single bond linking the first chemical moiety and one of the two second chemical moieties D or is selected from the group consisting of hydrogen, CN and $CF_3$;
# represents the binding site of a single bond linking the first chemical moiety and one of the two second chemical moieties D;
Z is at each occurrence independently from another selected from the group consisting of a direct bond, $CR^4R^5$, $C=CR^4R^5$, C=O, $C=NR^4$, $NR^4$, O, $SiR^4R^5$, S, S(O) and $S(O)_2$;
each of $R^1$ and $R^2$ is at each occurrence independently from another selected from the group consisting of hydrogen, deuterium, $C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl; $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl; $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $CF_3$;
$R^3$ is selected from the group consisting of hydrogen, deuterium, $C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;
each of $R^a$, $R^4$ and $R^5$ is at each occurrence independently from another selected from the group consisting of hydrogen, CN, $CF_3$, $C_1$-$C_{20}$-alkyl, which is optionally substituted with one or more $R^x$, $C_6$-$C_{18}$-aryl, which is optionally substituted with one or more $R^x$, $C_3$-$C_{17}$-heteroaryl, which is optionally substituted with one or more $R^x$, $Si(R^t)_3$, $N(R^s)_2$, and $OR^s$;
$R^x$ is at each occurrence independently from another selected from the group consisting of hydrogen, Cl, Br, I, CN, $CF_3$, $C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;
each of $R^s$ and $R^t$ is at each occurrence independently from another selected from the group consisting of hydrogen, $C_1$-$C_{20}$-alkyl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl.

According to the invention, each of the residues $R^a$, $R^4$, $R^5$, $R^s$, $R^t$ or $R^x$ optionally form a mono- or polycyclic, aliphatic, aromatic and/ or benzanilated ring system with one or more residues $R^a$, $R^4$, $R^5$, $R^s$, $R^t$ or $R^x$.

According to the invention, exactly one residue selected from the group consisting of W, X and Y is CN or $CF_3$, and exactly two residues selected from the group consisting of T, V, W, X and Y are the binding site of a single bond linking the first chemical moiety and one of the two second chemical moieties D,
and
either the two residues $R^1$ or the two residues $R^2$ are $CF_3$.

In one embodiment of the invention, the organic electroluminescent device is a device selected from the group consisting of an organic light emitting diode, a light emitting electrochemical cell, and a light-emitting transistor.

In a further embodiment of the invention, X and Y in formula I are O.

In a further embodiment of the invention, X and Y in formula I are S.

In a further embodiment, all of the residues $R^I$, $R^{II}$, $R^{III}$, $R^{IV}$, $R^V$, $R^{VI}$, $R^{VII}$ and $R^{VIII}$ in formula I are each hydrogen (H). In an alternative embodiment, at least one of the residues $R^I$, $R^{II}$, $R^{III}$, $R^{IV}$, $R^V$, $R^{VI}$, $R^{VII}$ and $R^{VIII}$ in formula I is not hydrogen.

In a preferred embodiment, the light-emitting layer B comprises host compound **H1:**

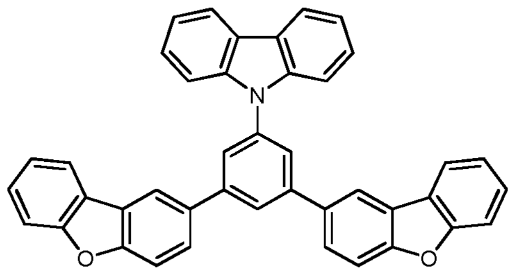

**H1**

In a preferred embodiment, the light-emitting layer B comprises host compound **H2:**

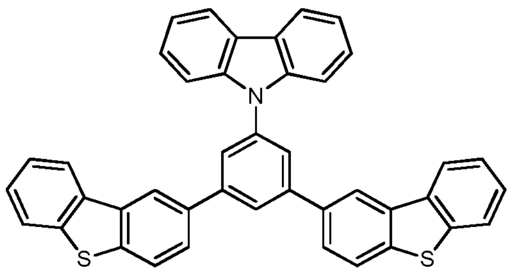

**H2**

In one embodiment, the least one emitter compound E of the device comprises or consists of a structure of formula IV,

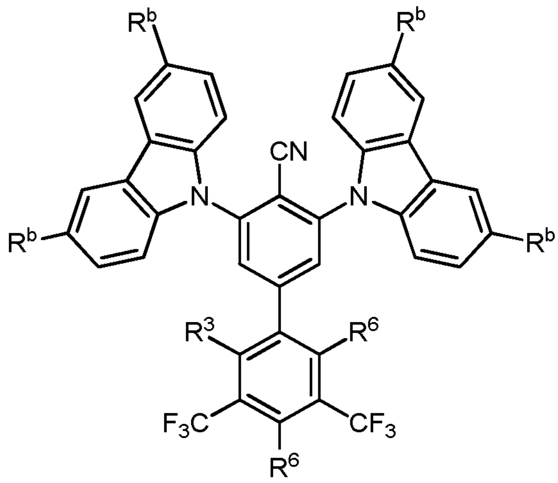

Formula IV

wherein

$R^b$ is at each occurrence independently from another selected from the group consisting hydrogen, CN, $CF_3$, Me, $^iPr$, $^tBu$, Ph, which is optionally substituted with one or more residues selected from the group consisting of Me, $^iPr$, $^tBu$, CN, $CF_3$ and Ph, pyridinyl, which is optionally substituted with one or more residues selected from the group consisting of Me, $^iPr$, $^tBu$, CN, $CF_3$ and Ph, pyrimidinyl, which is optionally substituted with one or more residues selected from the group consisting of Me, $^iPr$, $^tBu$, CN, $CF_3$ and Ph, 1,3,5-triazinyl, which is optionally substituted with one or more residues selected from the group consisting of Me, $^iPr$, $^tBu$, CN, $CF_3$ and Ph, and carbazolyl, which is optionally substituted with one or more residues selected from the group consisting of Me, $^iPr$, $^tBu$, CN, $CF_3$ and Ph;

$R^6$ is selected from the group consisting of hydrogen, deuterium, $C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;

and $R^3$ is defined as for formula II.

In one embodiment, the least one emitter compound E of the device comprises or consists of a structure of formula V,

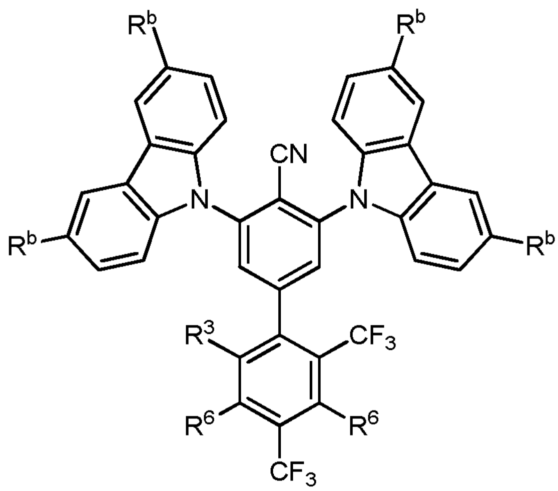

Formula V

wherein

$R^b$ is at each occurrence independently from another selected from the group consisting hydrogen, CN, $CF_3$, Me, $^iPr$, $^tBu$, Ph, which is optionally substituted with one or more residues selected from the group consisting of Me, $^iPr$, $^tBu$, CN, $CF_3$ and Ph, pyridinyl, which is optionally substituted with one or more residues selected from the group consisting of Me, $^iPr$, $^tBu$, CN, $CF_3$ and Ph, pyrimidinyl, which is optionally substituted with one or more residues selected from the group consisting of Me, $^iPr$, $^tBu$, CN, $CF_3$ and Ph, 1,3,5-triazinyl, which is optionally substituted with one or more residues selected from the group consisting of Me, $^iPr$, $^tBu$, CN, $CF_3$ and Ph, and carbazolyl, which is optionally substituted with one or more residues selected from the group consisting of Me, $^iPr$, $^tBu$, CN, $CF_3$ and Ph;
$R^6$ is selected from the group consisting of hydrogen, deuterium, $C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;
and $R^3$ is defined as for formula II.

In one embodiment $R^3$ and $R^6$ is H at each occurrence.

In one embodiment, the at least one emitter compound E of the device has an excited state lifetime of not more than 150 μs, of not more than 100 μs, in particular of not more than 50 μs, more of not more than 10 μs or not more than 7 μs.

In a further embodiment of the invention, the at least one emitter compound E of the device has an emission peak in the visible region with a full width at half maximum of less than 0.50 eV, preferably less than 0.48 eV, more preferably less than 0.45 eV, even more preferably less than 0.43 eV or even less than 0.40 eV.

In a further embodiment of the invention, the at least one emitter compound E of the device has a "blue material index" (BMI), calculated by dividing the photoluminescence quantum yield (PLQY) in % by the $CIE_y$ color coordinate of the emitted light, of more than 150, in particular more than 200, preferably more than 250, more preferably of more than 300 or even more than 500.

The host compound H and/or the at least one emitter compound E may optionally also be used to transport or inject charges and each thereby help to transport charges within the light-emitting layer B.

Preferably, energy can be transferred from the host compound H to the at least one emitter compound E, in particular transferred from the first excited triplet state $T_1(H)$ of the host compound H to the first excited triplet state $T_1(E)$ of the emitter compound E and/ or from the first excited singlet state $S_1(H)$ of the host compound H to the first excited singlet state $S_1(E)$ of the emitter compound E.

Preferably, the light-emitting layer B concomitant to light-emission has an additional functionality selected from the group consisting of serving as an electron transport layer, a hole blocking layer, a hole transport layer, and an electron blocking layer, and an exciton blocking layer.

Orbital and excited state energies can be determined either by means of experimental methods or calculated employing quantum-chemical methods, in particular density functional theory calculations. The energy of the highest occupied molecular orbital $E^{HOMO}$ is determined by methods known to the person skilled in the art from cyclic voltammetry measurements with an accuracy of 0.1 eV. The energy of the lowest unoccupied molecular orbital $E^{LUMO}$ is calculated as $E^{HOMO} + E^{gap}$, where $E^{gap}$ is determined as follows: For host compounds, the onset of emission of a film with 10% host in PMMA is used as $E^{gap}$, unless stated otherwise. For emitter compounds, $E^{gap}$ is determined as the energy at which the excitation and emission spectra of a film with 10% emitter in PMMA cross.

The energy of the first excited triplet state $T_1$ is determined from the onset of emission at low temperature, typically at 77 K. For host compounds, where the first excited singlet state and the lowest triplet state are energetically separated by > 0.4 eV, the phosphorescence is usually visible in steady-state spectra in 2-Me-THF. The triplet energy can thus be determined as the onset of the phosphorescence spectra. For TADF emitter compounds, the energy of the first excited triplet state $T_1$ is determined from the onset of the delayed emission spectrum at 77 K, if not otherwise stated measured in a film of poly(methyl methacrylate) (PMMA) with 10 weight-% of emitter. Both for host and emitter compounds, the energy of the first excited singlet state $S_1$ is determined from the onset of the emission spectrum, if not otherwise stated measured in a film of poly(methyl methacrylate) (PMMA) with 10 weight-% of host or emitter compound.

Particularly preferably the light-emitting layer B comprises (or (essentially) consists of):

(i) 5-99 % by weight, preferably 30-94.9 % by weight, in particular 40-89% by weight, of at least one host compound H;
(ii) 1-50 % by weight, preferably 5-40 % by weight, in particular 10-30 % by weight, of the at least one emitter compound E; and
(iii) optionally 0-94 % by weight, preferably 0.1-65 % by weight, in particular 1-50 % by weight, of at least one further host compound $D^1$ with a structure that is not according to formula (I); and
(iv) optionally 0-94 % by weight, preferably 0-65 % by weight, in particular 0-50 % by weight, of a solvent; and

(v) optionally 0-30 % by weight, in particular 0-20 % by weight, preferably 0-5 % by weight, of at least one further emitter compound.

In one embodiment, the host compound H has a highest occupied molecular orbital HOMO(H) having an energy $E^{HOMO}(H)$ in the range of from -5 to -6.5 eV and the at least one further host compound $D^1$ has a highest occupied molecular orbital HOMO($D^1$) having an energy $E^{HOMO}(D^1)$, wherein $E^{HOMO}(H) > E^{HOMO}(D^1)$.

In another embodiment, the host compound H has a lowest unoccupied molecular orbital LUMO(H) having an energy $E^{LUMO}(H)$ and the at least one further host compound $D^1$ has a lowest unoccupied molecular orbital LUMO($D^1$) having an energy $E^{LUMO}(D^1)$, wherein $E^{LUMO}(H) > E^{LUMO}(D^1)$.

In one embodiment, the host compound H has a highest occupied molecular orbital HOMO(H) having an energy $E^{HOMO}(H)$ and a lowest unoccupied molecular orbital LUMO(H) having an energy $E^{LUMO}(H)$, and
the at least one further host compound $D^1$ has a highest occupied molecular orbital HOMO($D^1$) having an energy $E^{HOMO}(D^1)$ and a lowest unoccupied molecular orbital LUMO($D^1$) having an energy $E^{LUMO}(D^1)$,
the emitter compound E has a highest occupied molecular orbital HOMO(E) having an energy $E^{HOMO}(E)$ and a lowest unoccupied molecular orbital LUMO(E) having an energy $E^{LUMO}(E)$,
wherein
$E^{HOMO}(H) > E^{HOMO}(D^1)$ and the difference between the energy level of the highest occupied molecular orbital HOMO(E) of the emitter compound E ($E^{HOMO}(E)$) and the energy level of the highest occupied molecular orbital HOMO(H) of the host compound H ($E^{HOMO}(H)$) is between - 0.5 eV and 0.5 eV, more preferably between -0.3 eV and 0.3 eV, even more preferably between -0.2 eV and 0.2 eV or even between -0.1 eV and 0.1 eV; and
$E^{LUMO}(H) > E^{LUMO}(D^1)$ and the difference between the energy level of the lowest unoccupied molecular orbital LUMO(E) of emitter compound E ($E^{LUMO}(E)$) and the lowest unoccupied molecular orbital LUMO($D^1$) of the at least one further host compound $D^1$ ($E^{LUMO}(D^1)$) is between -0.5 eV and 0.5 eV, more preferably between -0.3 eV and 0.3 eV, even more preferably between -0.2 eV and 0.2 eV or even between -0.1 eV and 0.1 eV.

In a further preferred embodiment, at least one further host compound $D^1$ comprises or consists of a structure of formula (VII):

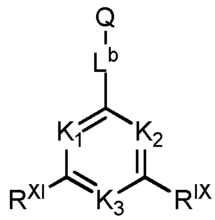

Formula VII

wherein:

each of $K_1$, $K_2$ and $K_3$ is independently from another selected from the group consisting of CH, $CR^k$, and N; wherein at least one of the residues $K_1$, $K_2$ and $K_3$ is N;

wherein $R^k$ is at each occurrence identical or differing and independently selected from the group consisting of $C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $Si(R^m)_3$;

each of $R^{IX}$ and $R^{XI}$ is independently from another selected from the group consisting of hydrogen, $C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and/or $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $Si(R^m)_3$;

$R^m$ is at each occurrence identical or differing and independently from another selected from the group consisting

of hydrogen, $C_1$-$C_{20}$-alkyl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and/or $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;

$L^b$ is selected from the group consisting of a single bond and $C_6$-$C_{18}$-arylene, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;

Q is a group comprising or consisting of a structure of one of formulas VIII to XI

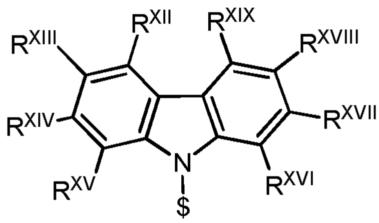

Formula VIII

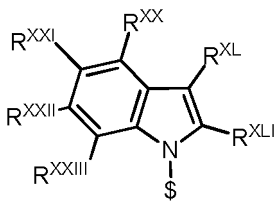

Formula IX

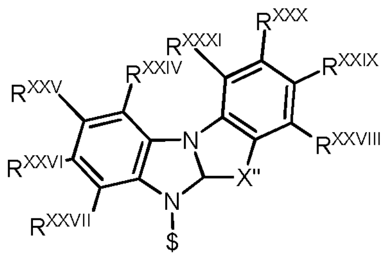

Formula X

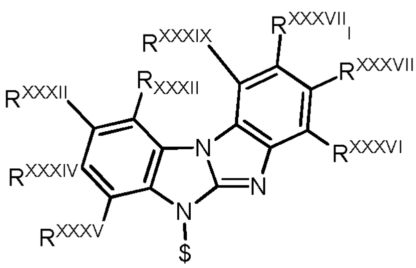

Formula XI

wherein

$ is the binding site to $L^b$;
X" is selected from the group consisting of O and S;

each of $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}R^{XXII}$, $R^{XXIII}$, $R^{XXIV}$, $D^{XXV}$, $R^{XXVI}$, $R^{XXVII}$, $R^{XXVIII}$, $R^{XXIX}$, $D^{XXX}$, $R^{XXXI}$, $R^{XXXII}$, $R^{XXXIII}$, $R^{XXXIV}$, $D^{XXXV}$, $R^{XXXVI}$, $R^{XXXVII}$, $R^{XXXVIII}$ and $R^{XXXIX}$ is independently from another selected from the group consisting of hydrogen, Cl, Br, I, CN, $CF_3$, $C_1$-$C_{20}$-alkyl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$, $C_6$-$C_{18}$-aryl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$, $C_3$-$C_{17}$-heteroaryl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$, and $Si(R^m)_3$;

each of $R^{XL}$ and $R^{XLI}$ is independently from another selected from the group consisting of hydrogen, $C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and $Si(R^m)_3$.

As used throughout the present application, the terms "aryl" and "aromatic" may be understood in the broadest sense as any mono-, bi- or polycyclic aromatic moieties. If not otherwise indicated, an aryl may also be optionally substituted by one or more substituents which are exemplified further throughout the present application. Accordingly, an aryl group contains 6 to 60 aromatic ring atoms, and a heteroaryl group contains 5 to 60 aromatic ring atoms, of which at least one is a heteroatom. In particular, the heteroaromatic ring includes one to three heteroatoms. Again, the terms "heteroaryl" and "heteroaromatic" may be understood in the broadest sense as any mono-, bi- or polycyclic heteroaromatic moieties that include at least one heteroatom. The heteroatoms may at each occurrence be the same or different and be individually selected from the group consisting of N, O and S. Accordingly, the term "arylene" refers to a divalent residue that bears two binding sites to other molecular structures and thereby serving as a linker structure. In case, a group in the exemplary embodiments is defined differently from the definitions given here, for example the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term aryl group or heteroaryl group comprises groups, which can be bound via any position of the aromatic or heteroaromatic group, derived from benzene, naphthaline, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine und benzothiadiazole or combinations of the mentioned groups.

As used throughout the present application the terms "cyclic alkyl group", "cyclic alkoxy group" or "cyclic thioalkoxy group" may be understood in the broadest sense as any mono-, bi- or polycyclic moieties.

In particular, as used throughout the present application the term alkyl group comprises the residues methyl (Me), ethyl (Et), n-propyl ($^nPr$), i-propyl ($^iPr$), cyclopropyl, n-butyl ($^nBu$), i-butyl ($^iBu$), s-butyl ($^sBu$), t-butyl ($^tBu$), cyclobutyl, 2-methylbutyl, n-pentyl, s-pentyl, t-pentyl, 2-pentyl, neo-pentyl, pyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-cetylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl und 1-(n-decyl)-cyclohex-1-yl. The term alkenyl group exemplarily comprises the residues ethenyl, propenyl, butenyl, pentenyl, cyclopentenyl, hexenyl, cyclohexenyl, heptenyl, cycloheptenyl, octenyl, cyclooctenyl or cyclooctadienyl. The term alkynyl group exemplarily comprises ethynyl, propynyl, butynyl, pentynyl, hexynyl, heptynyl or octynyl. The term alkoxy group exemplarily comprises methoxy, ethoxy, n-propoxy, i-propoxy, n-butoxy, i-butoxy, s-butoxy, t-butoxy or 2-methylbutoxy.

If not otherwise indicated, as used herein, in particular, in the context of aryl, arylene, heteroaryl, alkyl and the

like, the term "substituted" may be understood in the broadest sense. Preferably, such substitution means a residue selected from the group consisting of $C_1$-$C_{20}$-alkyl, $C_7$-$C_{19}$-alkaryl and $C_6$-$C_{18}$-aryl. Accordingly, preferably, no charged moiety, more preferably no functional group is present in such substitution.

It will be noticed that hydrogen can, at each occurrence, be replaced by deuterium.

Exemplarily, when the organic electroluminescent device is an OLED, it may exhibit the following layer structure:

1. substrate
2. anode layer A
3. hole injection layer, HIL
4. hole transport layer, HTL
5. electron blocking layer, EBL
6. emitting layer, B
7. hole blocking layer, HBL
8. electron transport layer, ETL
9. electron injection layer, EIL
10. cathode layer,

wherein the OLED comprises each layer only optionally, different layers may be merged and may comprise more than one layer of each layer types defined above.

Furthermore, the organic electroluminescent device may optionally comprise one or more protective layers protecting the device from damaging exposure to harmful species in the environment including, exemplarily moisture, vapor and/or gases.

In one embodiment of the invention, the organic electroluminescent device is an OLED, which exhibits the following inverted layer structure:

1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A

Wherein the OLED with an inverted layer structure comprises each layer only optionally, different layers may be merged and may comprise more than one layer of each layer types defined above.

In one embodiment of the invention, the organic electroluminescent device is an OLED, which may exhibit stacked architecture. In this architecture, contrary to the typical arrangement, where the OLEDs are placed side by side, the individual units are stacked on top of each other. Blended light may be generated with OLEDs exhibiting a stacked architecture, in particular, white light may be generated by stacking blue, green and red OLEDs. Furthermore, the OLED exhibiting a stacked architecture may optionally comprise a charge generation layer (CGL), which is typically located between two OLED subunits and typically consists of a n-doped and p-doped layer with the n-doped layer of one CGL being typically located closer to the anode layer.

In one embodiment of the invention, the organic electroluminescent device is an OLED, which comprises two or more emission layers, including emission layer B, between anode and cathode. In particular, this so-called tandem OLED comprises three emission layer, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the

anode layer A comprises a large content or even consists of transparent conductive oxides (TCOs). Such anode layer A may exemplarily comprise indium tin oxide, aluminum zinc oxide, fluorine doped tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene.

Particularly preferably, the anode layer A (essentially) consists of indium tin oxide (ITO) (e.g., $(InO_3)_{0.9}(SnO_2)_{0.1}$). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. The hole injection layer (HIL) may also prevent the diffusion of metals from the anode layer A into the hole transport layer (HTL). The HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyi)bis(N1-phenyi-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL) typically a hole transport layer (HTL) is located. Herein, any hole transport compound may be used. Exemplarily, electron-rich heteroaromatic compounds such as triarylamines and/or carbazoles may be used as hole transport compound. The HTL may decrease the energy barrier between the anode layer A and the light-emitting layer B (serving as emitting layer (EML)). The hole transport layer (HTL) may also be an electron blocking layer (EBL). Preferably, hole transport compounds bear comparably high energy levels of their triplet states T1. Exemplarily the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may exemplarily be used as inorganic dopant. Tetrafluorotetracyanoquinodimethane (F4-TCNQ), copper-pentafluorobenzoate (Cu(I)pFBz) or transition metal complexes may exemplarily be used as organic dopant.

The EBL may exemplarily comprise mCP (1,3-bis(carbazol-9-yl)benzene), TCTA, 2-TNATA, mCBP (3,3-di(9H-carbazol-9-yl)biphenyl), tris-Pcz, CzSi (9-(4-tert-Butylphenyl)-3,6-bis(triphenylsilyl)-9H-carbazole), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine) and/or DCB (N,N'-dicarbazolyl-1,4-dimethylbenzene).

Adjacent to the hole transport layer (HTL), typically, the light-emitting layer B is located. This is specified in detail in the context of the present invention.

Adjacent to the light-emitting layer B an electron transport layer (ETL) may be located. Herein, any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL is doped with materials such as Liq. The electron transport layer (ETL) may also block holes or a holeblocking layer (HBL) is introduced.

The HBL may exemplarily comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide) and/or TCB/TCP (1,3,5-tris(N-carbazolyl)benzol/ 1,3,5-tris(carbazol)-9-yl) benzene).

Adjacent to the electron transport layer (ETL), a cathode layer C may be located. Exemplarily, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride,

cesium fluoride, silver, Liq (8-hydroxyquinolinolatolithium), $Li_2O$, $BaF_2$, MgO and/or NaF.

Optionally, also the electron transport layer (ETL) and/or a hole blocking layer (HBL) may comprise one or more host compounds H.

In order to modify the emission spectrum and/or the absorption spectrum of the light-emitting layer B further, the light-emitting layer B may further comprise one or more further emitter compound F. Such an emitter compound F may be any emitter compound known in the art. The emitter compound F may optionally be a TADF emitter. Alternatively, the emitter compound F may optionally be a fluorescent and/or phosphorescent emitter compound which is able to shift the emission spectrum and/or the absorption spectrum of the light-emitting layer B. Exemplarily, the triplet and/or singlet excitons may be transferred from the at least one emitter compound E to the emitter compound F before relaxing to the ground state So by emitting light typically red-shifted in comparison to the light emitted by emitter compound E. Optionally, the emitter compound F may also provoke two-photon effects (i.e., the absorption of two photons of half the energy of the absorption maximum).

Optionally, an organic electroluminescent device (e.g., an OLED) may exemplarily be an essentially white organic electroluminescent device. Exemplarily such white organic electroluminescent device may comprise at least one (deep) blue emitter compound and one or more emitter compounds emitting green and/or red light. Then, there may also optionally be energy transmittance between two or more compounds as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter compounds E, such colors refer to the emission maximum. Therefore, exemplarily, a deep blue emitter has an emission maximum in the range of from 420 to 480 nm, a sky blue emitter has an emission maximum in the range of from 480 to 500 nm, a green emitter has an emission maximum in a range of from 500 to 560 nm, a red emitter has an emission maximum in a range of from 620 to 800 nm.

A deep blue emitter may preferably have an emission maximum of below 480 nm, more preferably below 470 nm, even more preferably below 465 nm or even below 460 nm. It will typically be above 410 nm, preferably above 420 nm, more preferably above 430 nm.

Accordingly, a further aspect of the present invention relates to an OLED, which exhibits an external quantum efficiency at 1000 cd/$m^2$ of more than 8 %, more preferably of more than 10 %, more preferably of more than 13 %, even more preferably of more than 15 % or even more than 20 % and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 70 h, preferably more than 100 h, more preferably more than 200 h, even more preferably more than 300 h or even more than 400 h. Accordingly, a further aspect of the present invention relates to an OLED, whose emission exhibits a $CIE_y$ color coordinate of less than 0.45, preferably less than 0.30, more preferably less than 0.20 or even more preferably less than 0.15 or even less than 0.10.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than 0.50 eV, preferably less than 0.48 eV, more preferably less than 0.45 eV, even more preferably less than 0.43 eV or even less than 0.40 eV.

The organic electroluminescent device, in particular the OLED according to the present invention can be fabricated by any means of vapor deposition and/ or liquid processing. Accordingly, at least one layer is

- prepared by means of a sublimation process,
- prepared by means of an organic vapor phase deposition process,
- prepared by means of a carrier gas sublimation process,
- solution processed or printed.

The methods used to fabricate the organic electroluminescent device, in particular the OLED according to the present invention are known in the art. The different layers are individually and successively deposited on a suitable substrate by means of subsequent deposition processes. The individual layers may be deposited using the same or differing deposition methods.

Vapor deposition processes exemplarily comprise thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process exemplarily comprise spin coating, dip coating and jet printing. Liquid processing may optionally be carried out in an inert atmosphere (e.g., in a nitrogen atmosphere) and the solvent may optionally be completely or partially removed by means known in the state of the art.

**Examples**

**Synthesis of host compounds H**

General synthesis scheme I

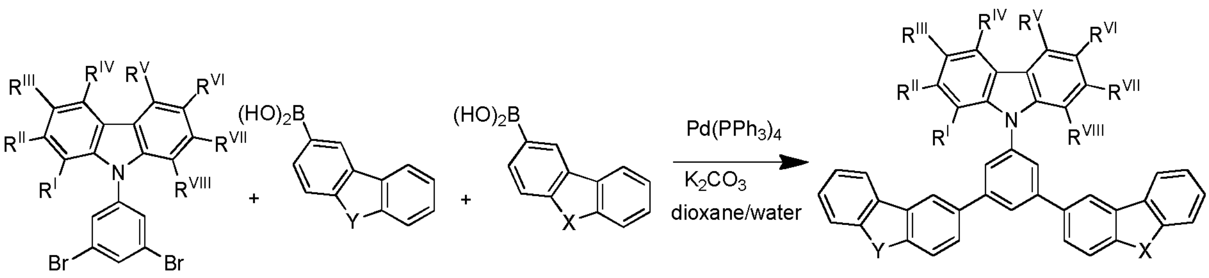


**Host compound H1**

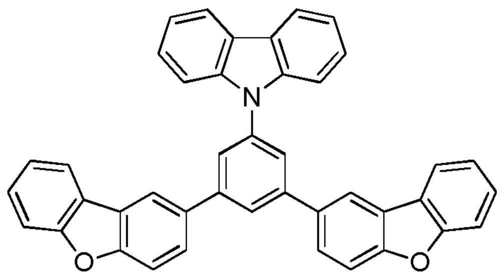

4 g (9.97 mmol) of 9-(3,5-Dibromophenyl)-9H-carbazole, 5.28 g (24.9 mmol) of dibenzofuran-2-boronic acid, 0.58 g (0.5 mmol) of tetrakis(triphenylphosphine)palladium(0) and 5.5 g (40 mmol) of potassium carbonate were placed in a round bottom and it is evacuated for 10 min, then refilled with nitrogen. The degassed solvent mixture (dioxane/water 10:1) was added to the reaction mixture. The reaction was heated under nitrogen. A white precipitate formed. After cooling the reaction was filtered and the collected solid washed with water and dioxane. It was dried in vacuo. The pure product was obtained after sublimation. Yield: 4.9 g (8.51 mmol, 85 %).
$^1$H NMR (500 MHz, $CDCl_3$) $\delta$ 8.30 (d, 2H), 8.21 (dt, 2H), 8.09 (t, 1H), 8.02 (dt, 2H), 7.90 (d, 2H), 7.85 (dd, 2H), 7.70 (d, 2H), 7.61 (ddd, 4H), 7.49 (dddd, 4H), 7.38 (td, 2H), 7.34 (ddd, 2H).

**Host compound H2**

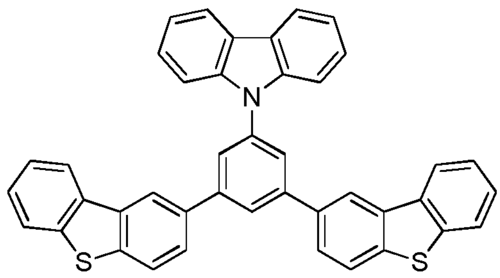

4 g (9.97 mmol) of 9-(3,5-Dibromophenyl)-9H-carbazole, 5.68 g (24.9 mmol) of dibenzothiophene-2-boronic acid, 0.58 g (0.5 mmol) of tetrakis(triphenylphosphine)palladium(0) and 5.5 g (40 mmol) of potassium carbonate were placed in a round bottom and it is evacuated for 10 min, then refilled with nitrogen. The degassed solvent mixture (dioxane/water 10:1) was added to the reaction mixture. The reaction was heated under nitrogen. An off-white precipitate formed. After cooling the reaction was filtered and the collected solid washed with water and dioxane. It was dried in vacuo. The pure product was obtained after column chromatography on silica gel using cyclohexane/ethyl acetate as eluent. It was further purified by sublimation. Yield: 5.5 g (9.05 mmol, 91 %).
$^1$H NMR (500 MHz, Chloroform-d) δ 8.49 (d, 2H), 8.27 - 8.23 (m, 2H), 8.21 (dt, 2H), 8.15 (t, 1H), 8.02 - 7.98 (m, 2H), 7.95 (d, 2H), 7.92 - 7.88 (m, 2H), 7.86 (dd, 2H), 7.62 (dt, 2H), 7.51 - 7.47 (m, 6H), 7.34 (ddd, 2H).

**Synthesis of emitter compound E**

General synthesis scheme II

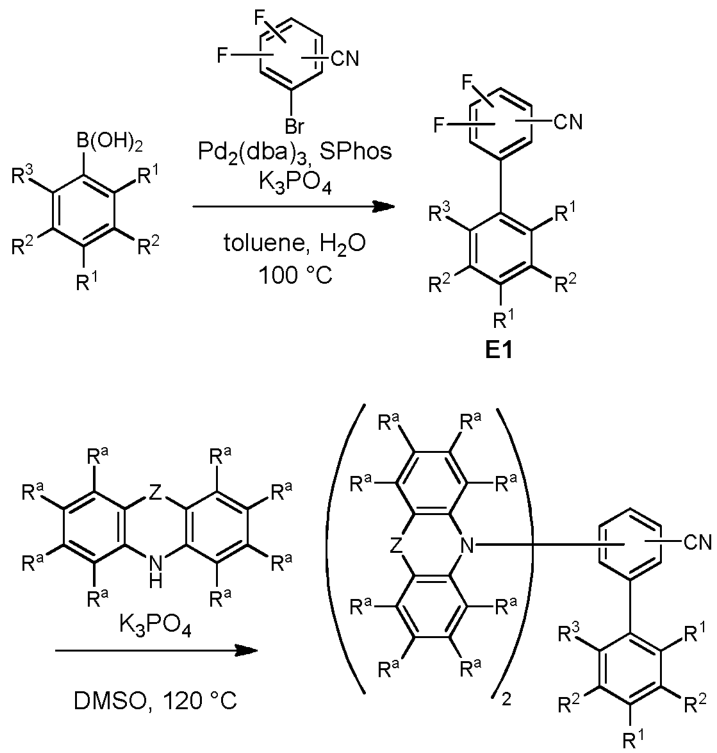


In the above scheme, the chemical group CN can be replaced by $CF_3$

*General procedure for synthesis **AAV1**:*

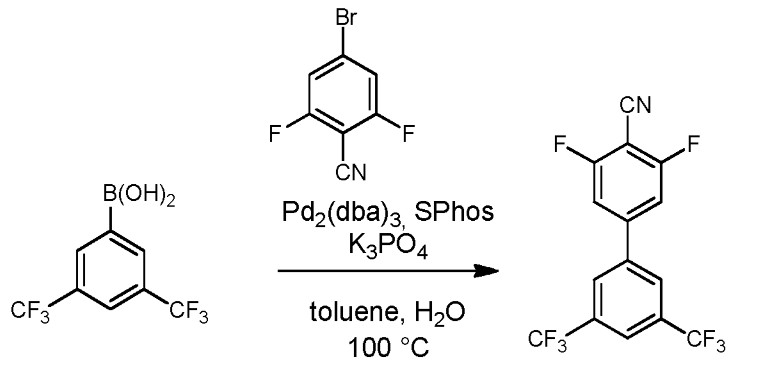


**Z1**

3,5-Bis(trifluoromethyl)-phenylboronic acid (1.50 equivalents), 4-bromo-2,6-difluorobenzonitrile (1.00 equivalents), $Pd_2(dba)_3$ (0.02 equivalent), 2-dicyclohexylphosphino-2',6'-dimethoxybiphenyl (SPhos) (0.08 equivalents) and tribasic potassium phosphate (2.50 equivalents) are stirred under nitrogen atmosphere in a toluene/water mixture (ratio of 20:1) at 100 °C for 16 h. Subsequently the reaction mixture is poured into 600 mL of a saturated sodium chloride solution and extracted with ethyl acetate. The combined organic phases are washed with saturated sodium chloride solution, dried over MgSO4 and the solvent is removed. The crude product obtained is purified by flash chromatography and the product obtained as solid. Instead of a boronic acid a corresponding boronic acid ester may be used.

*General procedure for synthesis **AAV2**:*

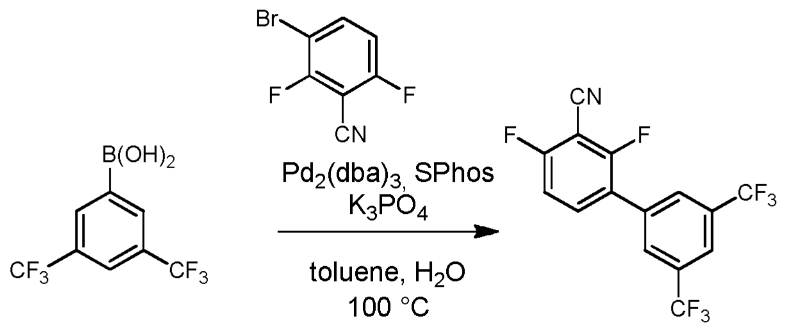


**Z2**

The synthesis of **Z2** is carried out according to ***AAV1,*** wherein 3,5-bis(trifluoromethyl)-phenylboronic acid is reacted with 3-bromo-2,6-difluorobenzonitrile.

*General procedure for synthesis **AAV**:*

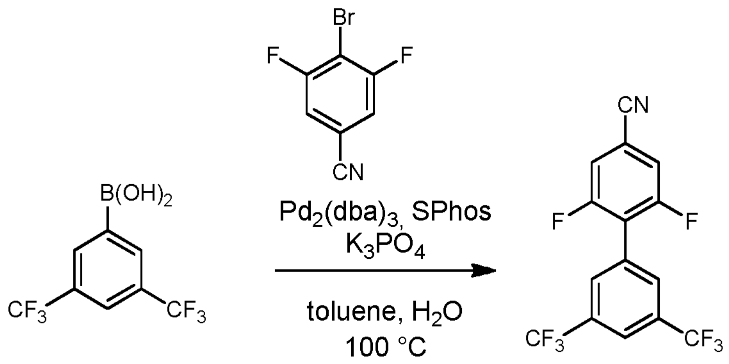


**Z3**

The synthesis of **Z3** is carried out according to *AAV1,* wherein 3,5-bis(trifluoromethyl)-phenylboronic acid is reacted with 4-bromo-3,5-difluorobenzonitrile.

*General procedure for synthesis* ***AAV4:***

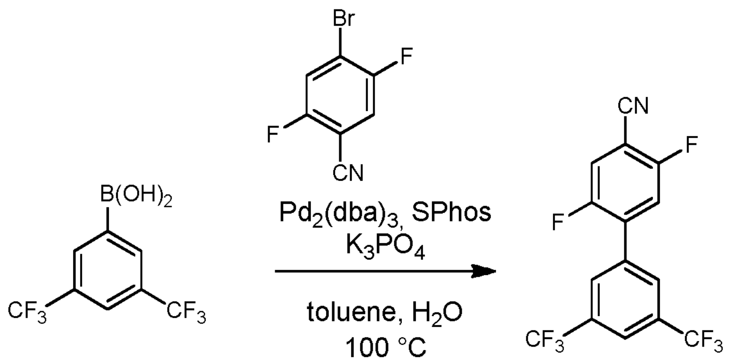


**Z4**

The synthesis of **Z4** is carried out according to ***AAV1,*** wherein 3,5-bis(trifluoromethyl)-phenylboronic acid is reacted with 4-bromo-2,5-difluorobenzonitrile.

*General procedure for synthesis* ***AAV5***:

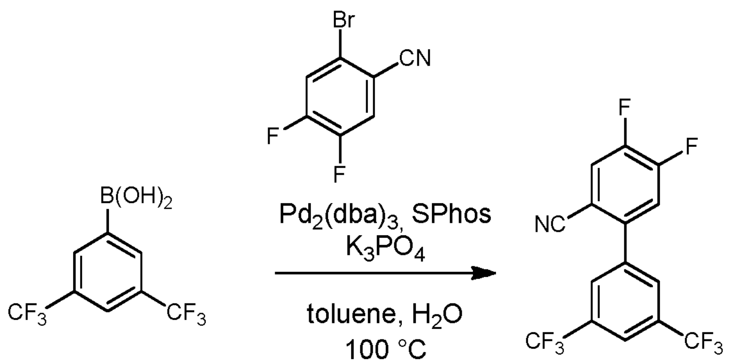


**Z5**

The synthesis of **Z5** is carried out according to ***AAV1,*** wherein 3,5-bis(trifluoromethyl)-phenylboronic acid is reacted with 3-bromo-4,5-difluorobenzonitrile.

*General procedure for synthesis* ***AAV6***:

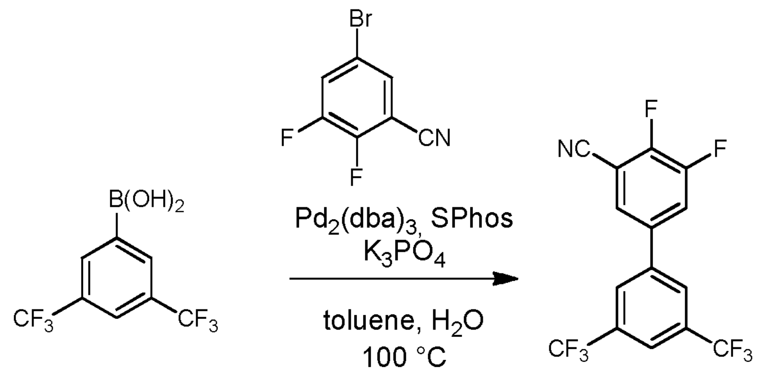


**Z6**

The synthesis of **Z6** is carried out according to ***AAV1***, wherein 3,5-bis(trifluoromethyl)-phenylboronic acid is reacted with 3-bromo-5,6-difluorobenzonitrile.

*General procedure for synthesis* ***AAV7***:

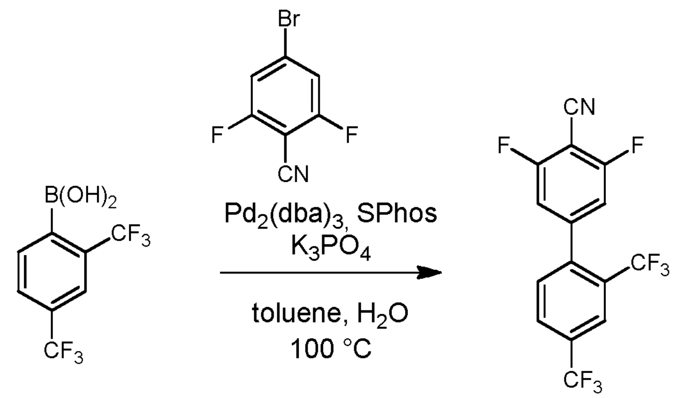


**Z7**

2,4-Bis(trifluoromethyl)-phenylboronic acid (1.50 equivalents), 4-bromo-2,6-difluorobenzonitrile (1.00 equivalents), $Pd_2(dba)_3$ (0.02 equivalent), 2-dicyclohexylphosphino-2',6'-dimethoxybiphenyl (SPhos) (0.08 equivalents) and tribasic potassium phosphate (2.50 equivalents) are stirred under nitrogen atmosphere in a toluene/water mixture (ratio of 20:1) at 100 °C for 16 h. Subsequently the reaction mixture is poured into 600 mL of a saturated sodium chloride solution and extracted with ethyl acetate. The combined organic phases are washed with saturated sodium chloride solution, dried over MgSO4 and the solvent is removed. The crude product obtained is purified by flash chromatography and the product obtained as solid. Instead of a boronic acid a corresponding boronic acid ester may be used.

*General procedure for synthesis* ***AAV8***:

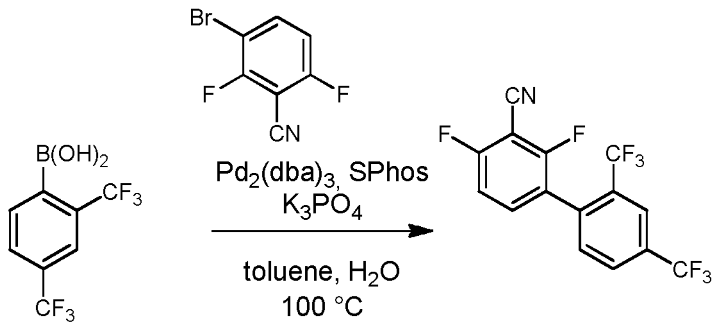


**Z8**

The synthesis of **Z8** is carried out according to ***AAV7***, wherein 2,4-bis(trifluoromethyl)-phenylboronic acid is reacted with 3-bromo-2,6-difluorobenzonitrile.

*General procedure for synthesis **AAV9**:*

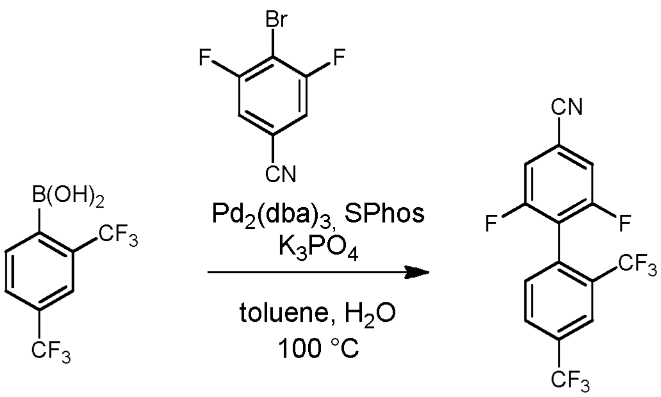


**Z9**

The synthesis of **Z9** is carried out according to ***AAV7***, wherein 2,4-bis(trifluoromethyl)-phenylboronic acid is reacted with 4-bromo-3,5-difluorobenzonitrile.

*General procedure for synthesis **AAV10**:*

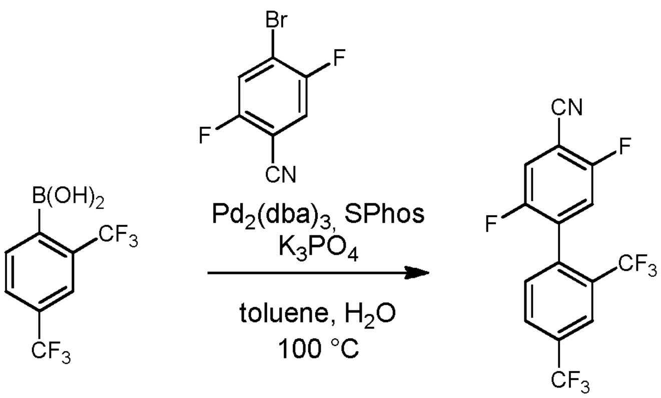


**Z10**

The synthesis of **Z10** is carried out according to ***AAV7***, wherein 2,4-bis(trifluoromethyl)-phenylboronic acid is reacted with 4-bromo-2,5-difluorobenzonitrile.

*General procedure for synthesis* ***AAV11***:

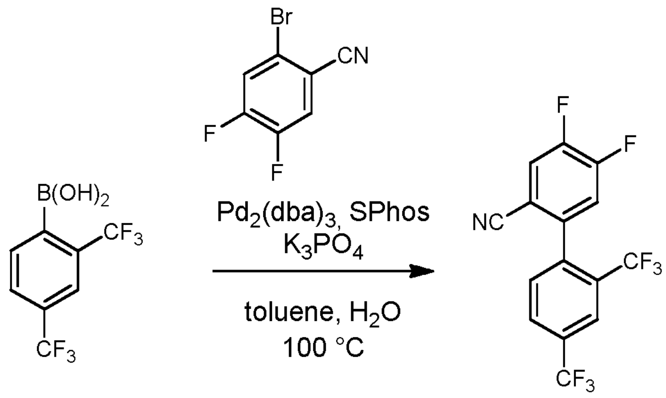


**Z11**

The synthesis of **Z11** is carried out according to ***AAV7***, wherein 2,4-bis(trifluoromethyl)-phenylboronic acid is reacted with 3-bromo-4,5-difluorobenzonitrile.

*General procedure for synthesis* ***AAV12***:

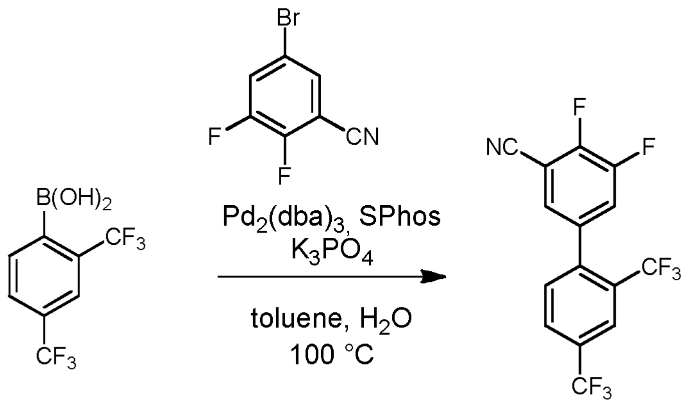


**Z12**

The synthesis of **Z12** is carried out according to ***AAV7***, wherein 2,4-bis(trifluoromethyl)-phenylboronic acid is reacted with 3-bromo-5,6-difluorobenzonitrile.

*General procedure for synthesis* ***AAV13***:

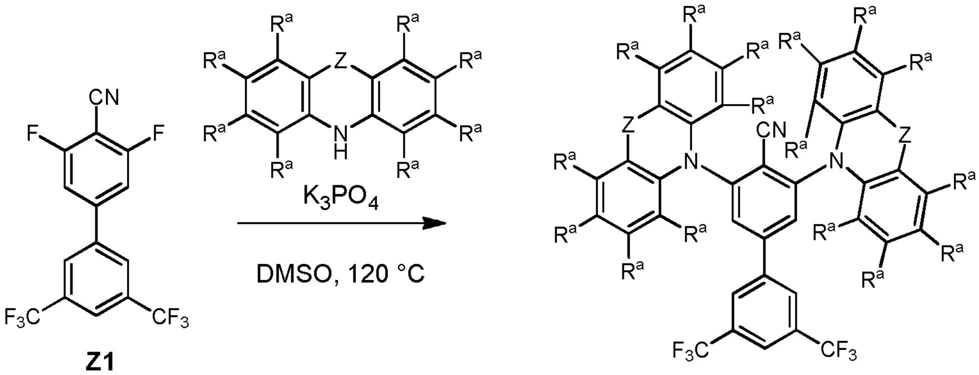
K3PO4
DMSO, 120 °C

Z1

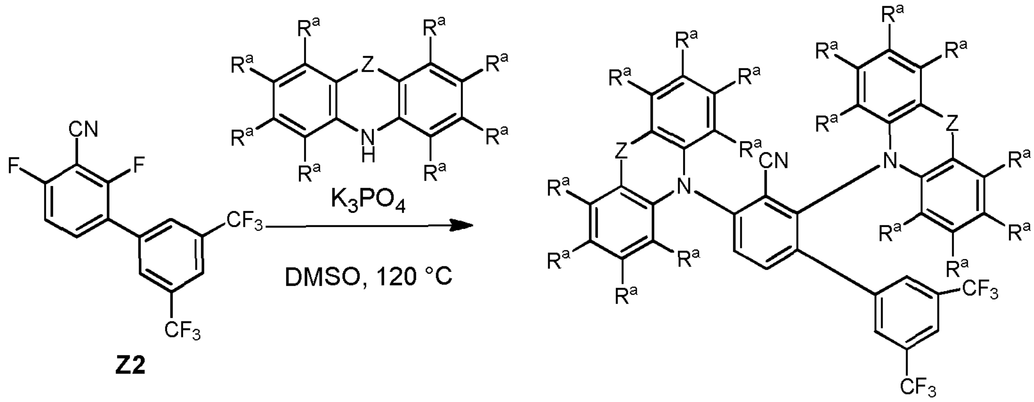
K3PO4
DMSO, 120 °C

Z2

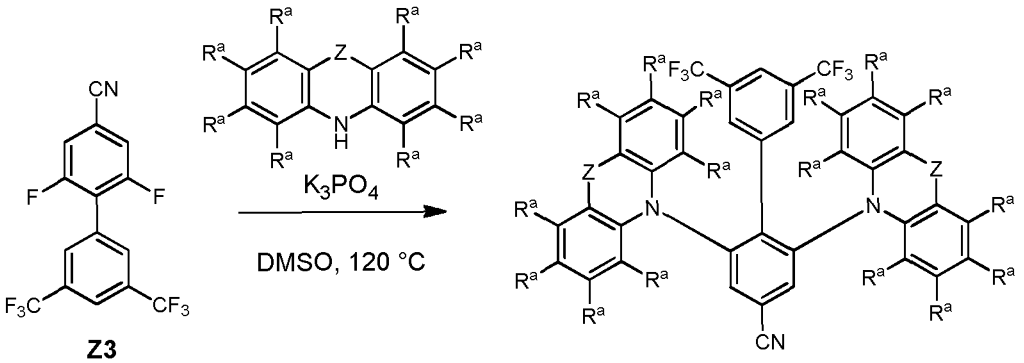
K3PO4
DMSO, 120 °C

Z3

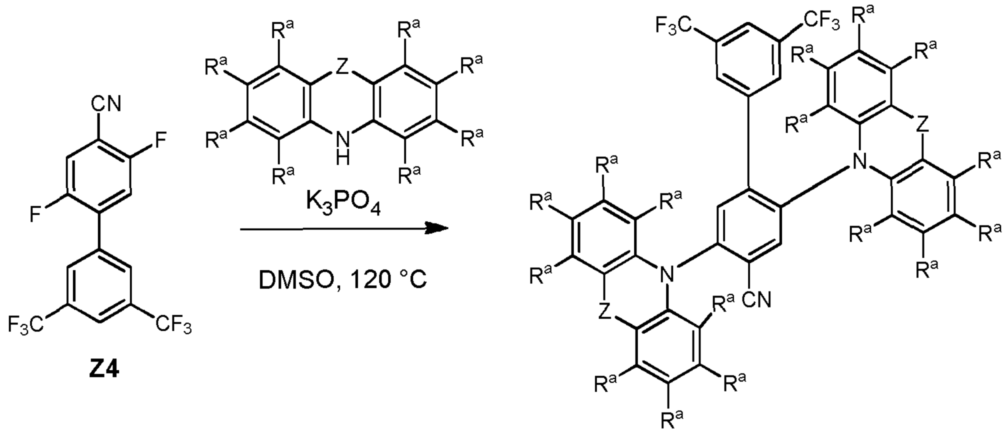
K3PO4
DMSO, 120 °C

Z4

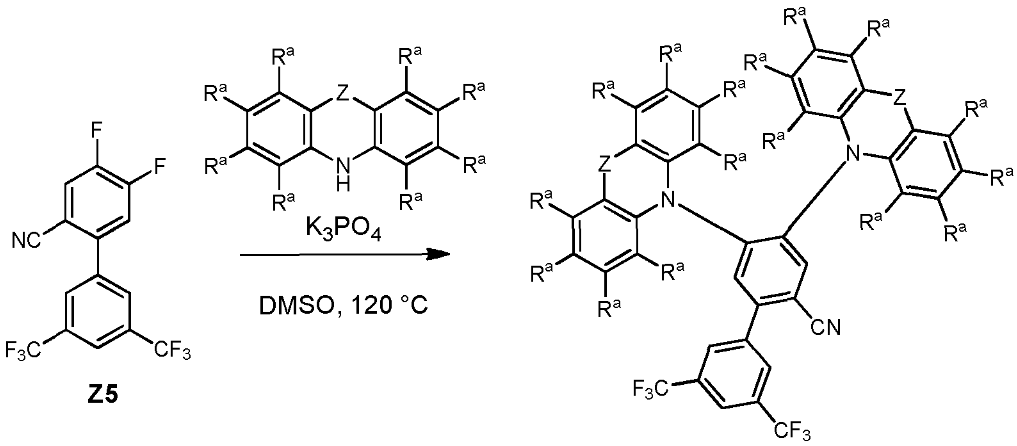


Z5

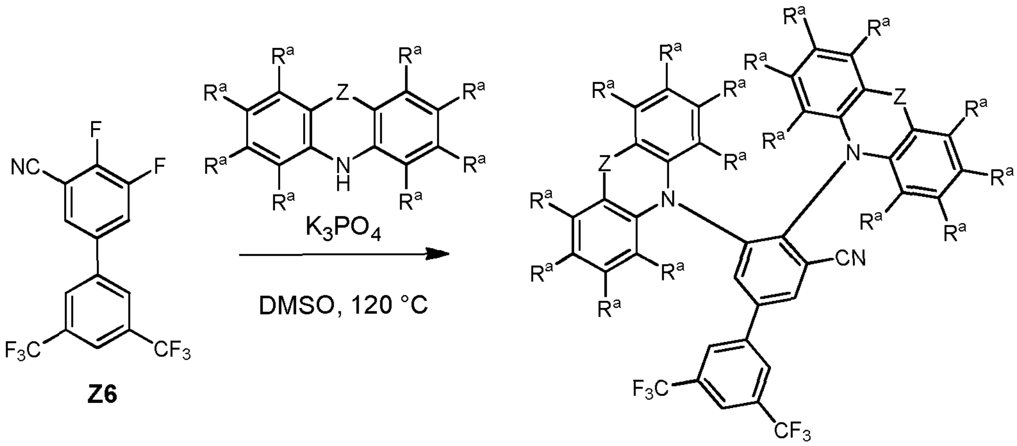


Z6

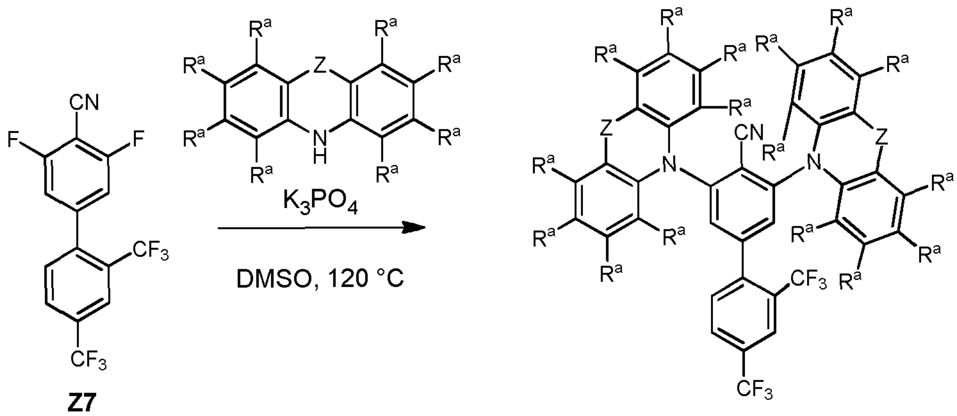


Z7

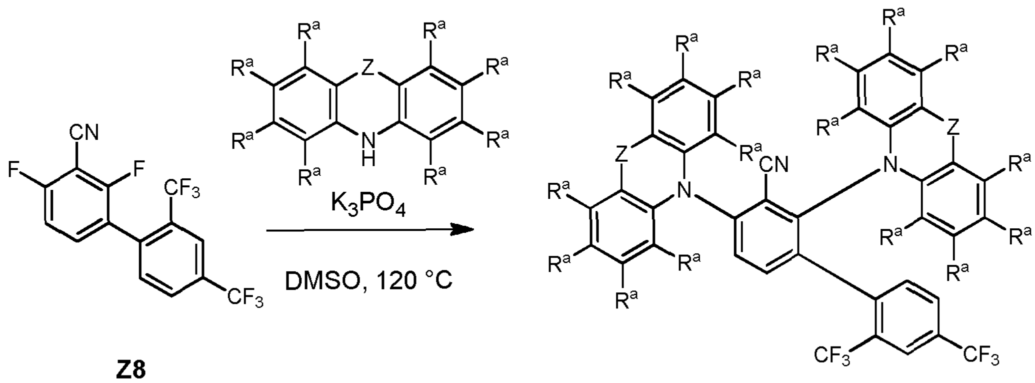


**Z8**

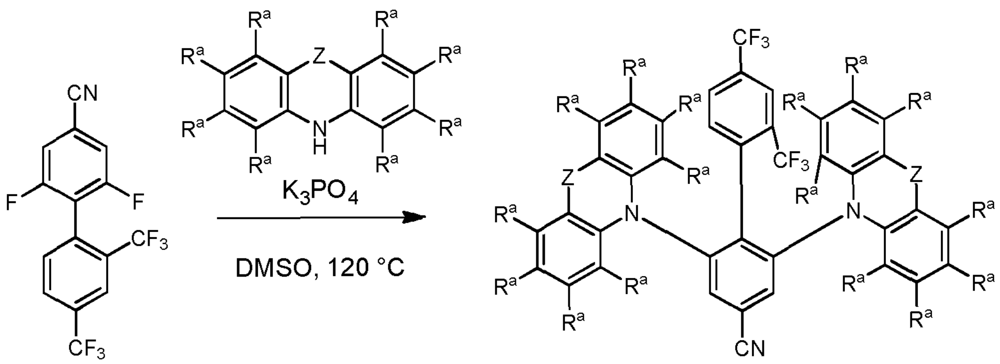


**Z9**

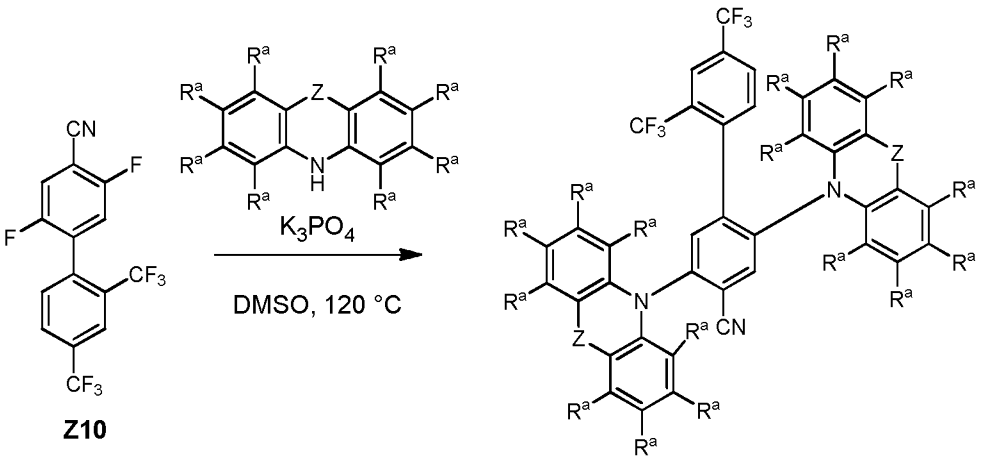


**Z10**

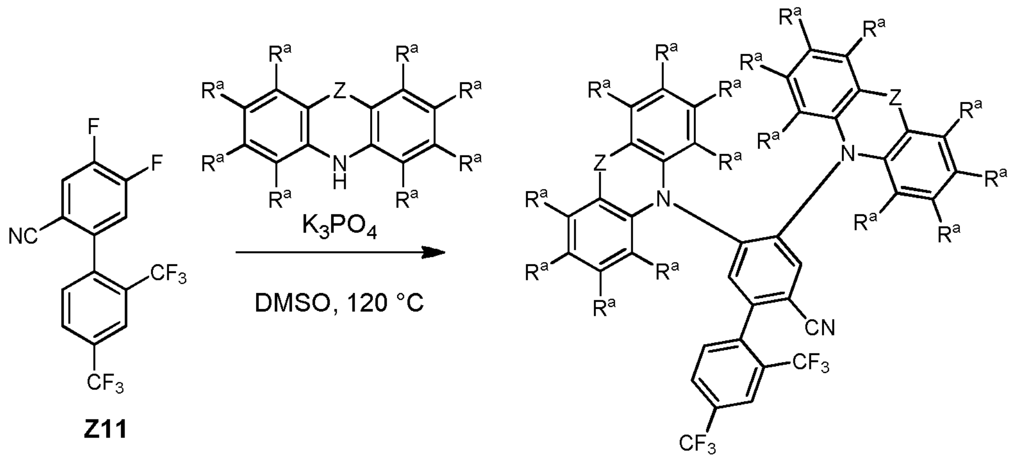


Z11

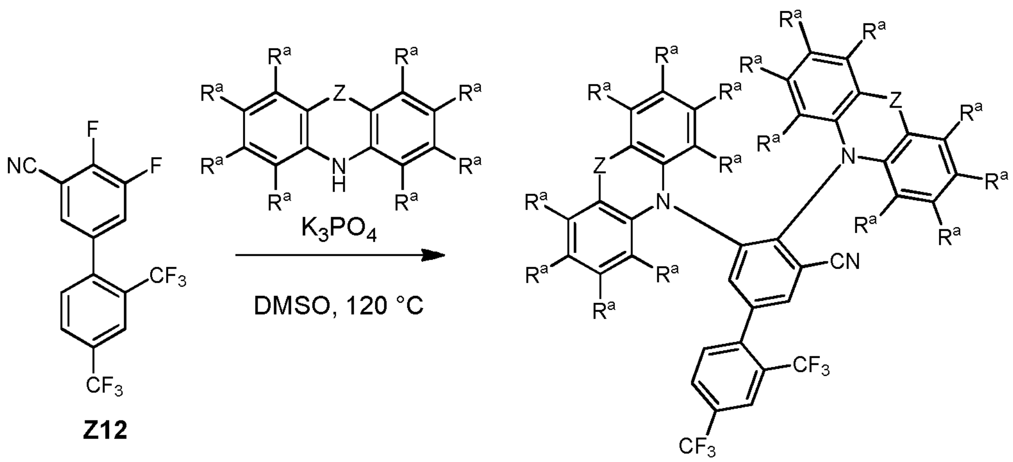


Z12

**Z1, Z2, Z3, Z4, Z5, Z6, Z7, Z8, Z9, Z10, Z11** or **Z12** (1 equivalent each), the corresponding donor molecule D-H (2.00 equivalents) and tribasic potassium phosphate (4.00 equivalents) are suspended under nitrogen atmosphere in DMSO and stirred at 110 °C (16 h). Subsequently the reaction mixture is poured into a saturated sodium chloride solution and extracted three times with dichloromethane. The combined organic phases are washed twice with saturated sodium chloride solution, dried over MgSO4 and the solvent removed. The crude product is purified by recrystallization out of toluene or by flash chromatography. The product is obtained as a solid.

In order to obtain the corresponding $R^3$-substituted products, a correspondingly $R^3$-substituted 3,5-bis(trifluoromethyl)-phenylboronic acid or 2,4-bis(trifluoromethyl)-phenylboronic acid is used instead of 3,5-bis(trifluoromethyl)-phenylboronic acid or 2,4-bis(trifluoromethyl)-phenylboronic acid.

D-H is in particular a 3,6-substituted carbazole (e.g. 3,6-dimethylcarbazole, 3,6-diphenylcarbazole, 3,6-di-tert-butylcarbazole), a 2,7-substituted carbazole (e.g. 2,7-dimethylcarbazole, 2,7-diphenylcarbazole, 2,7-di-tert-butylcarbazole), a 1,8-substituted carbazole (e.g. 1,8-dimethylcarbazole, 1,8-diphenylcarbazole, 1,8-di-tert-butylcarbazole), a 1-substituted carbazole (e.g. 1-methylcarbazole, 1-phenylcarbazole, 1-tert-butylcarbazole), a 2-substituted carbazole (e.g. 2-methylcarbazole, 2-phenylcarbazole, 2-tert-butylcarbazole) or a 3-substituted carbazole (e.g. 3-methylcarbazole, 3-phenylcarbazole, 3-tert-butylcarbazole).

*Cyclic voltammetry*

Cyclic voltammograms of solutions having concentration of $10^{-3}$ mol/l of the organic molecules in dichloromethane and tetrabutylammonium hexafluorophosphate as supporting electrolyte (0.1 mol/l) are recorded using a Model 601D Series Elechtrochemical Analyzer with work station (CH Instruments) with a scan rate of 100 mV/s. The measurements are conducted at room temperature and under nitrogen atmosphere with a three-electrode assembly (Working and counter electrodes: Pt wire, reference electrode: Pt wire) and calibrated using $FeCp_2/FeCp_2^+$ as internal standard. HOMO data was corrected using ferrocene as internal standard against SCE.

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration were used. The Turbomole program package was used for all calculations.

*Photophysicalmeasurements*

Sample pretreatment: Spin-coating
Apparatus: Spin150, SPS euro.
The sample concentration is 10 mg/ml, dissolved in a suitable solvent.
Program: 1) 3 s at 400 U/min; 20 s at 1000 U/min at 1000 Upm/s. 3) 10 s at 4000 U/min at 1000 Upm/s. After coating, the films are tried at 70 °C for 1 min.
Photoluminescence spectroscopy and TCSPC (*Time-correlated single-photon counting)* Steady-state emission spectroscopy is recorded using a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.
Excited state lifetimes are determined employing the same system using the TCSPC method with FM-2013 equipment and a Horiba Yvon TCSPC hub.
Excitation sources:

NanoLED 370 (wavelength: 371 nm, puls duration: 1,1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) was done using the software suite DataStation and DAS6 analysis software. The fit is specified using the chi-squared-test.

Phtotoluminescence quantum yield measurements

For phtotoluminescence quantum yield (PLQY) measurements an *Absolute PL Quantum Yield Measurement C9920-03G* system (*Hamamatsu Photonics*) is used. Quantum yields and CIE coordinates were determined using the software U6039-05 version 3.6.0.
Emission maxima are given in nm, quantum yields Φ in % and CIE coordinates as x,y values. PLQY was determined following the protocol:

1) Quality assurance: Anthracene in ethanol (known concentration) is used as reference
2) Excitation wavelength: the absorption maximum of the organic molecule is determined and the molecule is excited using this wavelength
3) Measurement

Quantum yields are measured for sample of solutions or films under nitrogen atmosphere. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. the intensity.

**Production and characterization of organic electroluminescence devices**

Via vacuum-deposition methods OLED devices comprising organic molecules according to the invention can be produced. If a layer contains more than one compound, the weight-percentage of one or more compounds is given

in %. The total weight-percentage values amount to 100 %, thus if a value is not given, the fraction of this compound equals to the difference between the given values and 100 %.

The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT 95 to the time point, at which the measured luminance decreased to 95 % of the initial luminance etc.

Accelerated lifetime measurements are performed (e.g. applying increased current densities). Exemplarily LT80 values at 500 cd/m$^2$ are determined using the following equation:

$$\mathrm{LT80}\left(500\frac{cd^2}{m^2}\right) = \mathrm{LT80}(L_0)\left(\frac{L_0}{500\frac{cd^2}{m^2}}\right)^{1.6}$$

wherein $L_0$ denotes the initial luminance at the applied current density.

The values correspond to the average of several pixels (typically two to eight), the standard deviation between these pixels is given. Figures show the data series for one OLED pixel.

**Examples of emitter compounds**

| structure | # | PLQY [%] | $\lambda_{max}$ [nm] | FWHM [eV] |
|---|---|---|---|---|
| 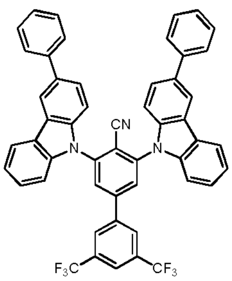 | **EM1** | 80 | 481 | 0.45 |
| 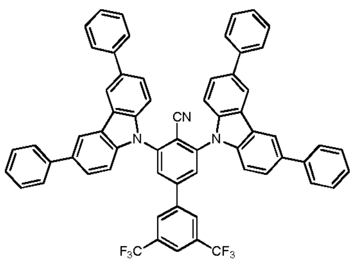 | **EM2** | 84 | 492 | 0.41 |
| 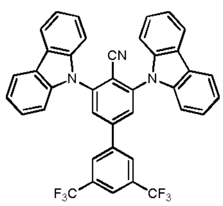 | **EM3** | 84 | 461 | 0.43 |

(continued)

| structure | # | PLQY [%] | $\lambda_{max}$ [nm] | FWHM [eV] |
|---|---|---|---|---|
| 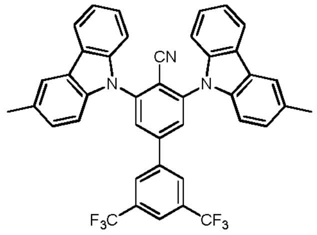 | **EM4** | 84 | 476 | 0.44 |
| 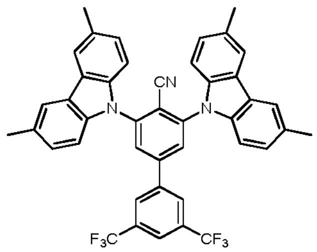 | **EM5** | 74 | 486 | 0.43 |
| 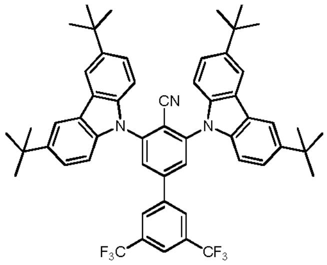 | **EM6** | 78 | 478 | 0.43 |
| 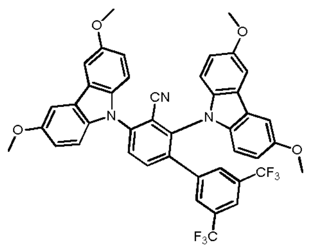 | **EM7** | 68 | 483 | 0.46 |
| 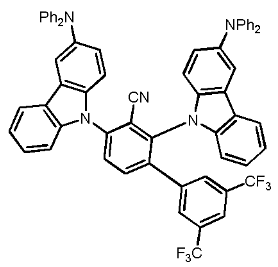 | **EM8** | 44 | 516 | 0.49 |
| 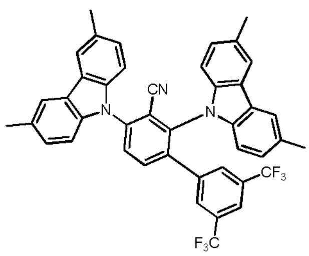 | **EM9** | 71 | 442 | 0.44 |

(continued)

| structure | # | PLQY [%] | $\lambda_{max}$ [nm] | FWHM [eV] |
|---|---|---|---|---|
| 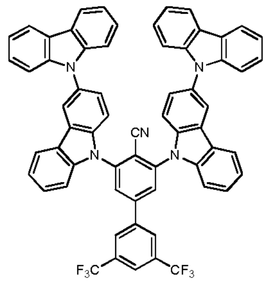 | **EM10** | 59 | 496 | 0.50 |
| 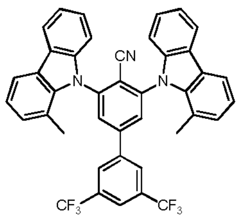 | **EM11** | 76 | 476 | 0.46 |
| 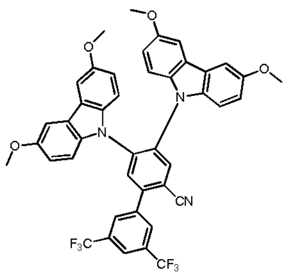 | **EM12** | 75 | 502 | 0,49 |
| 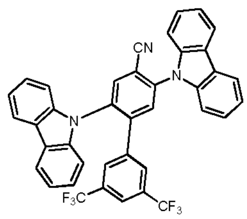 | **EM13** | 78 | 450 | 0.42 |
| 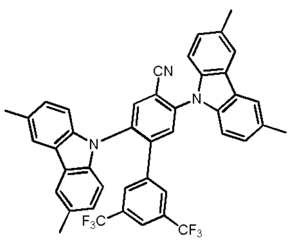 | **EM14** | 92 | 471 | 0.41 |
| 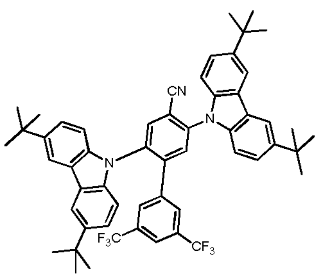 | **EM15** | 94 | 466 | 0.41 |

(continued)

| structure | # | PLQY [%] | $\lambda_{max}$ [nm] | FWHM [eV] |
|---|---|---|---|---|
| 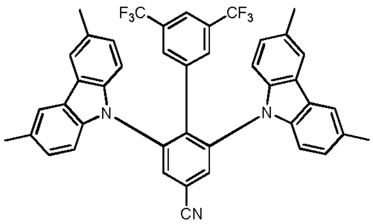 | **EM16** | 72 | 463 | 0.45 |
| 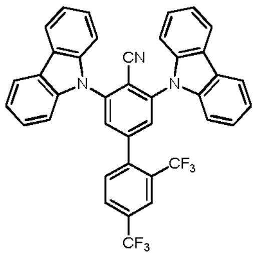 | **EM17** | 85 | 448 | 0.46 |
| 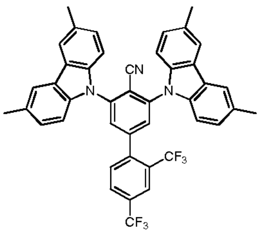 | **EM18** | 91 | 474 | 0.46 |
| 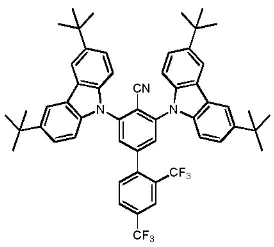 | **EM19** | 90 | 469 | 0.46 |
| PLQY is the photoluminescence quantum yield, $\lambda_{max}$ is the emission maximum and FWHM corresponds to the full width at half maximum of the emission peak in the visible region. | | | | |

**Example D1 and comparative example C1**

OLED devices **D1** and **D2** and comparative examples **C1** and **C2** were tested with the same layer structure, and except that the emitting layer B contained the emitter compounds **(EM1)** and host compound **H1** for device **D1,** the emitter compound **(EM1)** and the standard host compound mCBP for device **C1,** the emitter compounds **(EM2)** and host compound **H1** for device **D2,** the emitter compound (**EM2**) and the standard host compound mCBP for device **C2.**

| Layer | Thickness | D1 | D2 |
|---|---|---|---|
| **9** | 100 nm | Al | Al |
| **8** | 2 nm | Liq | Liq |
| **7** | 40 nm | NBPhen | NBPhen |
| **6** | 20 nm | **EM1** (10%):**H1** (90%) | **EM2** (20%):**H1** (80%) |
| **5** | 10 nm | TCTA | TCTA |
| **4** | 110 nm | NPB | NPB |

(continued)

| Layer | Thickness | D1 | D2 |
|---|---|---|---|
| **3** | 5 nm | HAT-CN | HAT-CN |
| **2** | 50 nm | PEDOT | PEDOT |
| **1** | 130 nm | ITO | ITO |
| **Substrate** | | glass | glass |
| **Layer** | **Thickness** | **C1** | **C2** |
| **9** | 100 nm | Al | Al |
| **8** | 2 nm | Liq | Liq |
| **7** | 40 nm | NBPhen | NBPhen |
| **6** | 20 nm | **EM1** (10%):**mCBP** (90%) | **EM2** (20%):**mCBP** (80%) |
| **5** | 10 nm | TCTA | TCTA |
| **4** | 70 nm | NPB | NPB |
| **3** | 5 nm | HAT-CN | HAT-CN |
| **2** | 50 nm | PEDOT | PEDOT |
| **1** | 130 nm | ITO | ITO |
| **Substrate** | | glass | glass |

For comparative device **C1,** an external quantum efficiency (EQE) at 500 cd/m$^2$ of 8.5 $\pm$ 0.1 % and a LT80 value of 60 h at 500 cd/m$^2$ were determined from accelerated lifetime measurements. The onset voltage of device **C1** is 2.63 $\pm$ 0.04 V and the wavelength of the emission maximum is at 482 nm and the corresponding $CIE_x$ and $CIE_y$ coordinates are 0.20 and 0.36 at 6 V. Device **D1** is more efficient than **C1** with an EQE of 12.8 $\pm$ 0.1 % at 500 cd/m$^2$ and exhibits a much longer lifetime of 178 h (LT80) at 500 cd/m$^2$. The onset voltage is reduced to 2.60 $\pm$ 0.05 V. The emission maximum occurs blue-shifted at 479 nm.

For comparative device **C2**, an external quantum efficiency (EQE) at 500 cd/m$^2$ of 11.5 $\pm$ 0.2 % and a LT80 value of 488 h at 500 cd/m$^2$ were determined from accelerated lifetime measurements. The onset voltage of device **C1** is 2.50 $\pm$ 0.05 V and the wavelength of the emission maximum is at 495 nm and the corresponding $CIE_x$ and $CIE_y$ coordinates are 0.24 and 0.37 at 6 V. Device **D2** is more efficient than **C2** with an EQE of 12.6 $\pm$ 0.1 % at 500 cd/m$^2$ and exhibits a longer lifetime of 500 h (LT80) at 500 cd/m$^2$. The onset voltage remains at 2.50 $\pm$ 0.05 V. The emission maximum occurs blue-shifted at 492 nm.

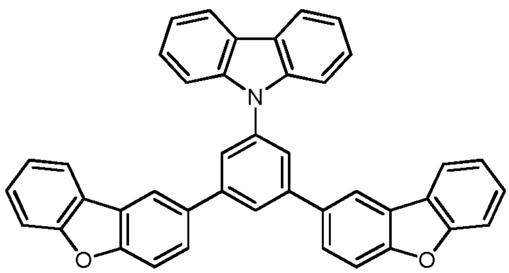

**H1**

**Examples of TADF emitters:**

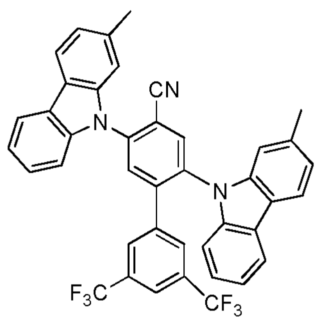
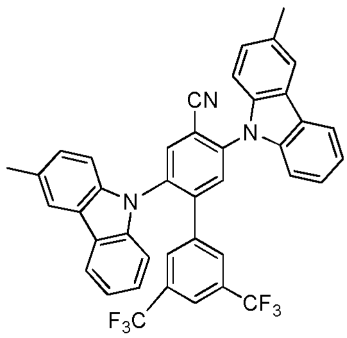
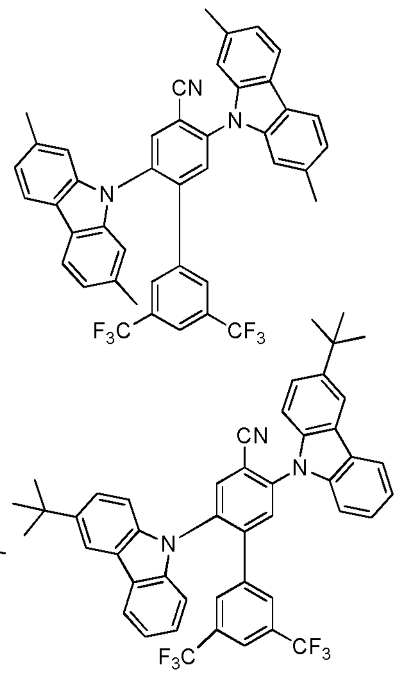
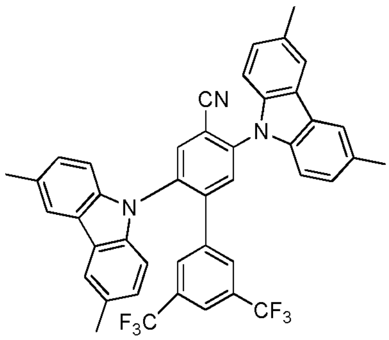
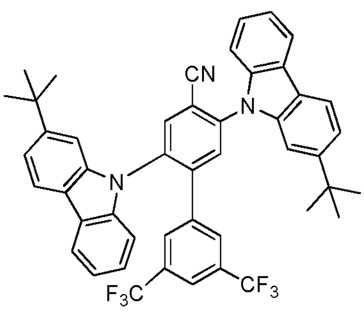
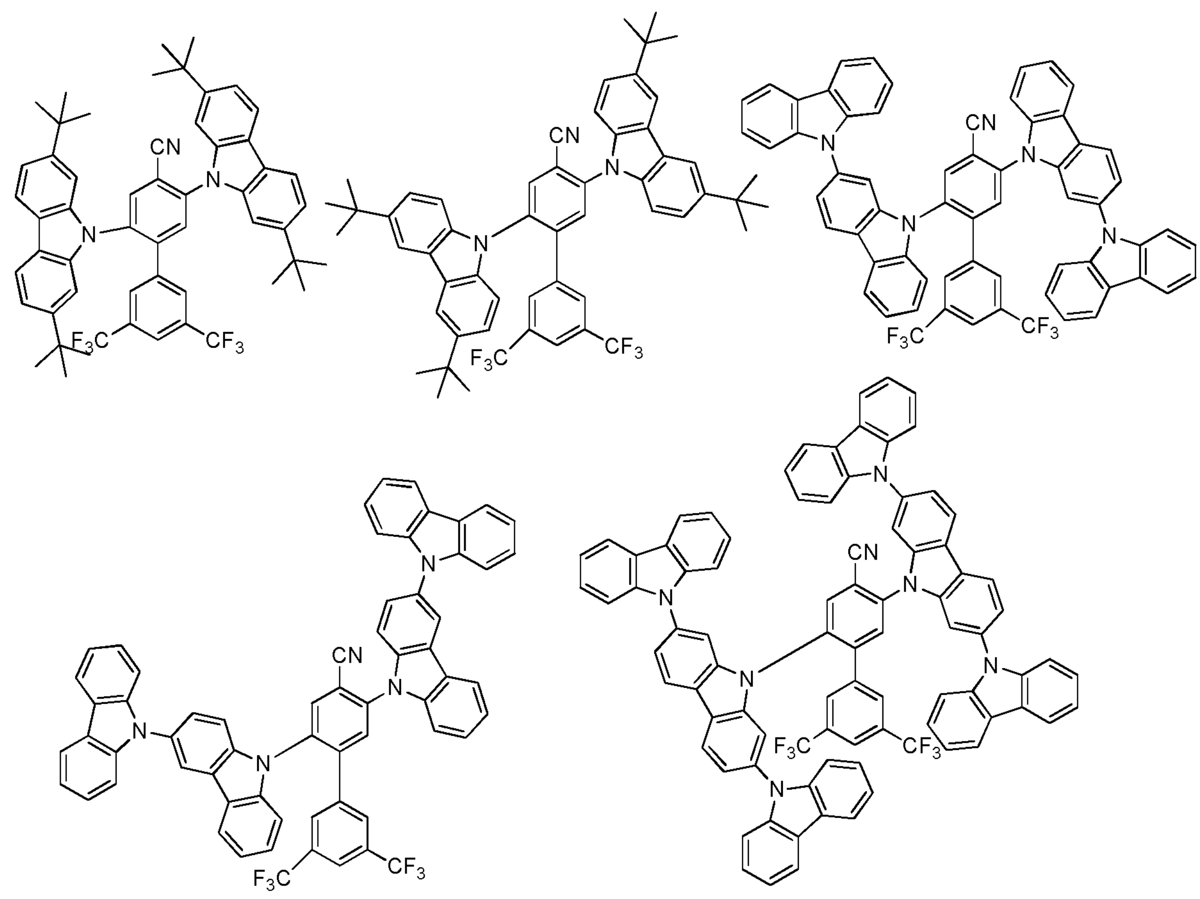

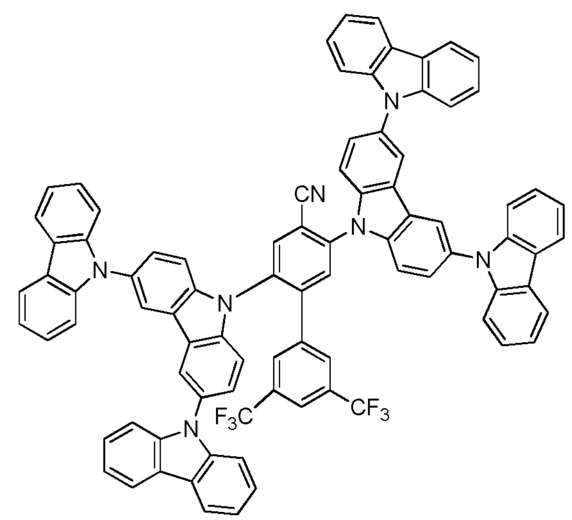

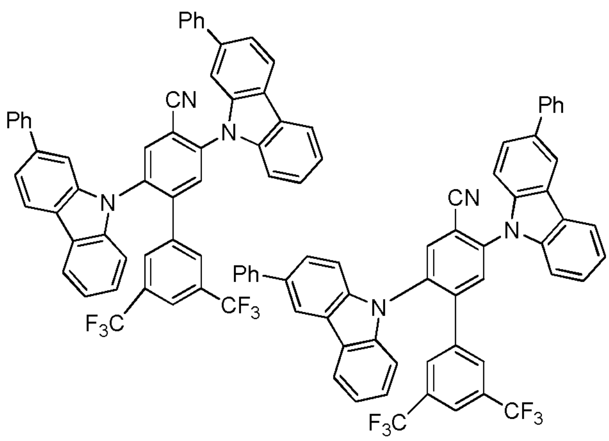

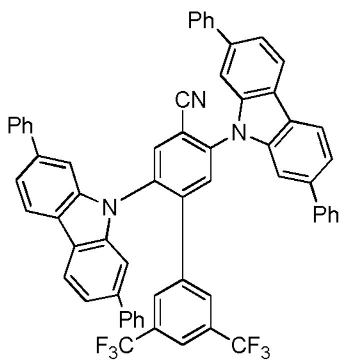

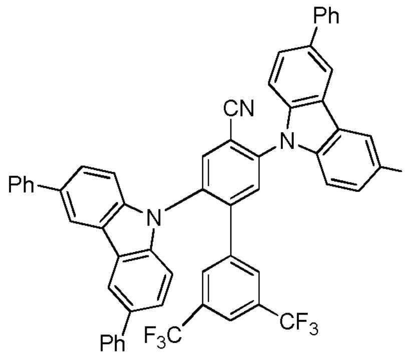

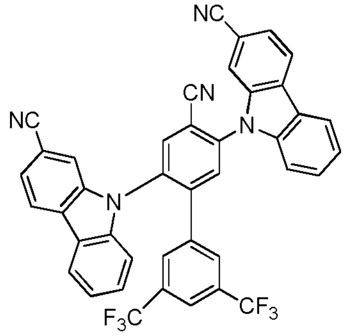

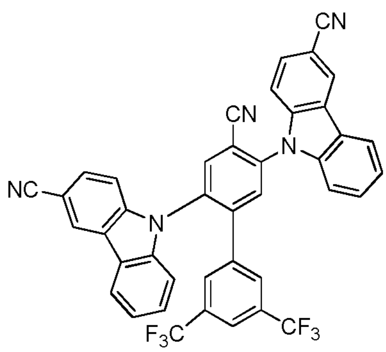

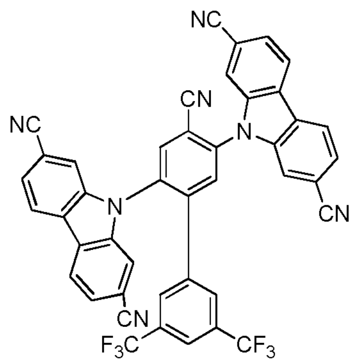

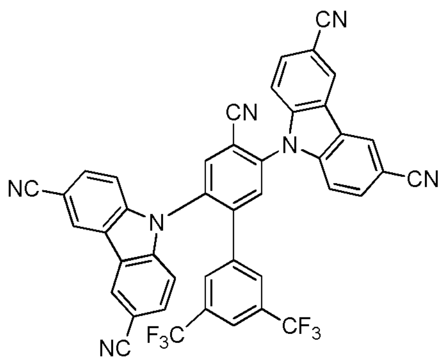

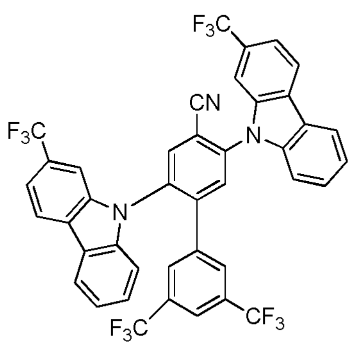

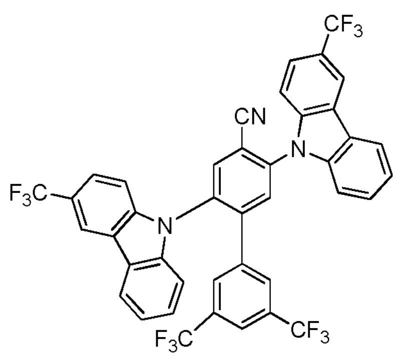

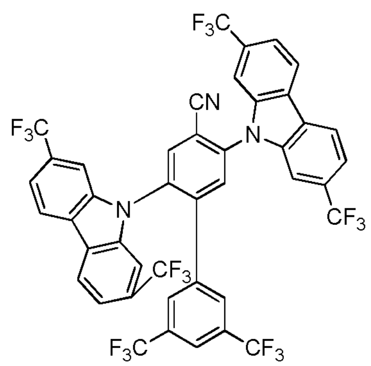

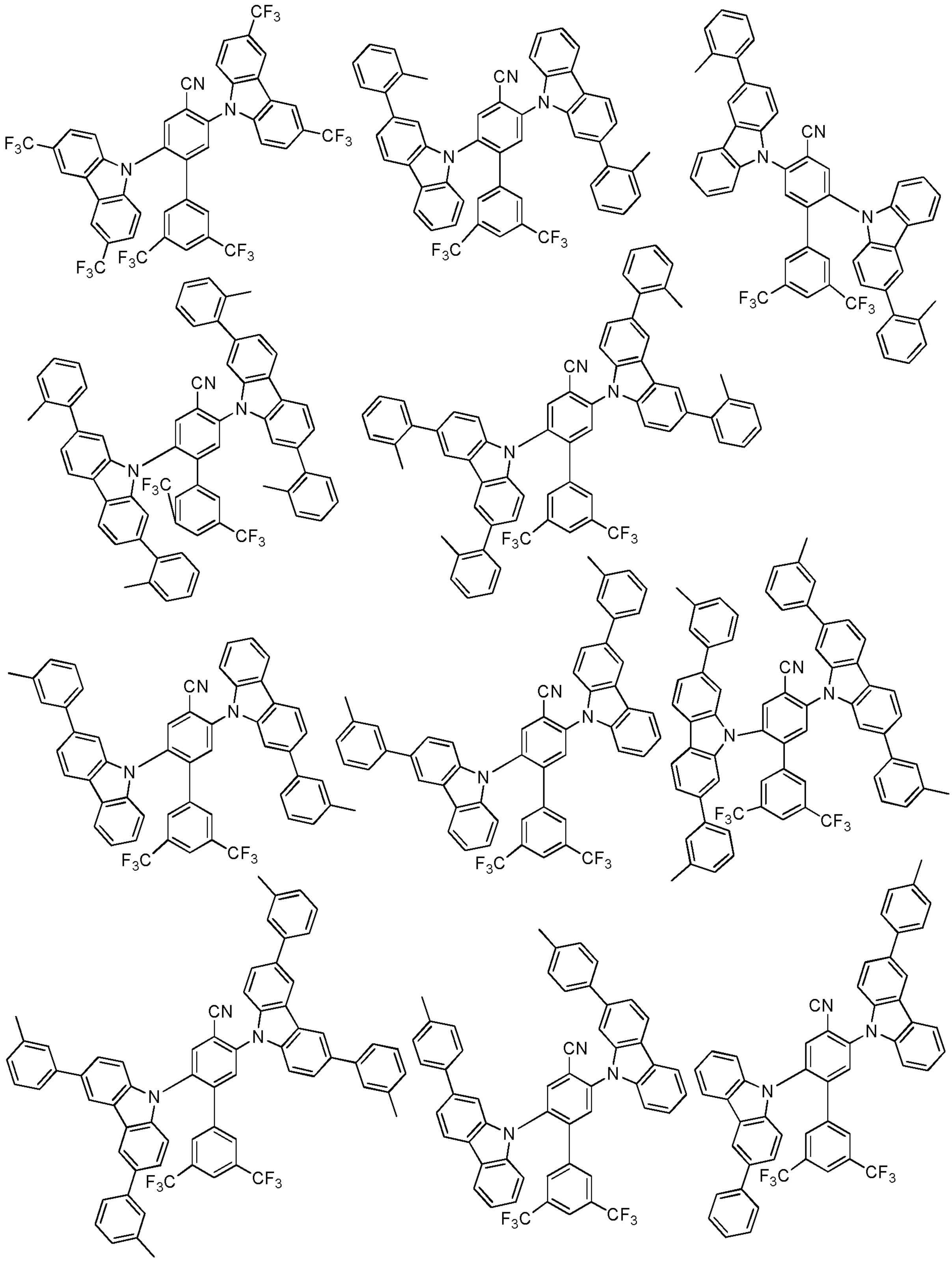

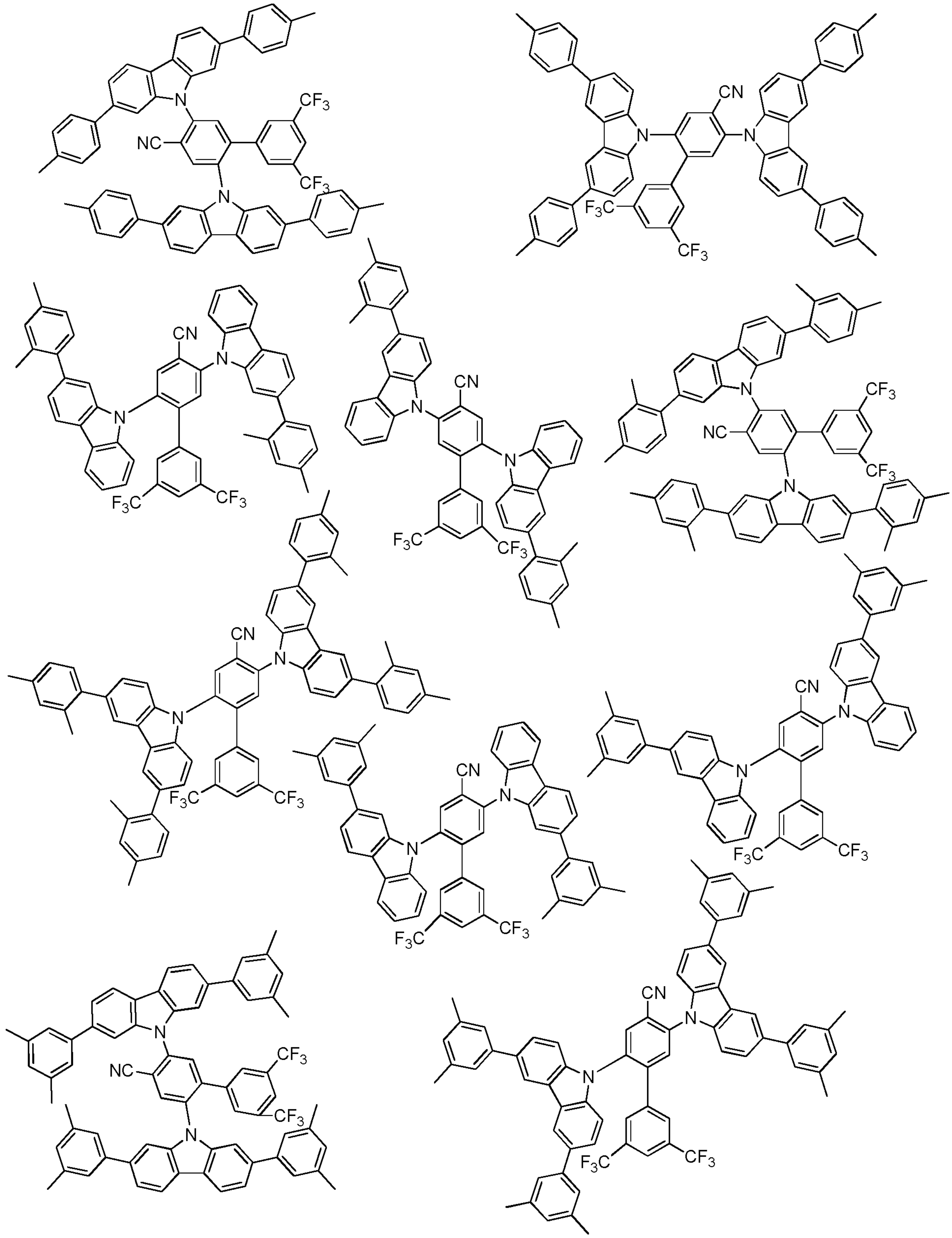

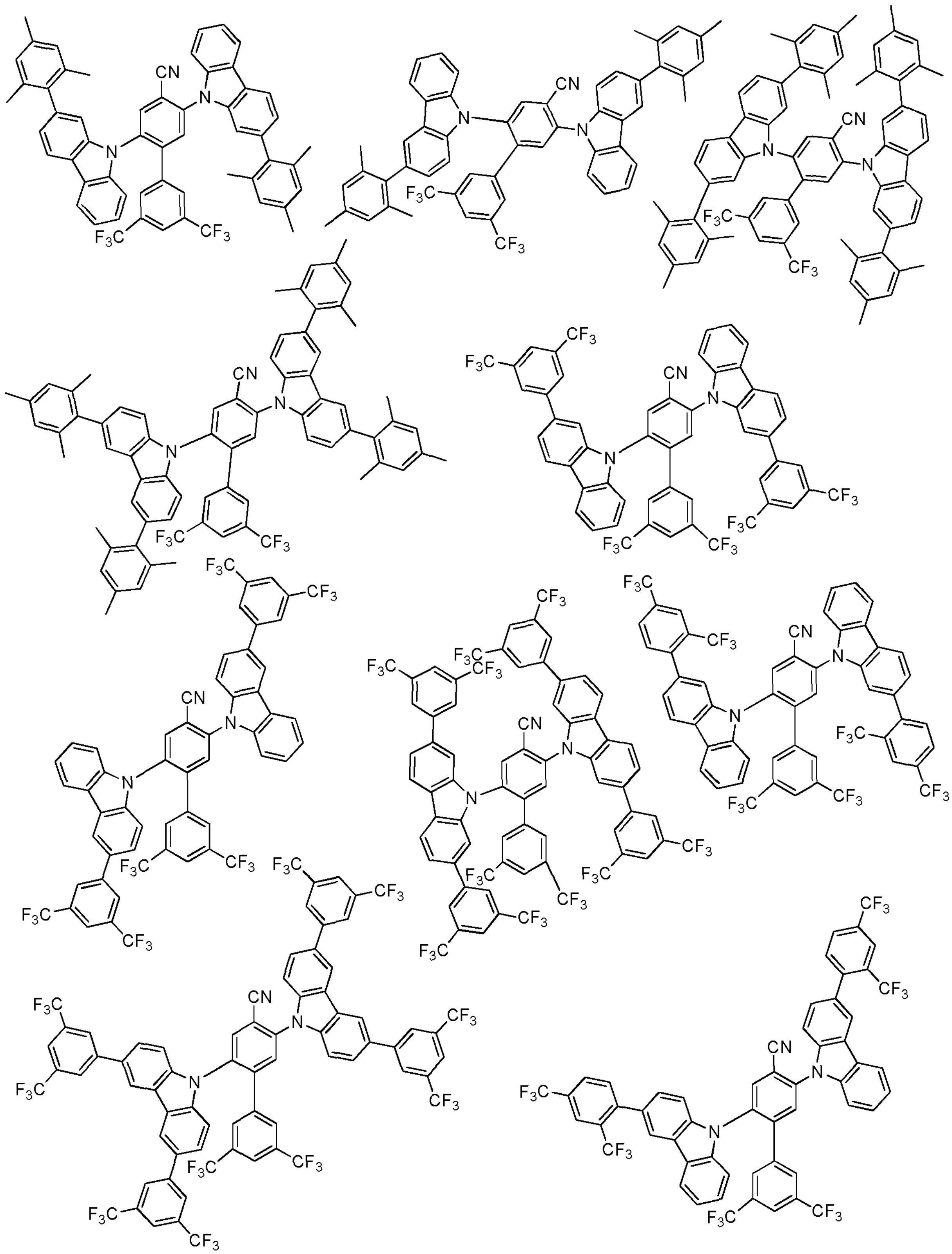

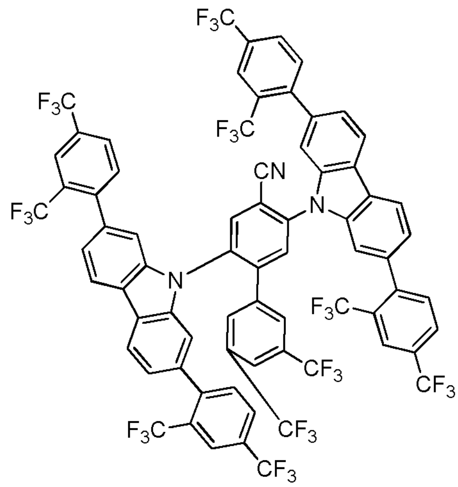

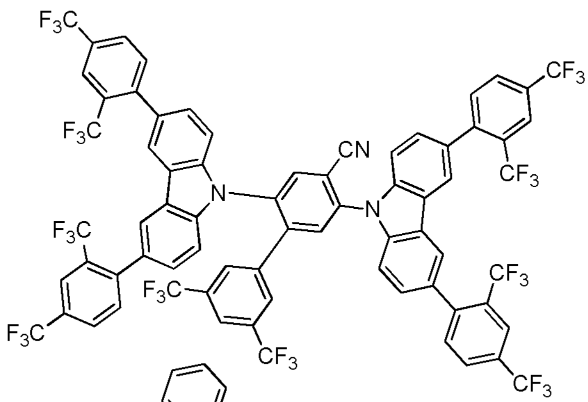

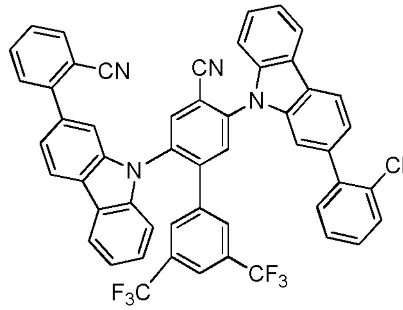

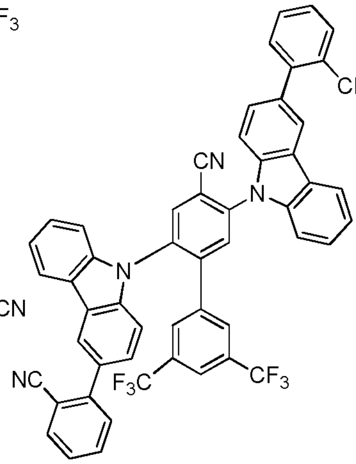

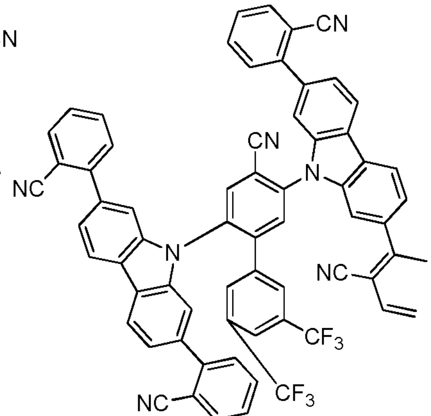

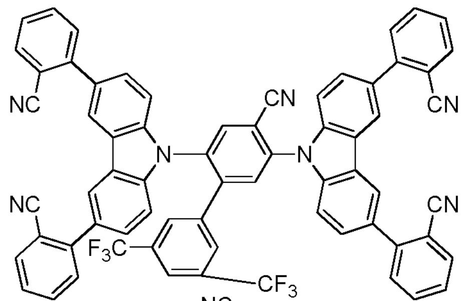

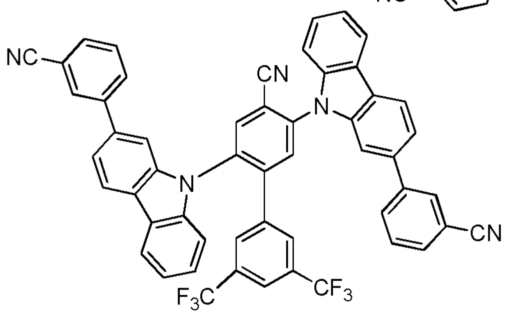

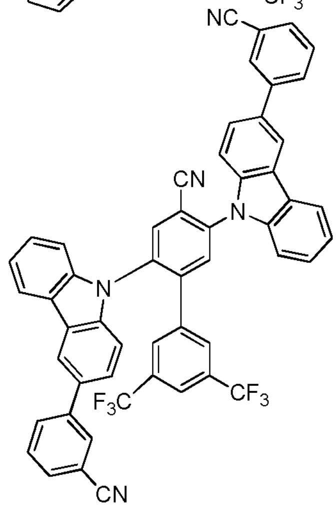

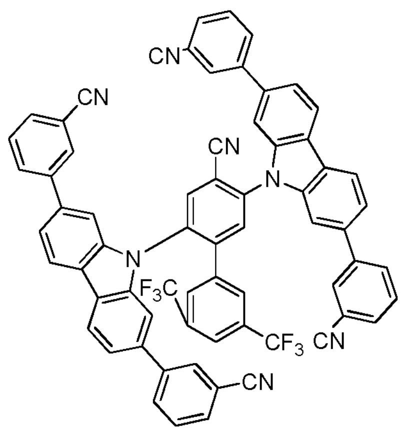

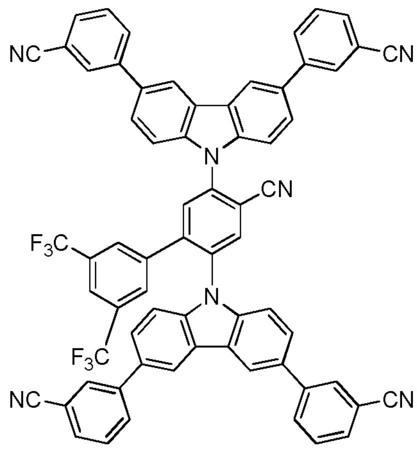

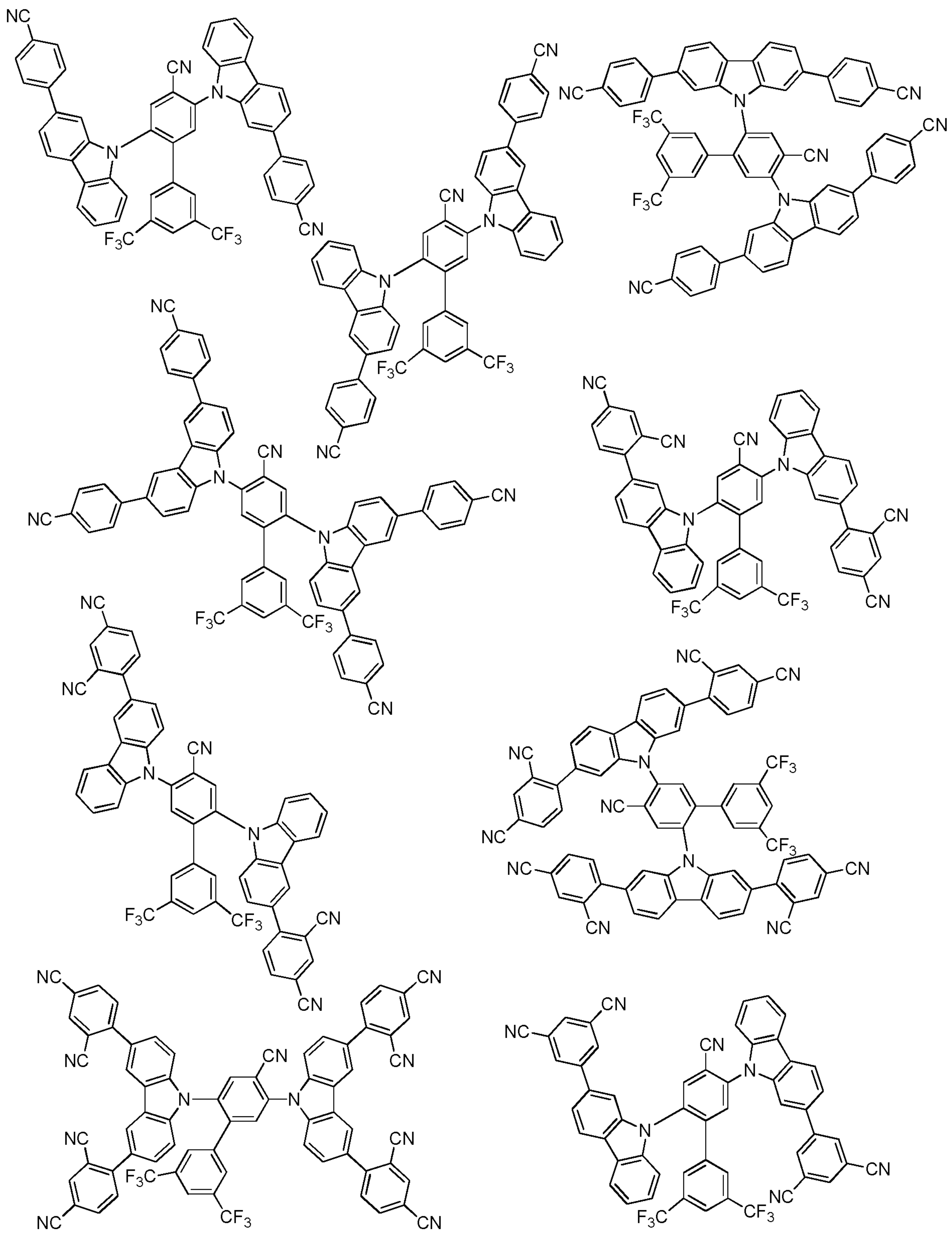

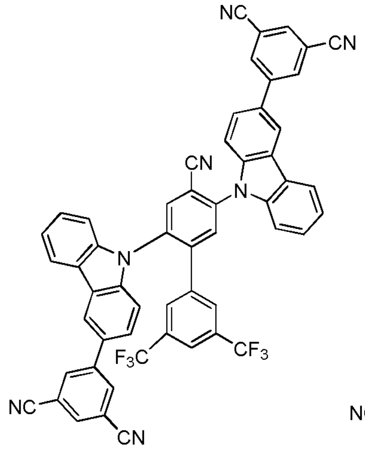
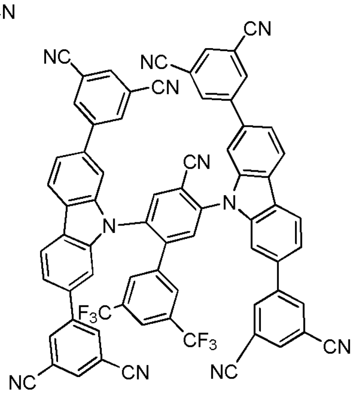
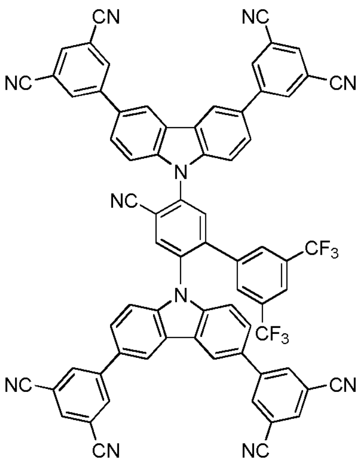
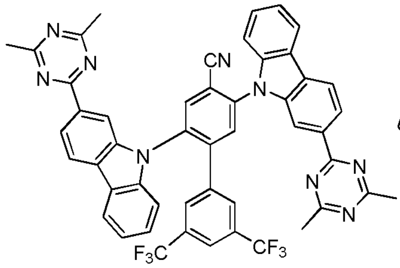
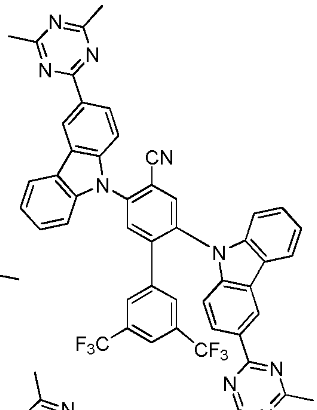
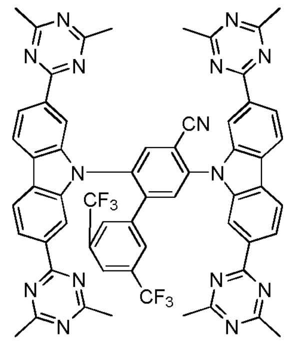
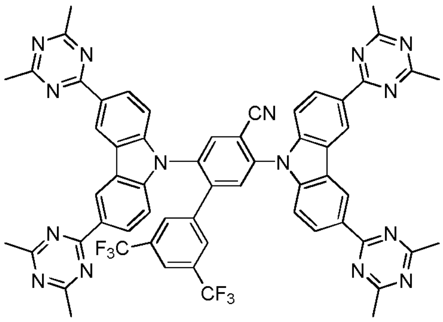
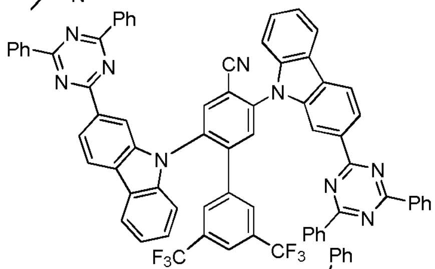
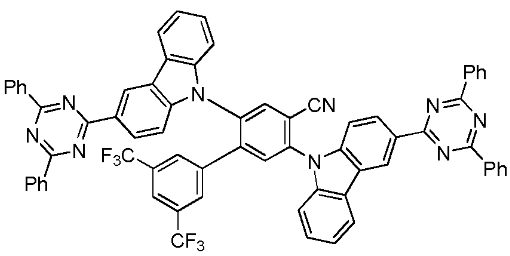
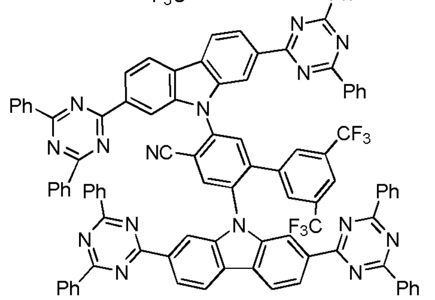
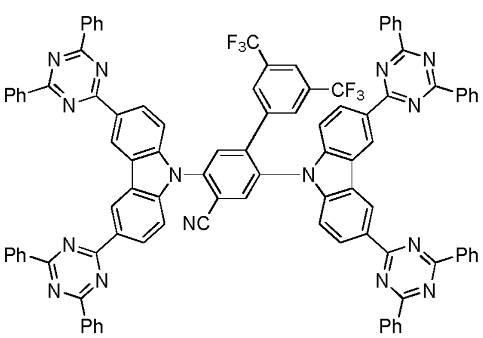

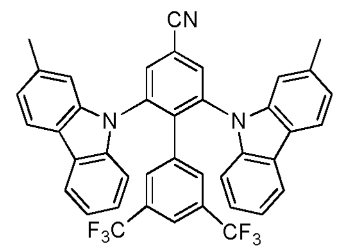

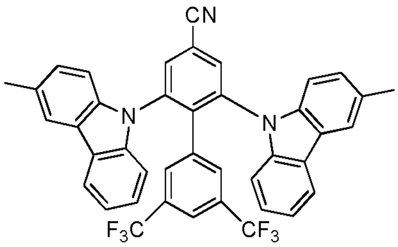

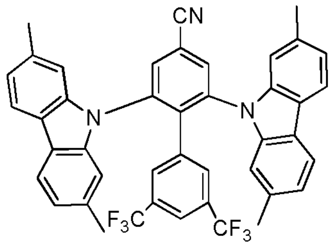

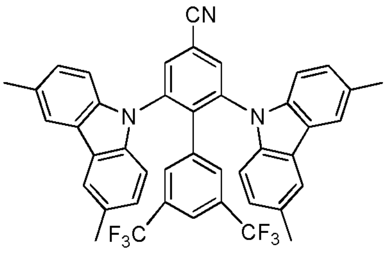

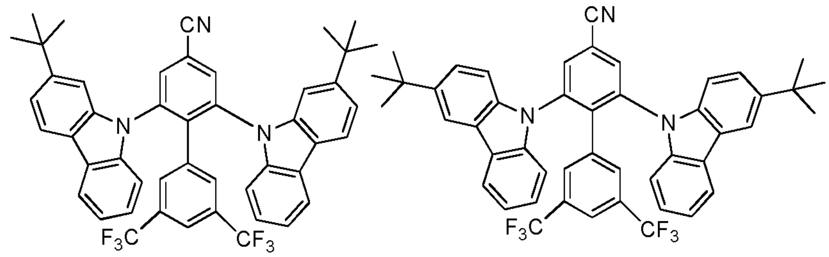

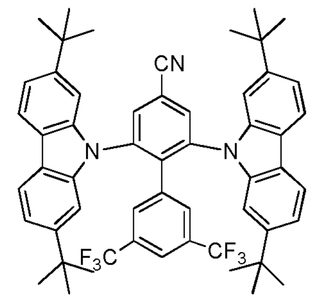

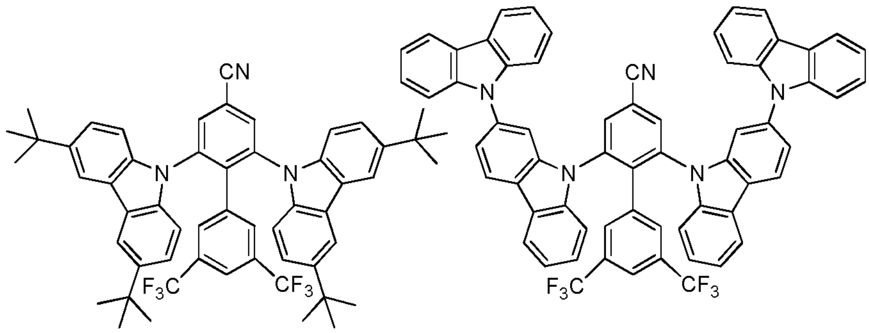

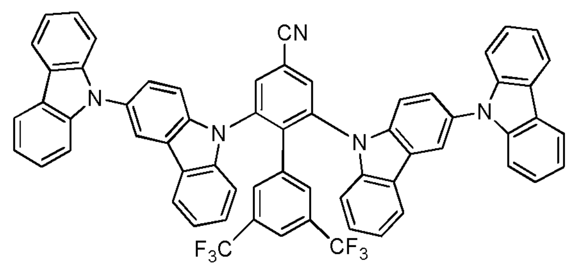

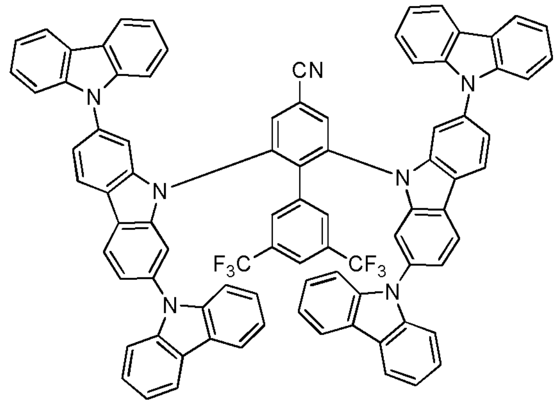

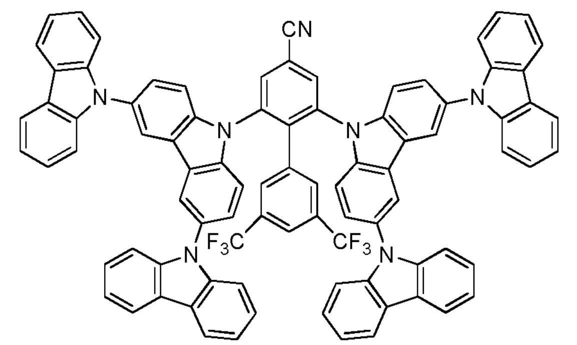

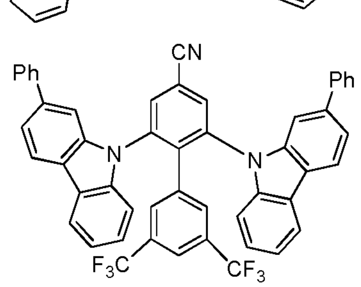

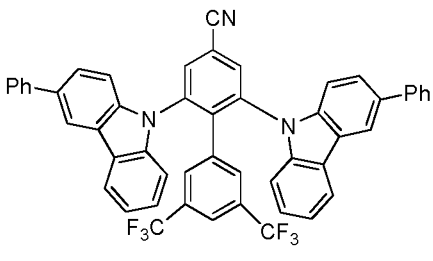

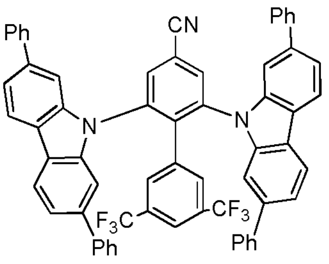

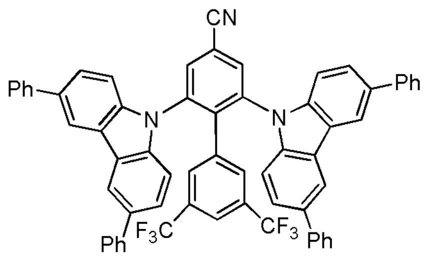

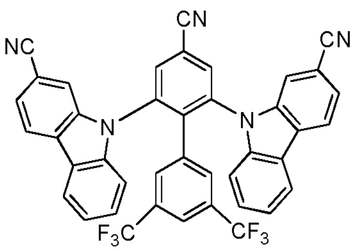

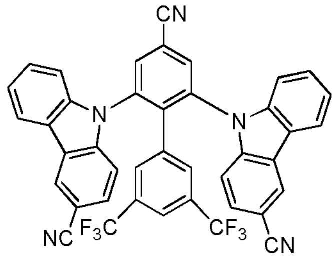

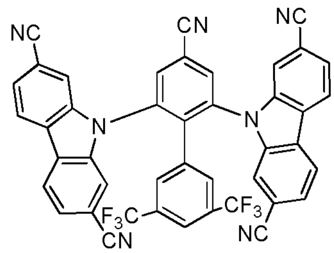

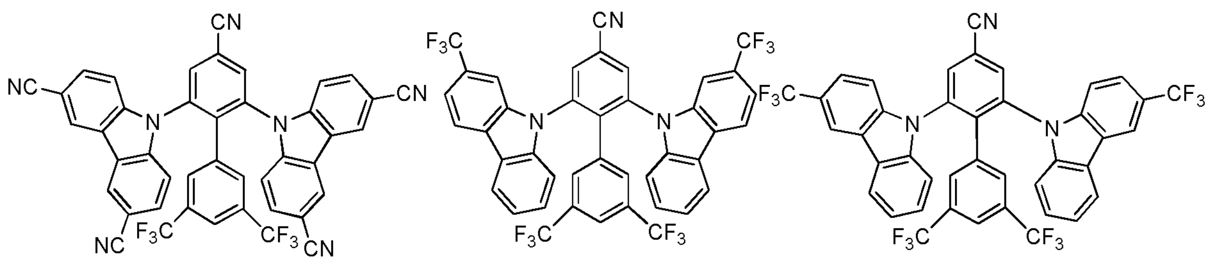

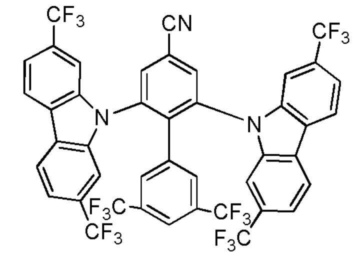

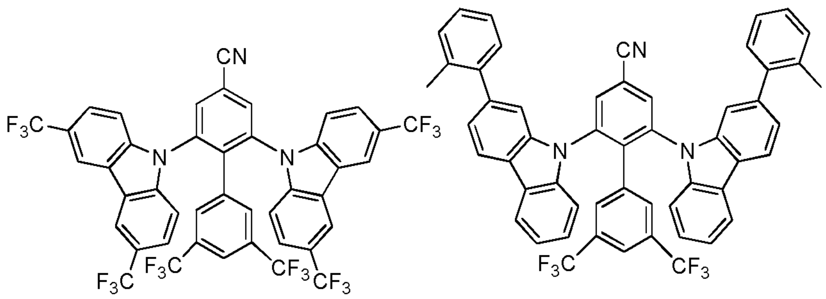

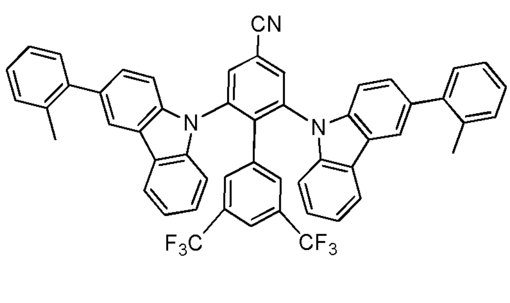

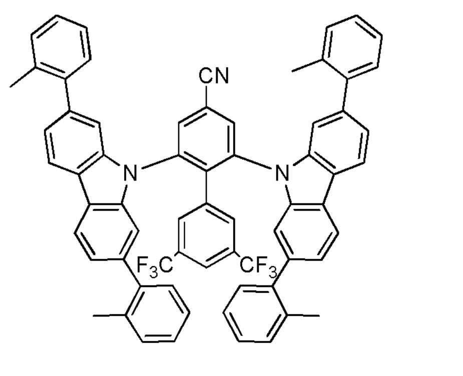

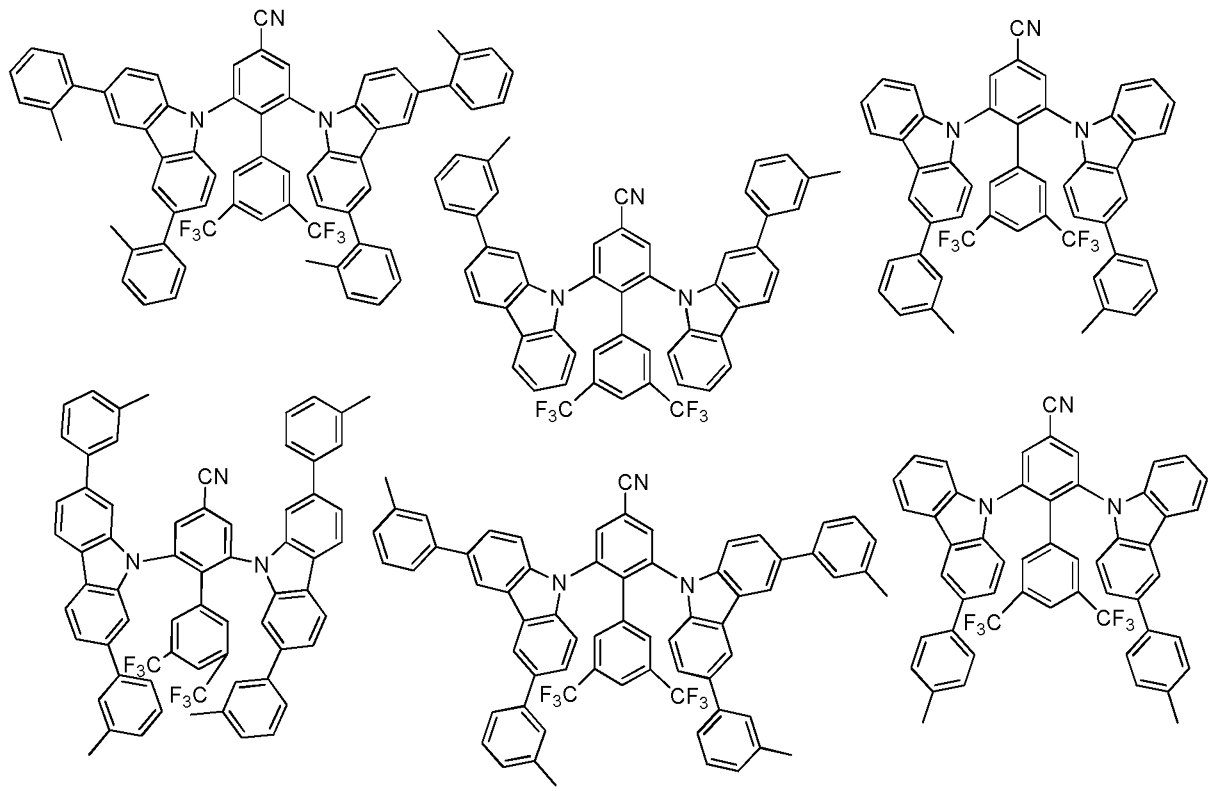

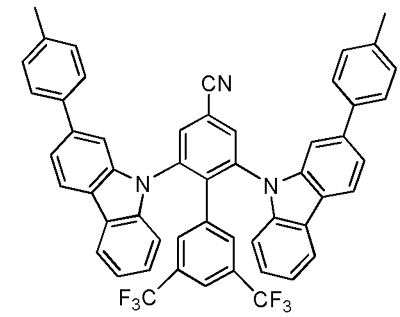

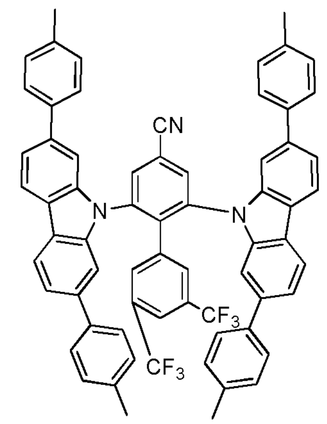

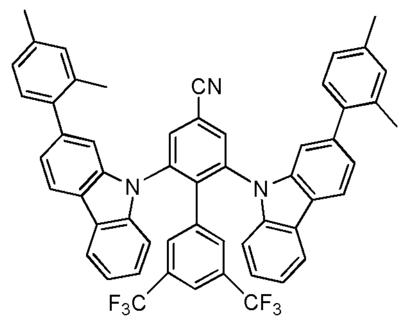

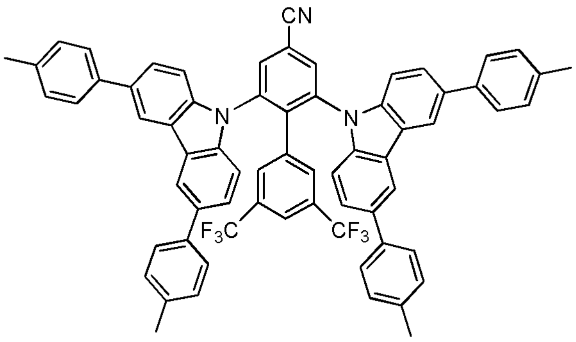

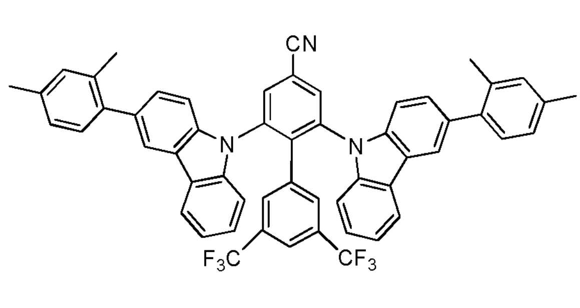

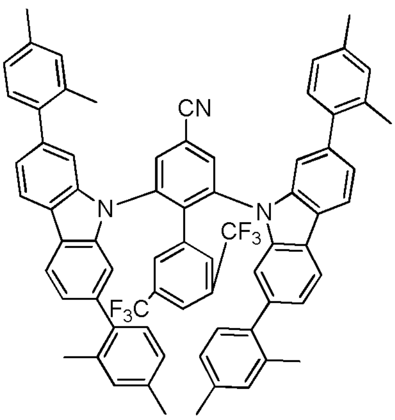

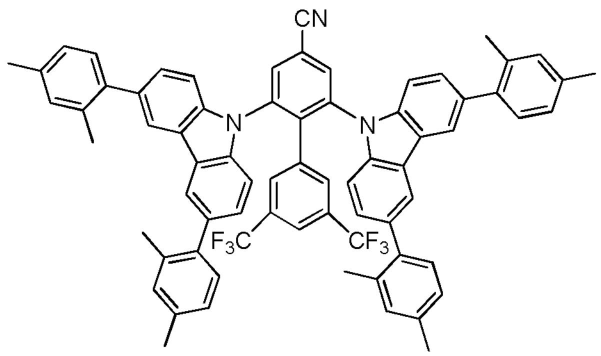

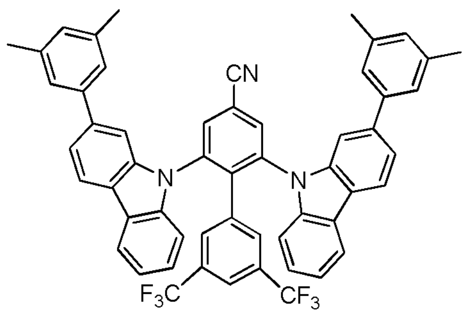

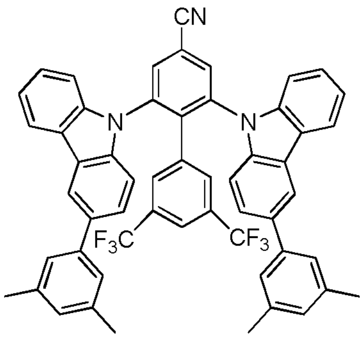

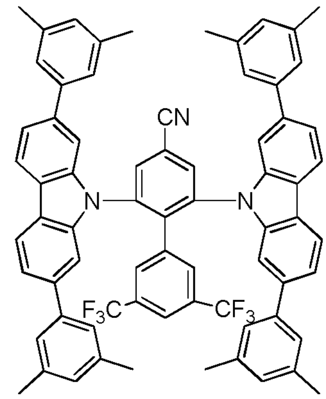

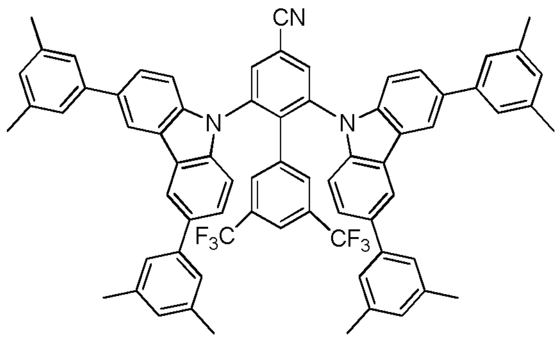

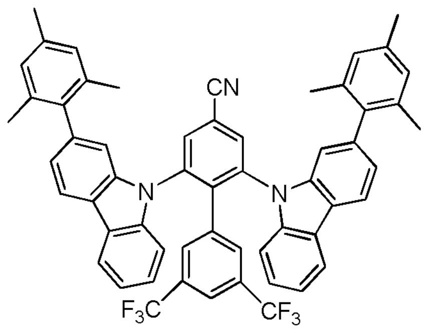

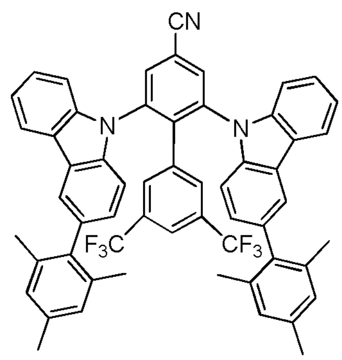

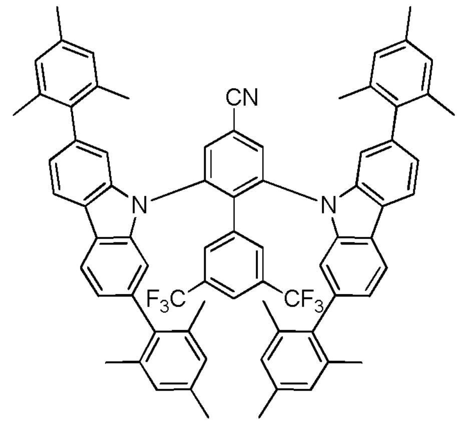

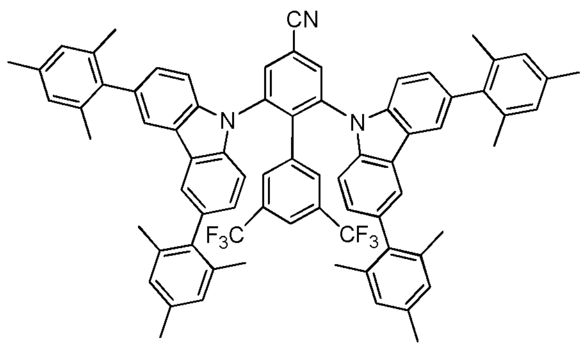

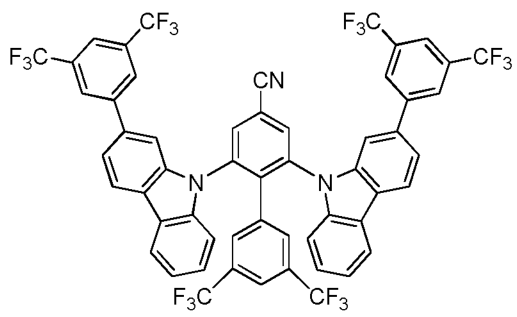

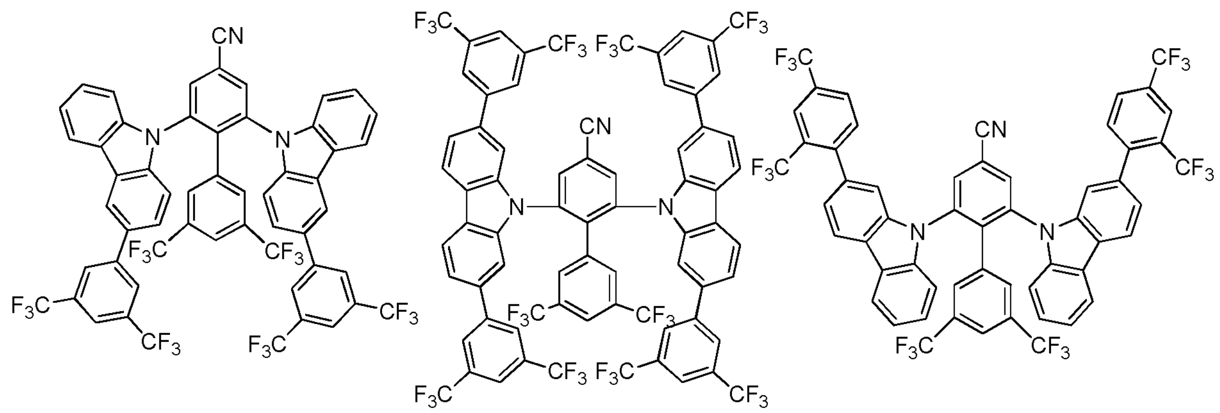

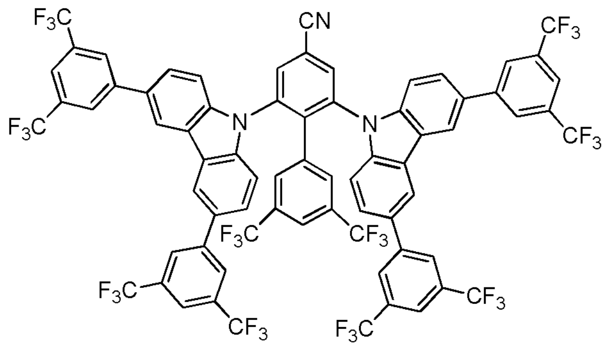

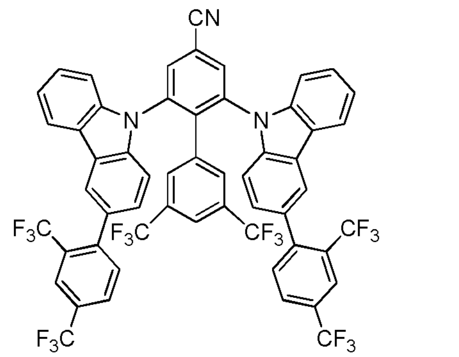

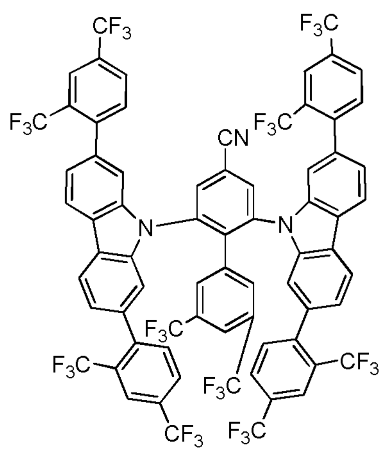

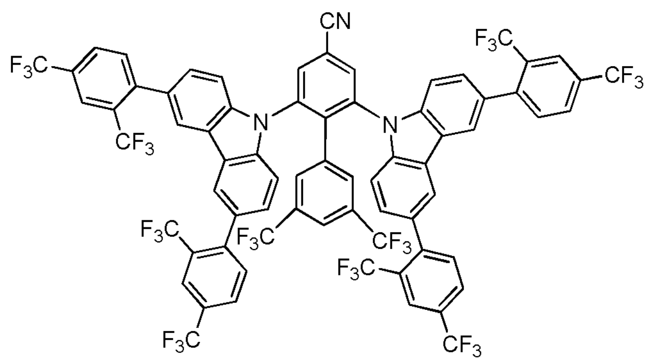

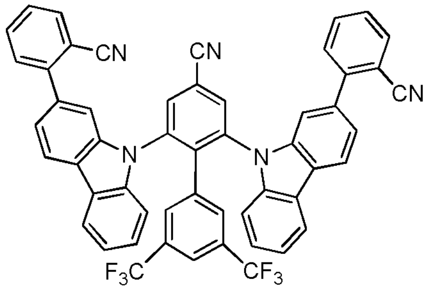

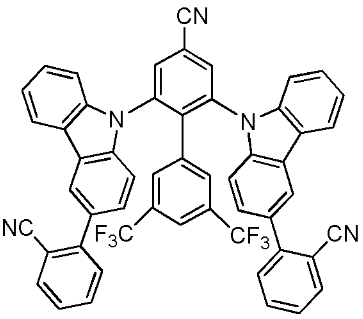

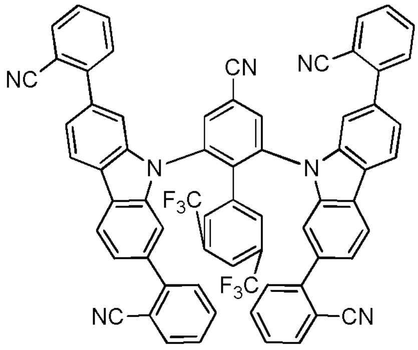

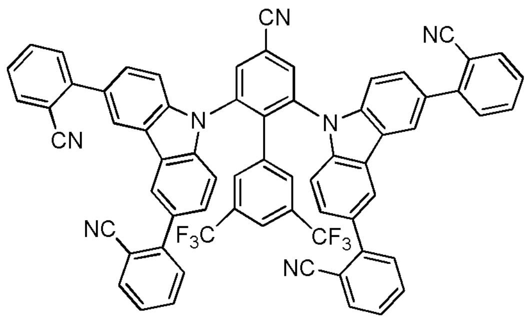

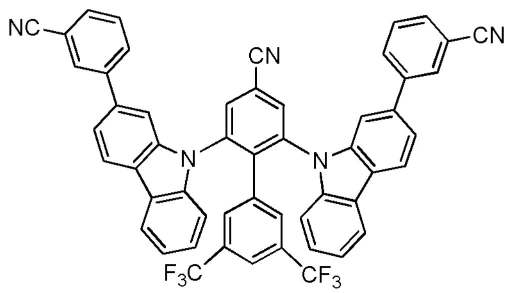

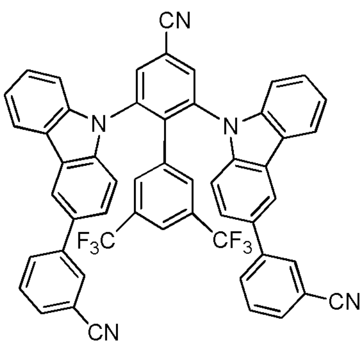

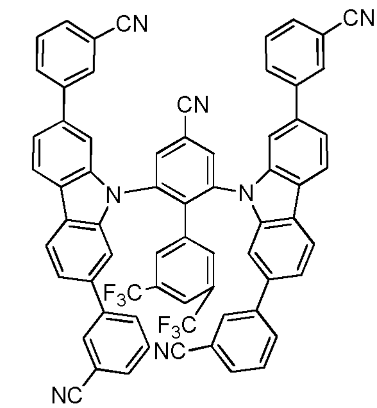

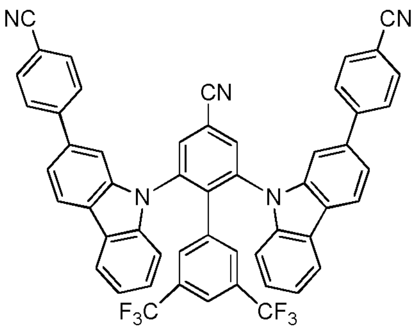

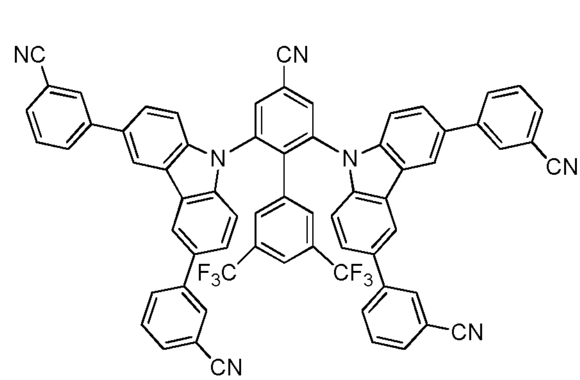

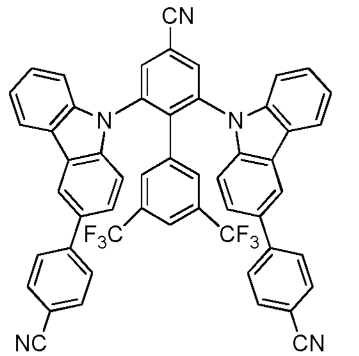

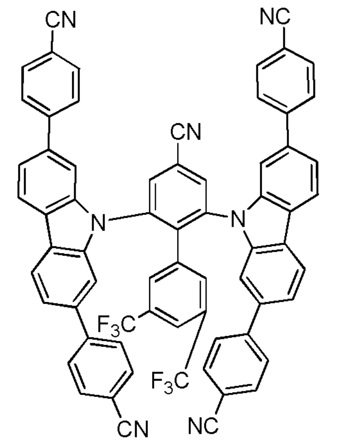

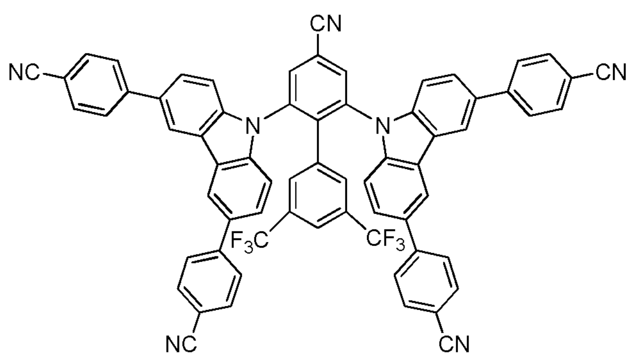

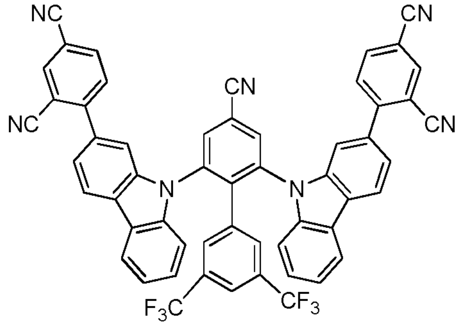

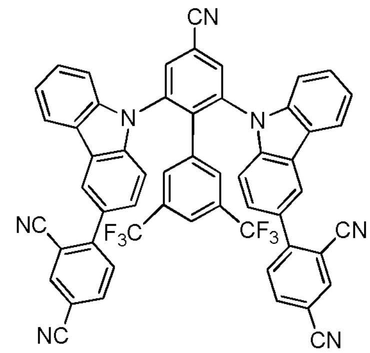

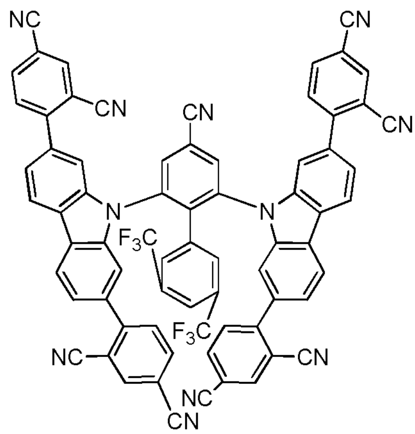

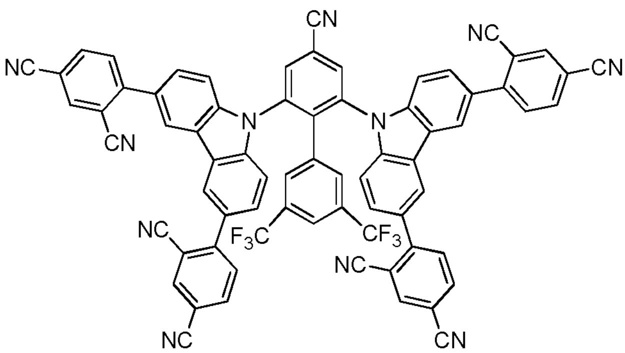

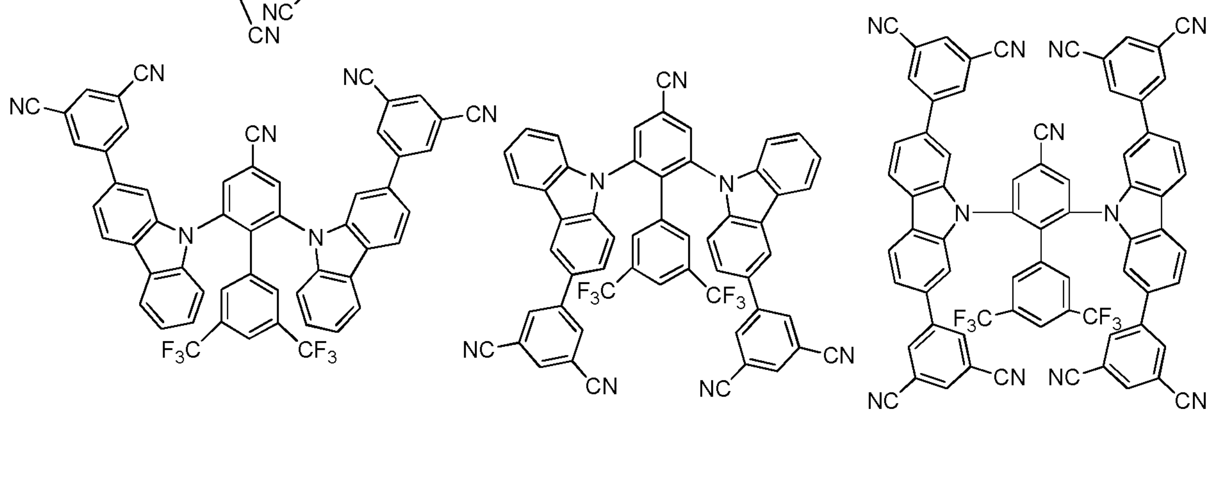

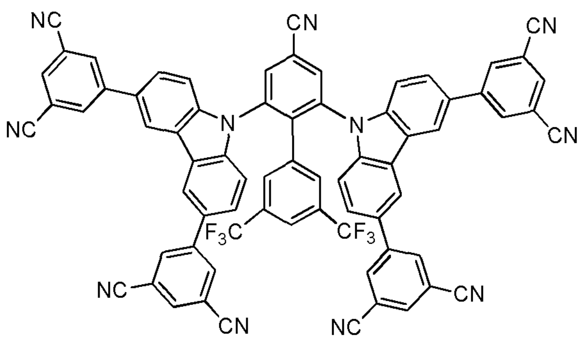

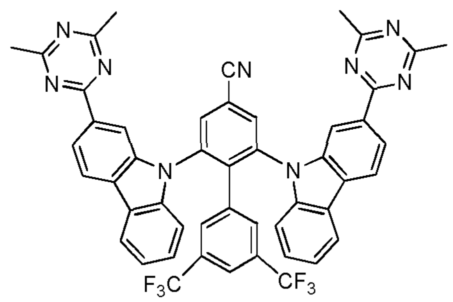

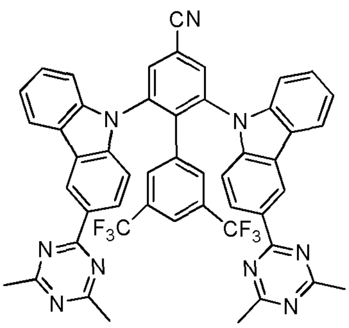

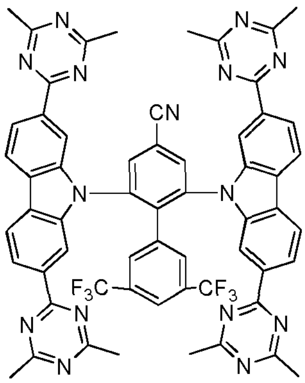

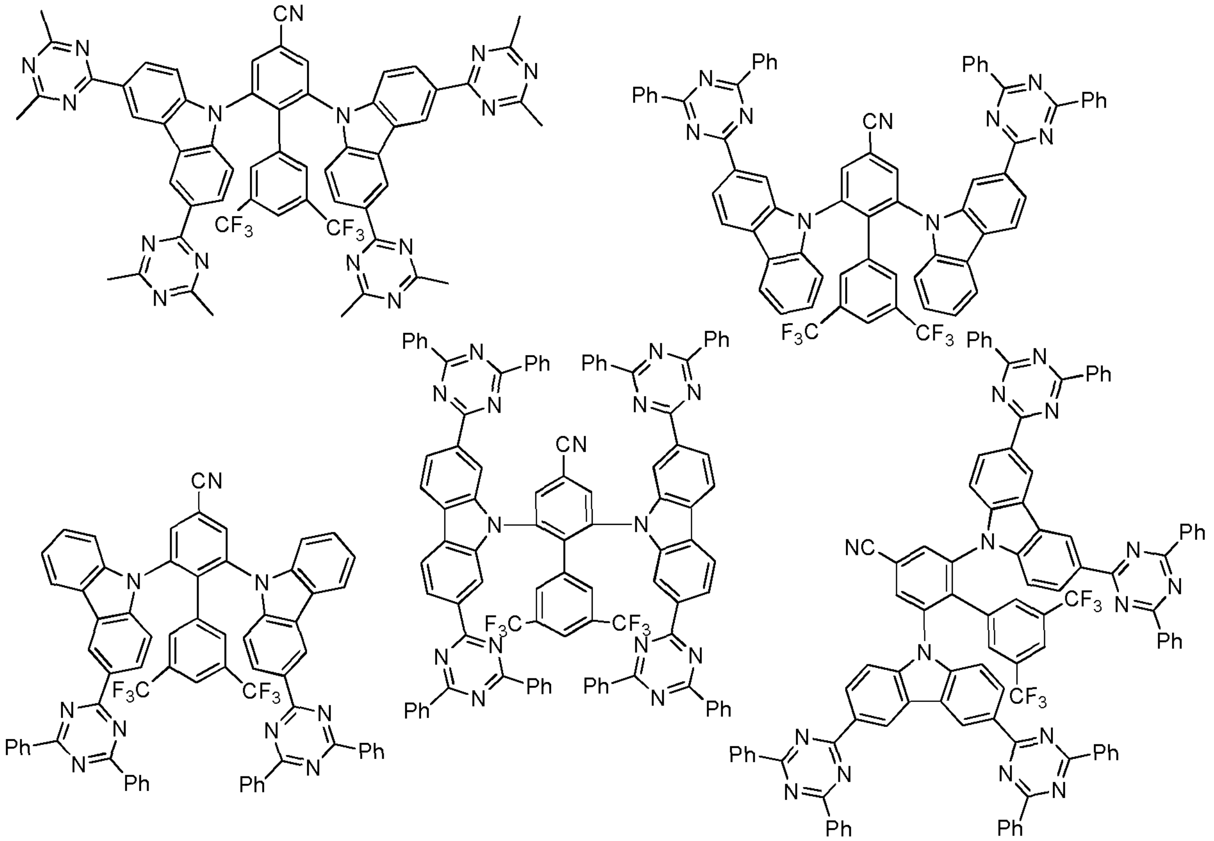

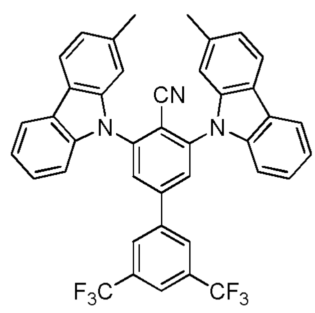

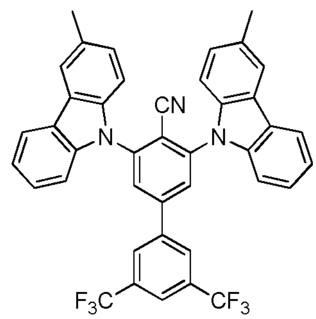

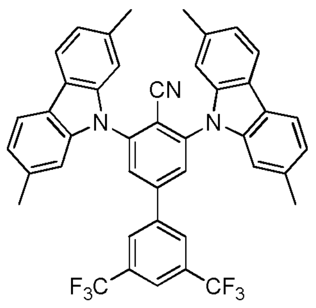

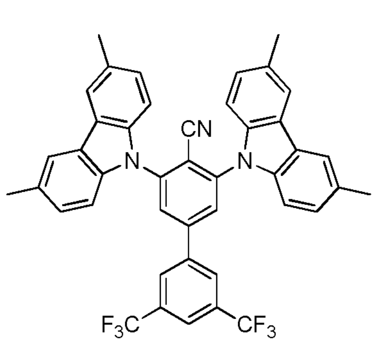

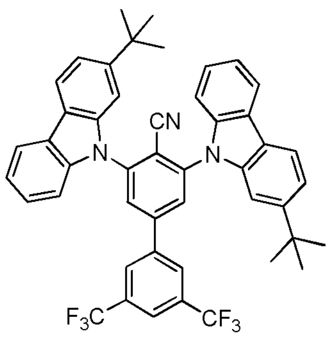

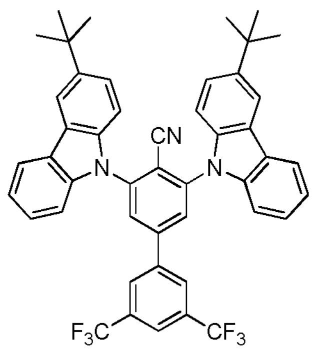

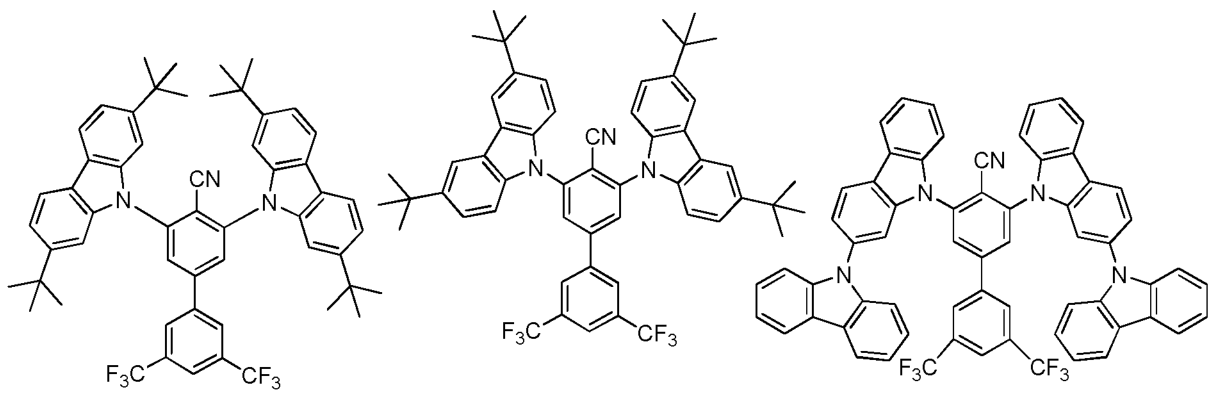

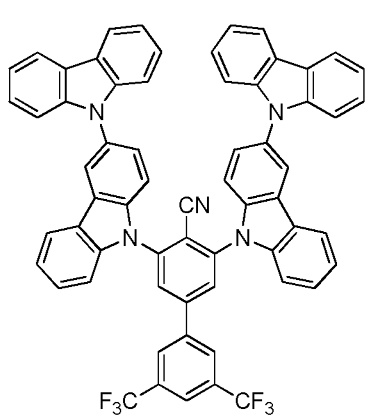

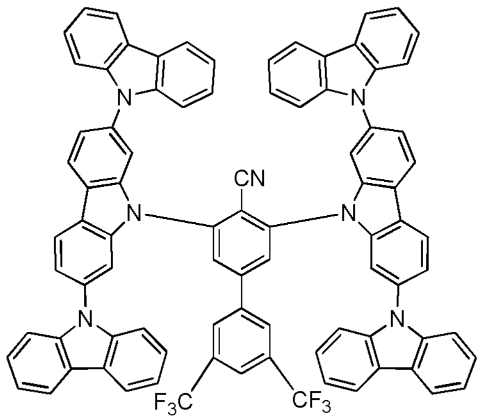

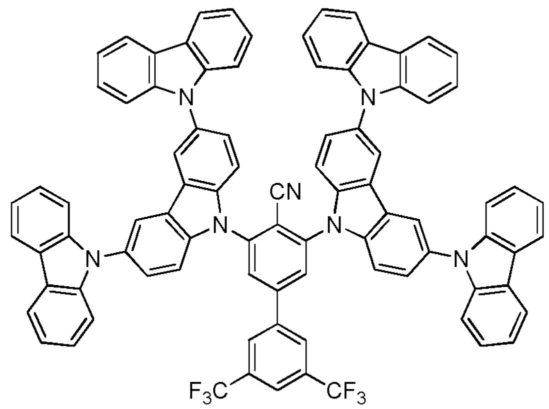
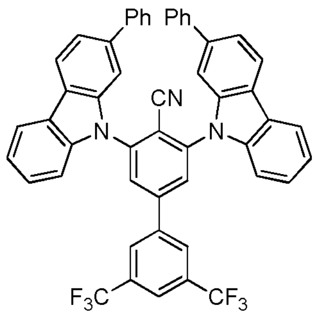
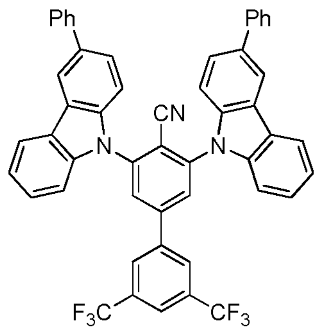

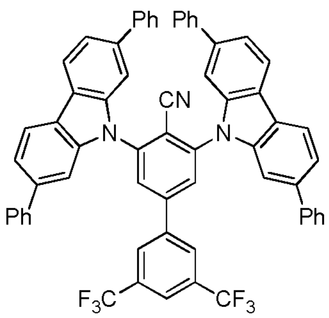
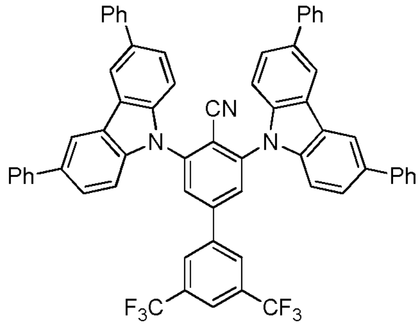
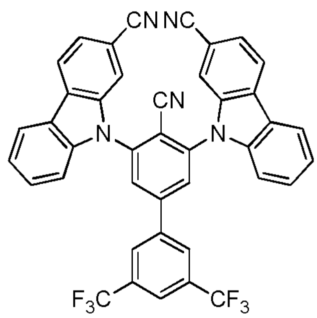

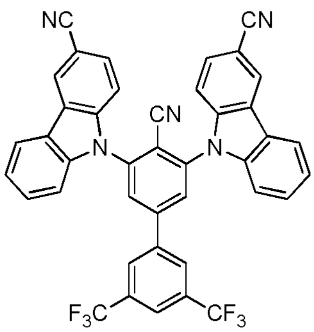
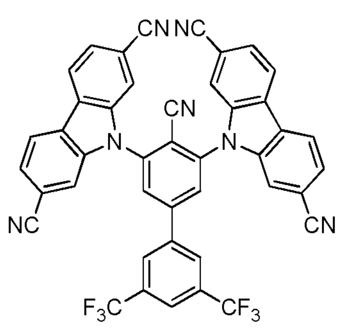
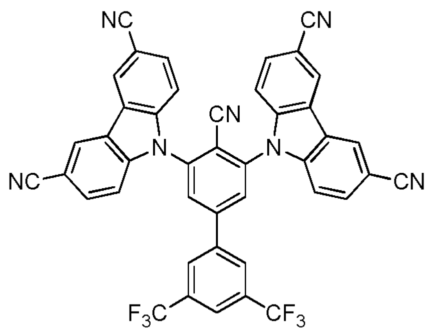

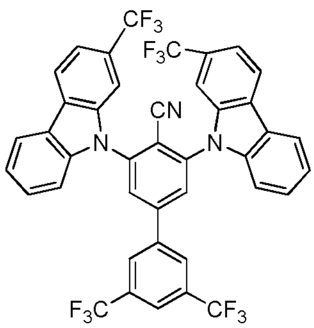
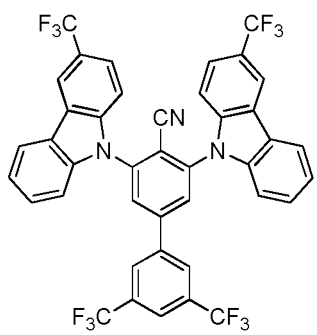
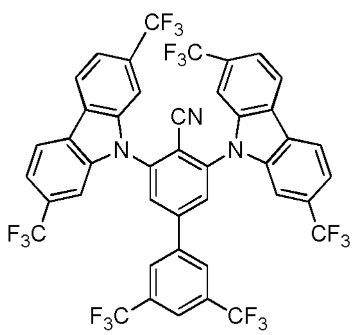

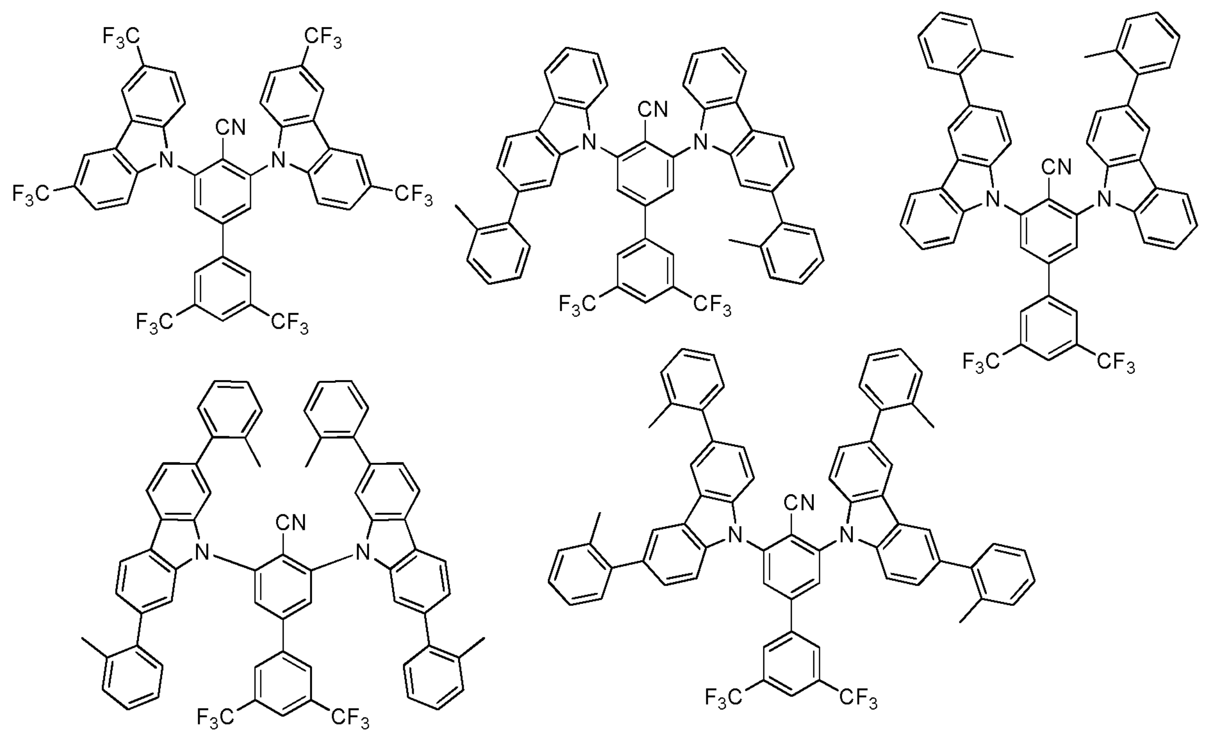

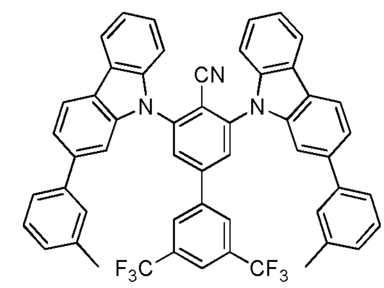

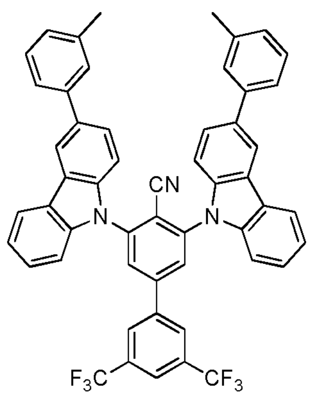

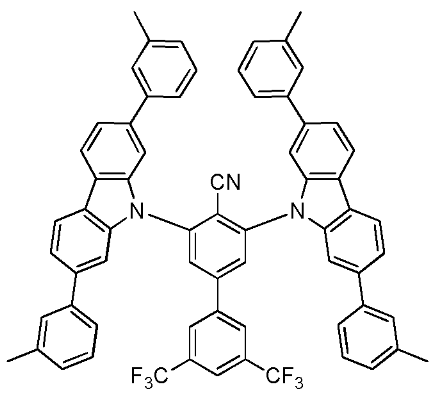

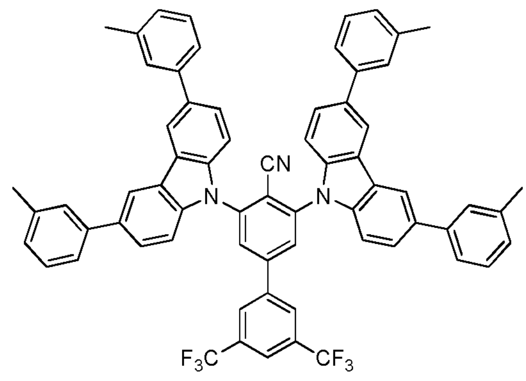

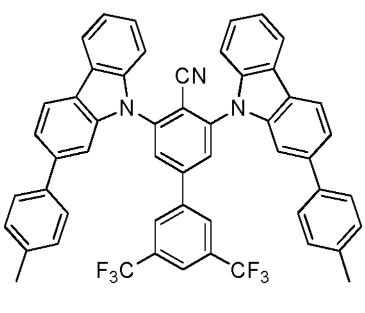

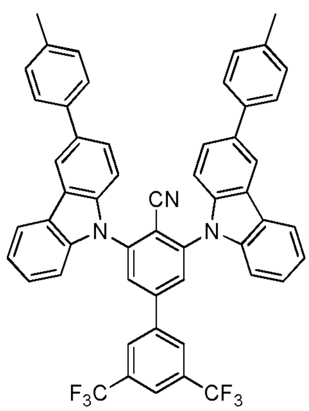

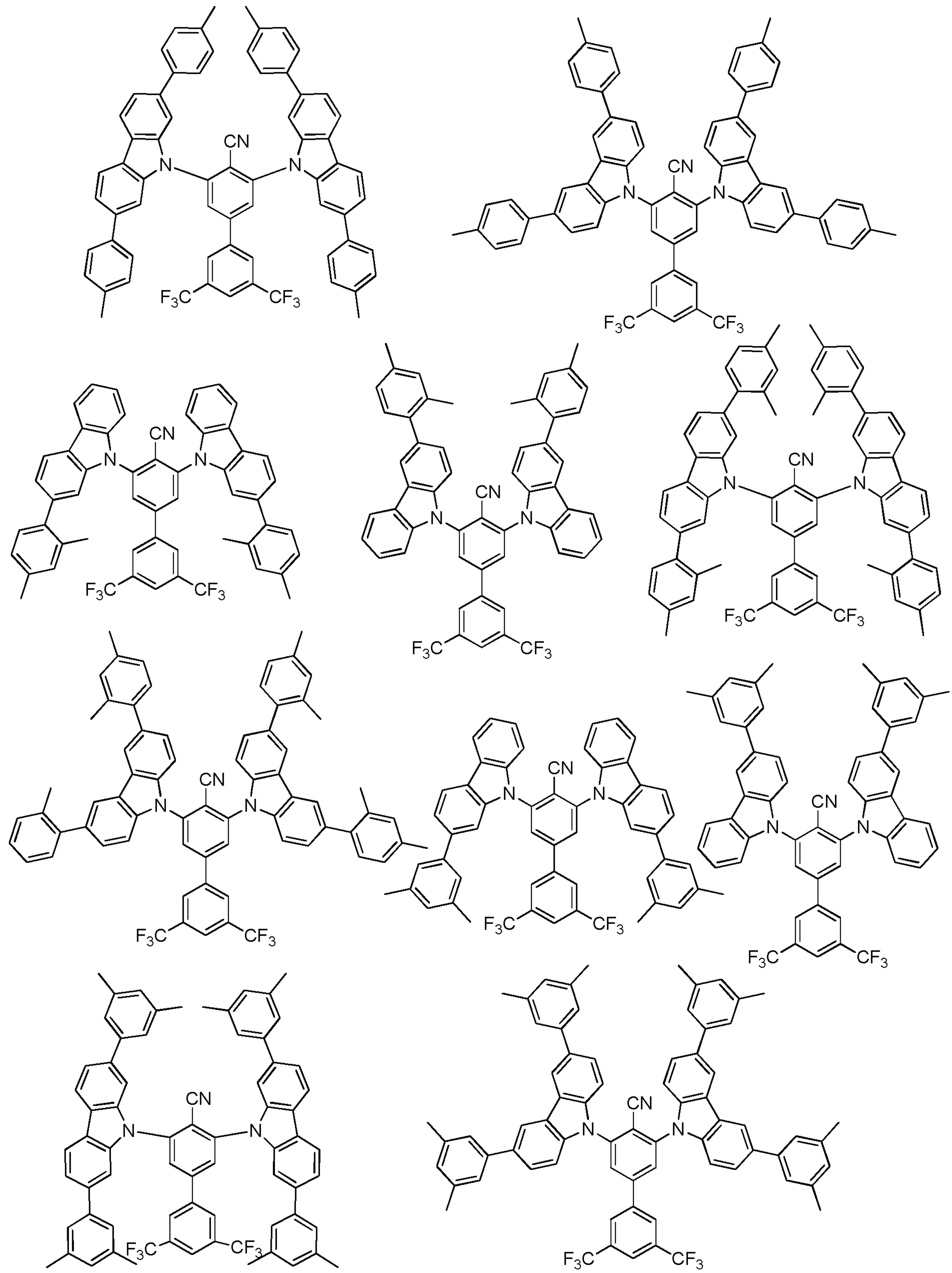

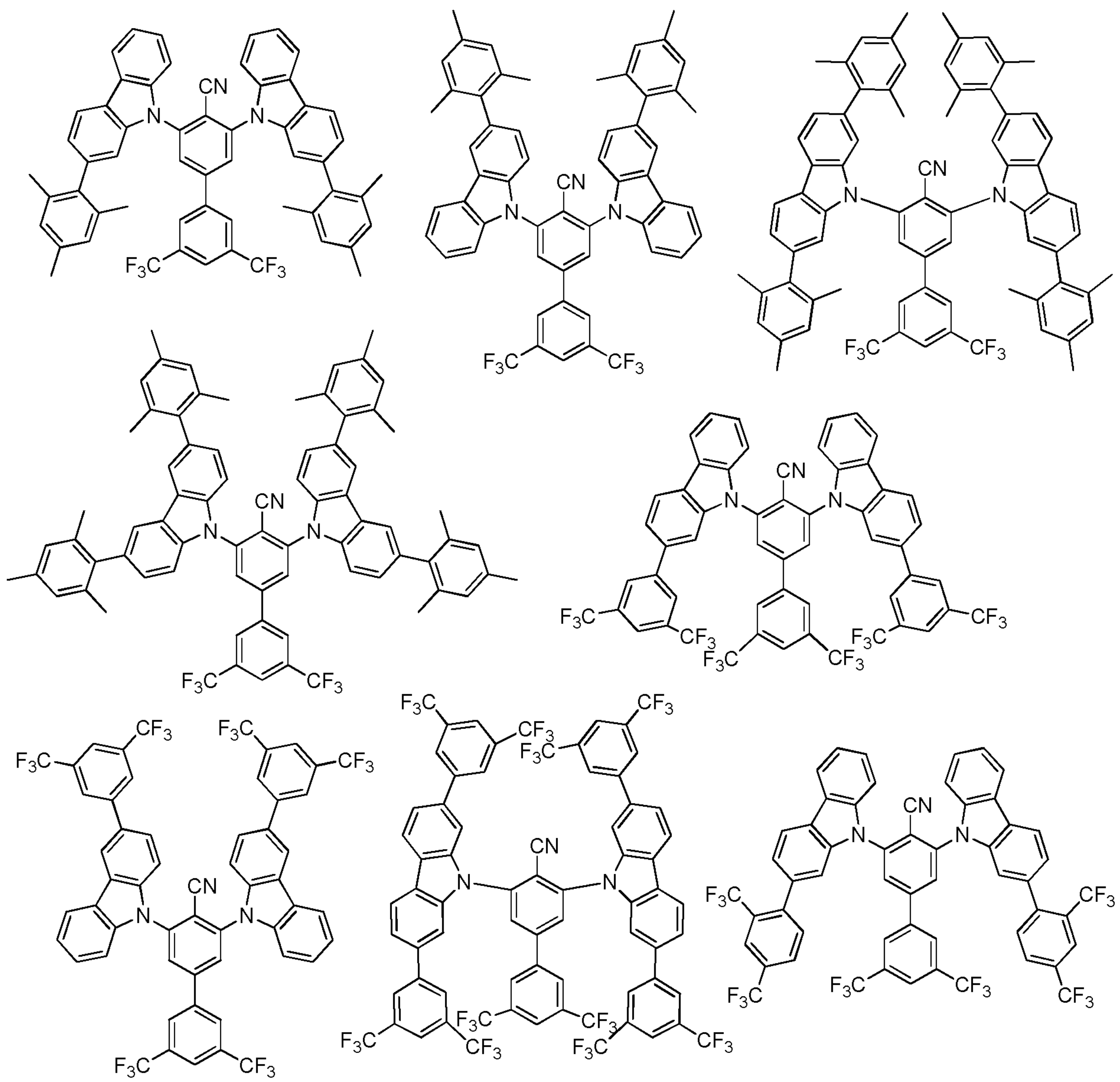

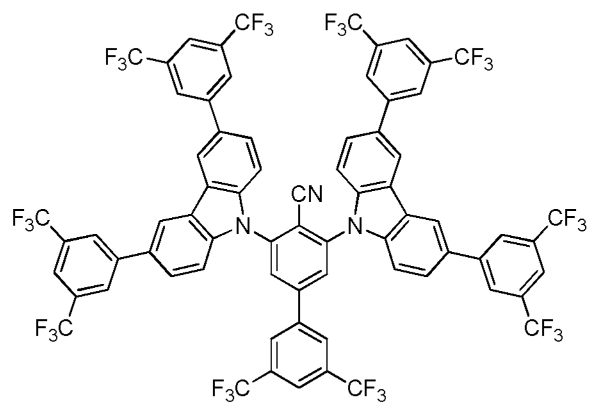

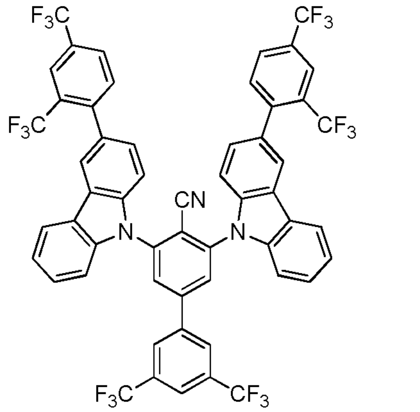

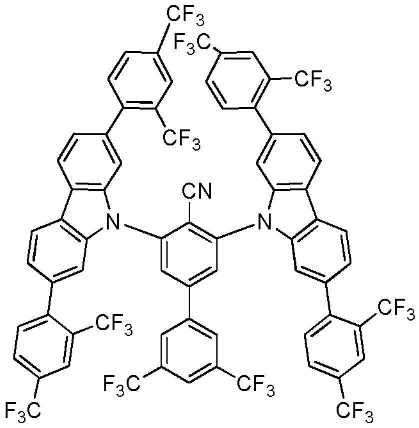

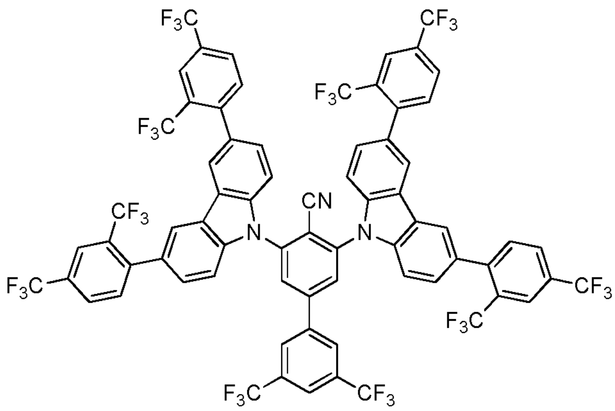

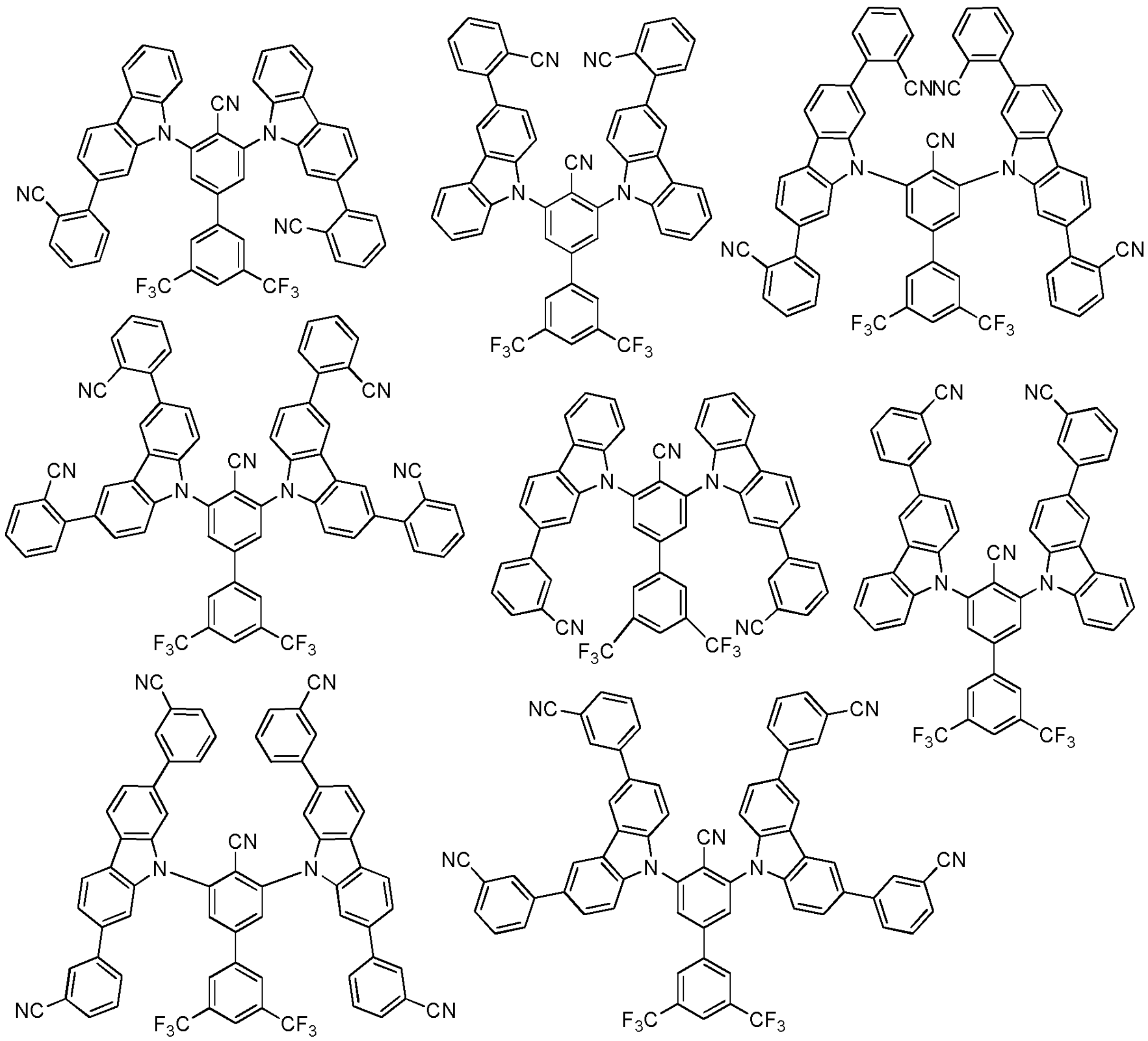

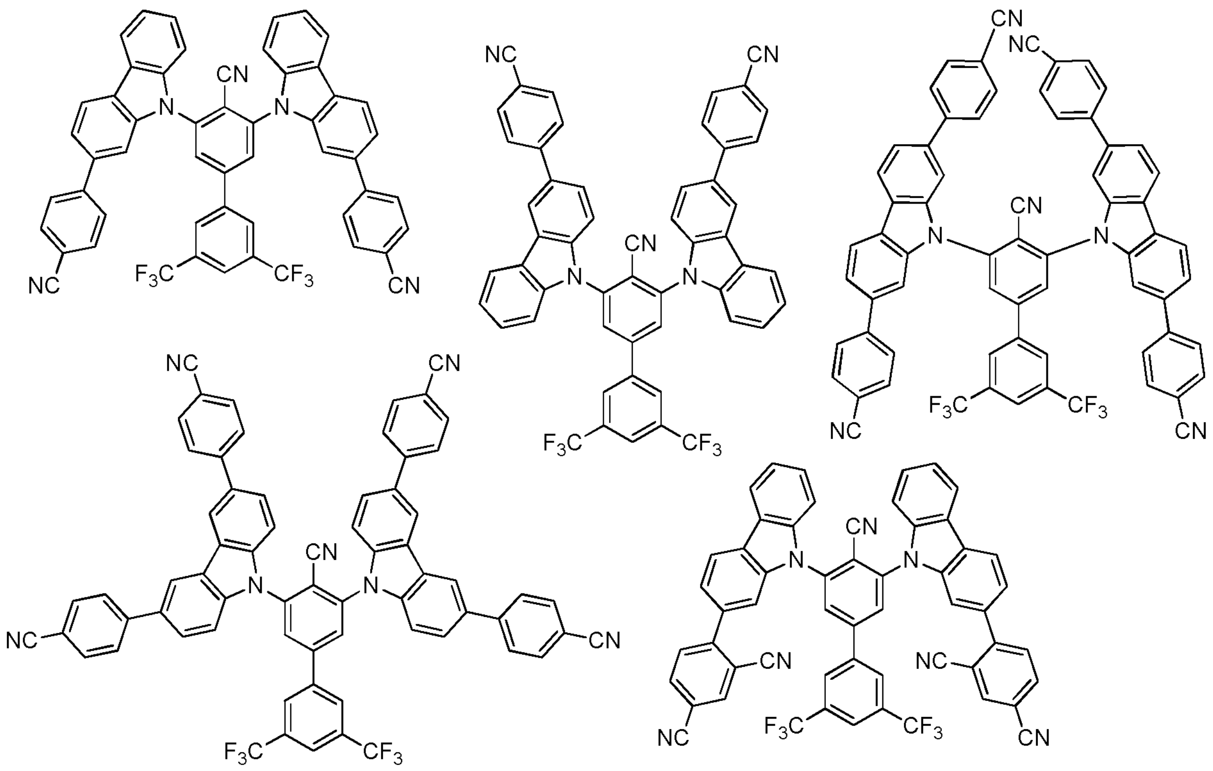

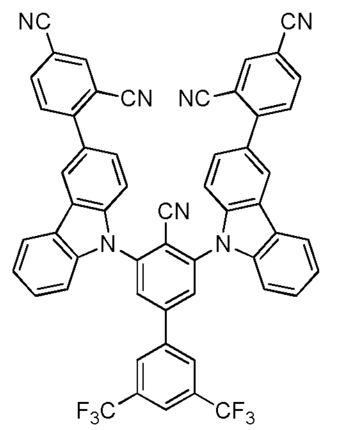

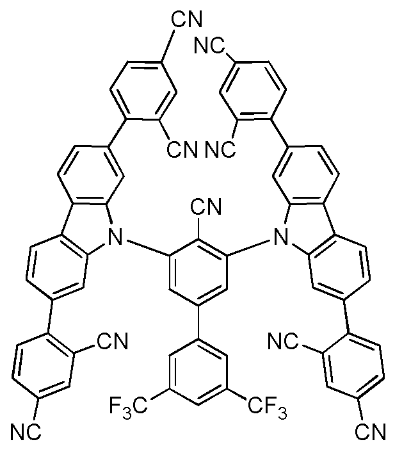

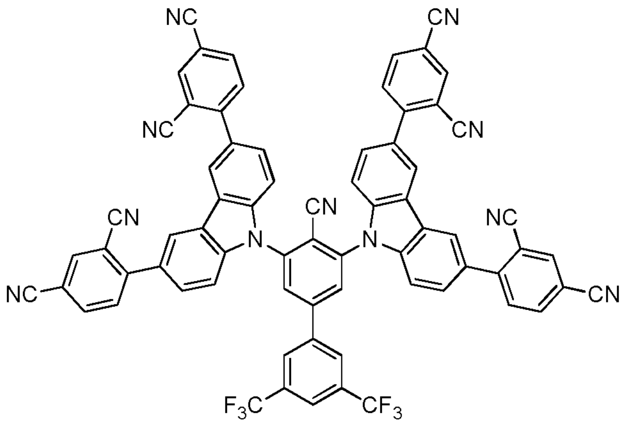

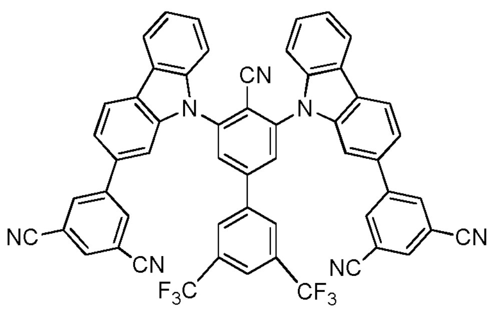

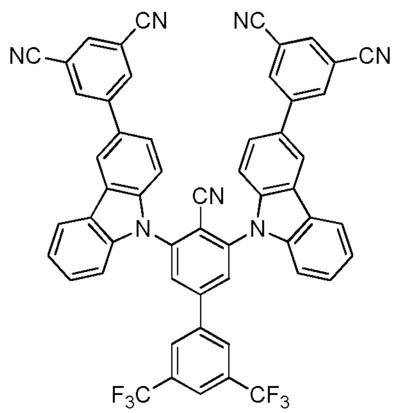

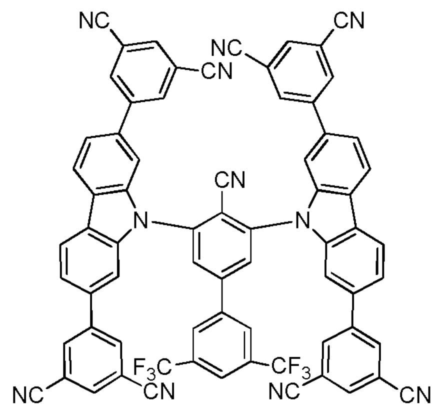

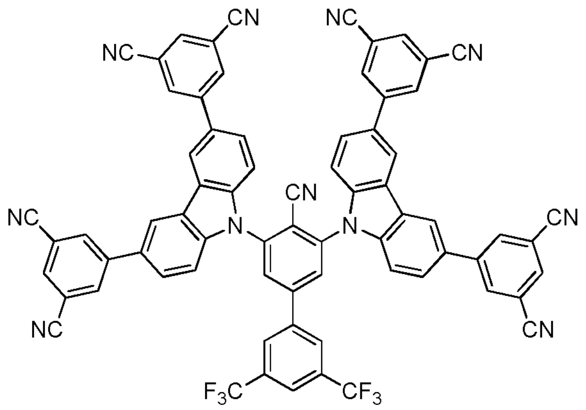

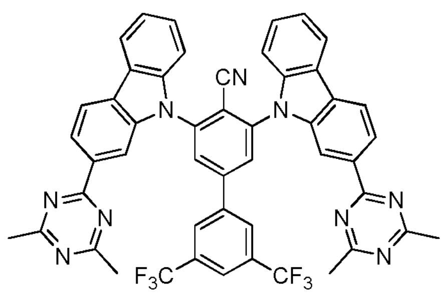

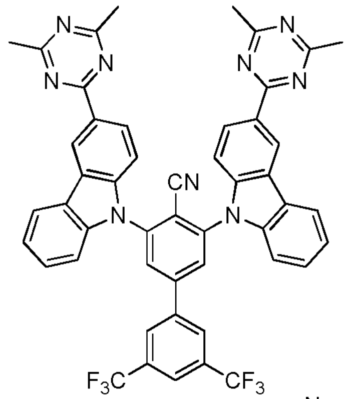

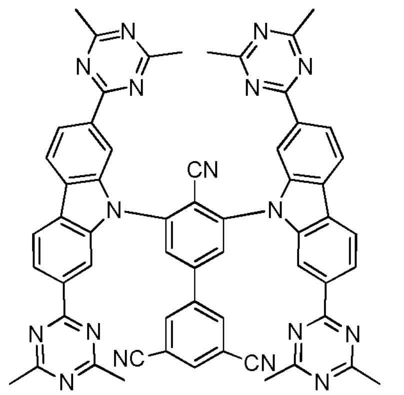

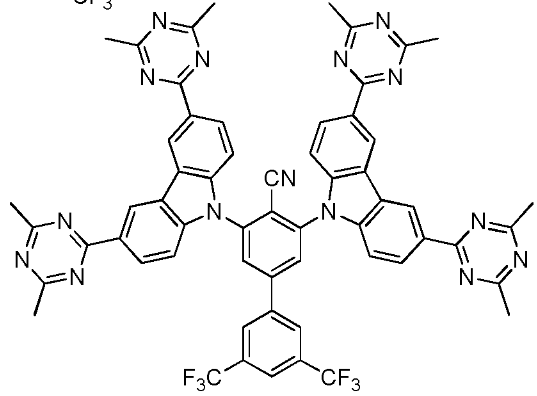

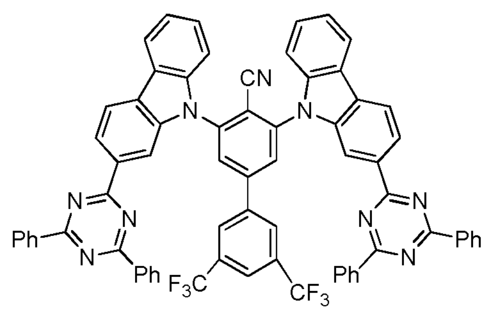

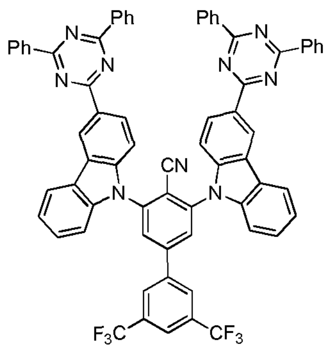

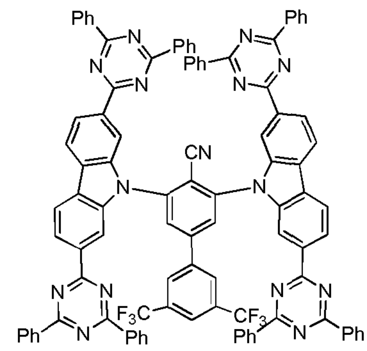

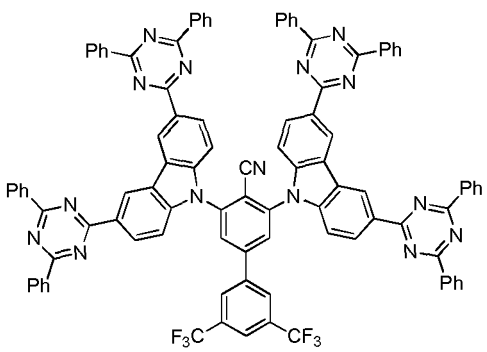

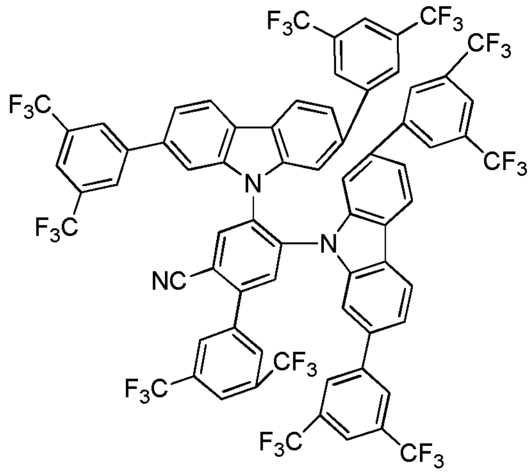

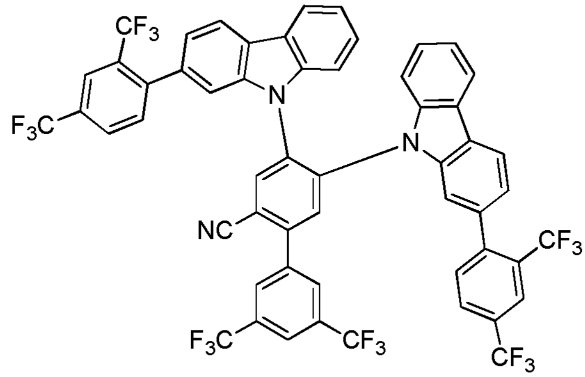

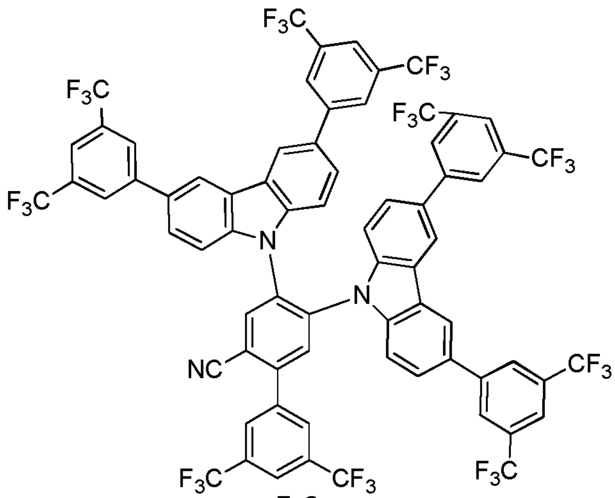

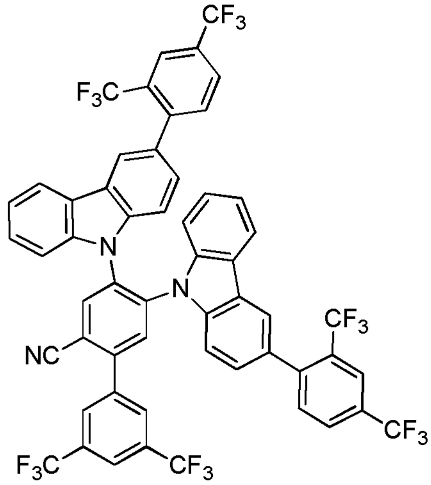

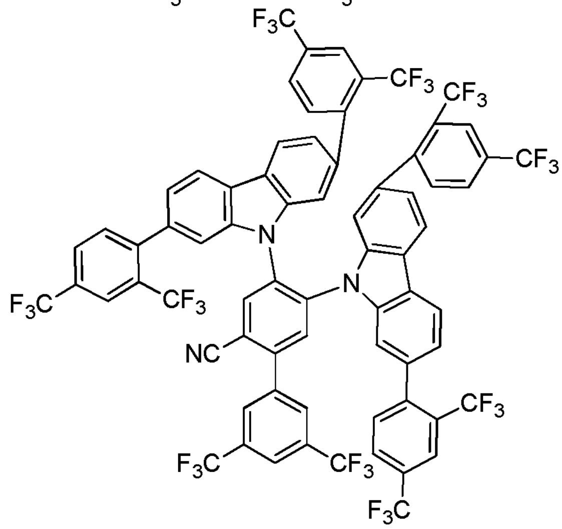

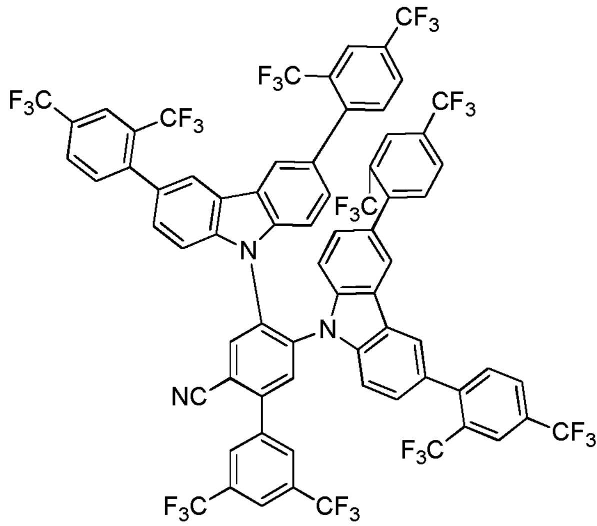

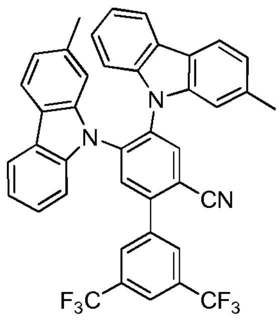

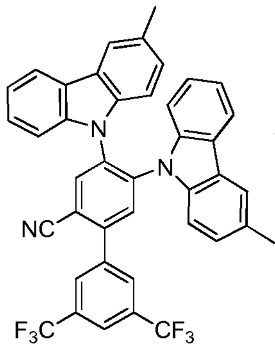

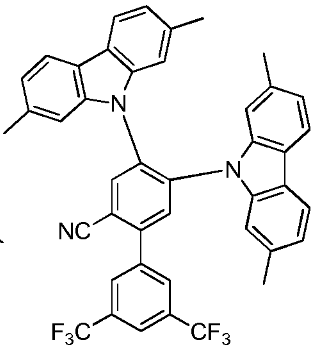

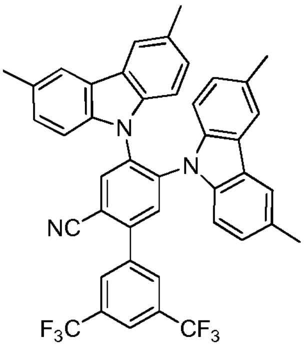

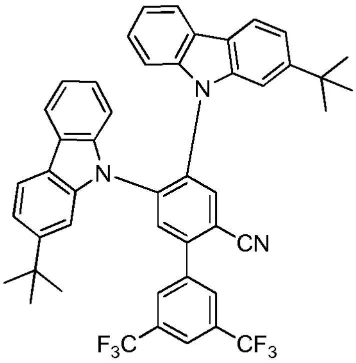

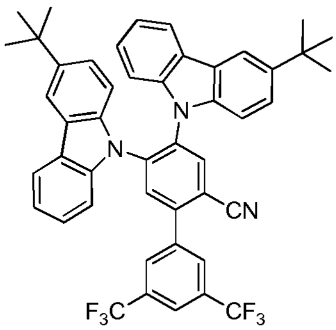

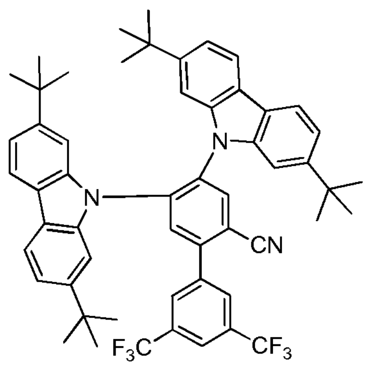

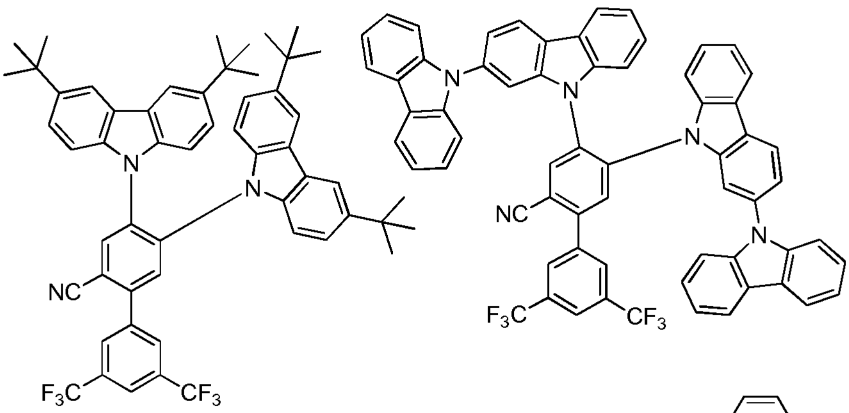

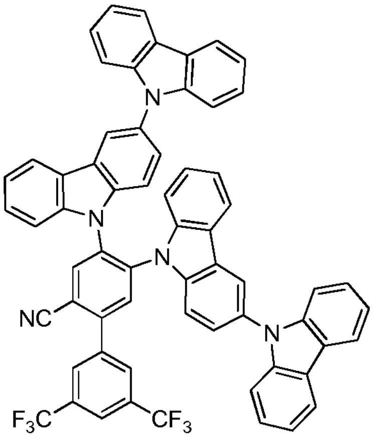

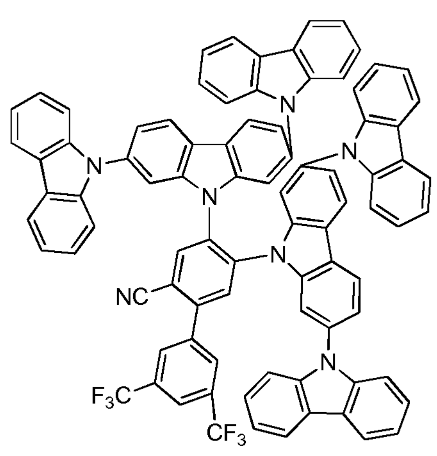

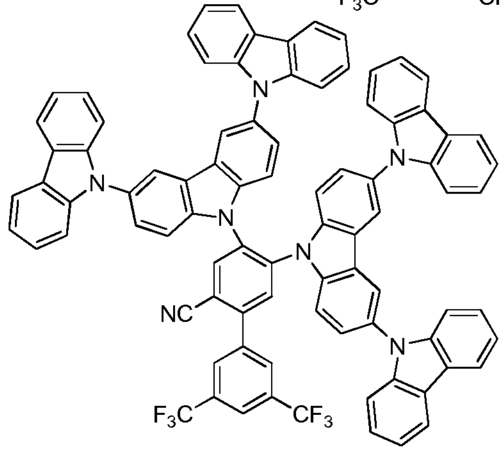

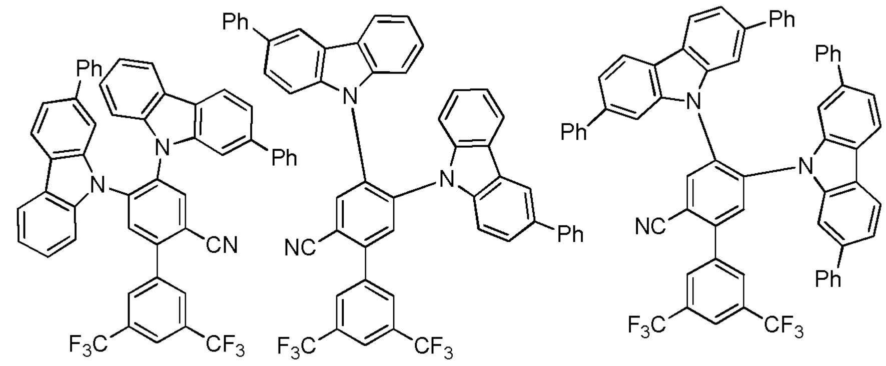

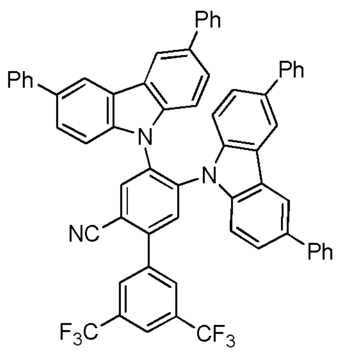

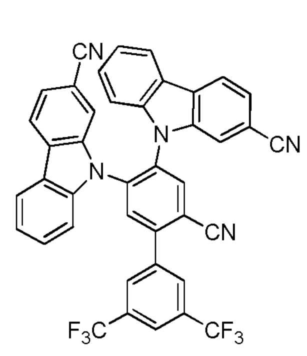

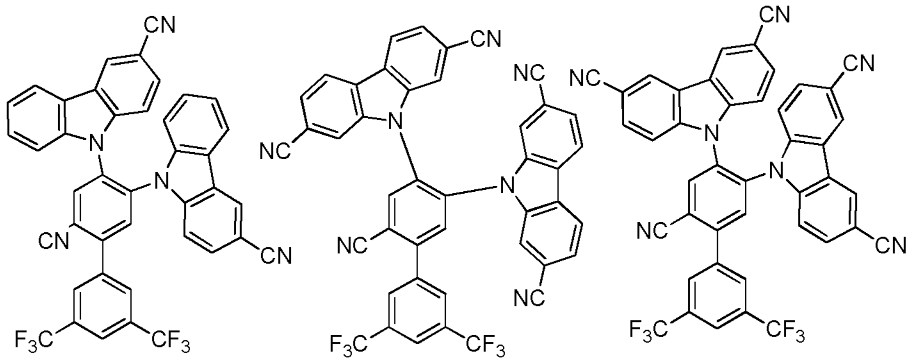

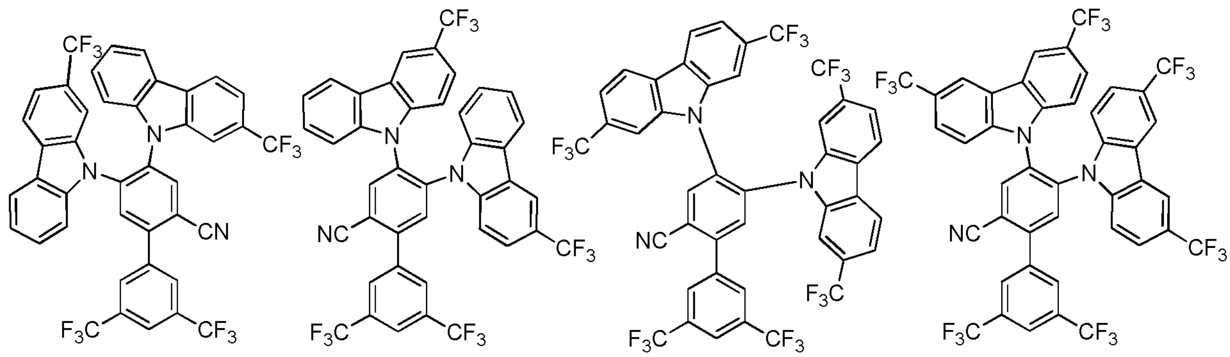

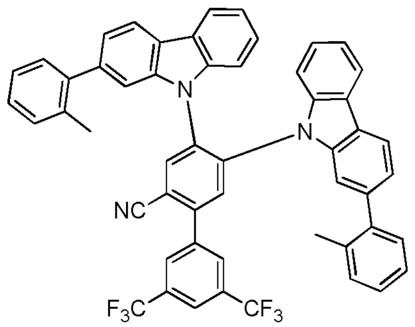

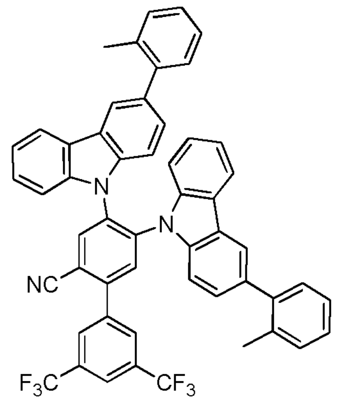

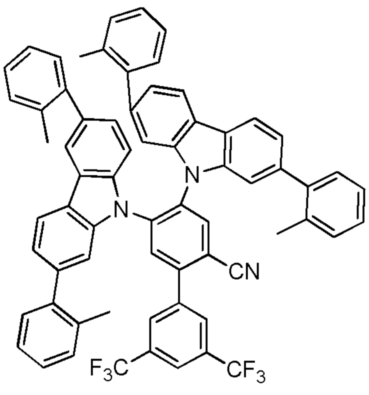

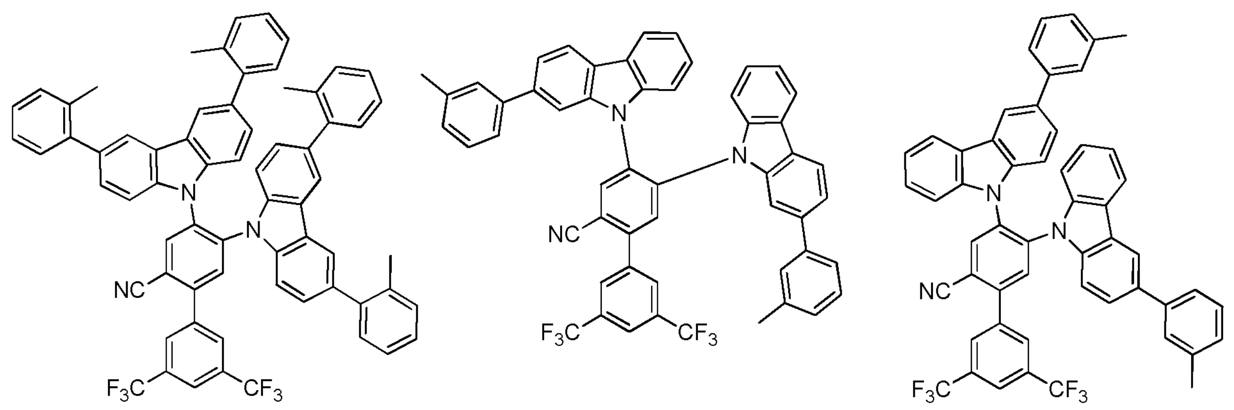

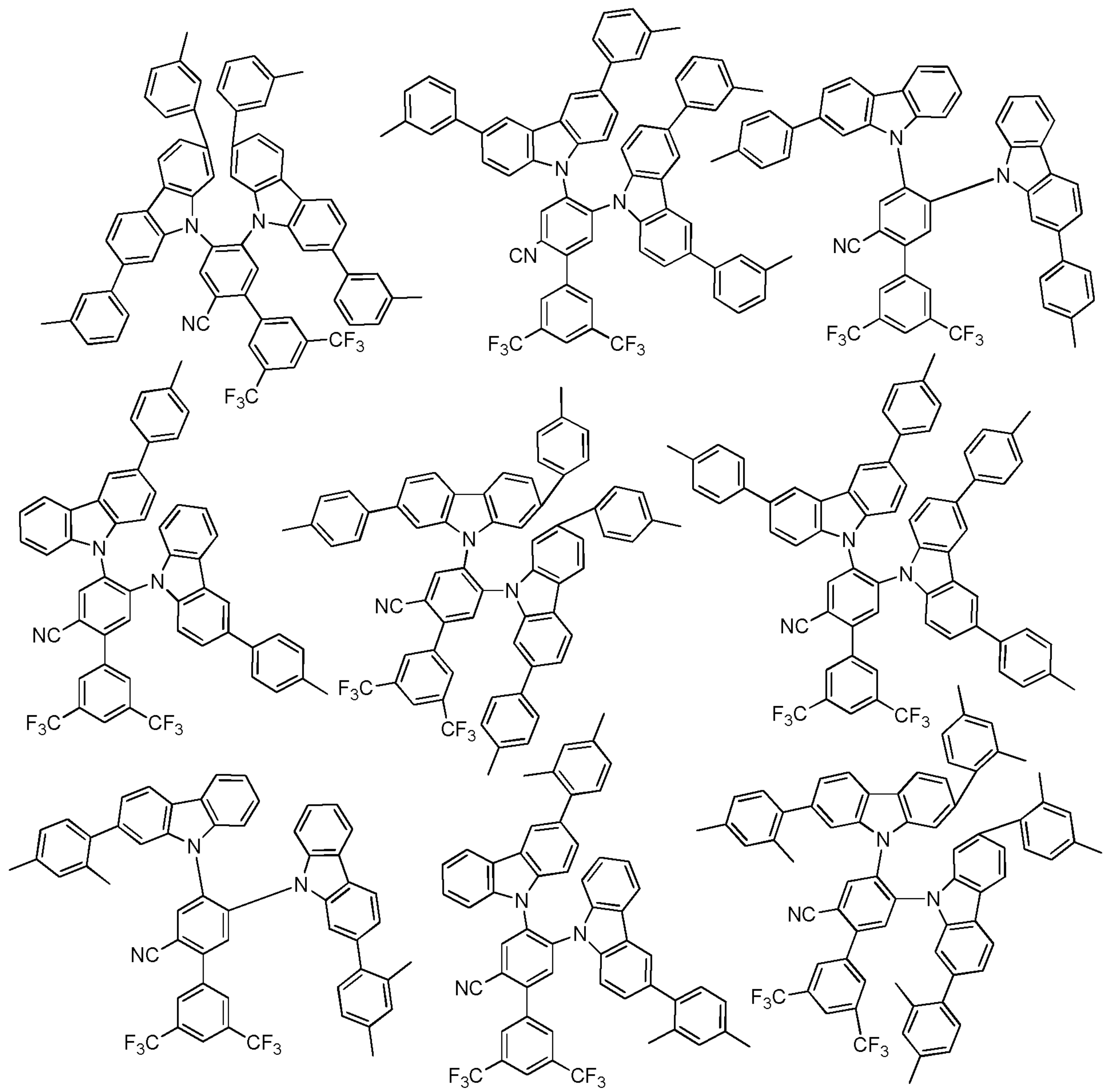

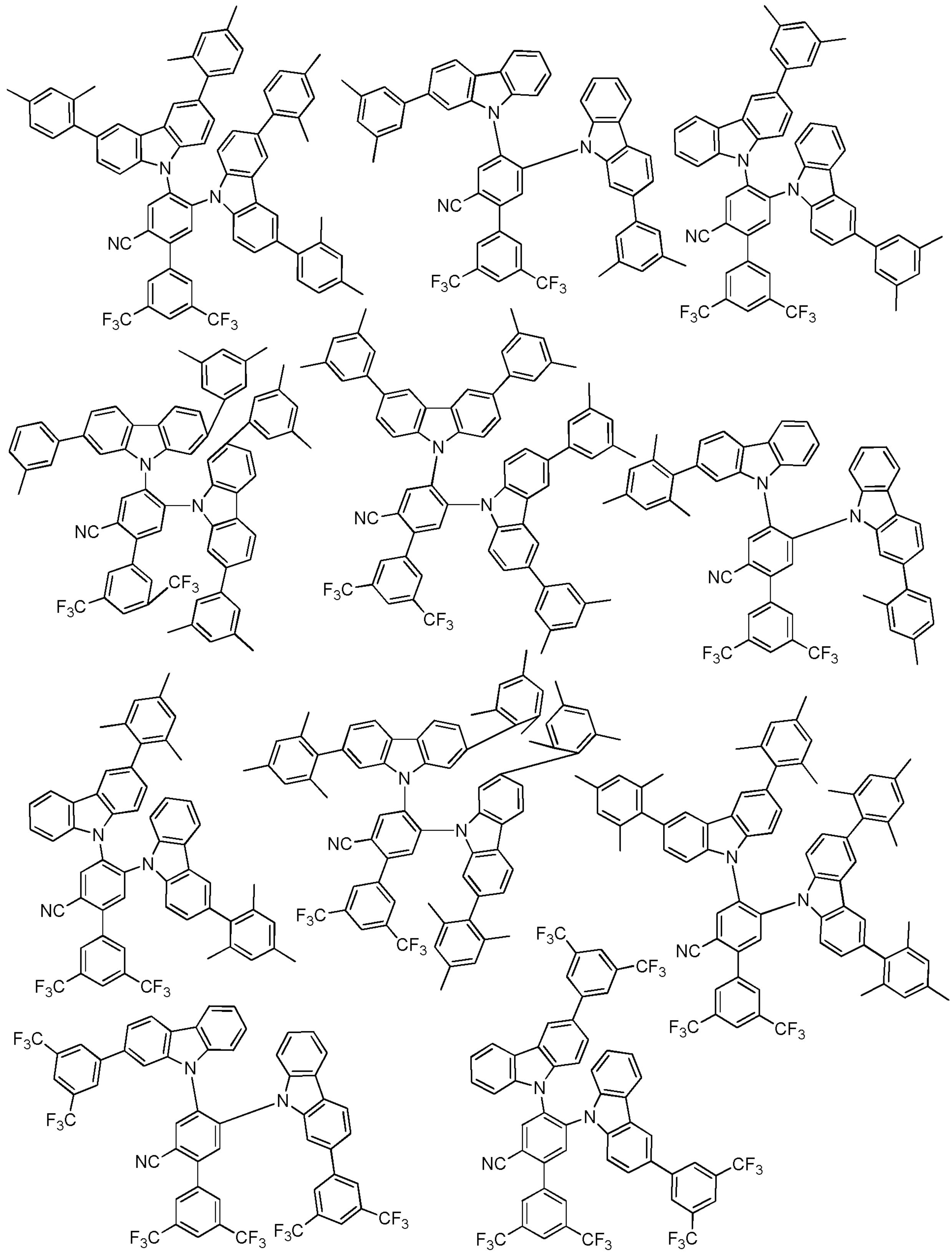

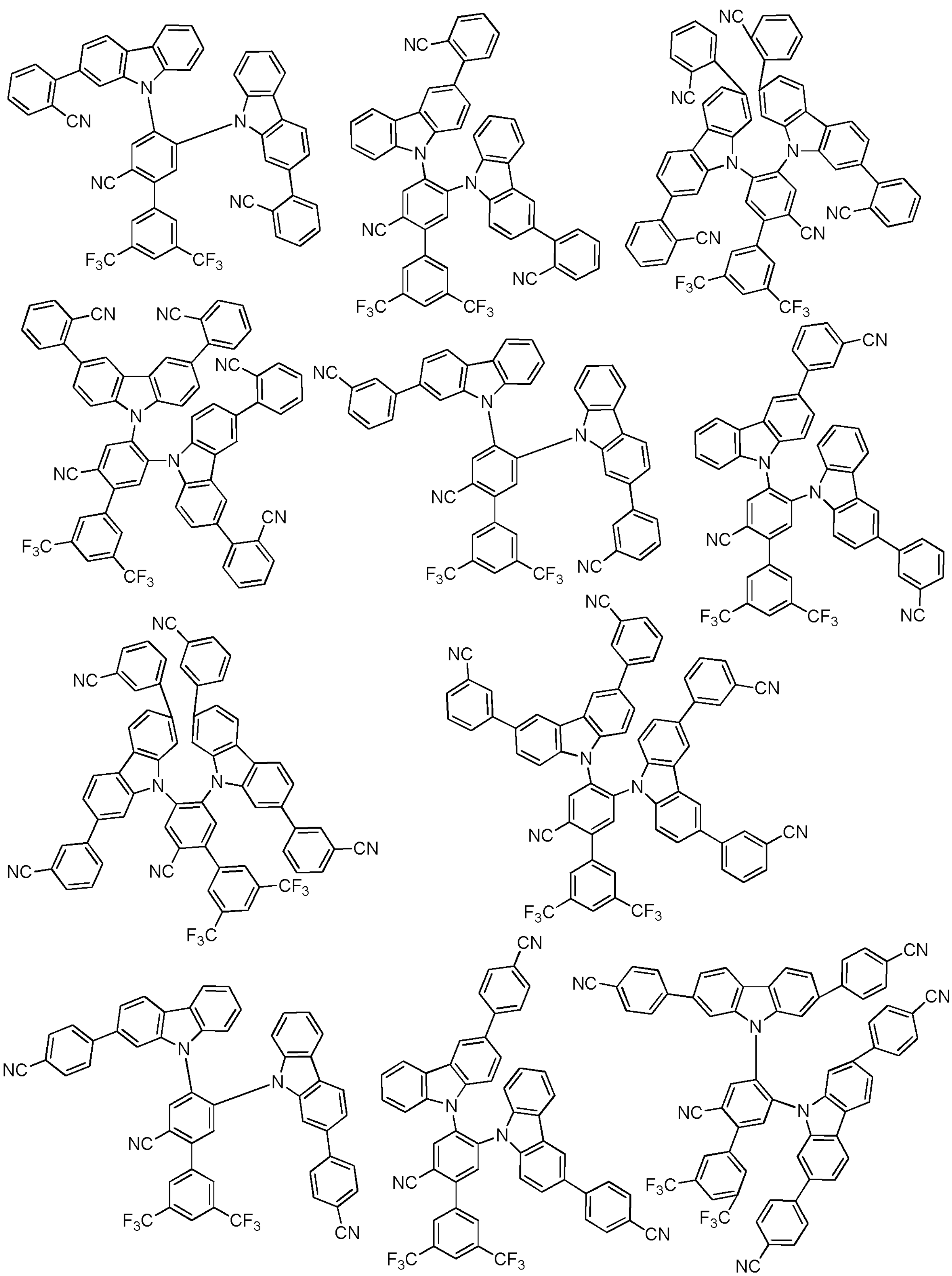

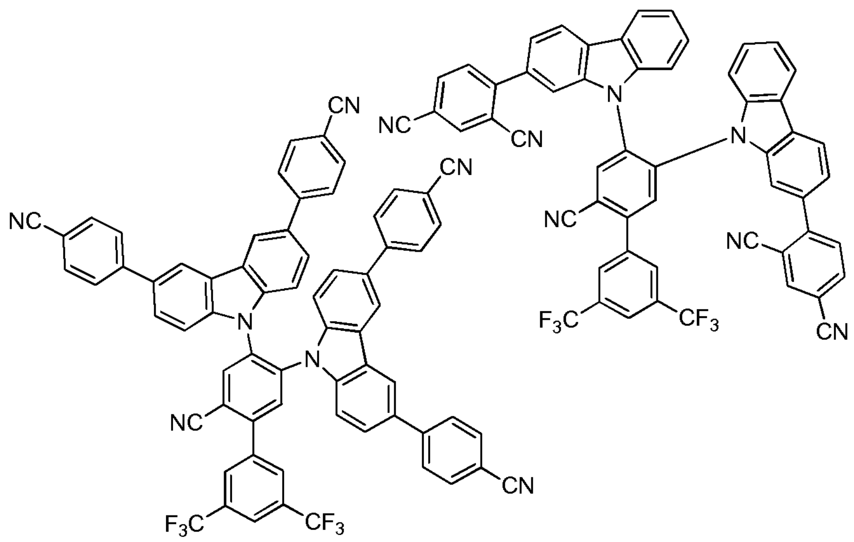

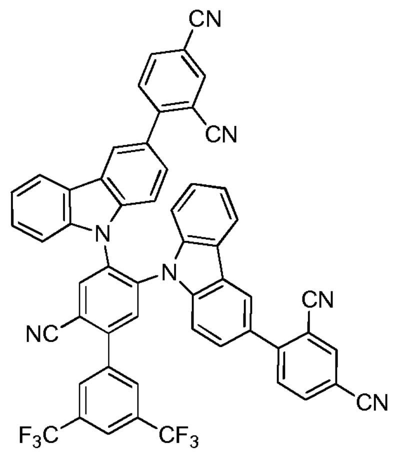

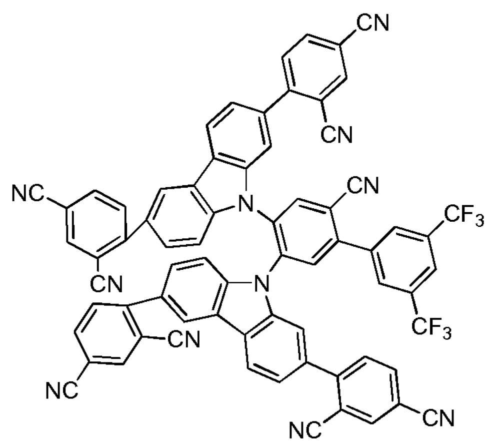

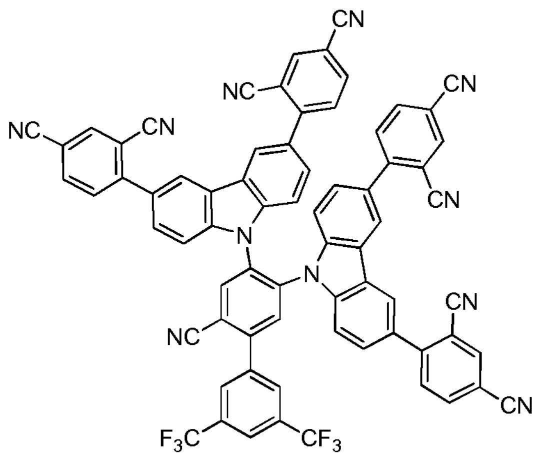

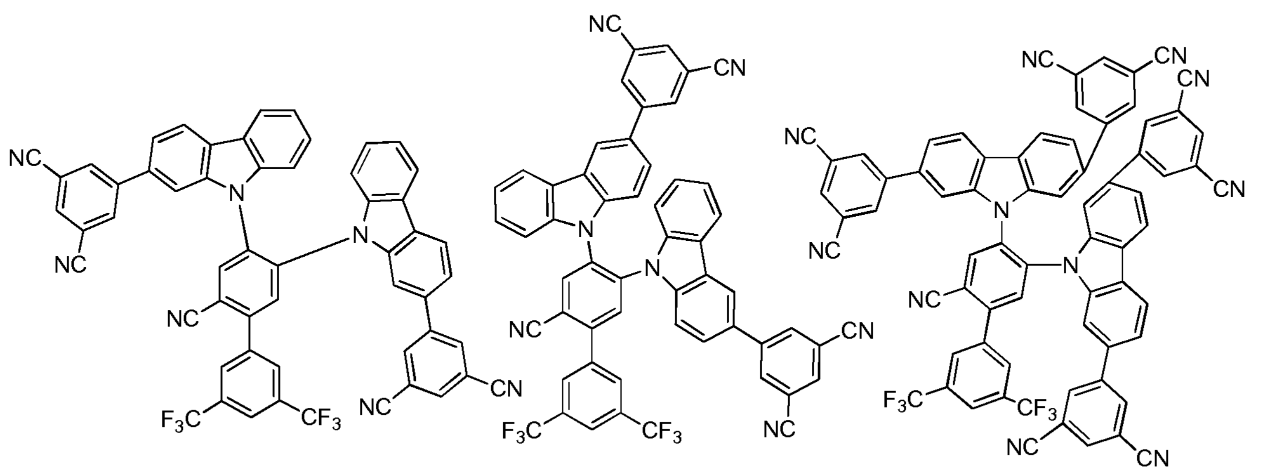

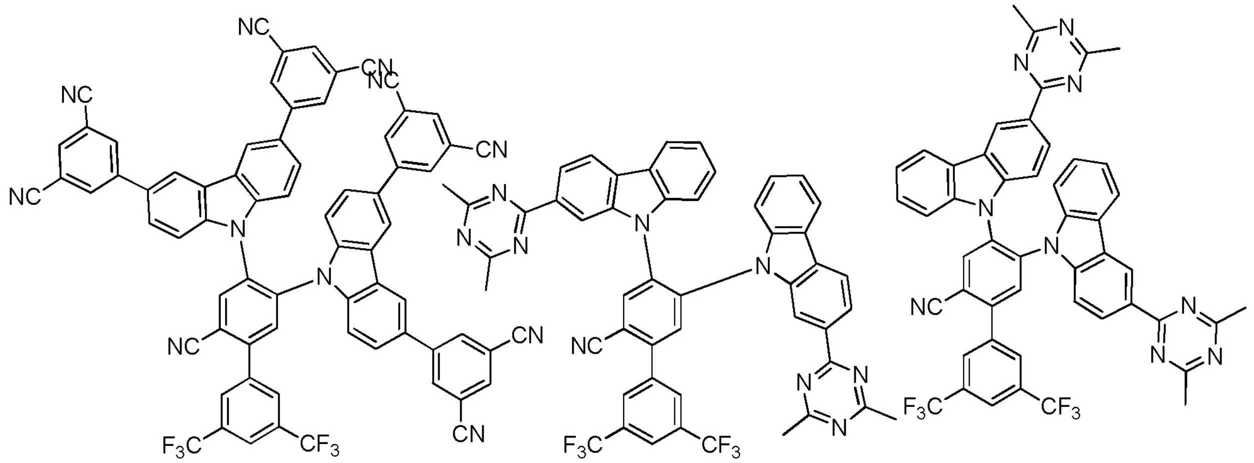

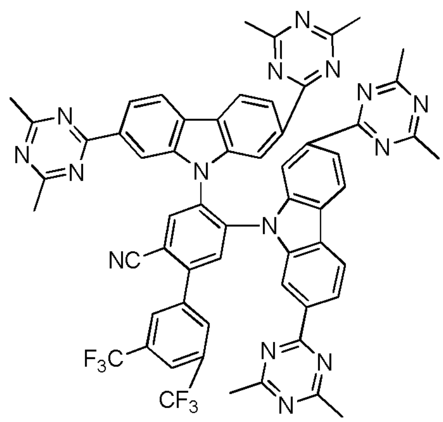

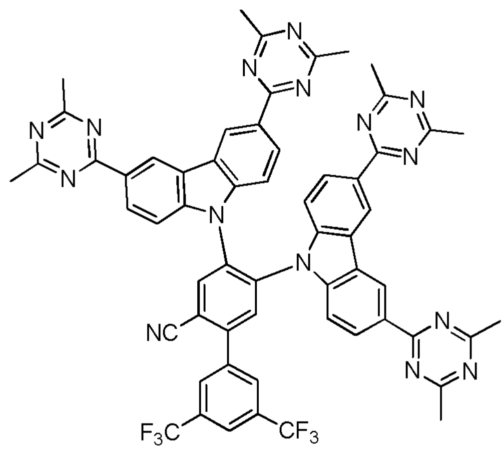

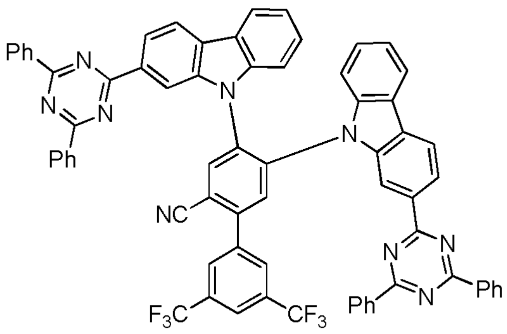

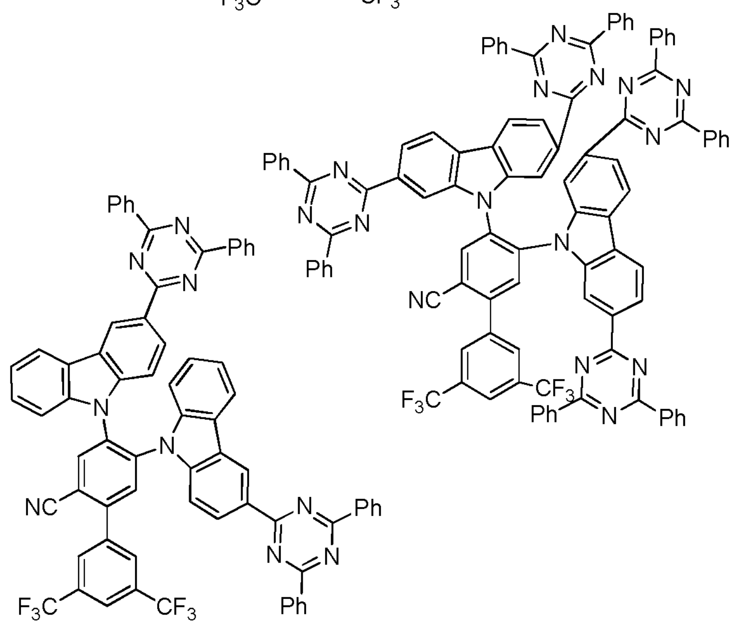

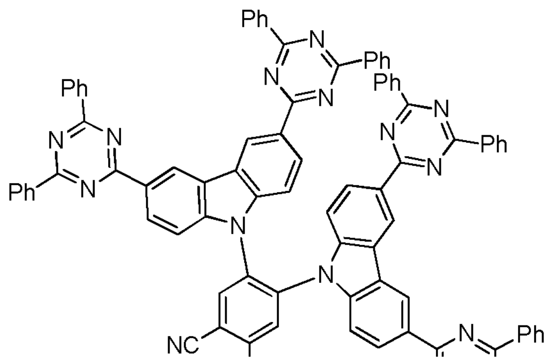

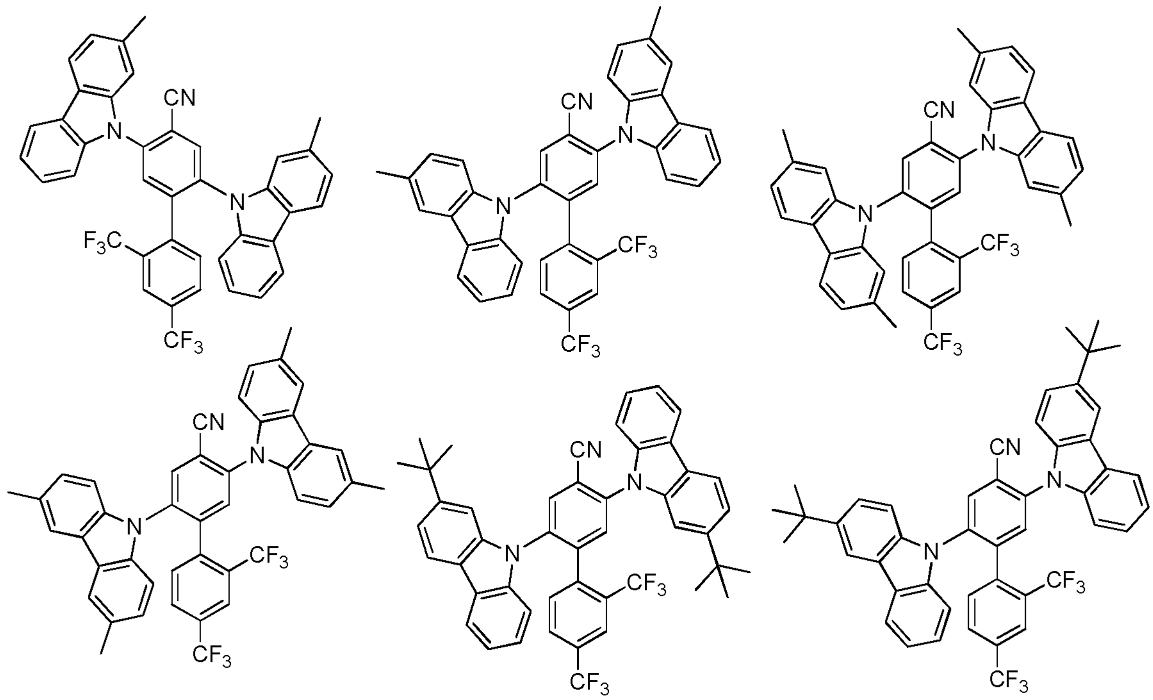

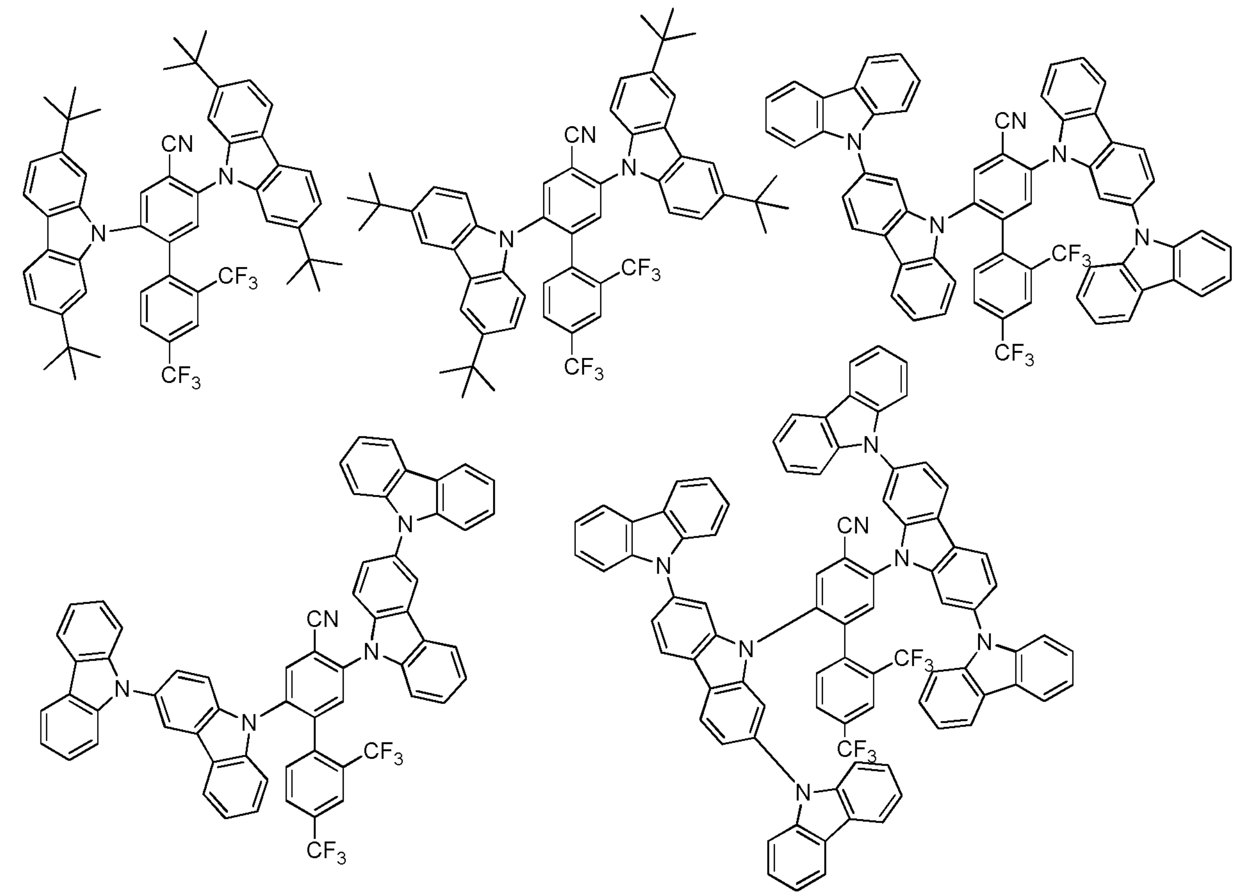

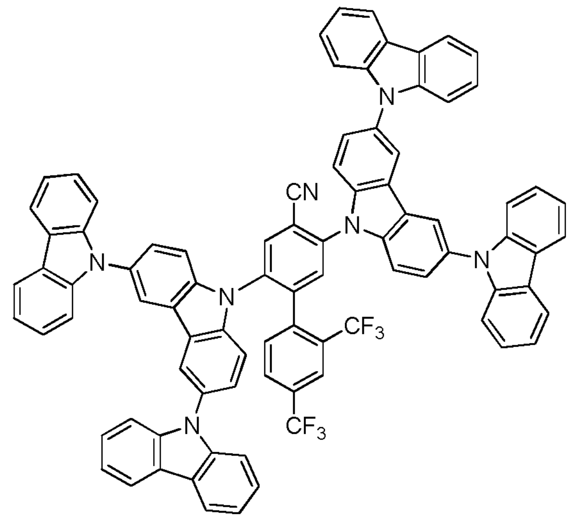

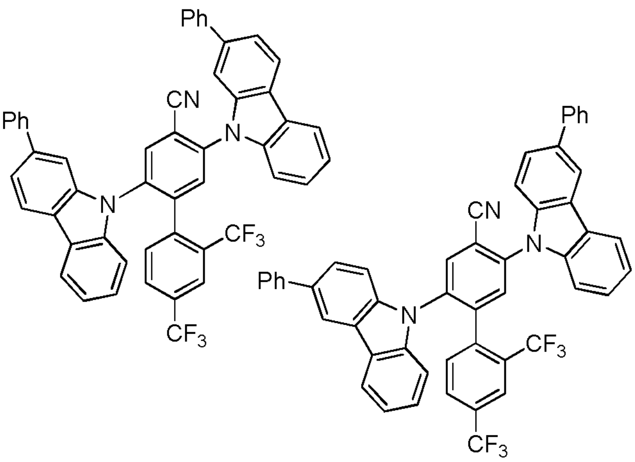

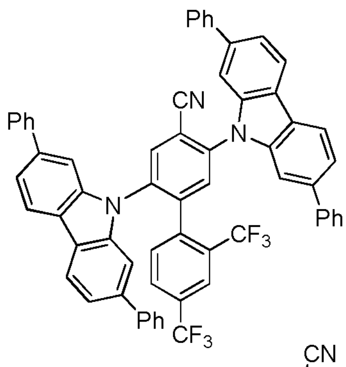

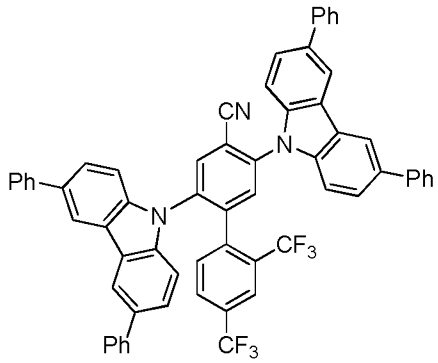

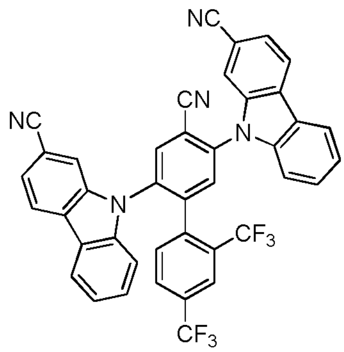

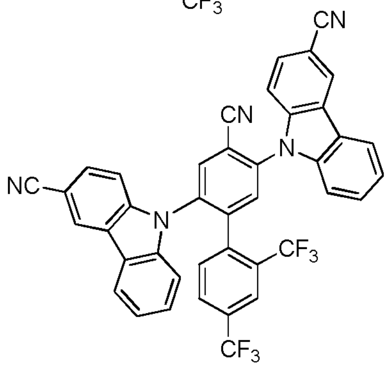

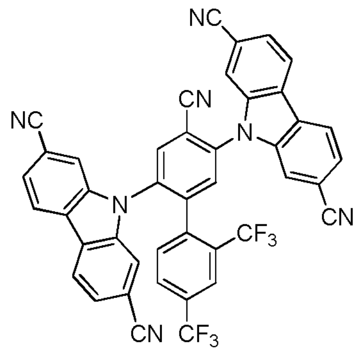

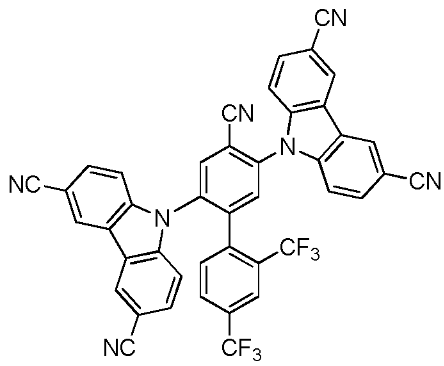

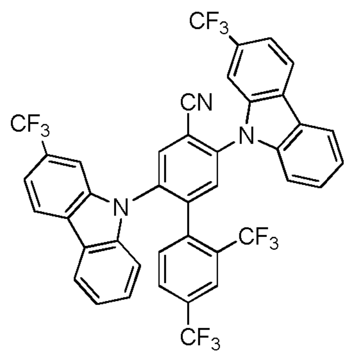

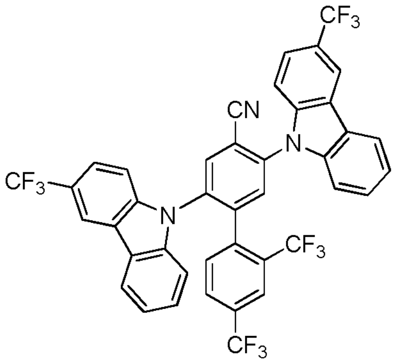

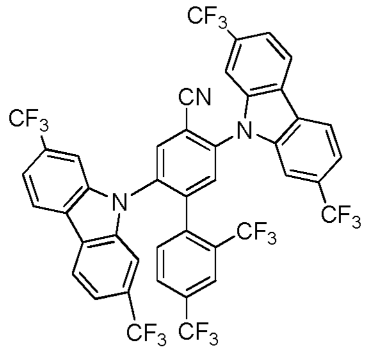

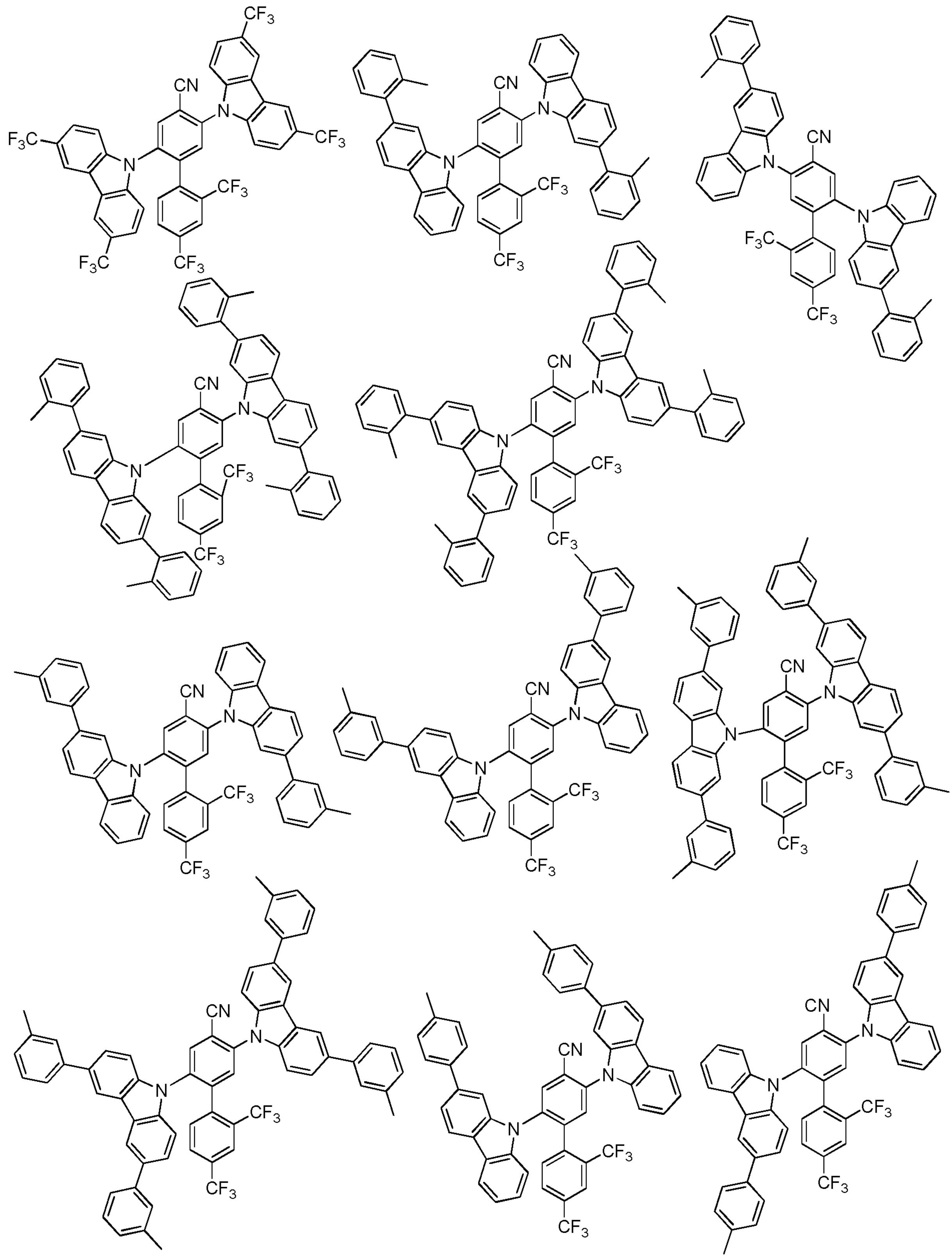

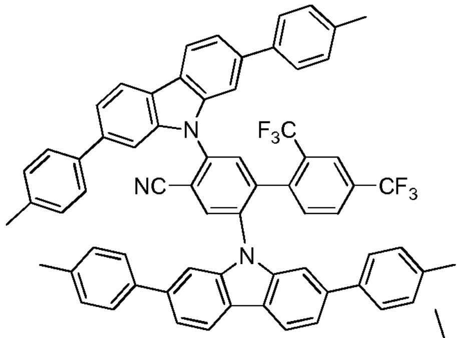

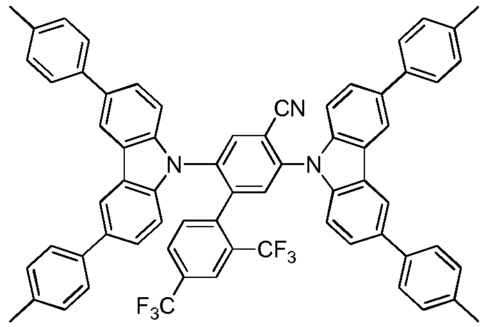

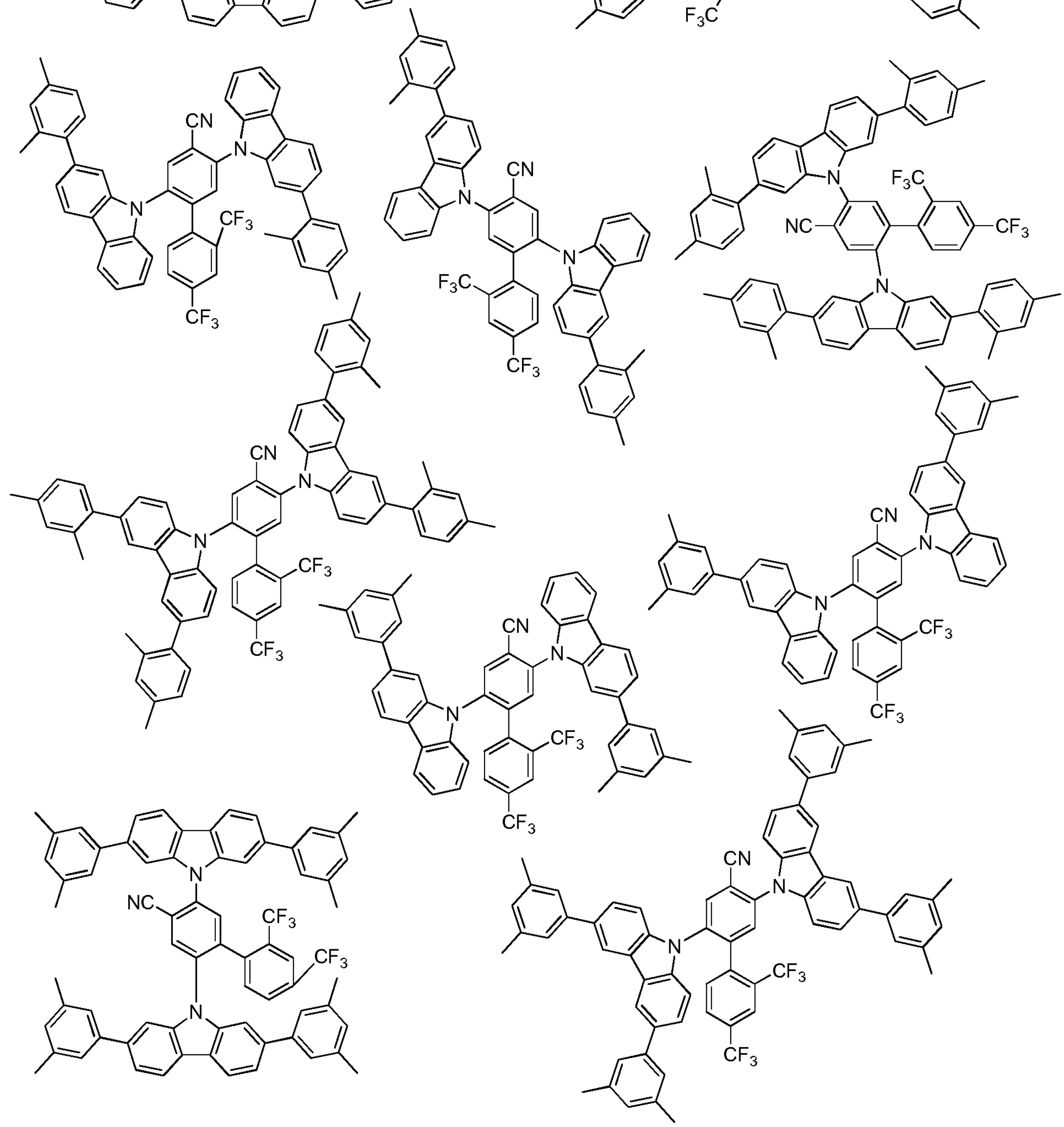

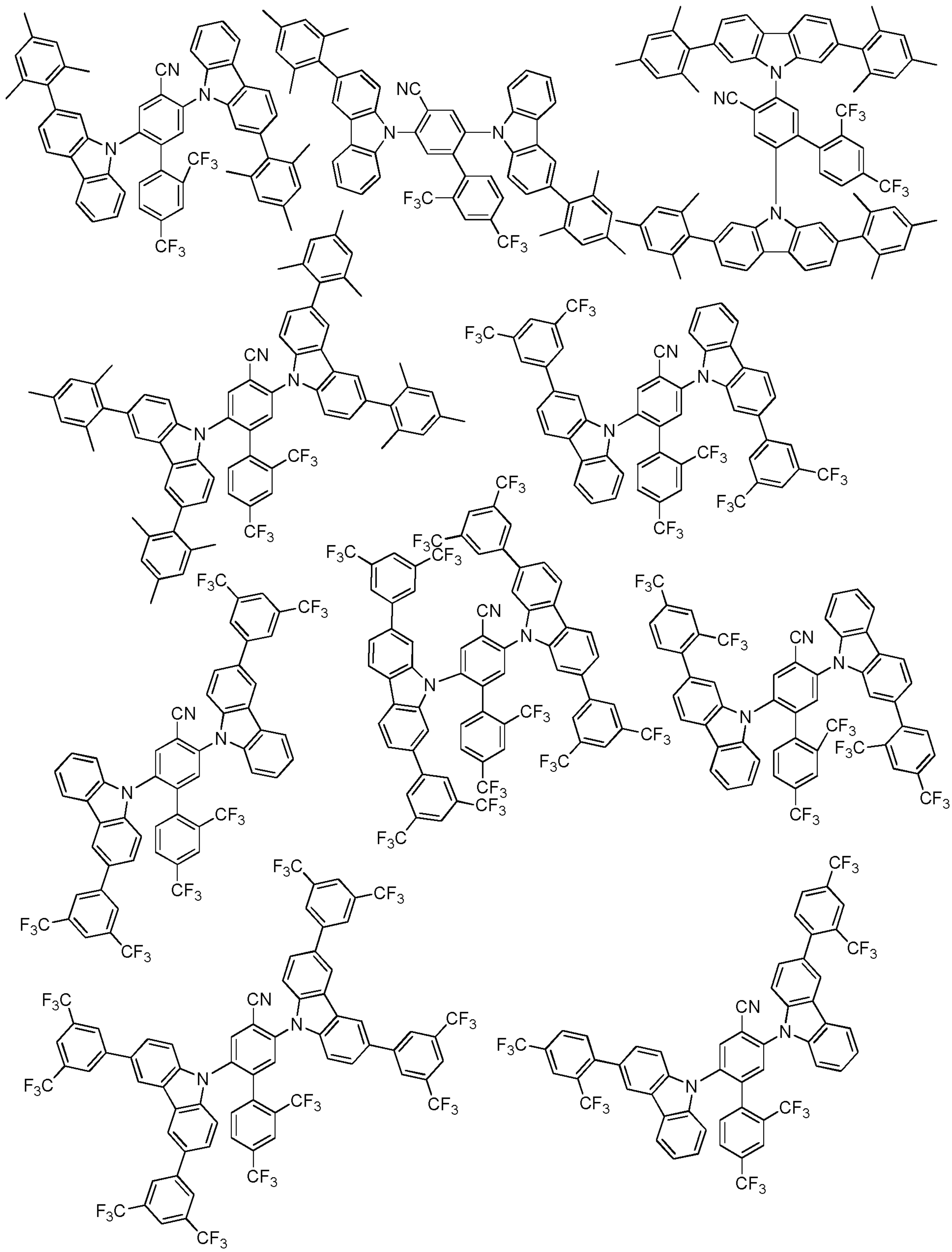

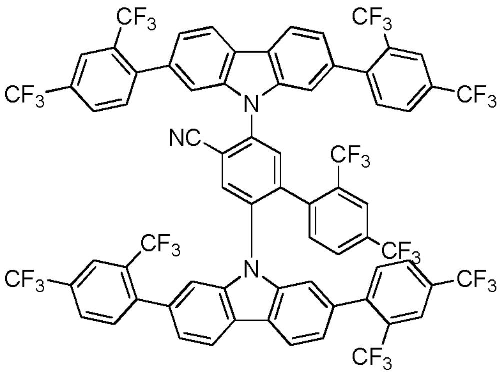

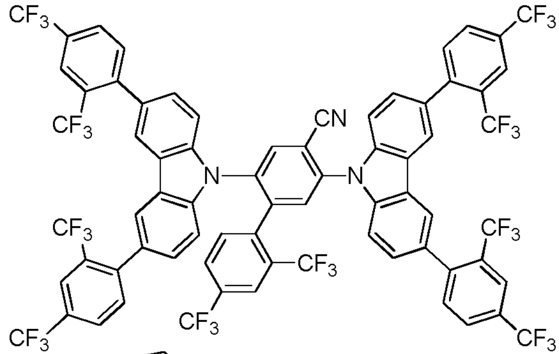

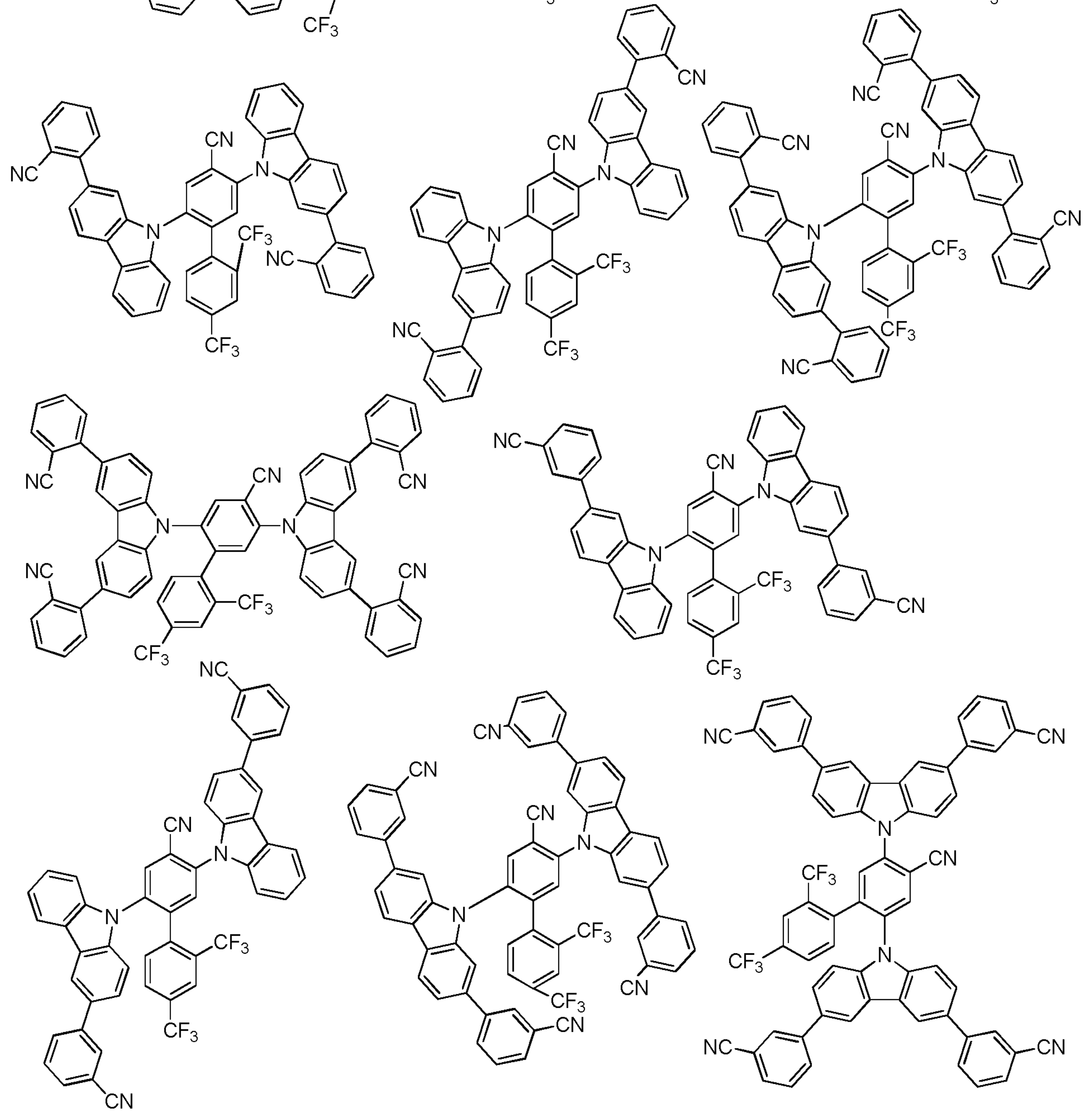

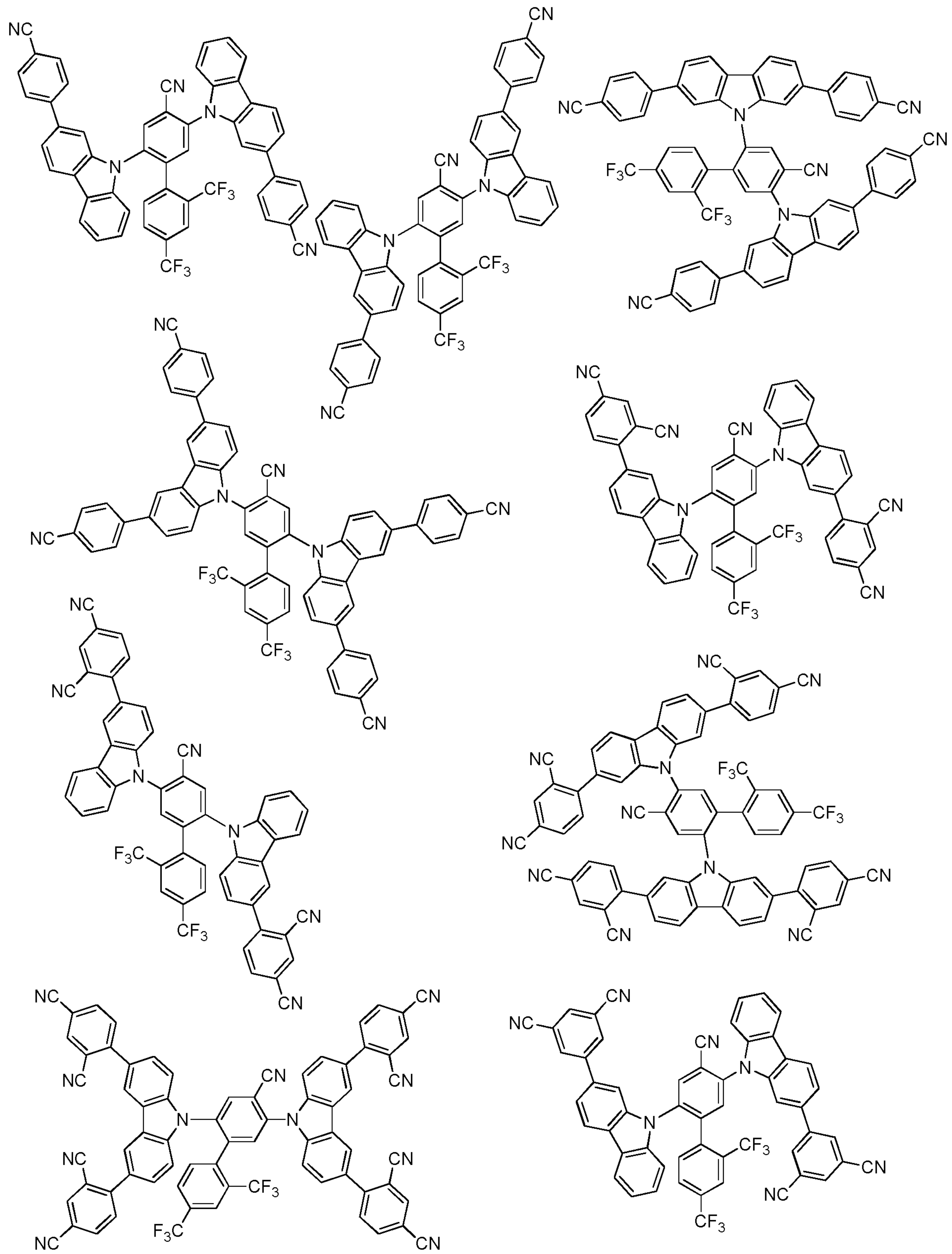

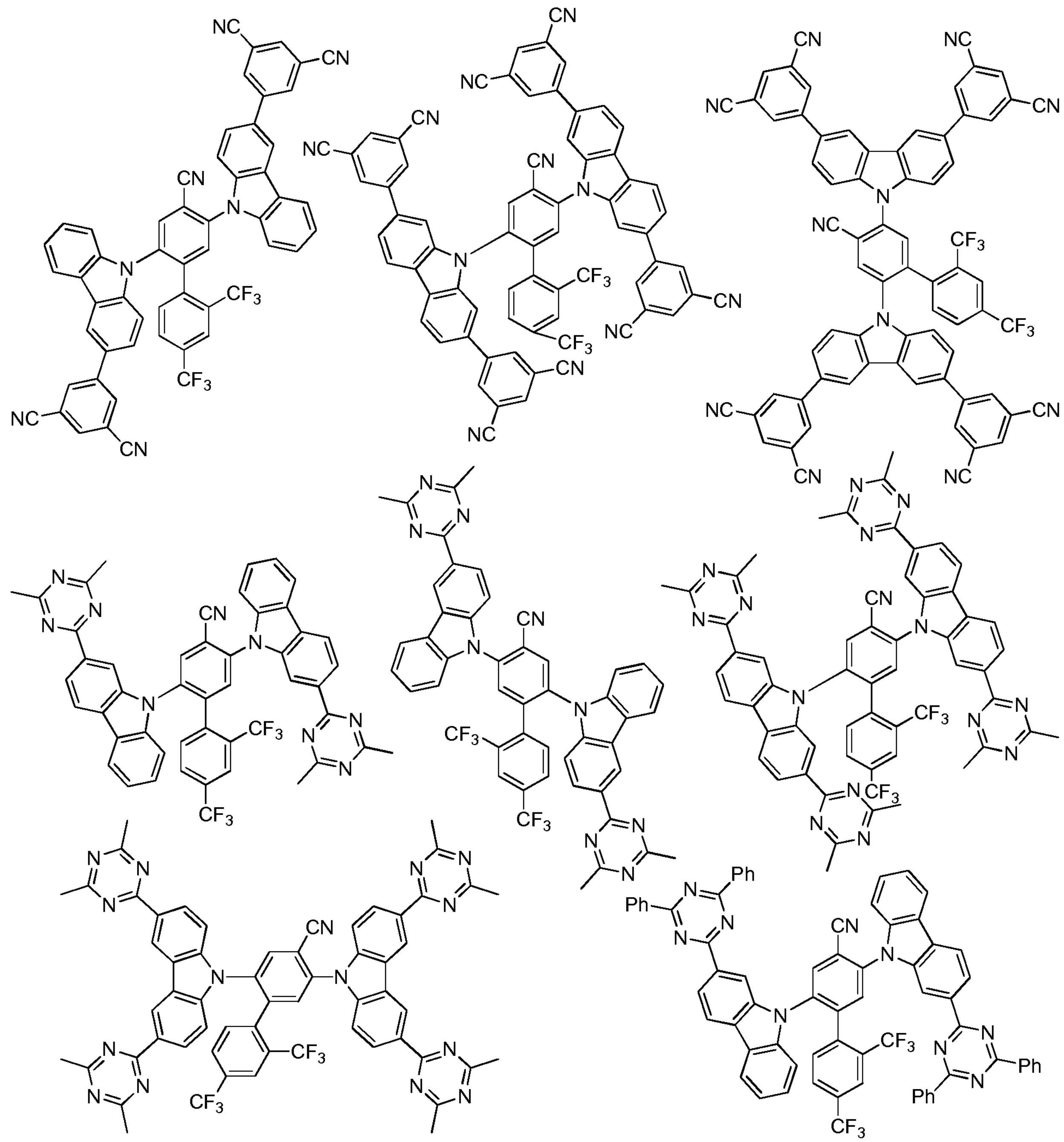

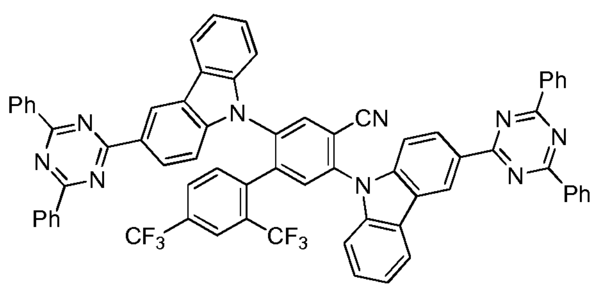

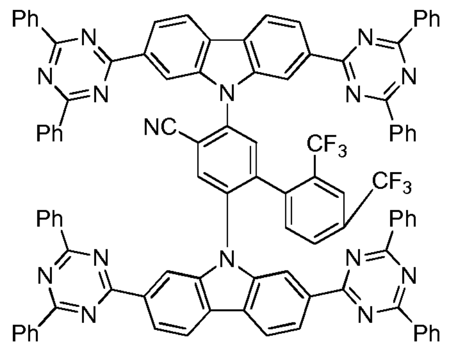

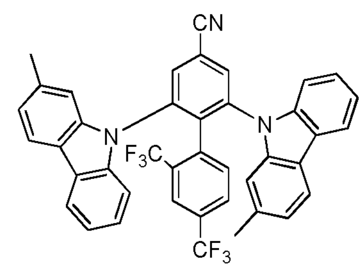
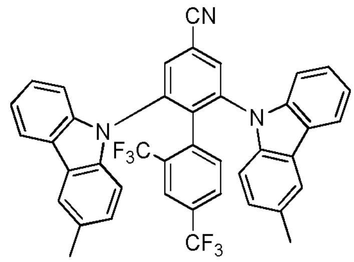
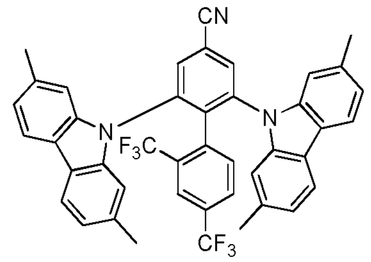
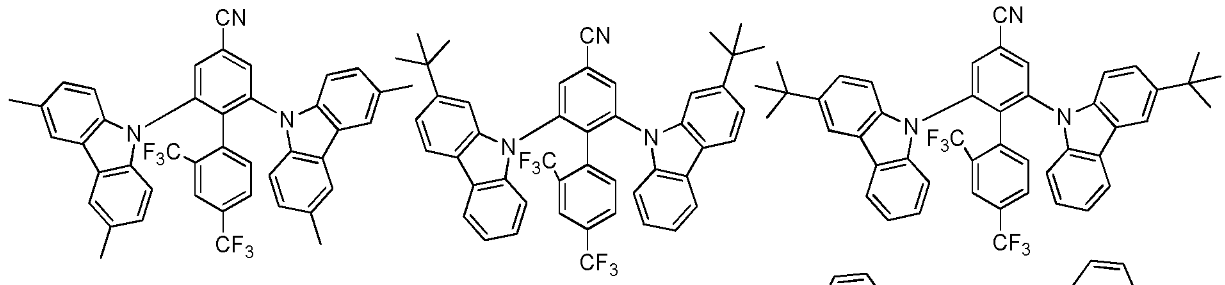
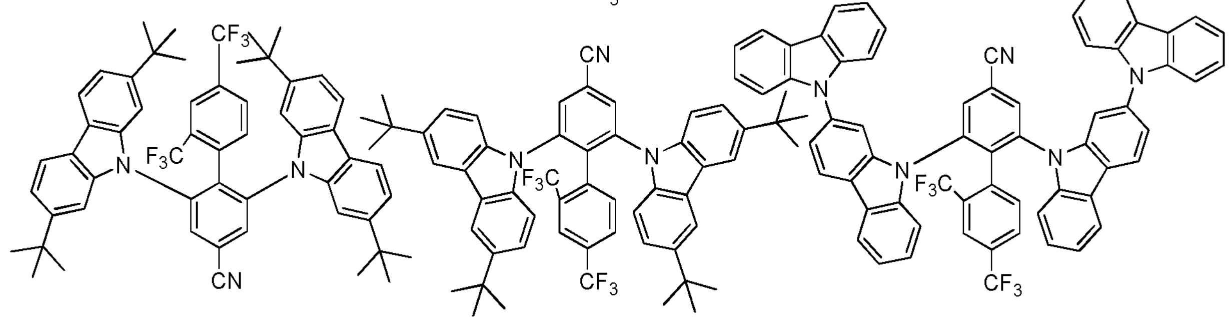
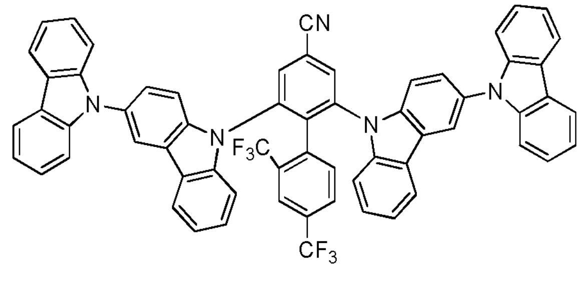
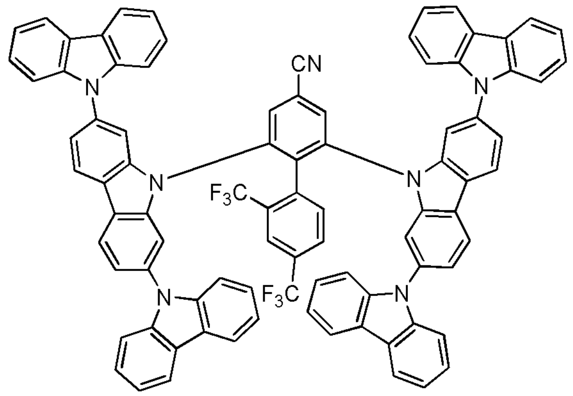
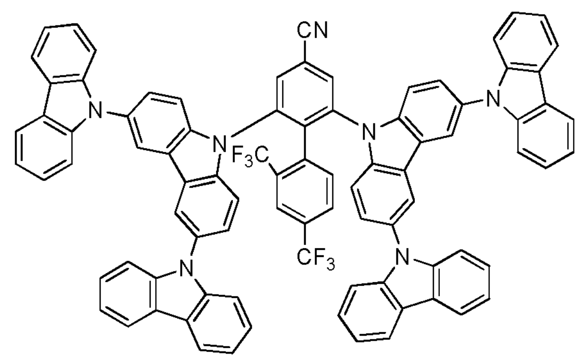
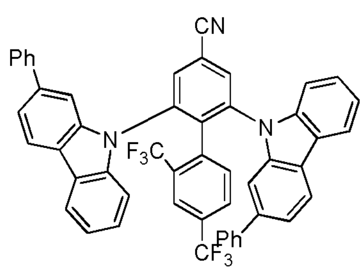

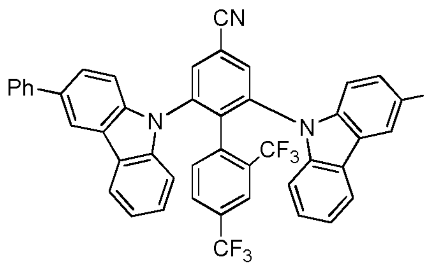
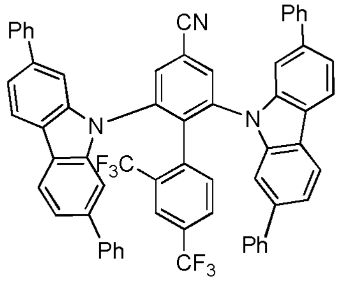
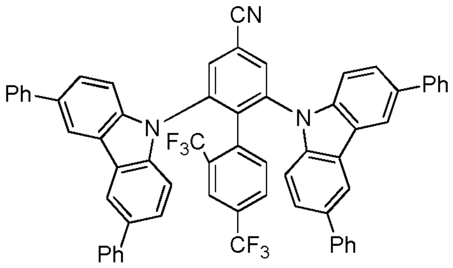

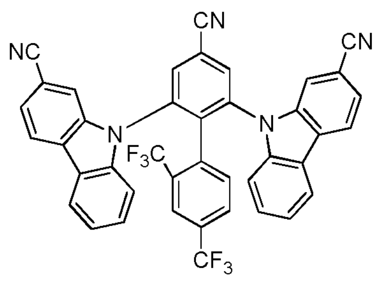
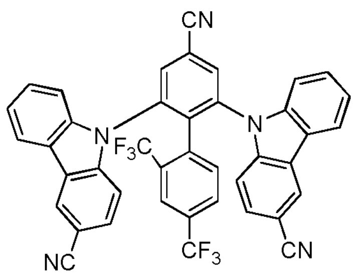
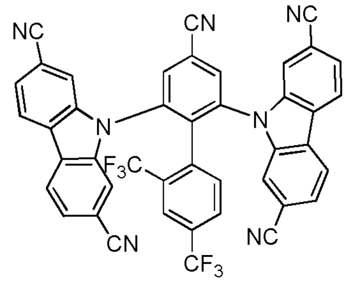

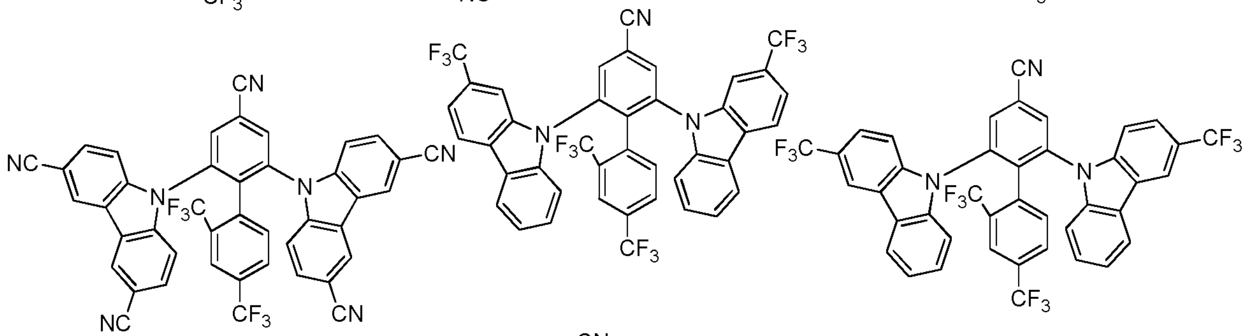

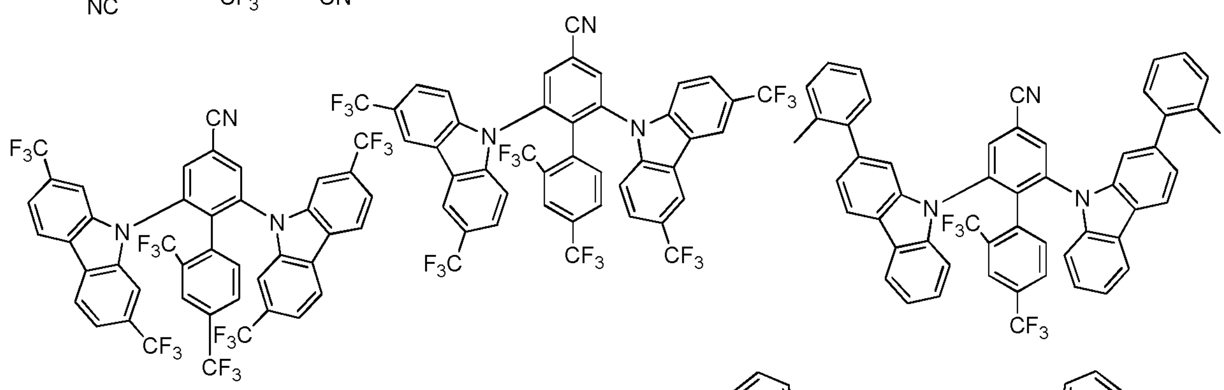

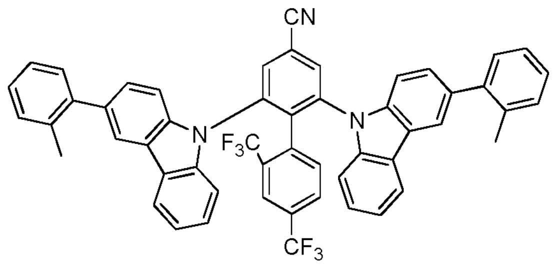
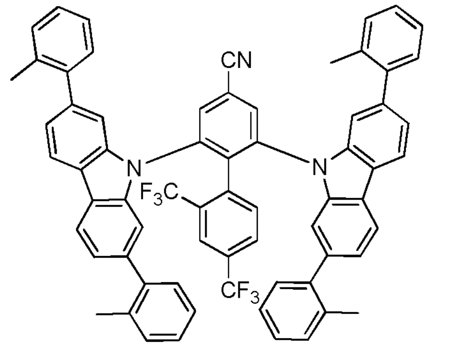

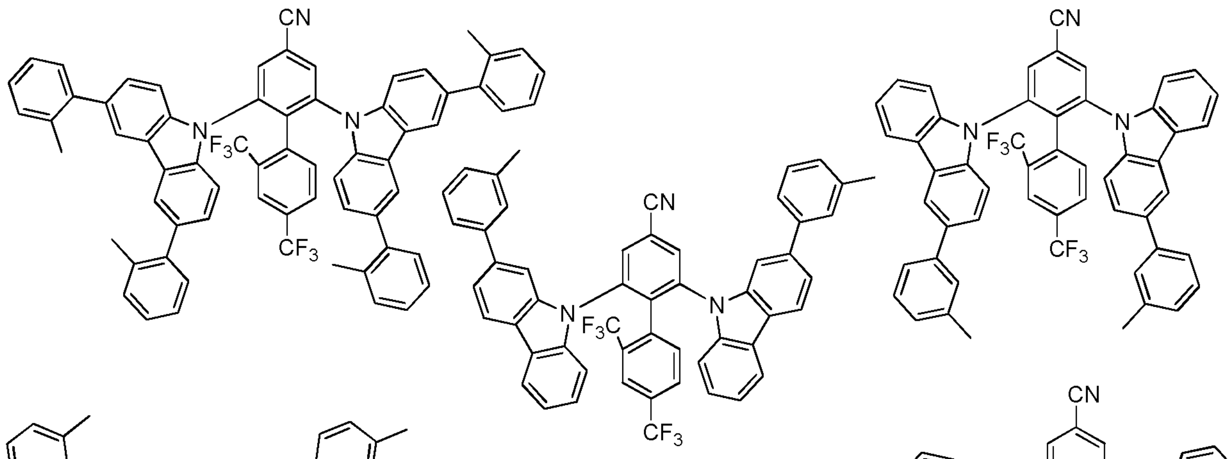

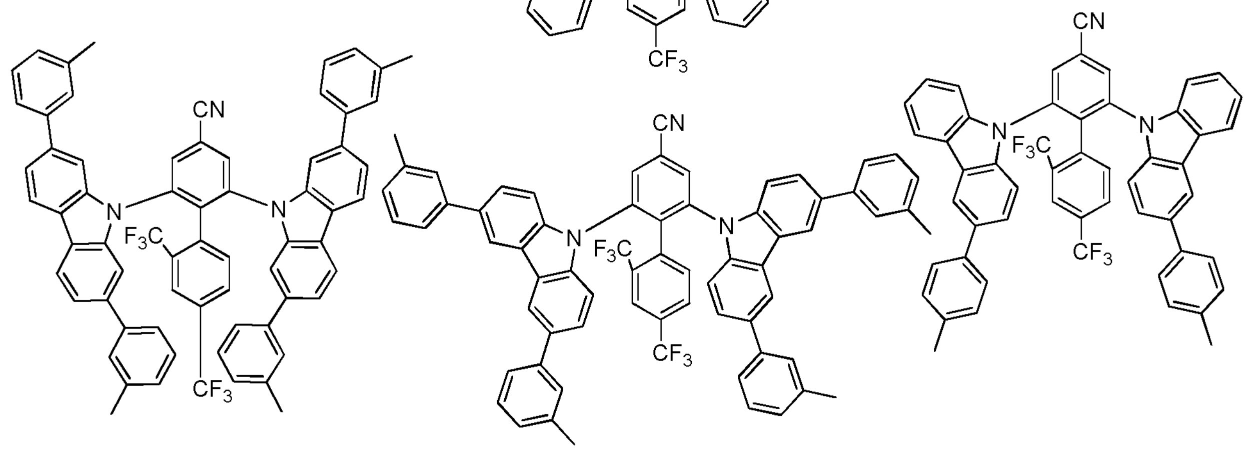

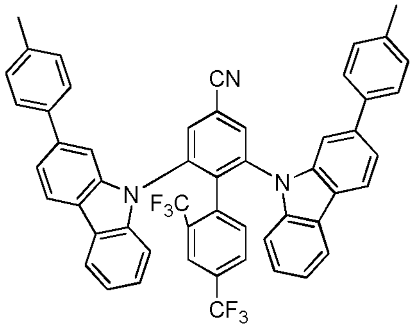

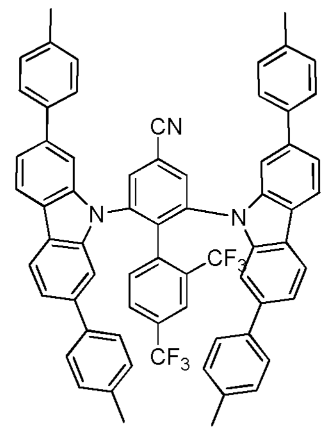

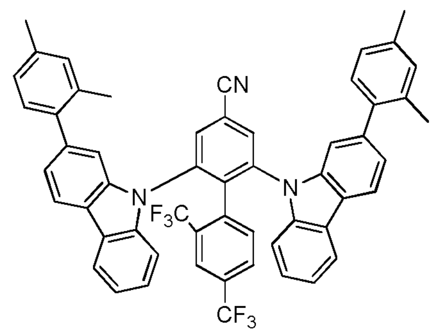

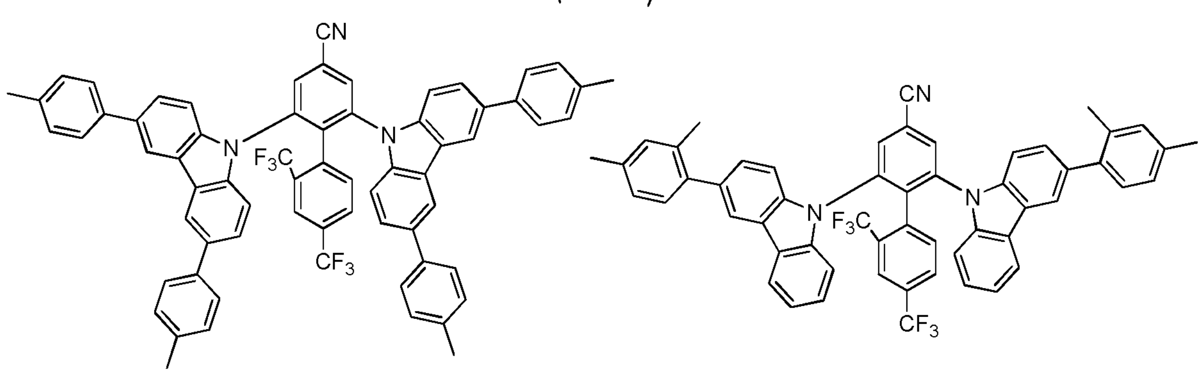

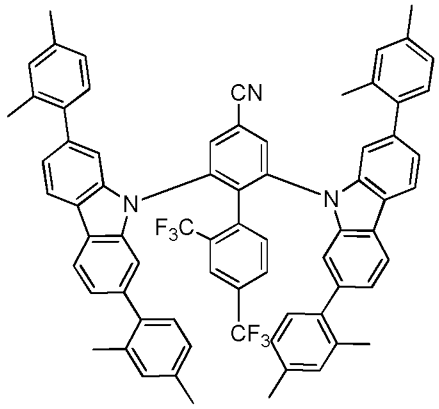

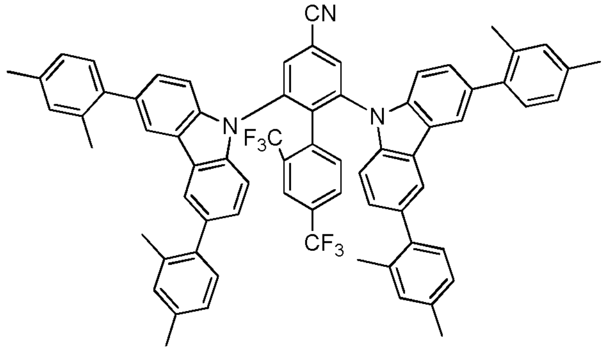

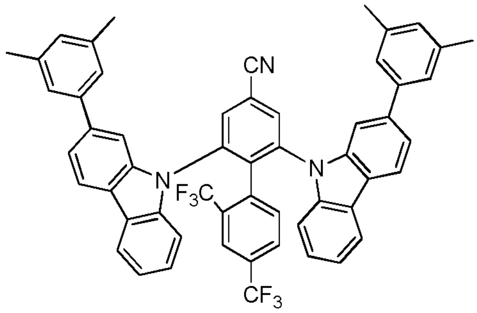

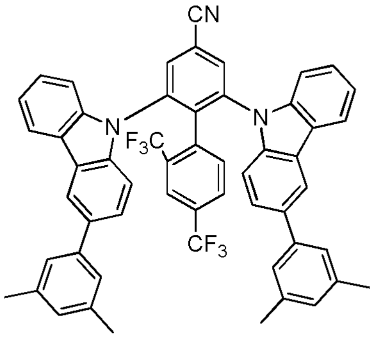

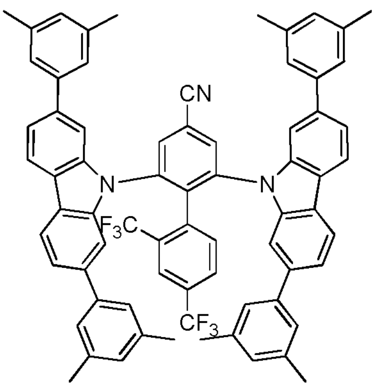

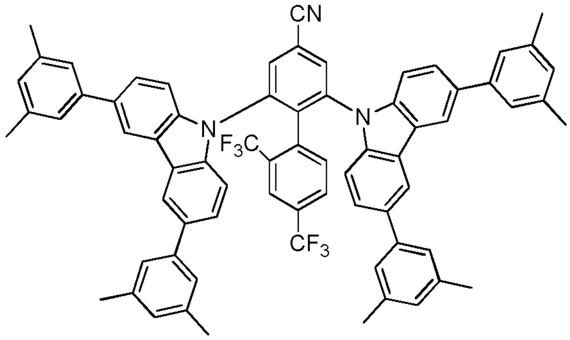

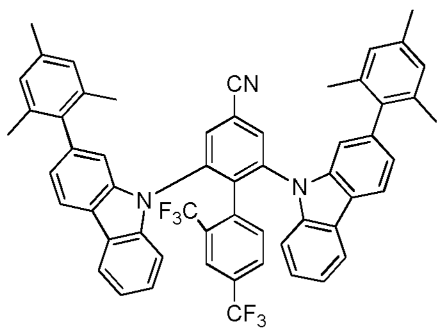

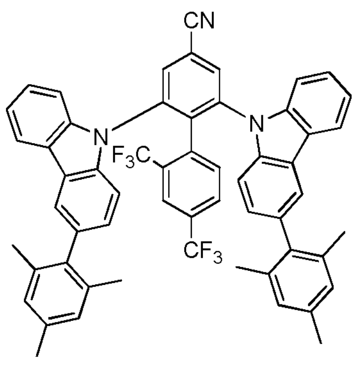

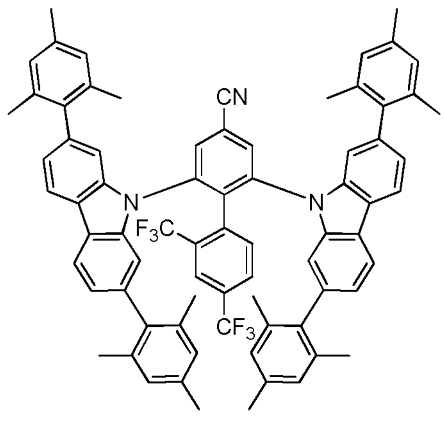

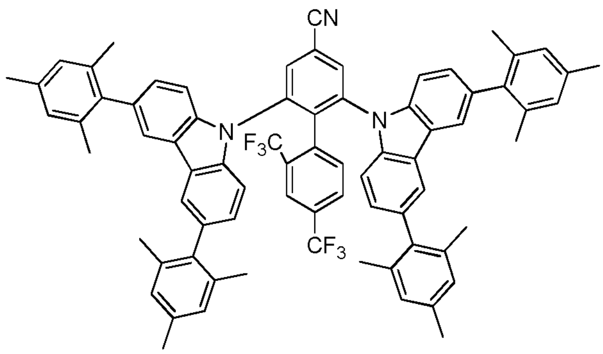

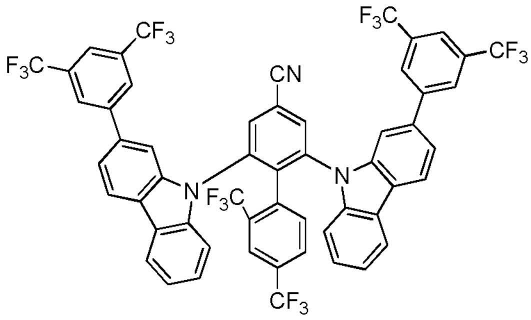

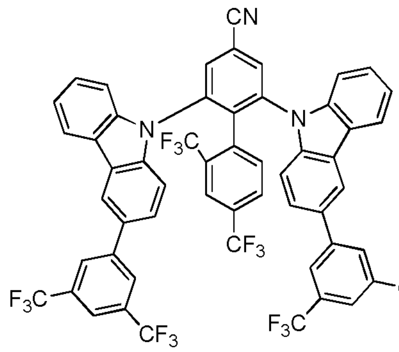

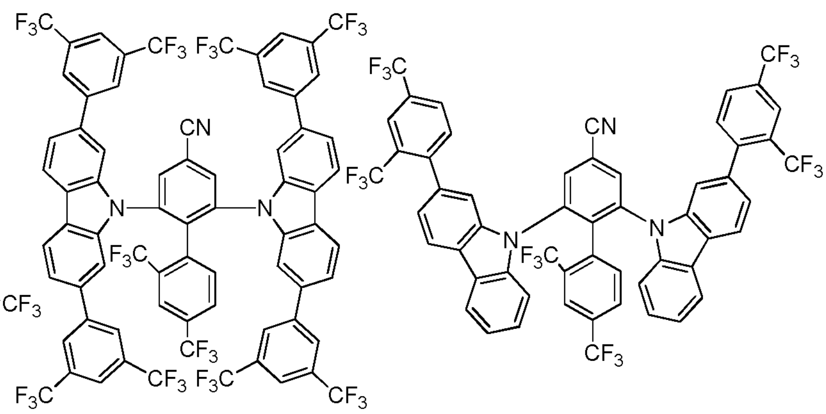

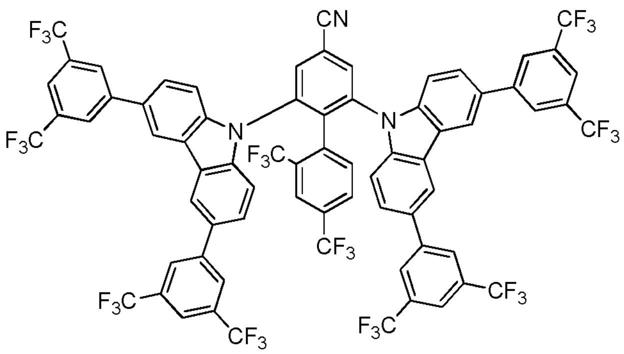

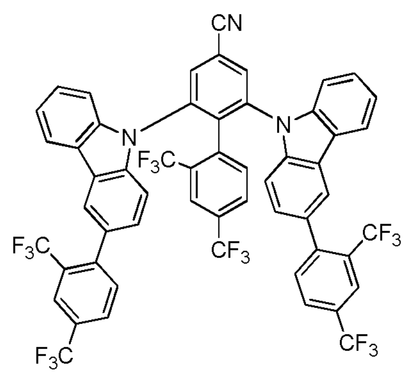

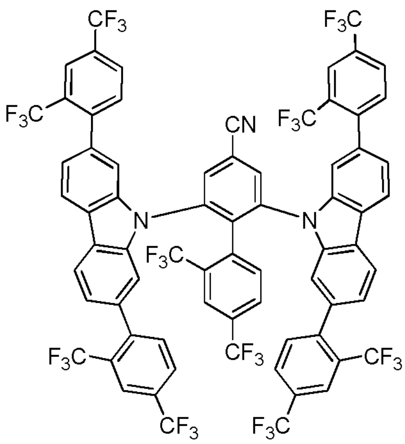

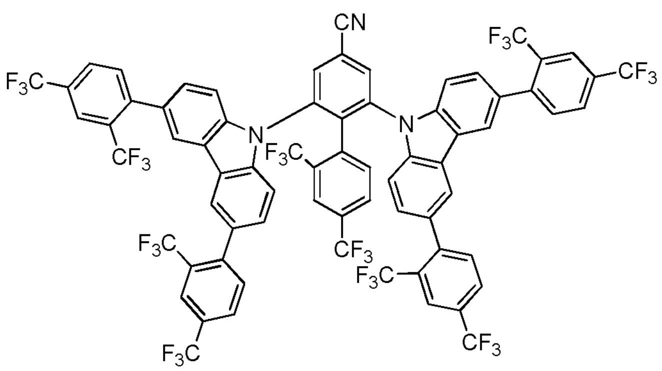

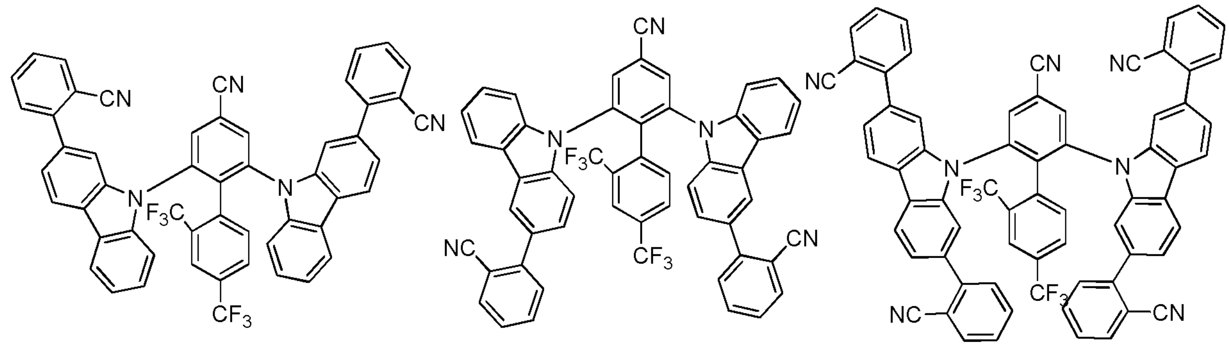

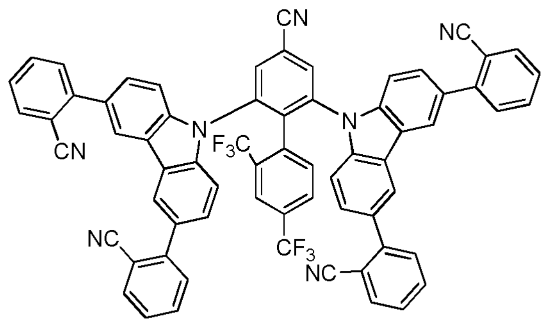

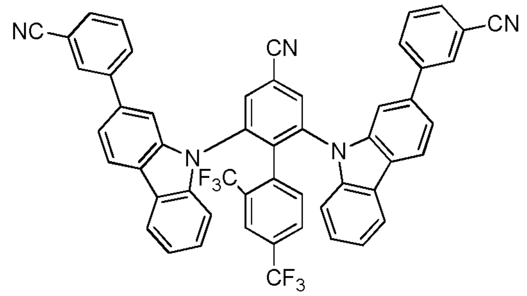

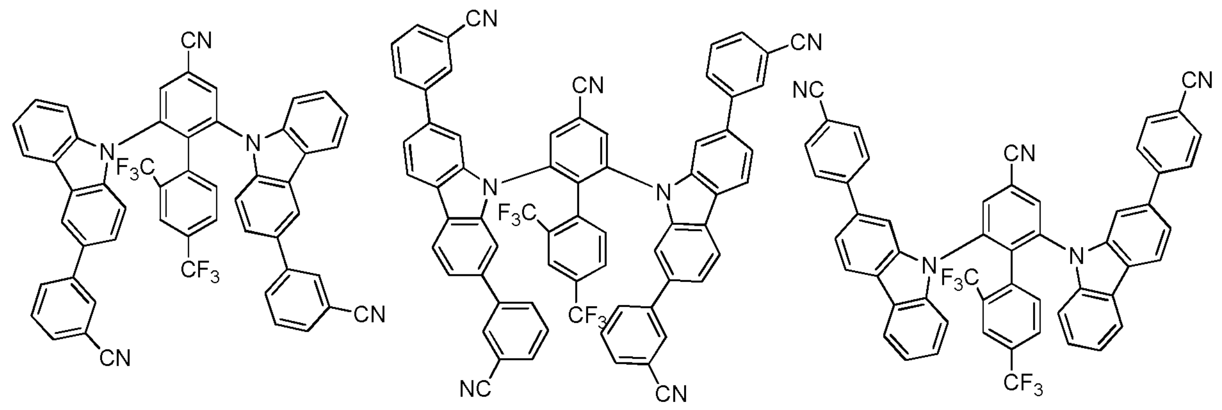

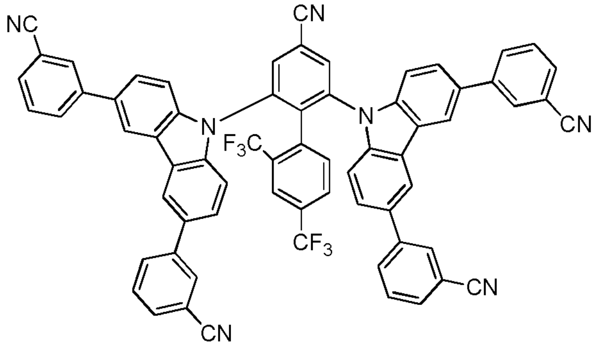

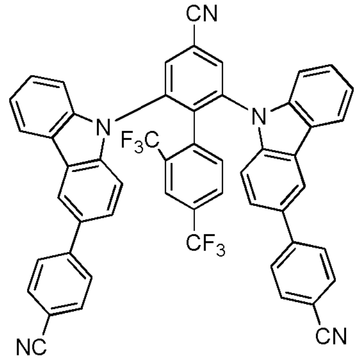

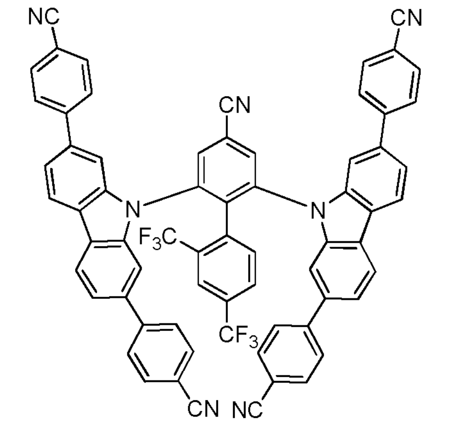

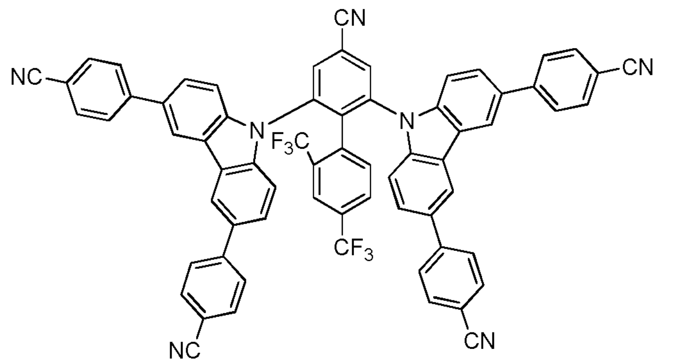

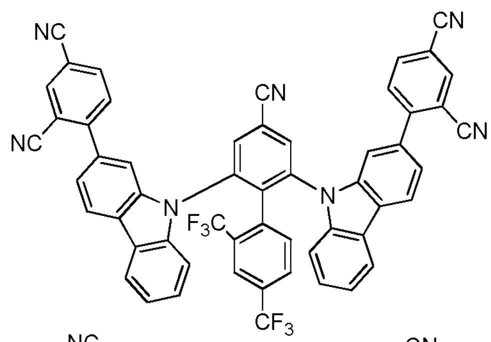

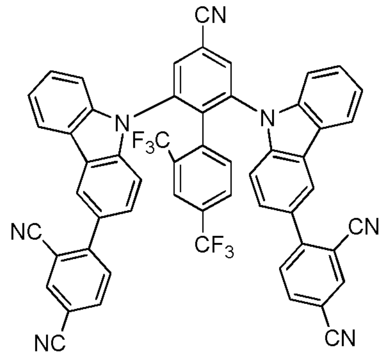

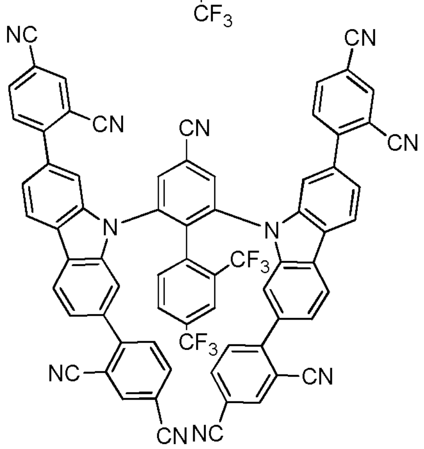

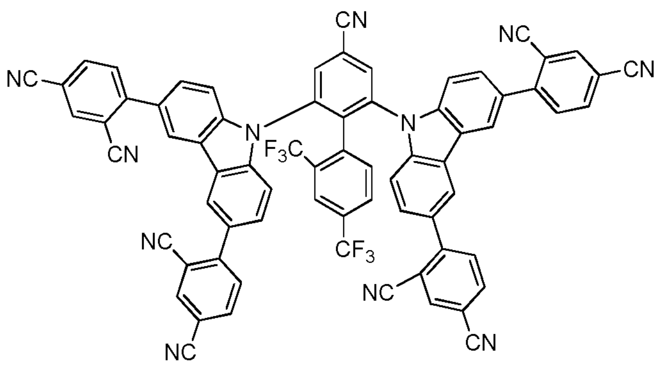

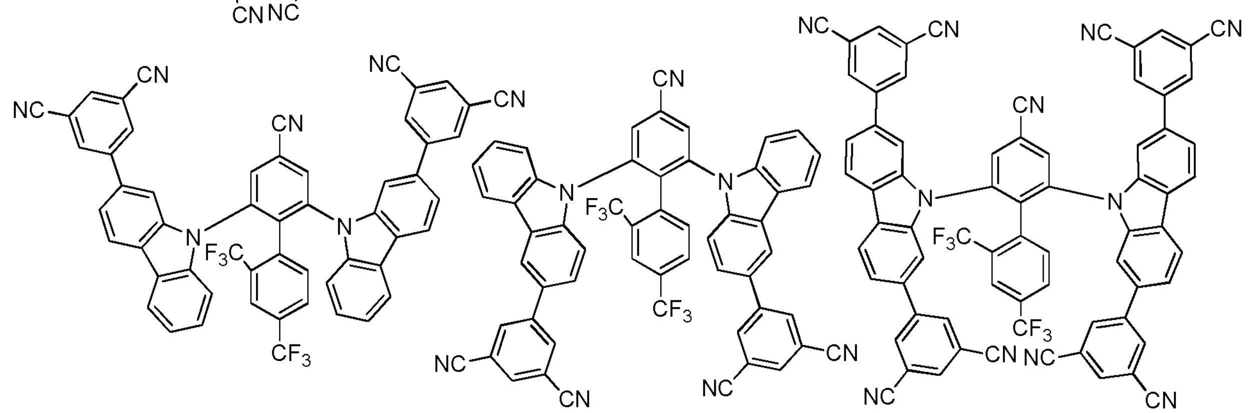

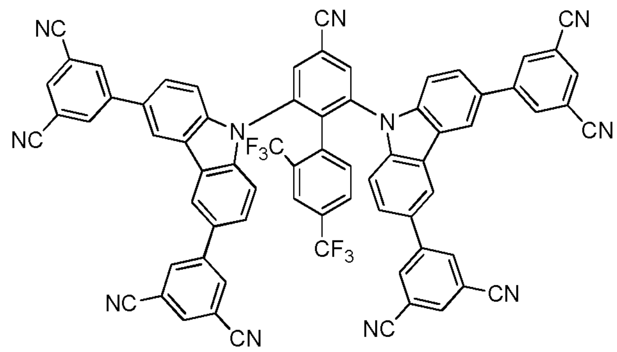

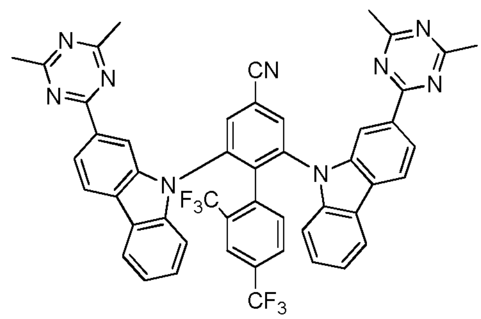

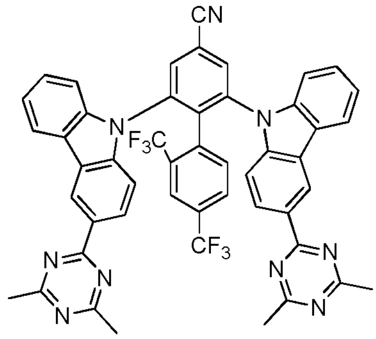

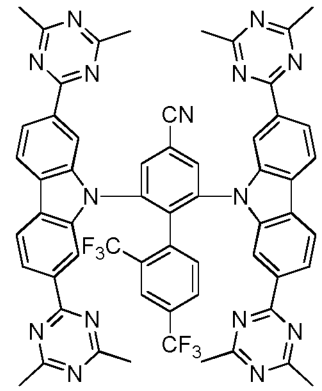

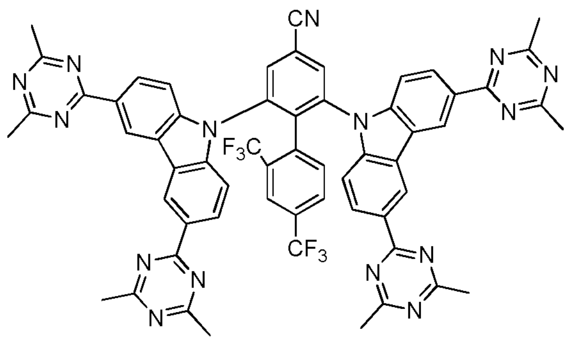

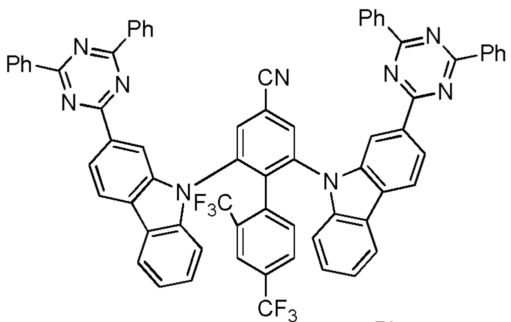

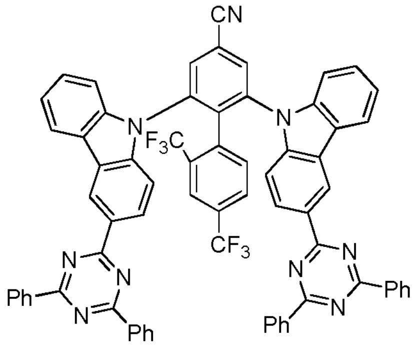

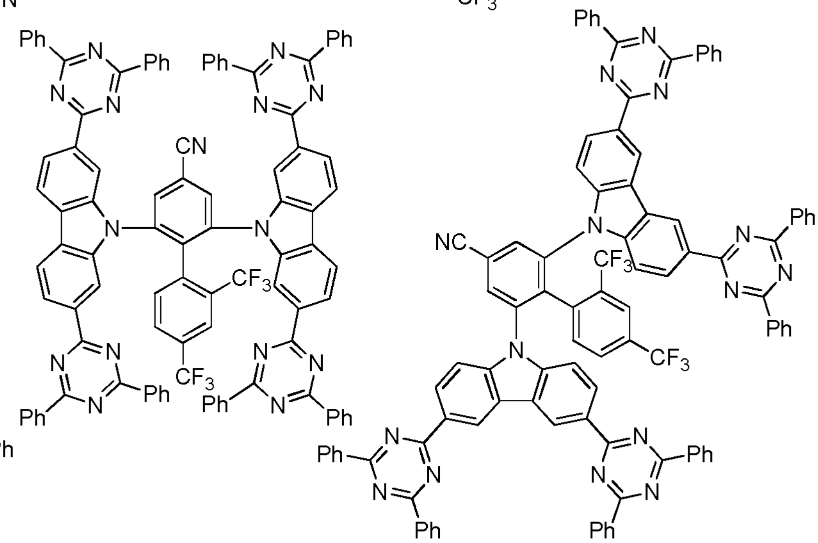

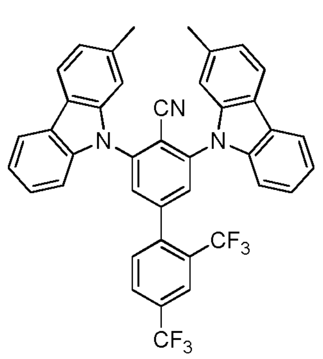
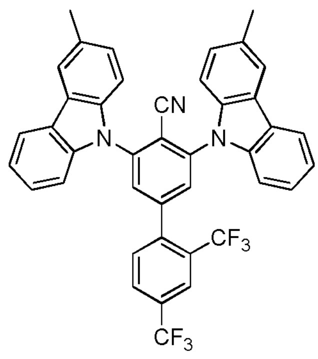
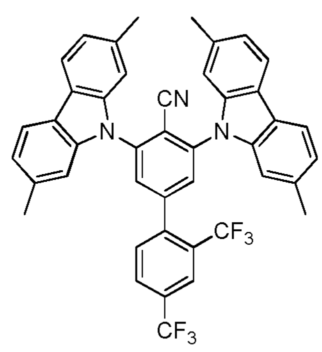
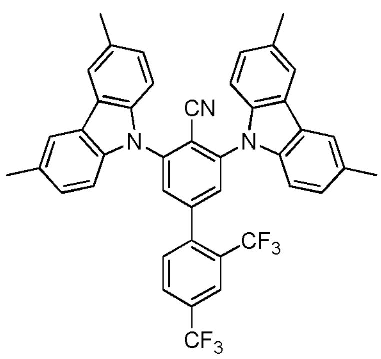
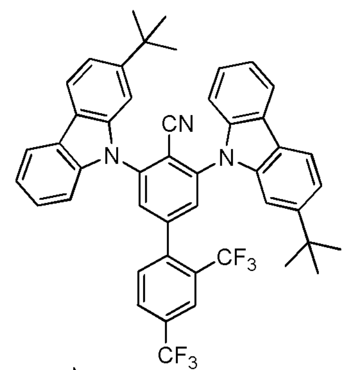
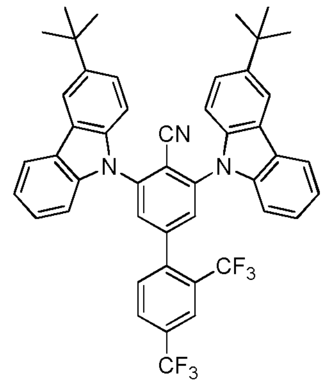
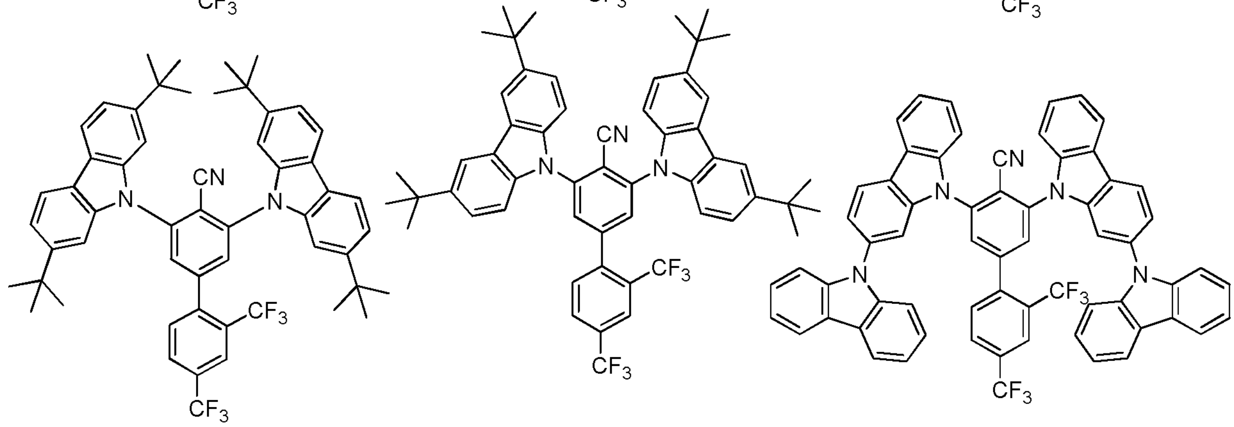
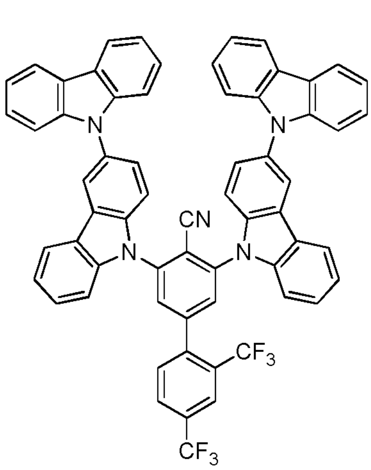
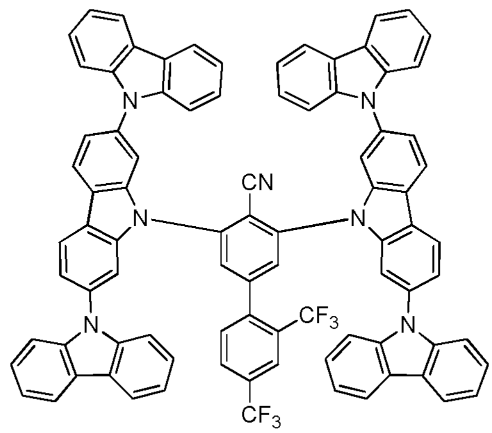

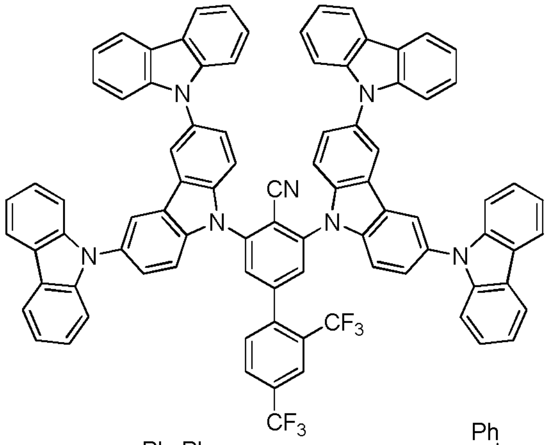
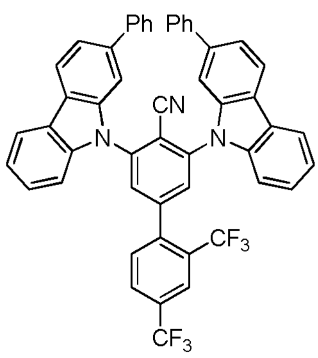
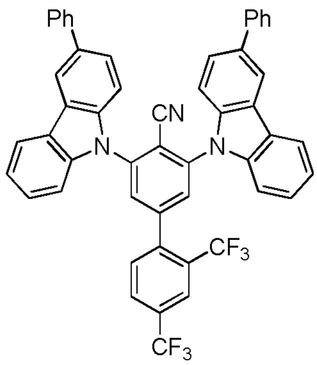

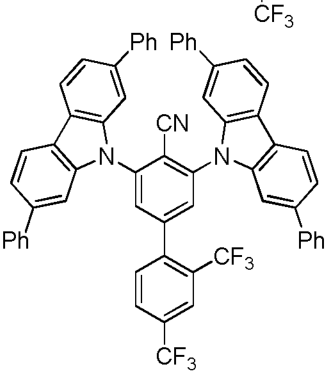
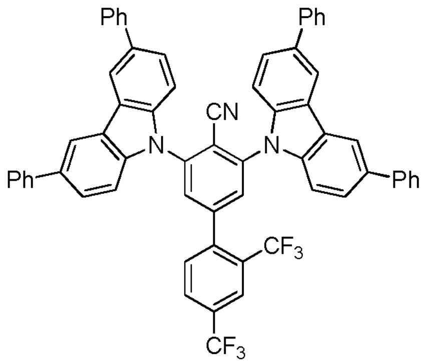
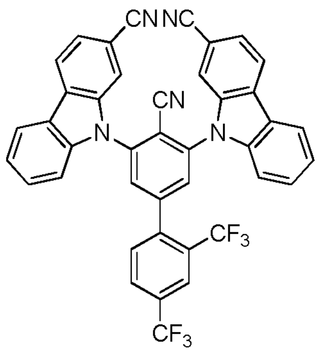

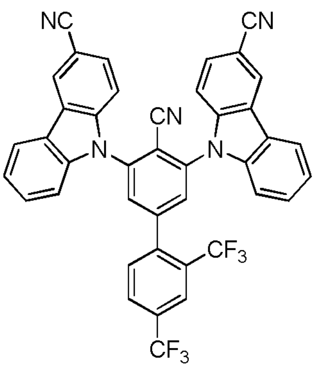
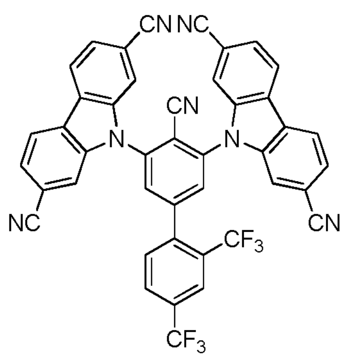
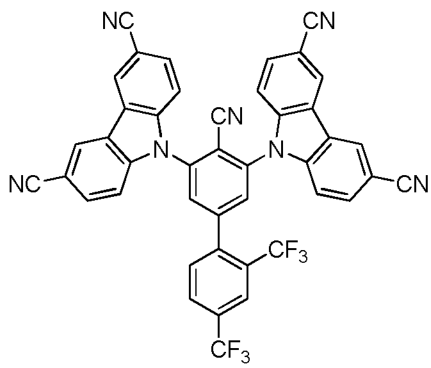

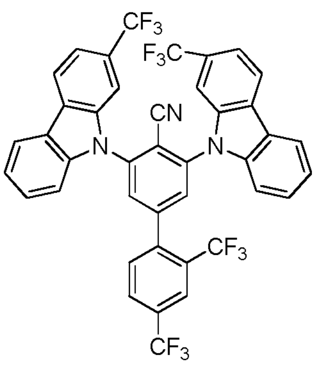
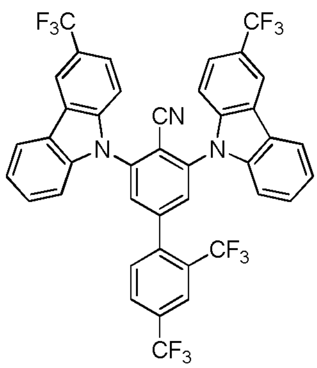
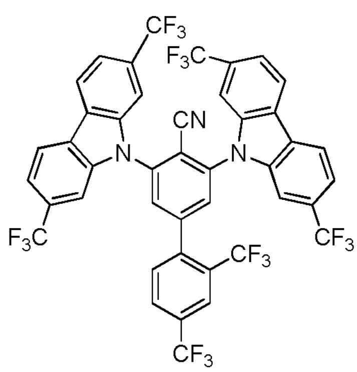

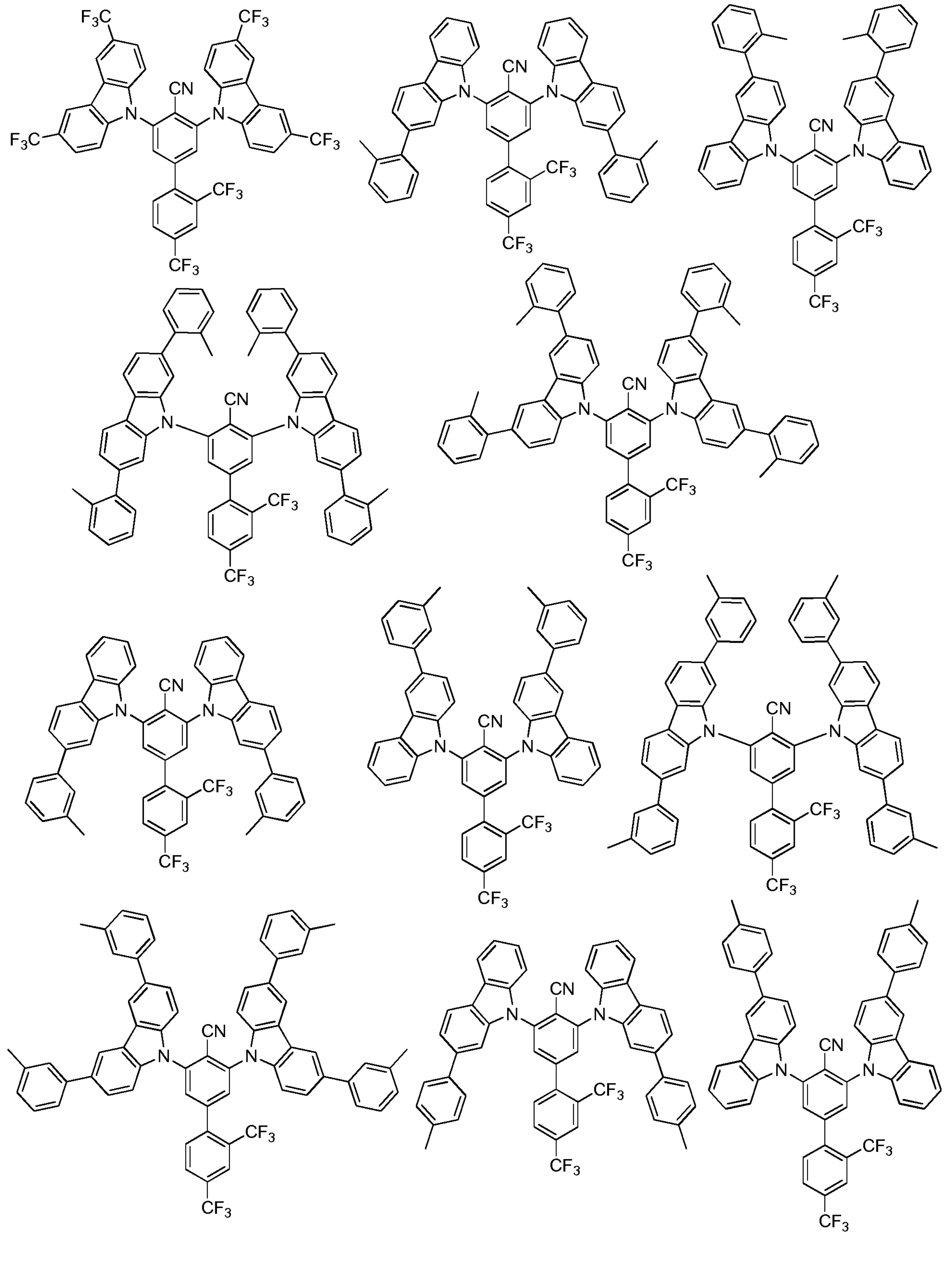

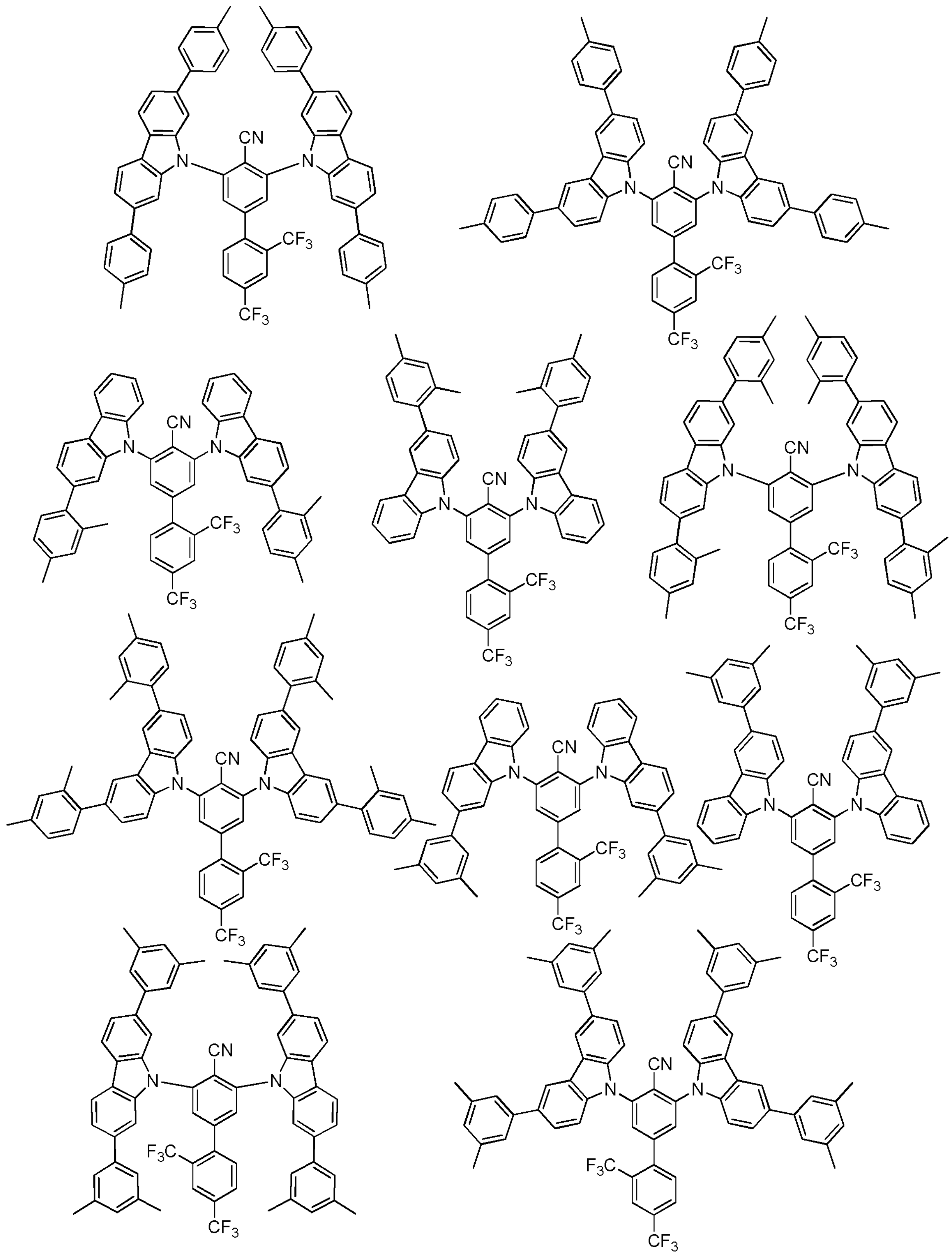

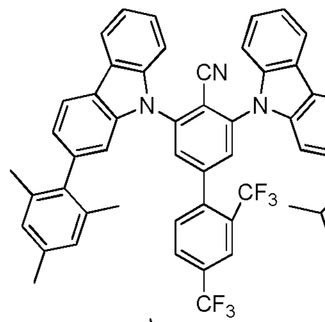

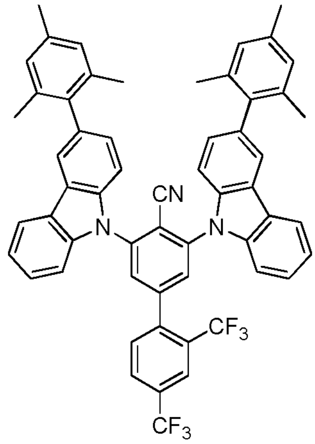

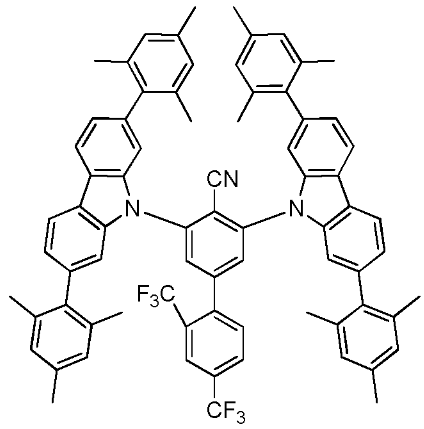

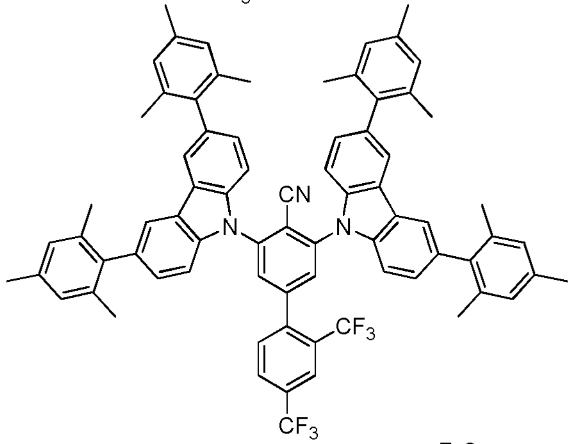

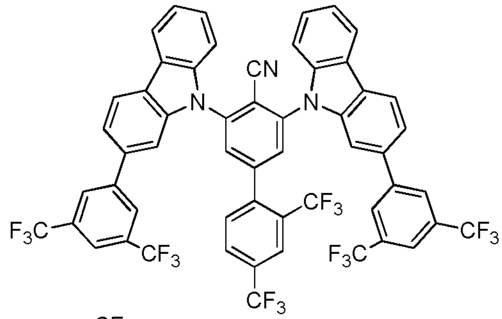

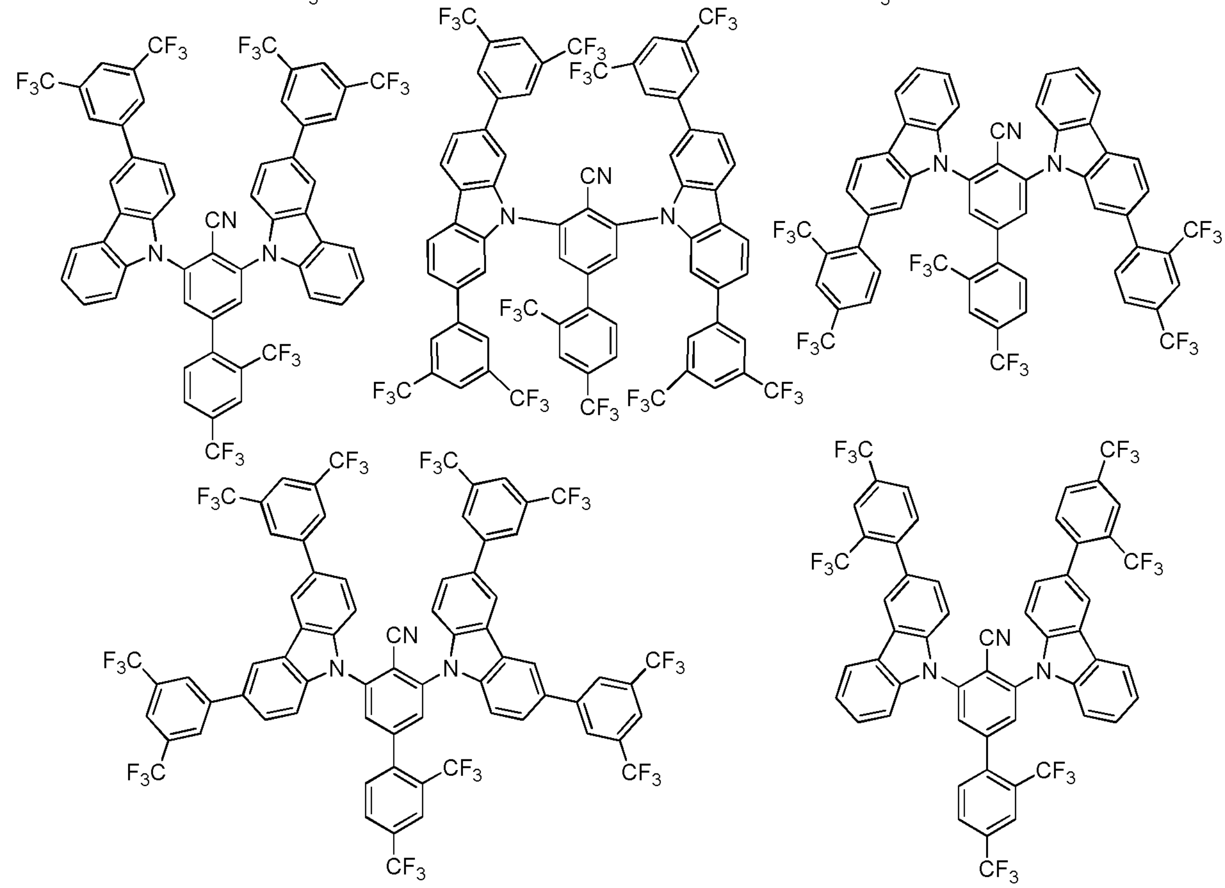

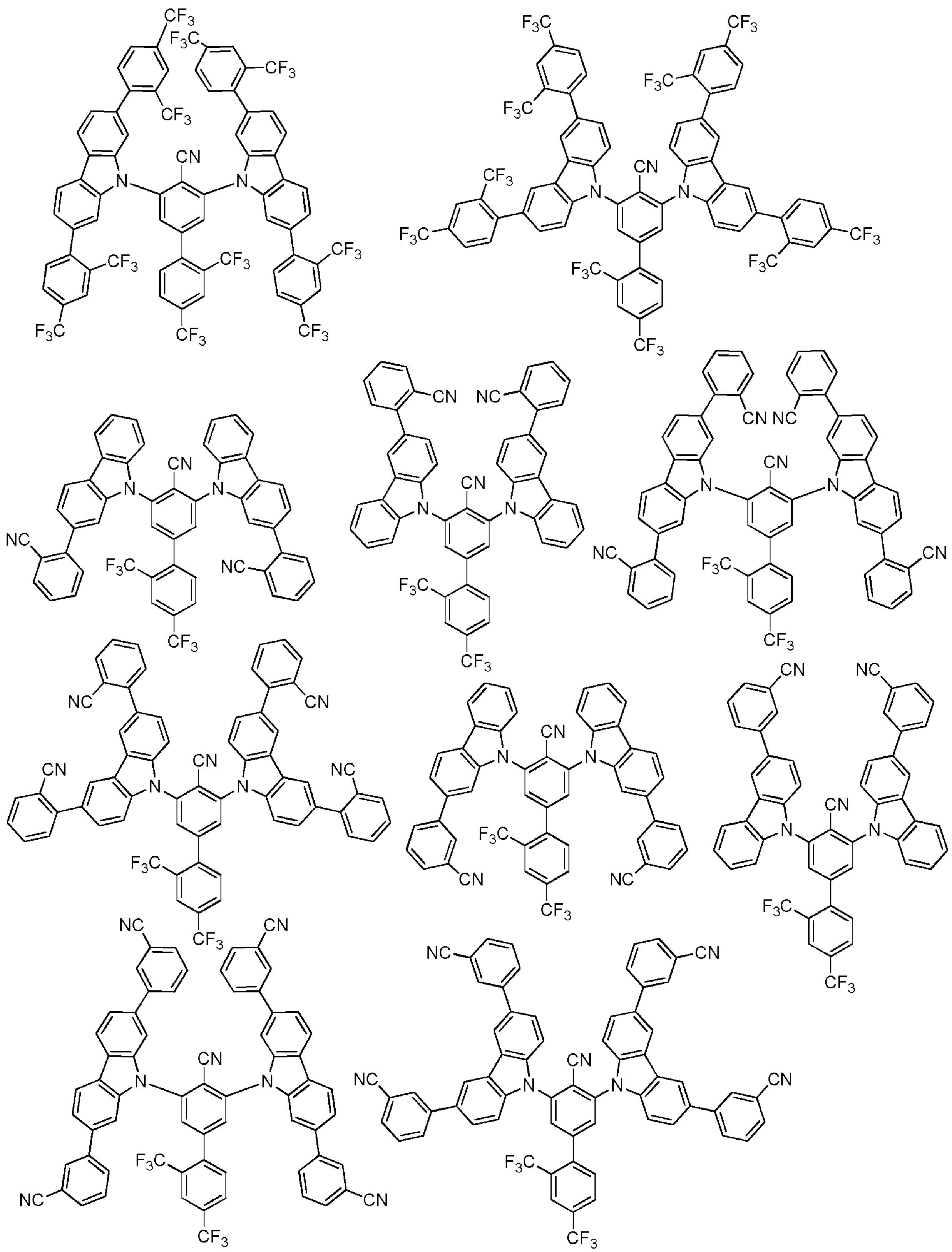

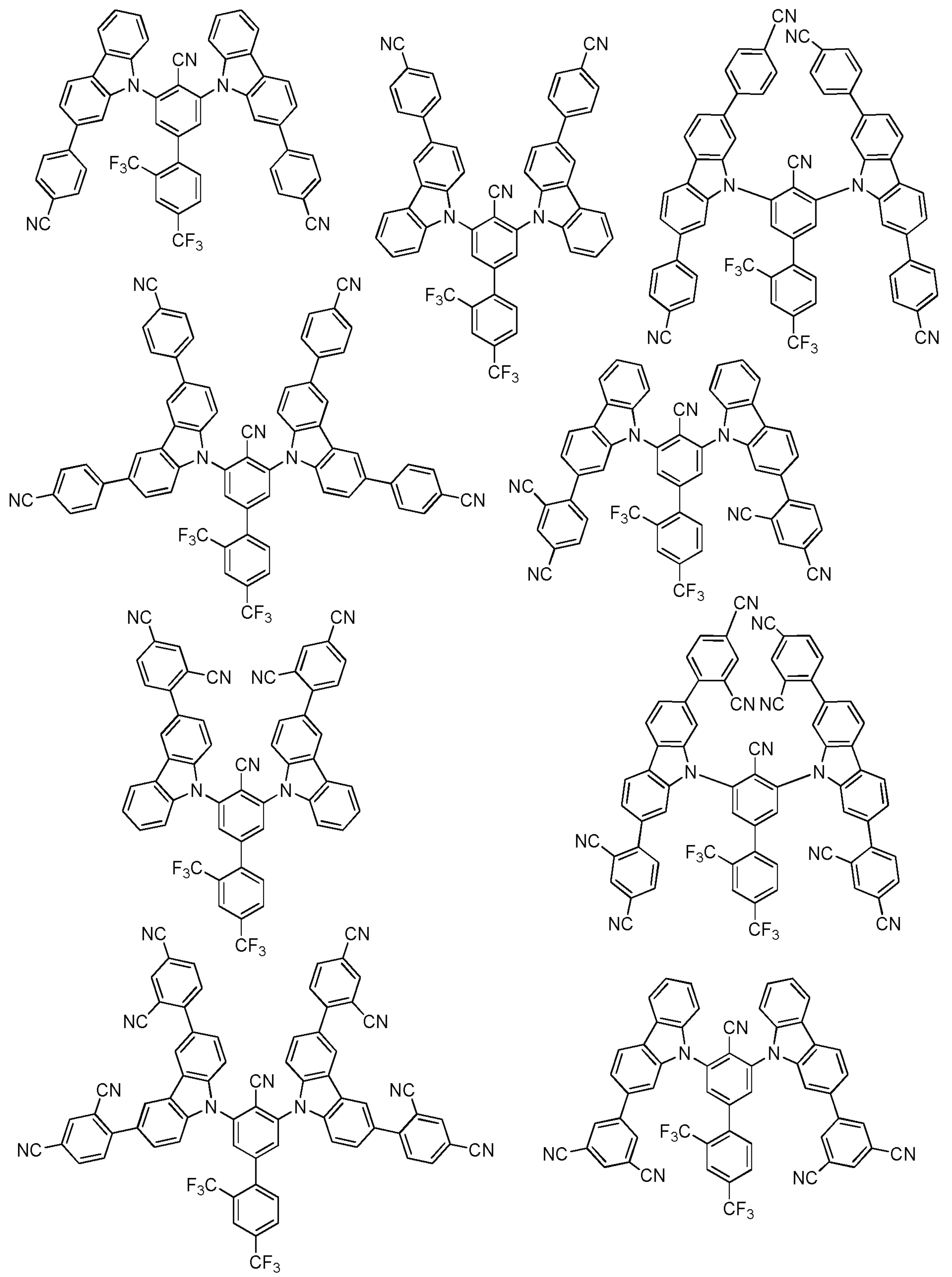

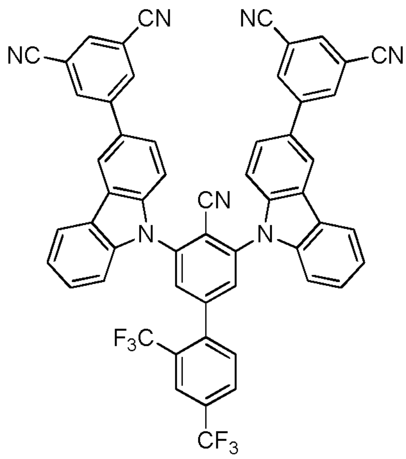

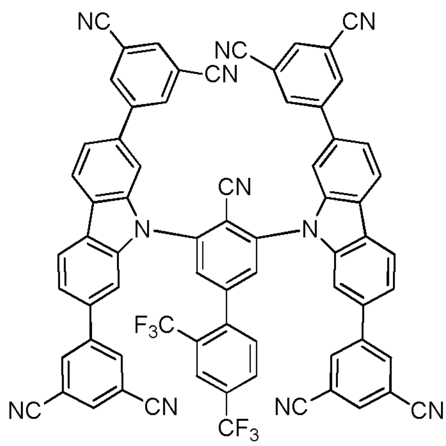

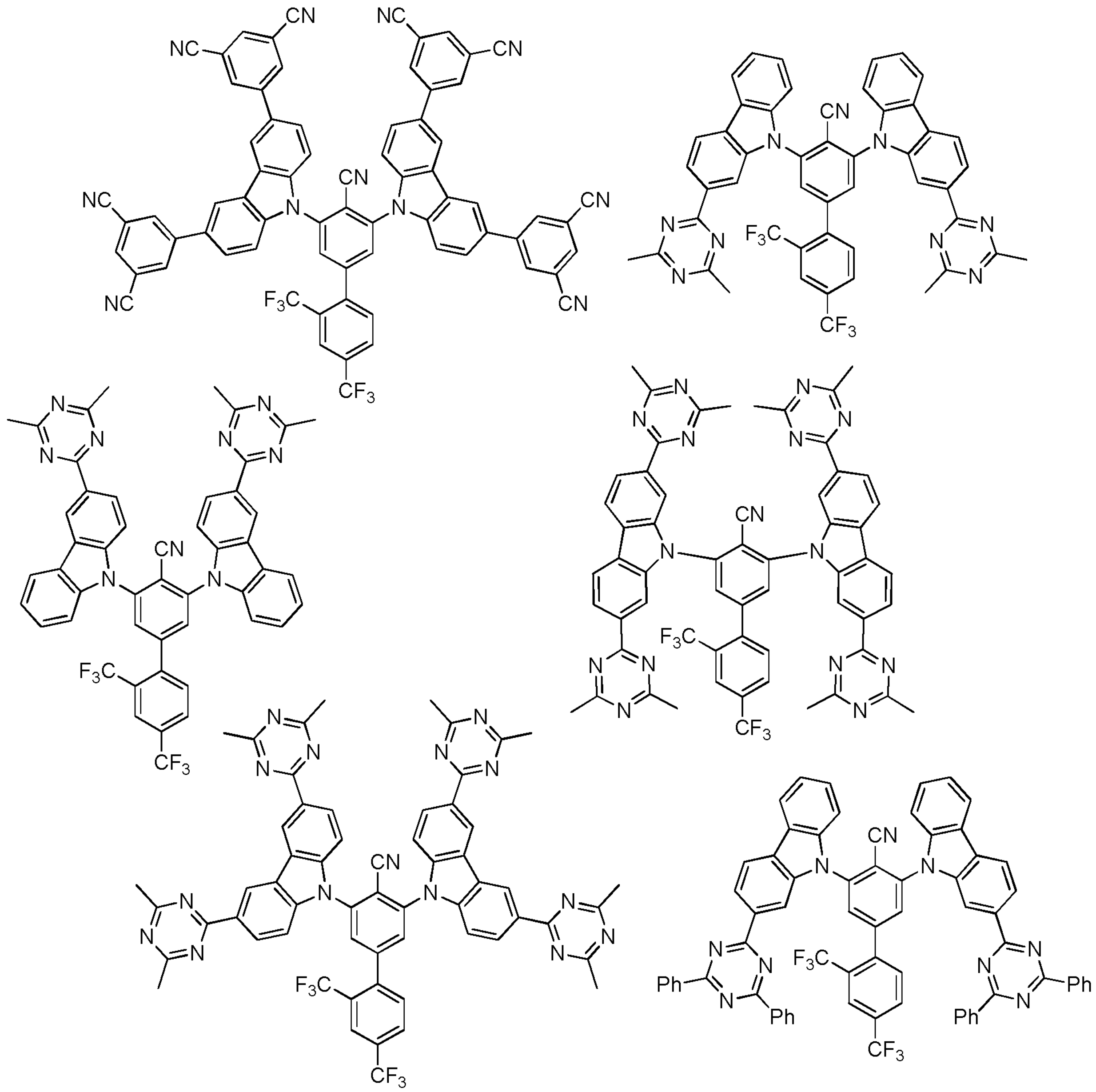

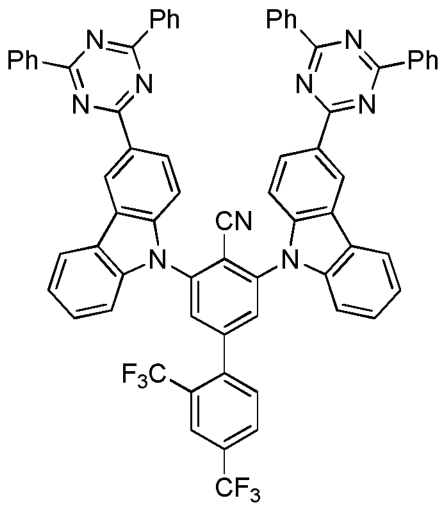

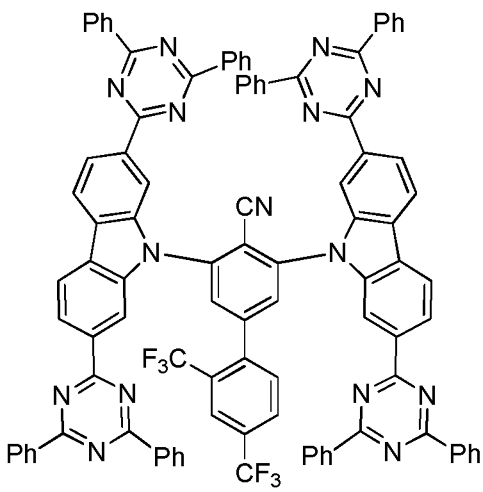

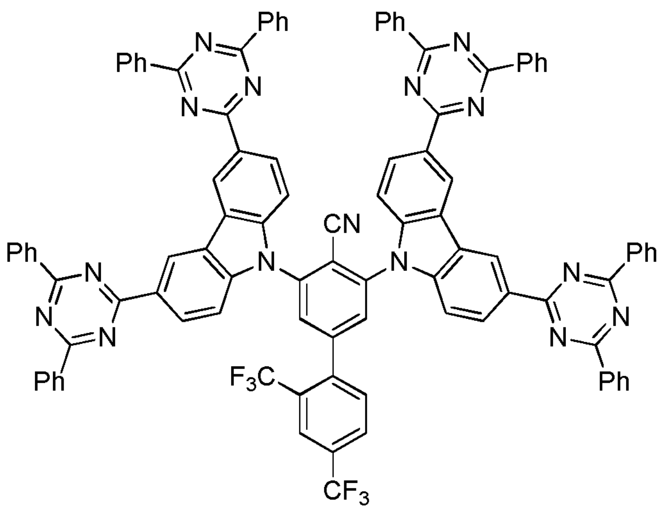

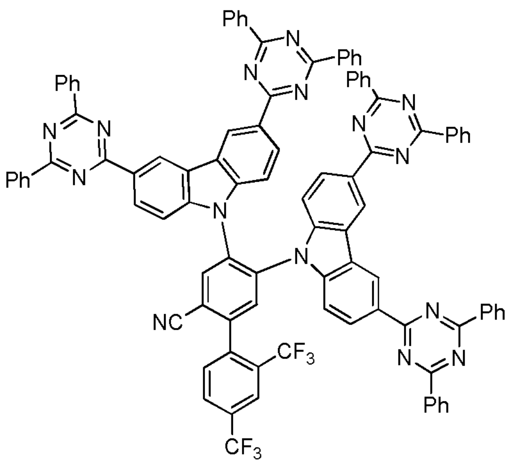

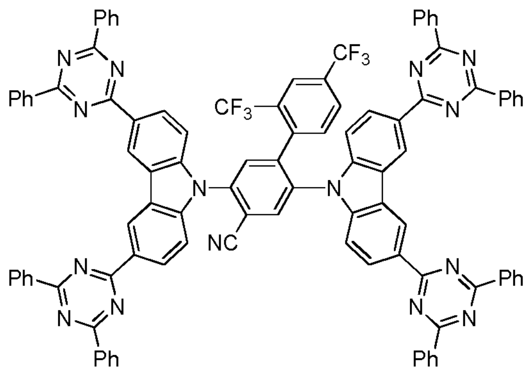

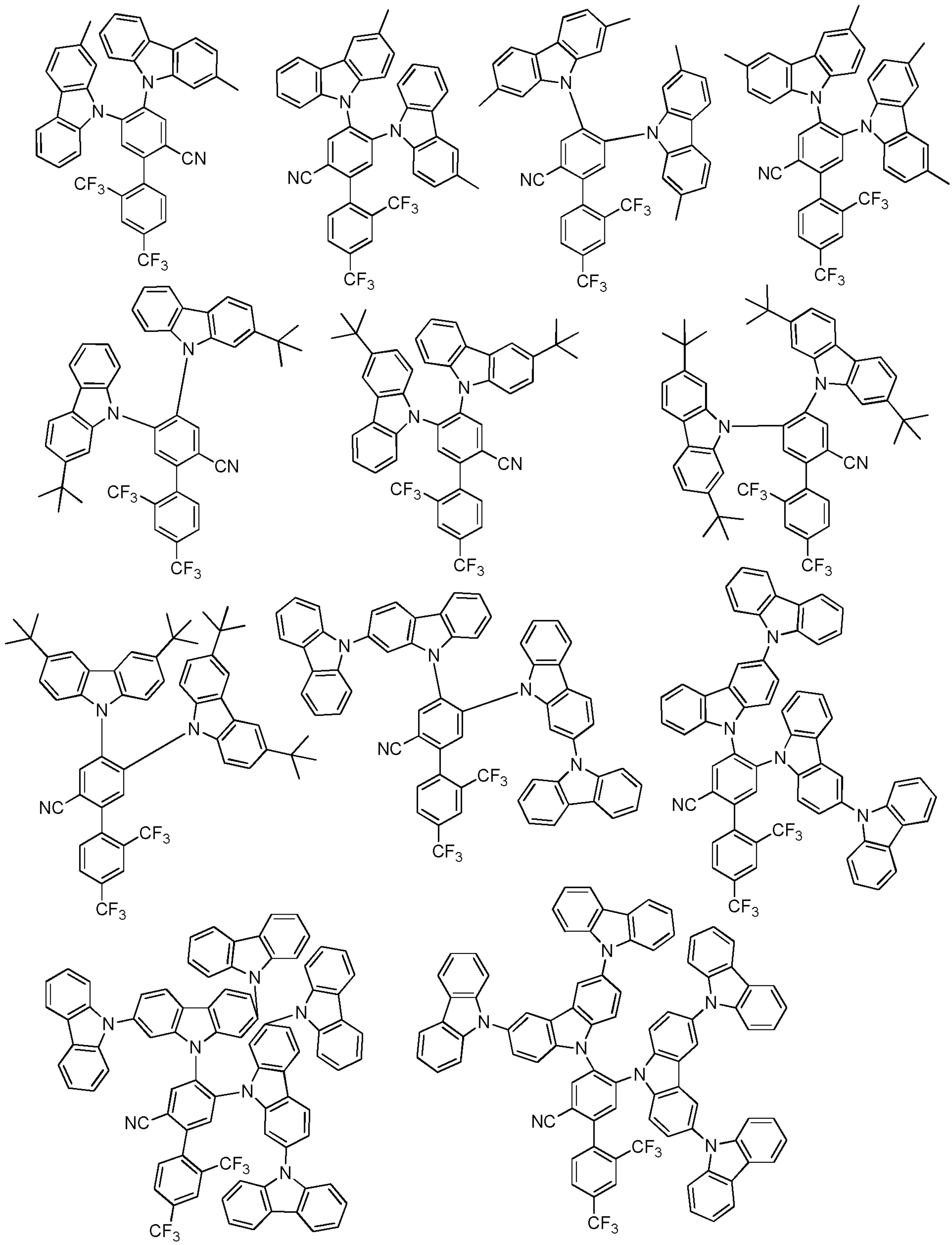

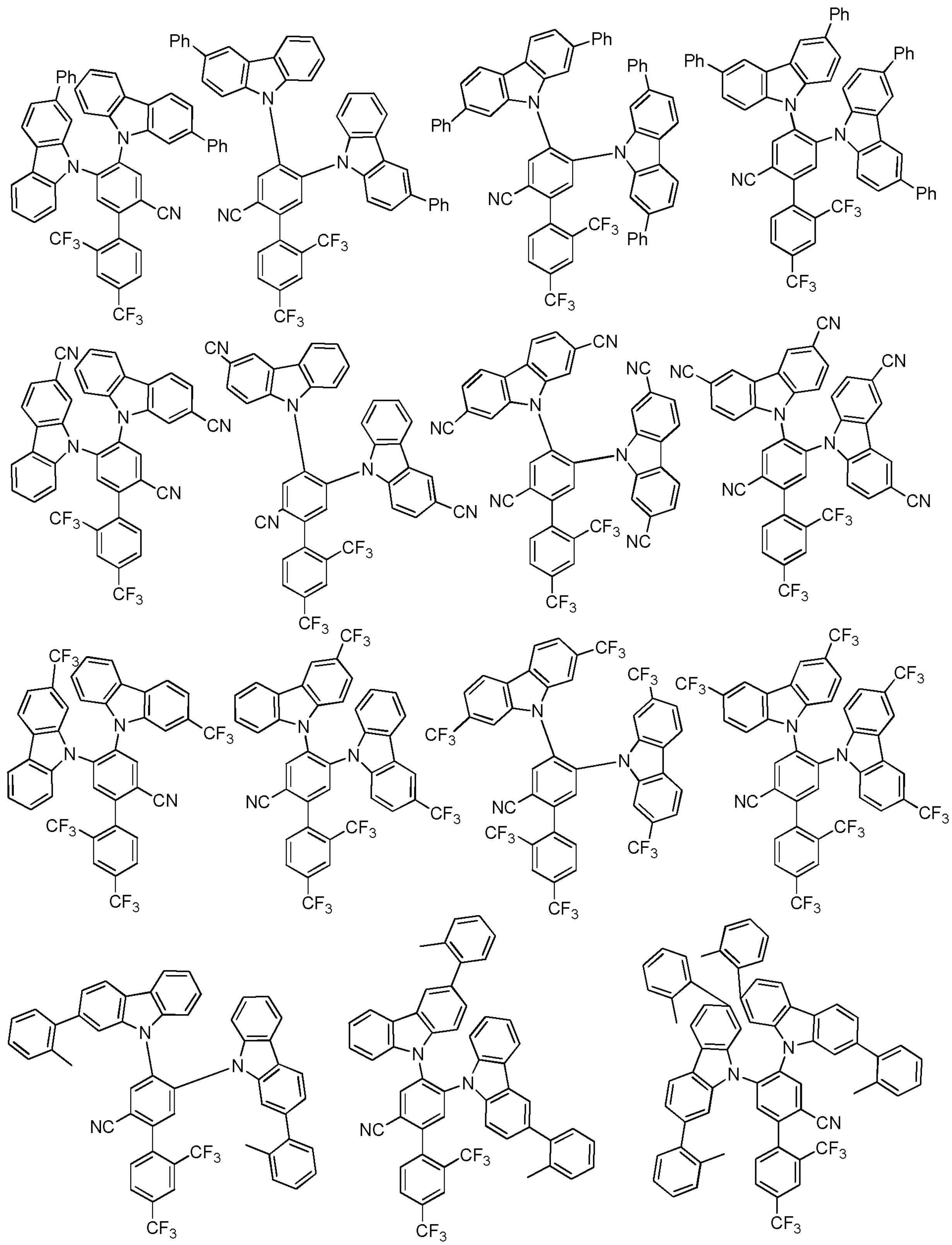

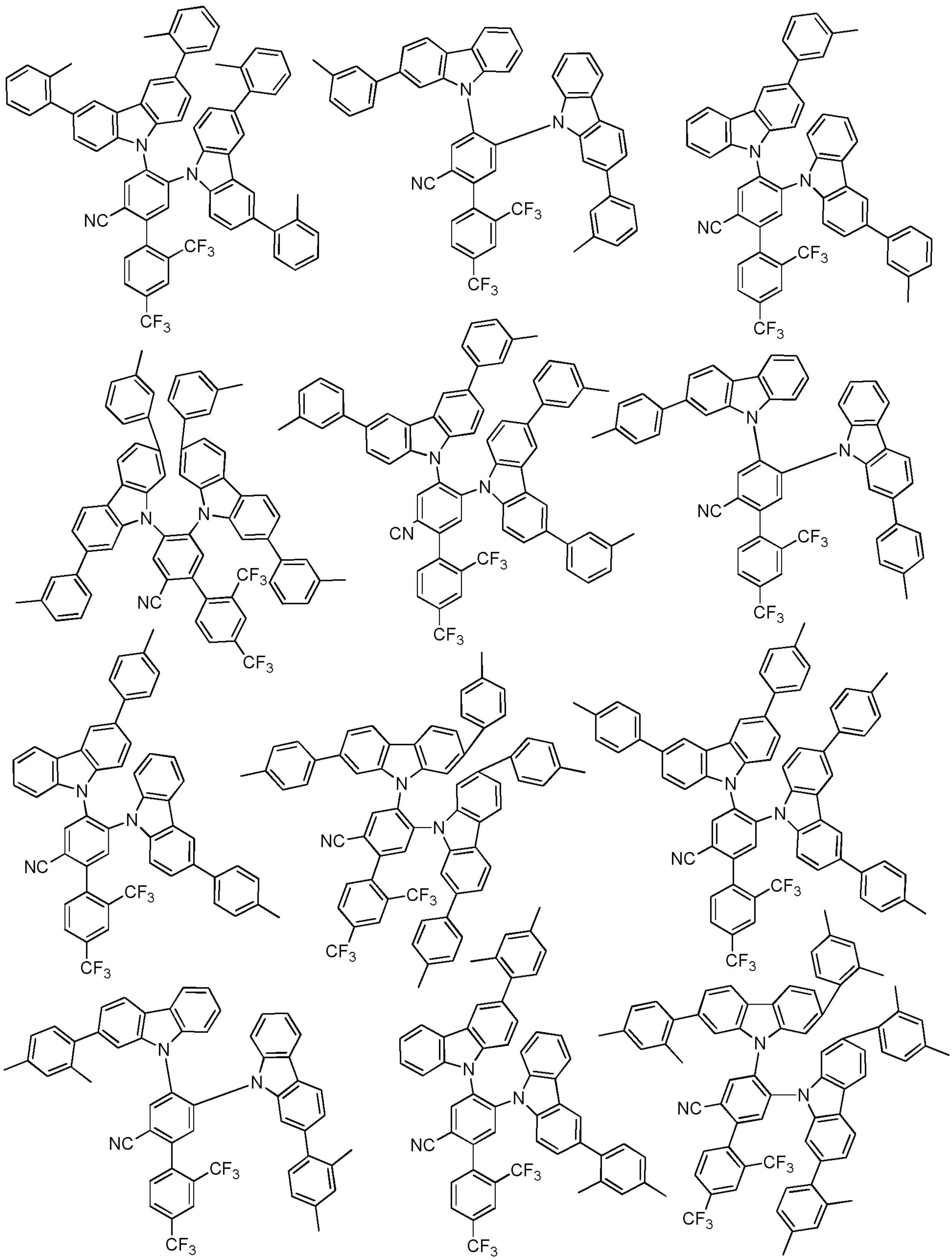

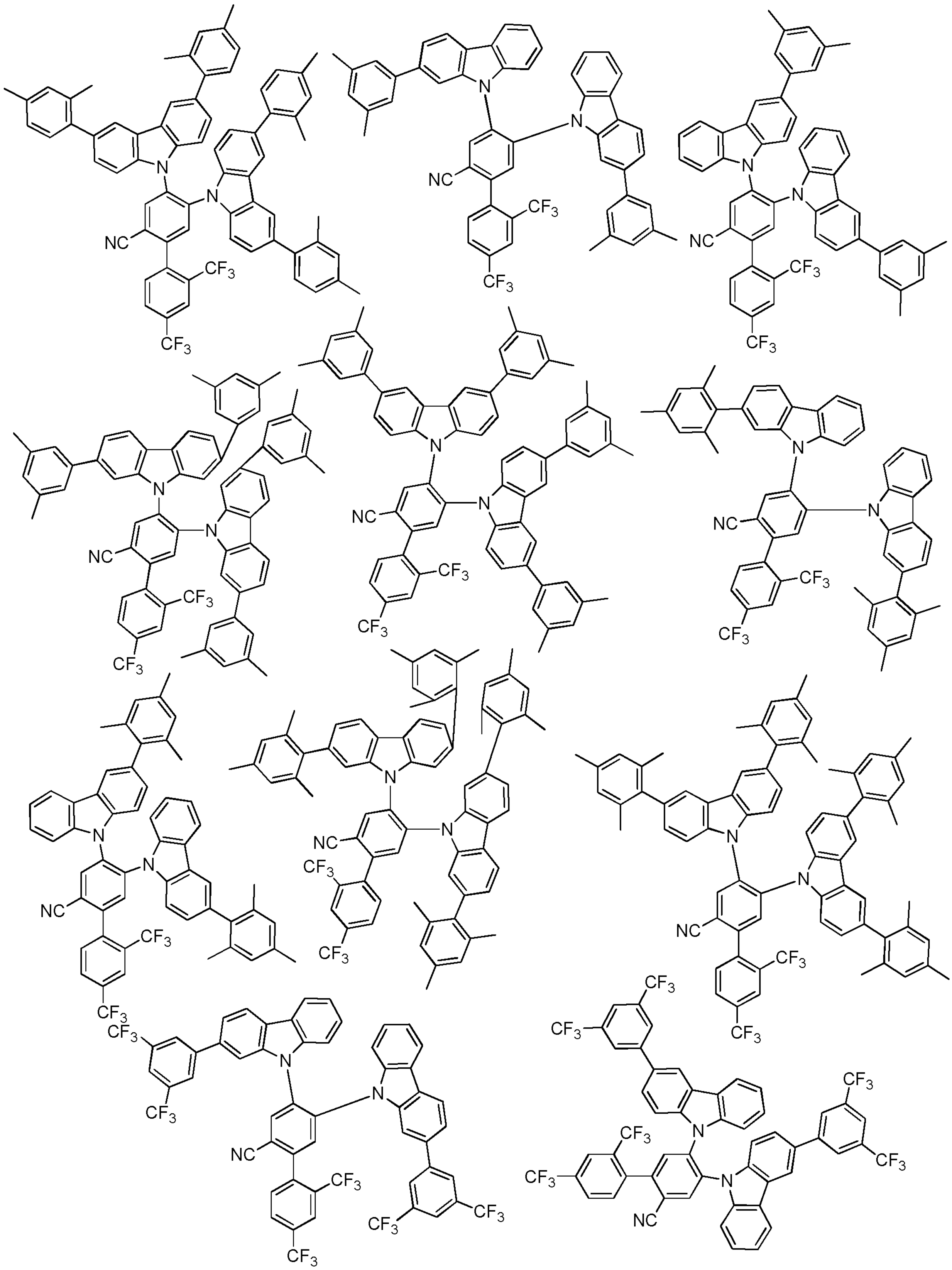

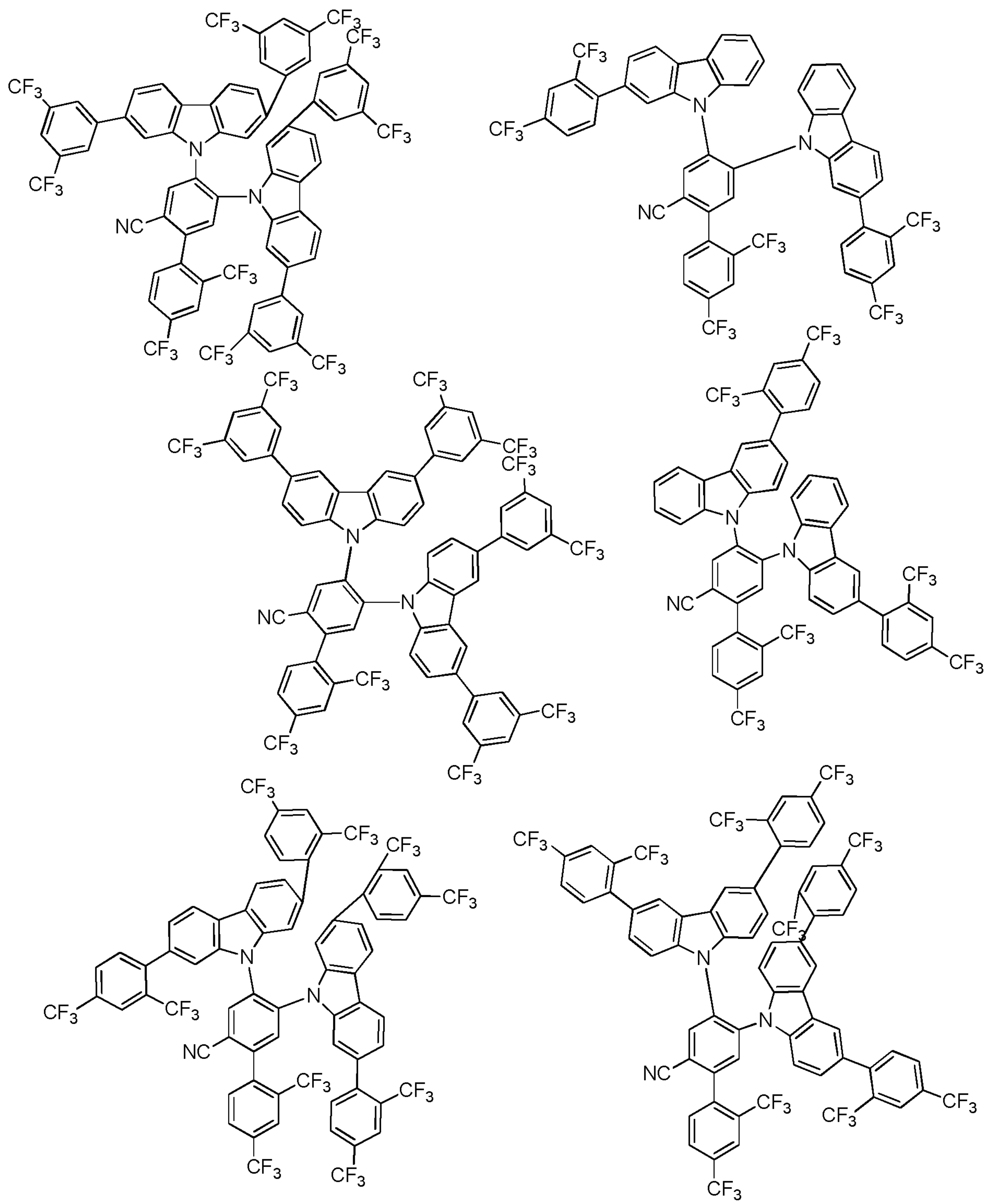

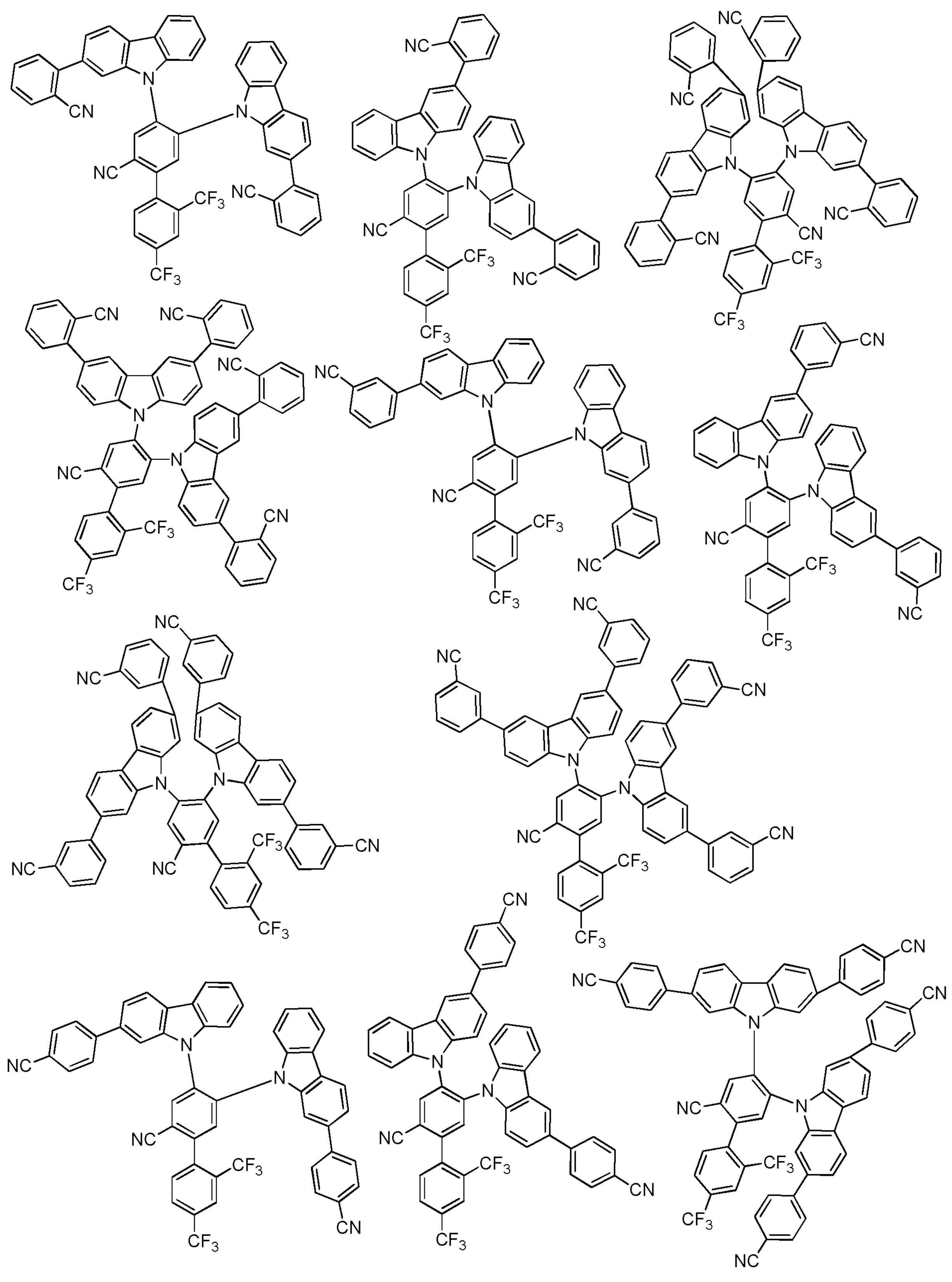

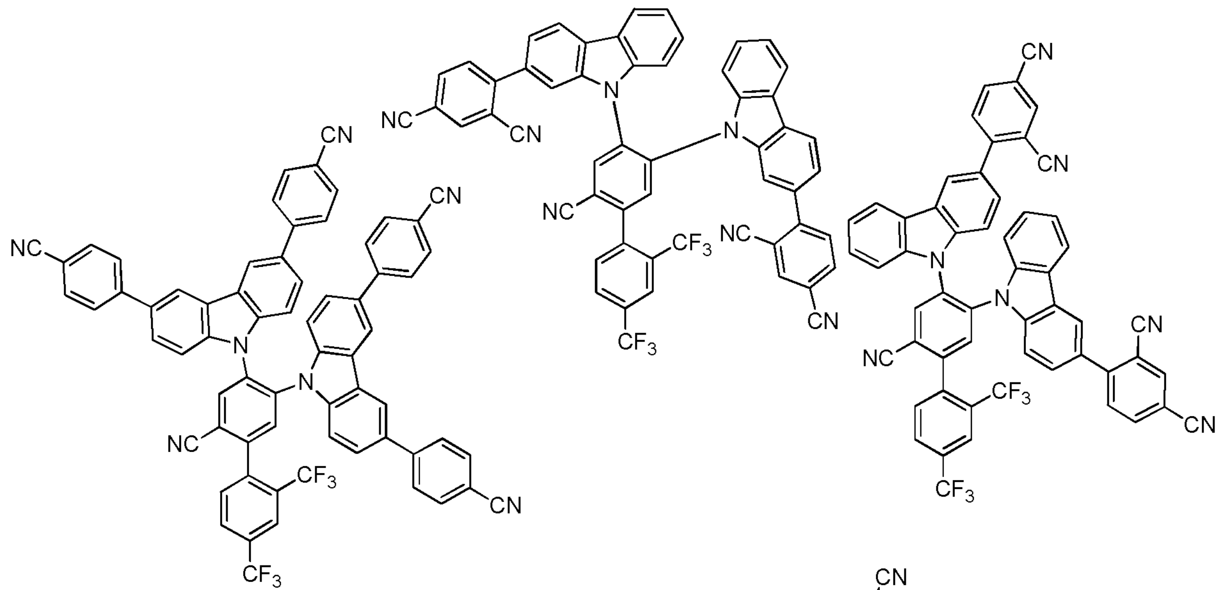

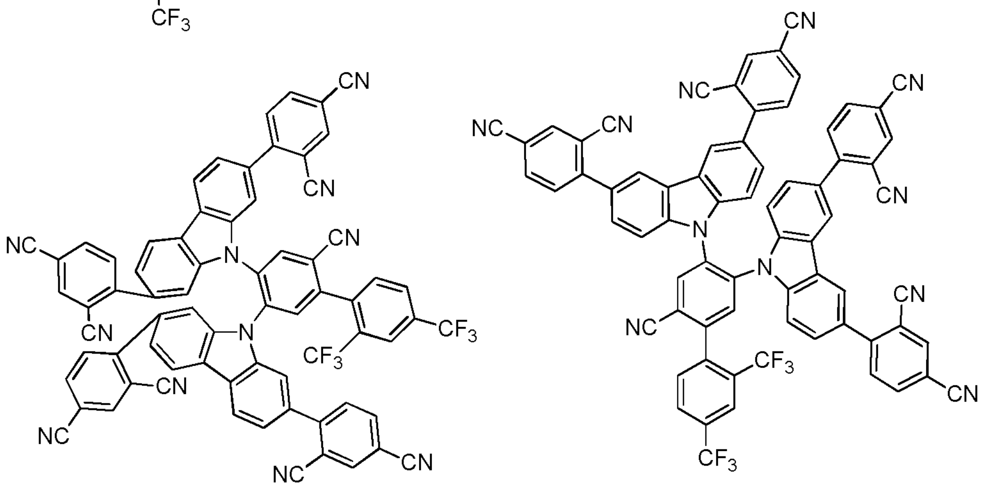

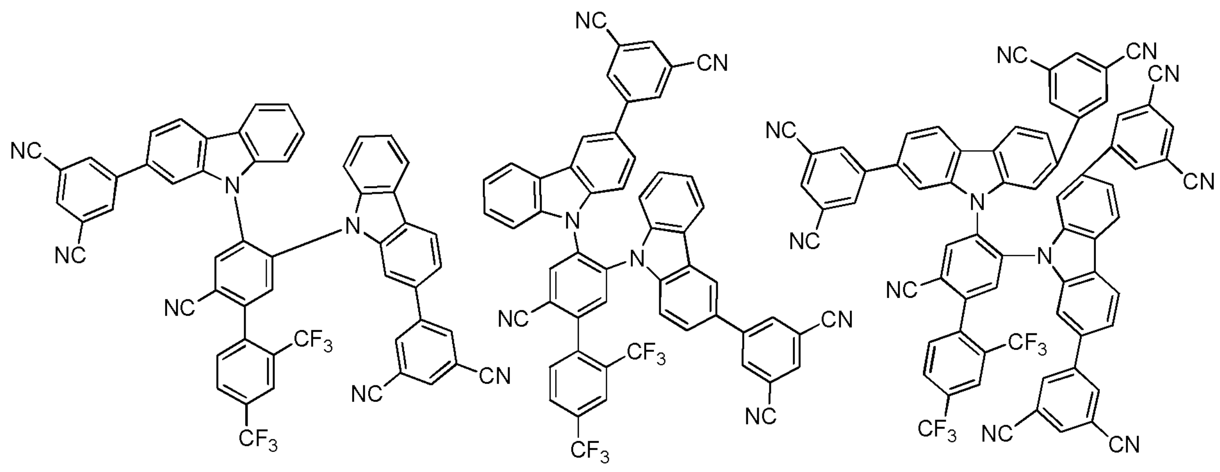

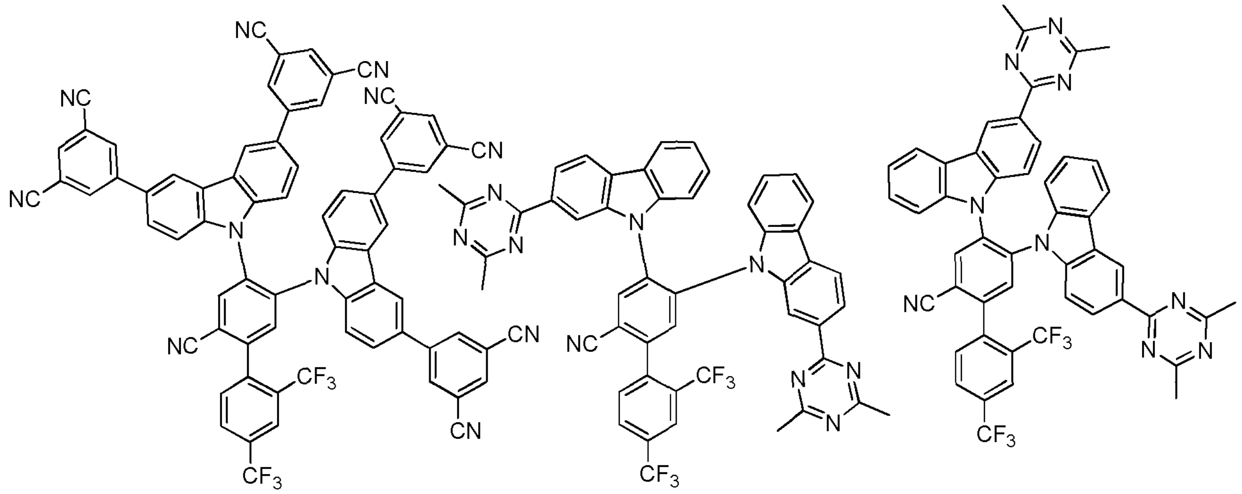

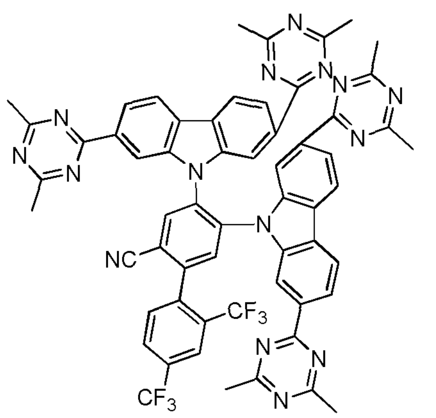

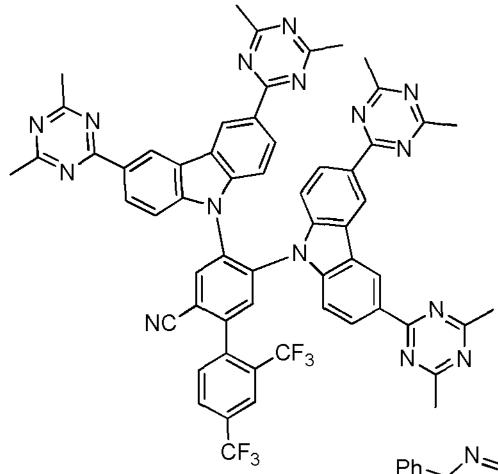

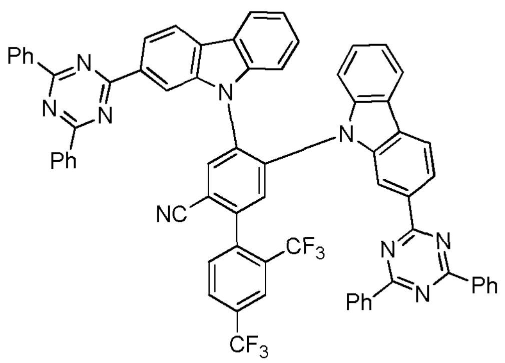

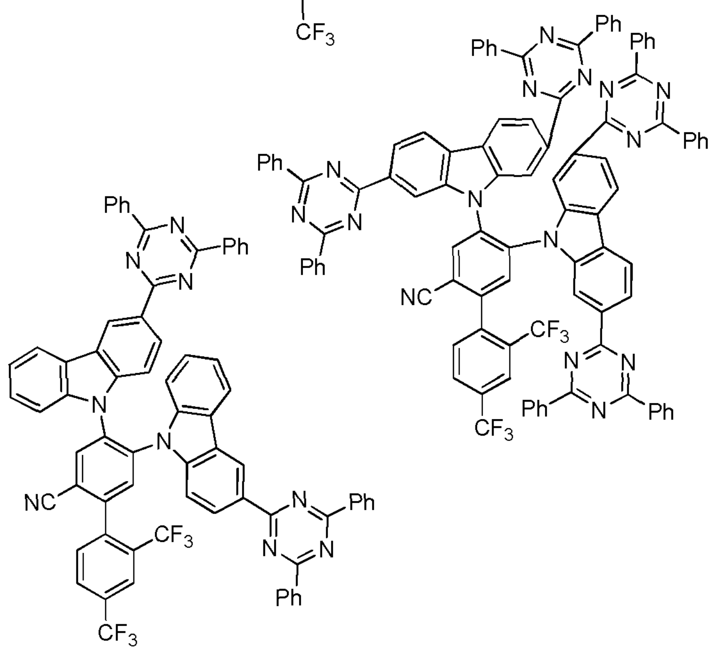

## Claims

1. An organic electroluminescent device, comprising

- a light-emitting layer B, comprising

a) at least one host compound H comprising or consisting of a structure of formula I:

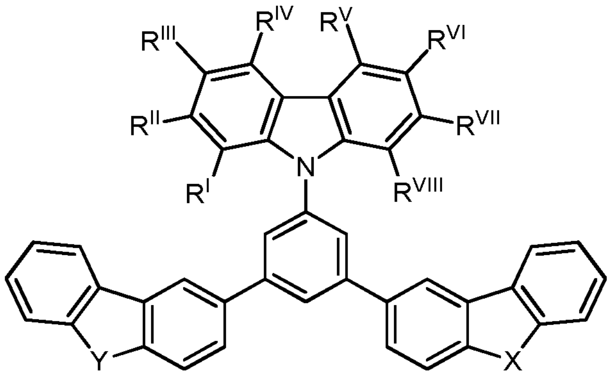

Formula I

wherein

X is O or S;
Y is O or S;

each of $R^I$, $R^{II}$, $R^{III}$, $R^{IV}$, $R^V$, $R^{VI}$, $R^{VII}$ and $R^{VIII}$ is independently from another selected from the group consisting of
hydrogen,
CN,
$CF_3$,
$C_1$-$C_{20}$-alkyl, which is optionally substituted with one or more $R^z$,
$C_6$-$C_{18}$-aryl, which is optionally substituted with one or more $R^z$,
$C_3$-$C_{17}$-heteroaryl, which is optionally substituted with one or more $R^z$, and
$Si(R^y)3$;
each of $R^y$ and $R^z$ is at each occurrence independently from another selected from the group consisting of
hydrogen,
CN,
$CF_3$,
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl; and
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl, and $C_3$-$C_{17}$-heteroaryl;
and
b) at least one emitter compound E comprising or consisting of

- a first chemical moiety comprising or consisting of a structure of formula II,

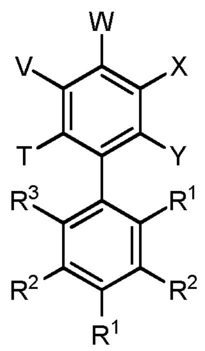

Formula II

and

- two second chemical moieties independently from another comprising or consisting of a structure of formula III,

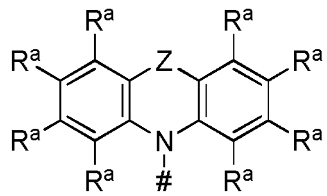

Formula III

wherein the first chemical moiety is linked to each of the two second chemical moieties via a single bond; wherein

T is the binding site of a single bond linking the first chemical moiety and one of the two second chemical moieties, or is hydrogen;
V is the binding site of a single bond linking the first chemical moiety and one of the two second chemical moieties, or is hydrogen;
W is the binding site of a single bond linking the first chemical moiety and one of the two second chemical moieties, or is selected from the group consisting of hydrogen, CN and $CF_3$;
X is the binding site of a single bond linking the first chemical moiety and one of the two second chemical moieties, or is selected from the group consisting of hydrogen, CN and $CF_3$;
Y is the binding site of a single bond linking the first chemical moiety and one of the two second chemical moieties, or is selected from the group consisting of hydrogen, CN and $CF_3$;
# represents the binding site of a single bond linking the first chemical moiety and one of the two second chemical moieties;
Z is at each occurrence independently from another selected from the group consisting of a direct bond, $CR^4R^5$, $C=CR^4R^5$, C=O, $C=NR^4$, $NR^4$, O, $SiR^4R^5$, S, S(O) and $S(O)_2$;
each of $R^1$ and $R^2$ is at each occurrence independently from another selected from the group consisting of
hydrogen,
deuterium,
$C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$CF_3$;
$R^3$ is selected from the group consisting of
hydrogen,
deuterium,

$C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;
each of $R^a$, $R^4$ and $R^5$ is at each occurrence independently from another selected from the group consisting of
hydrogen, CN, $CF_3$,
$C_1$-$C_{20}$-alkyl, which is optionally substituted with one or more $R^x$,
$C_6$-$C_{18}$-aryl, which is optionally substituted with one or more $R^x$,
$C_3$-$C_{17}$-heteroaryl, which is optionally substituted with one or more $R^x$,
$Si(R^t)3$,
$N(R^s)_2$,
and $OR^s$;
$R^x$ is at each occurrence independently from another selected from the group consisting of hydrogen,
Cl,
Br,
I,
CN,
$CF_3$,
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl, and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;
each of $R^s$ and $R^t$ is at each occurrence independently from another selected from the group consisting of
hydrogen,
$C_1$-$C_{20}$-alkyl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;
wherein each of the residues $R^a$, $R^4$, $R^5$, $R^s$, $R^t$ or $R^x$ optionally form a mono- or polycyclic, aliphatic, aromatic and/ or benzanilated ring system with one or more residues $R^a$, $R^4$, $R^5$, $R^s$, $R^t$ or $R^x$;
wherein
exactly one residue selected from the group consisting of W, X and Y is CN or $CF_3$, and
exactly two residues selected from the group consisting of T, V, W, X and Y are the binding site of a single bond linking the first chemical moiety and one of the two second chemical moieties, and
either the two residues $R^1$ or the two residues $R^2$ are $CF_3$.

**2.** The organic electroluminescent device of claim 1 selected from the group consisting of an organic light emitting diode, a light emitting electrochemical cell, and a light-emitting transistor.

**3.** The organic electroluminescent device of claim 1 or 2, wherein X and Y are each O.

**4.** The organic electroluminescent device of claim 1 or 2, wherein X and Y are each S.

**5.** The organic electroluminescent device of any one of claims 1 to 4, wherein all of the residues $R^I$, $R^{II}$, $R^{III}$, $R^{IV}$, $R^V$, $R^{VI}$, $R^{VII}$ and $R^{VIII}$ are each hydrogen.

**6.** The organic electroluminescent device of claim 1 to 5, wherein the at least one emitter compound E comprises or consists of a structure of formula IV

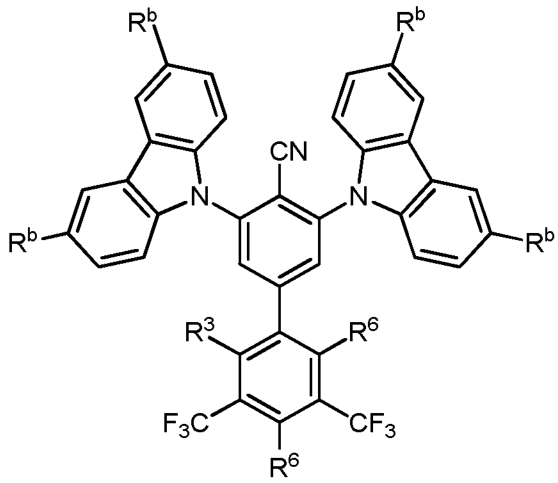

Formula IV

wherein

$R^b$ is at each occurrence independently from another selected from the group consisting of hydrogen,
CN,
$CF_3$,
methyl (Me),
iso-propyl ($^i$Pr),
tertiary-butyl ($^t$Bu),
phenyl (Ph), which is optionally substituted with one or more residues selected from the group consisting of Me, $^i$Pr, $^t$Bu, CN, $CF_3$ and Ph,
pyridinyl, which is optionally substituted with one or more residues selected from the group consisting of Me, $^i$Pr, $^t$Bu, CN, $CF_3$ and Ph,
pyrimidinyl, which is optionally substituted with one or more residues selected from the group consisting of Me, $^i$Pr, $^t$Bu, CN, $CF_3$ and Ph,
1,3,5-triazinyl, which is optionally substituted with one or more residues selected from the group consisting of Me, $^i$Pr, $^t$Bu, CN, $CF_3$ and Ph, and
carbazolyl, which is optionally substituted with one or more residues selected from the group consisting of Me, $^i$Pr, $^t$Bu, CN, $CF_3$ and Ph;
$R^6$ is selected from the group consisting of
hydrogen,
deuterium,
$C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;
and $R^3$ is defined as in claim 1.

**7.** The organic electroluminescent device of claim 1 to 5, wherein the at least one emitter compound comprises or consists of a structure of formula V

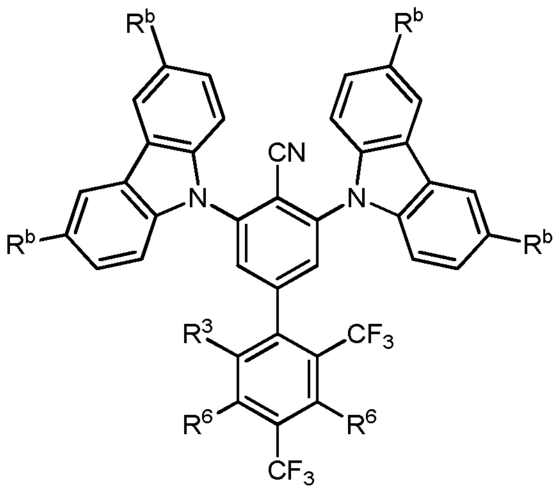

Formula V

wherein

$R^b$ is at each occurrence independently from another selected from the group consisting of hydrogen,
CN,
$CF_3$,
Me,
$^iPr$,
$^tBu$,
Ph, which is optionally substituted with one or more residues selected from the group consisting of Me, $^iPr$, $^tBu$, CN, $CF_3$ and Ph,
pyridinyl, which is optionally substituted with one or more residues selected from the group consisting of Me, $^iPr$, $^tBu$, CN, $CF_3$ and Ph,
pyrimidinyl, which is optionally substituted with one or more residues selected from the group consisting of Me, $^iPr$, $^tBu$, CN, $CF_3$ and Ph,
1,3,5-triazinyl, which is optionally substituted with one or more residues selected from the group consisting of Me, $^iPr$, $^tBu$, CN, $CF_3$ and Ph, and
carbazolyl, which is optionally substituted with one or more residues selected from the group consisting of Me, $^iPr$, $^tBu$, CN, $CF_3$ and Ph;
$R^6$ is selected from the group consisting of
hydrogen,
deuterium,
$C_1$-$C_5$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl;
and $R^3$ is defined as in claim 1.

**8.** The organic electroluminescent device of claim 6 or 7, wherein $R^3$ and $R^6$ is H at each occurrence.

**9.** The organic electroluminescent device of claims 1 to 8, wherein the light-emitting layer comprises:

(i) 5-99 % by weight, in particular 30-94.9 % by weight, preferably 40-89% by weight, of at least one host compound H;
(ii) 1-50 % by weight, in particular 5-40 % by weight, preferably 10-30 % by weight, of the at least one emitter compound E; and optionally
(iii) 0-94 % by weight, in particular 0.1-65 % by weight, preferably 1-50 % by weight, of at least one further host compound $D^1$ with a structure that is not according to formula (I); and optionally

(iv) 0-30 % by weight, in particular 0-20 % by weight, preferably 0-5 % by weight, of at least one further emitter compound.

**10.** The organic electroluminescent device of claim 9, wherein the host compound H has a highest occupied molecular orbital HOMO(H) and the at least one further host compound $D^1$ has a highest occupied molecular orbital HOMO($D^1$) having an energy $E^{HOMO}(D^1)$, wherein $E^{HOMO}(H) > E^{HOMO}(D^1)$.

**11.** The organic electroluminescent device of claim 9 or 10, wherein the at least one host compound H has a lowest unoccupied molecular orbital LUMO(H) having an energy $E^{LUMO}(H)$ and the at least one further host compound $D^1$ has a lowest unoccupied molecular orbital LUMO($D^1$) having an energy wherein $E^{LUMO}(H) > E^{LUMO}(D^1)$.

**12.** The organic electroluminescent device of claim 9 to 11, wherein
the at least one host compound H has a highest occupied molecular orbital HOMO(H) having an energy $E^{HOMO}(H)$ and a lowest unoccupied molecular orbital LUMO(H) having an energy $E^{LUMO}(H)$, and
the at least one further host compound $D^1$ has a highest occupied molecular orbital HOMO($D^1$) having an energy $E^{HOMO}(D^1)$ and a lowest unoccupied molecular orbital LUMO($D^1$) having an energy
the at least one emitter compound E has a highest occupied molecular orbital HOMO(E) having an energy $E^{HOMO}(E)$ and a lowest unoccupied molecular orbital LUMO(E) having an energy $E^{LUMO}(E)$, wherein
$E^{HOMO}(H) > E^{HOMO}(D^1)$ and the difference between the energy level of the highest occupied molecular orbital HOMO(E) of the at least one emitter compound E ($E^{HOMO}(E)$) and the energy level of the highest occupied molecular orbital HOMO(H) of the at least one host compound H ($E^{HOMO}(H)$) is between -0.5 eV and 0.5 eV, more preferably between -0.3 eV and 0.3 eV, even more preferably between -0.2 eV and 0.2 eV or even between -0.1 eV and 0.1 eV; and
$E^{LUMO}(H) > E^{LUMO}(D^1)$ and the difference between the energy level of the lowest unoccupied molecular orbital LUMO(E) of the at least one emitter compound E ($E^{LUMO}(E)$) and the lowest unoccupied molecular orbital LUMO($D^1$) of the at least one further host compound $D^1$ ($E^{LUMO}(D^1)$) is between -0.5 eV and 0.5 eV, more preferably between -0.3 eV and 0.3 eV, even more preferably between -0.2 eV and 0.2 eV or even between -0.1 eV and 0.1 eV.

**13.** The organic electroluminescent device of claims 9 to 12, wherein the at least one further host compound $D^1$ comprises or consists of a structure of formula VII:

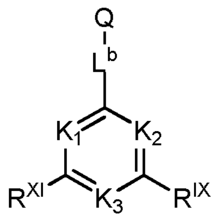

Formula VII

wherein:

each of $K_1$, $K_2$ and $K_3$ is independently from another selected from the group consisting of CH, $CR^k$, and N; wherein at least one of the residues $K_1$, $K_2$ and $K_3$ is N;
wherein $R^k$ is at each occurrence identical or differing and independently selected from the group consisting of
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl or $C_3$-$C_{17}$-heteroaryl, and
$Si(R^m)_3$;
each of $R^{IX}$ and $R^{XI}$ is independently from another selected from the group consisting of hydrogen,
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of

$C_6$-$C_{18}$-aryl, $C_1$-$C_{20}$-alkyl, $C_1$-$C_{20}$-heteroalkyl and $C_3$-$C_{17}$-heteroaryl,
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$Si(R^m)_3$;
$R^m$ is at each occurrence identical or differing and independently from another selected from the group consisting of
hydrogen,
$C_1$-$C_{20}$-alkyl, which is optionally substituted with one or more residues selected from the group $C_6$-$C_{18}$-aryl, $C_1$-$C_{20}$-alkyl, $C_1$-$C_{20}$-heteroalkyl and $C_3$-$C_{17}$-heteroaryl,
$C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl, and
$C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;
$L^b$ is selected from the group consisting of a single bond and $C_6$-$C_{18}$-arylene, which is optionally substituted with one or more residues selected from the group consisting of $C_6$-$C_{18}$-aryl, $C_1$-$C_{20}$-alkyl, $C_1$-$C_{20}$-heteroalkyl and $C_3$-$C_{17}$-heteroaryl;
Q is a group comprising or consisting of a structure of one of formulas VIII to XI

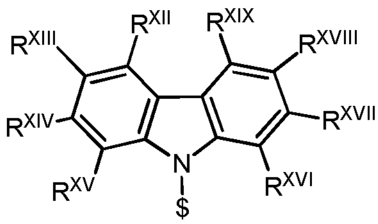

Formula VIII

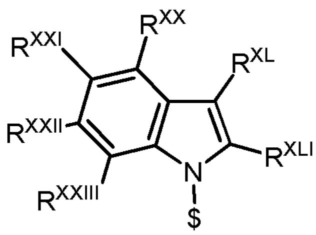

Formula IX

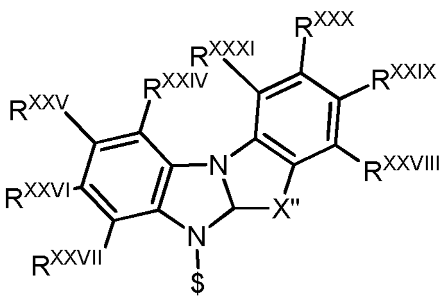

Formula X

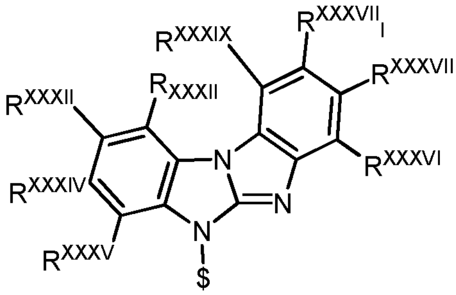

Formula XI

wherein

$ is the binding site to $L^b$;
X" is selected from the group consisting of O and S;
each of $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$ $R^{XXII}$, $R^{XXIII}$ $R^{XXIV}$, $R^{XXV}$, $R^{XXVI}$, $R^{XXVII}$, $R^{XXVIII}$, $R^{XXIX}$, $R^{XXX}$, $R^{XXXI}$, $R^{XXXII}$, $R^{XXXIII}$, $R^{XXXIV}$, $R^{XXXV}$, $R^{XXXVI}$, $R^{XXXVII}$, $R^{XXXVIII}$ and $R^{XXXIX}$ is independently from another selected from the group consisting of
hydrogen,
Cl,
Br,
I,
CN,
$CF_3$,
$C_1$-$C_{20}$-alkyl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$,
$C_6$-$C_{18}$-aryl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$,
$C_3$-$C_{17}$-heteroaryl, which is optionally substituted with one or more residues selected from the group consisting of Cl, Br, I, CN, $CF_3$, $C_1$-$C_{20}$-alkyl, $C_6$-$C_{18}$-aryl, $C_3$-$C_{17}$-heteroaryl and $Si(R^m)_3$, and
$Si(R^m)_3$;
each of $R^{XL}$ and $R^{XLI}$ is independently from another selected from the group consisting of: hydrogen;
$C_1$-$C_{20}$-alkyl, which is optionally substituted with one or more residues selected from the group consisting of $C_6$-$C_{18}$-aryl, $C_1$-$C_{20}$-alkyl, $C_1$-$C_{20}$-heteroalkyl, and $C_3$-$C_{17}$-heteroaryl; $C_6$-$C_{18}$-aryl, which is optionally substituted with one or more residues selected from the group consisting of $C_6$-$C_{18}$-aryl, $C_1$-$C_{20}$-alkyl, $C_1$-$C_{20}$-heteroalkyl, and $C_3$-$C_{17}$-heteroaryl; $C_3$-$C_{17}$-heteroaryl, which is optionally substituted with one or more residues selected from the group consisting of $C_6$-$C_{18}$-aryl, $C_1$-$C_{20}$-alkyl, $C_1$-$C_{20}$-heteroalkyl, and $C_3$-$C_{17}$-heteroaryl; and
$Si(R^m)_3$.

## Patentansprüche

**1.** Organische elektrolumineszierende Vorrichtung, aufweisend

- eine lichtemittierende Schicht B, aufweisend,

a) mindestens eine Hostverbindung H aufweisend oder bestehend aus einer Struktur der Formel I:

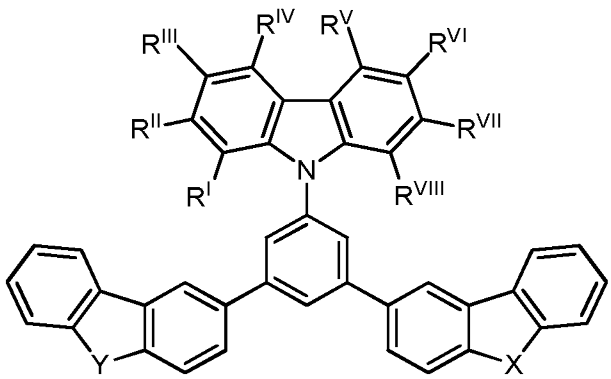

Formel I

wobei

X gleich O oder S ist;
Y gleich O oder S ist;

jeder $R^I$, $R^{II}$, $R^{III}$, $R^{IV}$, $R^V$, $R^{VI}$, $R^{VII}$ und $R^{VIII}$ ist unabhängig voneinander ausgewählt aus der Gruppe bestehend aus
Wasserstoff,
CN,
$CF_3$,
$C_1$-$C_{20}$-Alkyl, welches optional substituiert ist mit einem oder mehreren $R^z$,
$C_6$-$C_{18}$-Aryl, welches optional substituiert ist mit einem oder mehreren $R^z$,
$C_3$-$C_{17}$-Heteroaryl, welches optional substituiert ist mit einem oder mehreren $R^z$, und $Si(R^y)_3$;
jeder $R^y$ und $R^z$ ist bei jedem Auftreten unabhängig voneinander ausgewählt aus der Gruppe bestehend aus
Wasserstoff,
CN,
$CF_3$,
$C_1$-$C_{20}$-Alkyl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl und
$C_3$-$C_{17}$-Heteroaryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl;
und
b) mindestens eine Emitterverbindung E aufweisend oder bestehend aus

- einer ersten chemischen Einheit aufweisend oder bestehend aus einer Struktur der Formel II,

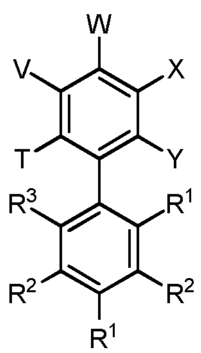

Formel II

und

- zwei zweite chemische Einheiten unabhängig voneinander aufweisend oder bestehend aus einer Struktur der Formel III,

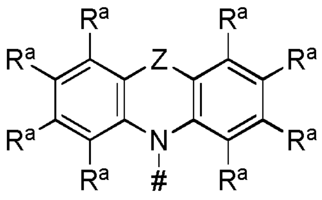

Formel III

wobei die erste chemische Einheit mit jeder der zwei zweiten chemischen Einheiten über eine Einfachbindung verknüpft ist;
wobei

T die Bindungsstelle einer Einfachbindung ist, die die erste chemische Einheit und eine der zwei zweiten chemischen Einheiten verknüpft oder ist Wasserstoff;
V die Bindungsstelle einer Einfachbindung ist, die die erste chemische Einheit und eine der zwei zweiten chemischen Einheiten verknüpft oder ist Wasserstoff;
W die Bindungsstelle einer Einfachbindung ist, die die erste chemische Einheit und eine der zwei zweiten chemischen Einheiten verknüpft oder ist ausgewählt aus der Gruppe bestehend aus Wasserstoff, CN und $CF_3$;
X die Bindungsstelle einer Einfachbindung ist, die die erste chemische Einheit und eine der zwei zweiten chemischen Einheiten verknüpft oder ist ausgewählt aus der Gruppe bestehend aus Wasserstoff, CN und $CF_3$;
Y die Bindungsstelle einer Einfachbindung ist, die die erste chemische Einheit und eine der zwei zweiten chemischen Einheiten verknüpft oder ist ausgewählt aus der Gruppe bestehend aus Wasserstoff, CN und $CF_3$;
# die Bindungsstelle einer Einfachbindung repräsentiert, die die erste chemische Einheit und eine der zwei zweiten chemischen Einheiten verknüpft;
Z bei jedem Auftreten unabhängig voneinander ausgewählt ist aus der Gruppe bestehend aus einer direkten Bindung, $CR^4R^5$, $C{=}CR^4R^5$, C=O, $C{=}NR^4$, $NR^4$, O, $SiR^4R^5$, S, S(O) und $S(O)_2$;
jeder $R^1$ und $R^2$ ist bei jedem Auftreten unabhängig voneinander ausgewählt aus der Gruppe bestehend aus
Wasserstoff,
Deuterium,
$C_1$-$C_5$-Alkyl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,
$C_3$-$C_{17}$-Heteroaryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl und $CF_3$;
$R^3$ ausgewählt ist aus der Gruppe bestehend aus
Wasserstoff,
Deuterium,
$C_1$-$C_5$-Alkyl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl und
$C_3$-$C_{17}$-Heteroaryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl;
jeder $R^a$, $R^4$ und $R^5$ ist bei jedem Auftreten unabhängig voneinander ausgewählt aus der Gruppe bestehend aus
Wasserstoff, CN, $CF_3$,
$C_1$-$C_{20}$-Alkyl, welches optional substituiert ist mit einem oder mehreren $R^x$,
$C_6$-$C_{18}$-Aryl, welches optional substituiert ist mit einem oder mehreren $R^x$,

$C_3$-$C_{17}$-Heteroaryl, welches optional substituiert ist mit einem oder mehreren $R^x$, $Si(R^t)_3$, $N(R^s)_2$ und $OR^s$;

$R^x$ bei jedem Auftreten unabhängig voneinander ausgewählt ist aus der Gruppe bestehend aus

Wasserstoff,

Cl,

Br,

I,

CN,

$CF_3$,

$C_1$-$C_{20}$-Alkyl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,

$C_6$-$C_{18}$-Aryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl und

$C_3$-$C_{17}$-Heteroaryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl;

jeder $R^s$ und $R^t$ ist bei jedem Auftreten unabhängig voneinander ausgewählt aus der Gruppe bestehend aus

Wasserstoff,

$C_1$-$C_{20}$-Alkyl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl,

$C_6$-$C_{18}$-Aryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl und

$C_3$-$C_{17}$-Heteroaryl, welches optional substituiert ist mit einem oder mehreren Resten ausgewählt aus der Gruppe $C_6$-$C_{18}$-Aryl, $C_1$-$C_{20}$-Alkyl, $C_1$-$C_{20}$-Heteroalkyl und $C_3$-$C_{17}$-Heteroaryl;

wobei jeder der Reste $R^a$, $R^4$, $R^5$, $R^s$, $R^t$ oder $R^x$ optional ein mono- oder polycyclisches, aliphatisches, aromatisches und/oder benzoanneliertes Ringsystem mit einem oder mehreren Resten $R^a$, $R^4$, $R^5$, $R^s$, $R^t$ oder $R^x$ ausbildet;

wobei

genau ein Rest ausgewählt aus der Gruppe bestehend aus W, X und Y gleich CN oder $CF_3$ ist und genau zwei Reste ausgewählt aus der Gruppe bestehend aus T, V, W, X und Y die Bindungsstelle einer Einfachbindung sind, die die erste chemische Einheit und eine der zwei zweiten chemischen Einheiten verknüpft, und

entweder die zwei Reste $R^1$ oder die zwei Reste $R^2$ gleich $CF_3$ sind.

**2.** Organische elektrolumineszierende Vorrichtung nach Anspruch 1 ausgewählt aus der Gruppe bestehend aus einer organischen lichtemittierenden Diode, einer lichtemittierenden elektrochemischen Zelle und einem lichtemittierenden Transistor.

**3.** Organische elektrolumineszierende Vorrichtung nach Anspruch 1 oder 2, wobei X und Y beide O sind.

**4.** Organische elektrolumineszierende Vorrichtung nach Anspruch 1 oder 2, wobei X und Y beide S sind.

**5.** Organische elektrolumineszierende Vorrichtung nach einem der Ansprüche 1 bis 4, wobei alle Reste $R^I$, $R^{II}$, $R^{III}$, $R^{IV}$, $R^V$, $R^{VI}$, $R^{VII}$ und $R^{VIII}$ jeweils Wasserstoff sind

**6.** Organische elektrolumineszierende Vorrichtung nach Anspruch 1 bis 5, wobei die mindestens eine Emitterverbindung E eine Struktur der Formel IV aufweist oder daraus besteht

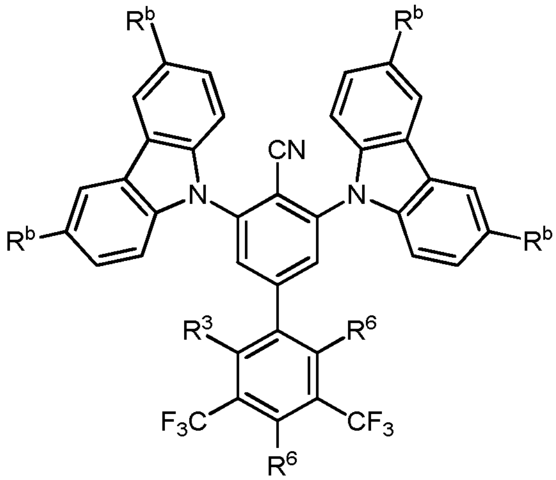

Formel IV

wobei

$R^b$ bei jedem Auftreten unabhängig voneinander ausgewählt ist aus der Gruppe bestehend aus
Wasserstoff,
CN,
$CF_3$,
Methyl (Me),
iso-Propyl ($^i$Pr),
tertiär-Butyl ($^t$Bu),
Phenyl (Ph), welches optional substituiert ist mit einem oder mehreren Resten ausgewählt aus der Gruppe bestehend aus Me, $^i$Pr, $^t$Bu, CN, $CF_3$ und Ph,
Pyridinyl, welches optional substituiert ist mit einem oder mehreren Resten ausgewählt aus der Gruppe bestehend aus Me, $^i$Pr, $^t$Bu, CN, $CF_3$ und Ph,
Pyrimidinyl, welches optional substituiert ist mit einem oder mehreren Resten ausgewählt aus der Gruppe bestehend aus Me, $^i$Pr, $^t$Bu, CN, $CF_3$ und Ph,
1,3,5-Triazinyl, welches optional substituiert ist mit einem oder mehreren Resten ausgewählt aus der Gruppe bestehend aus Me, $^i$Pr, $^t$Bu, CN, $CF_3$ und Ph und
Carbazolyl, welches optional substituiert ist mit einem oder mehreren Resten ausgewählt aus der Gruppe bestehend aus Me, $^i$Pr, $^t$Bu, CN, $CF_3$ und Ph;
$R^6$ ausgewählt ist aus der Gruppe bestehend aus
Wasserstoff,
Deuterium,
$C_1$-$C_5$-Alkyl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl und
$C_3$-$C_{17}$-Heteroaryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl;
und $R^3$ ist definiert wie in Anspruch 1.

**7.** Organische elektrolumineszierende Vorrichtung nach Anspruch 1 bis 5, wobei die mindestens eine Emitterverbindung eine Struktur der Formel V aufweist oder daraus besteht

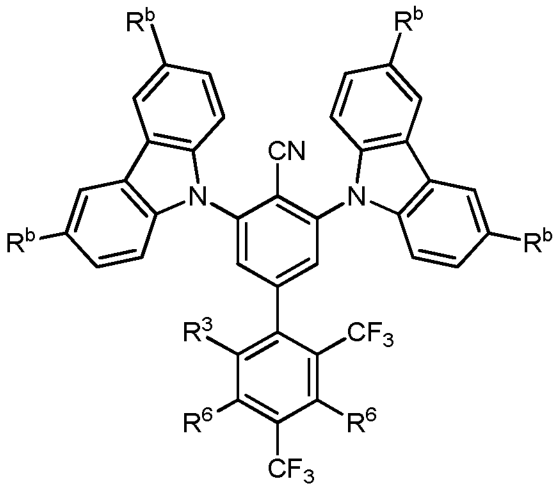

Formel V

wobei

$R^b$ ist bei jedem Auftreten unabhängig voneinander ausgewählt aus der Gruppe bestehend aus
Wasserstoff,
CN,
$CF_3$,
Me,
$^iPr$,
$^tBu$,
Ph, welches optional substituiert ist mit einem oder mehreren Resten ausgewählt aus der Gruppe bestehend aus Me, $^iPr$, $^tBu$, CN, $CF_3$ und Ph,
Pyridinyl, welches optional substituiert ist mit einem oder mehreren Resten ausgewählt aus der Gruppe bestehend aus Me, $^iPr$, $^tBu$, CN, $CF_3$ und Ph,
Pyrimidinyl, welches optional substituiert ist mit einem oder mehreren Resten ausgewählt aus der Gruppe bestehend aus Me, $^iPr$, $^tBu$, CN, $CF_3$ und Ph,
1,3,5-Triazinyl, welches optional substituiert ist mit einem oder mehreren Resten ausgewählt aus der Gruppe bestehend aus Me, $^iPr$, $^tBu$, CN, $CF_3$ und Ph und
Carbazolyl, welches optional substituiert ist mit einem oder mehreren Resten ausgewählt aus der Gruppe bestehend aus Me, $^iPr$, $^tBu$, CN, $CF_3$ und Ph;
$R^6$ ist ausgewählt aus der Gruppe bestehend aus
Wasserstoff,
Deuterium,
$C_1$-$C_5$-Alkyl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl, und
$C_3$-$C_{17}$-Heteroaryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl;
und $R^3$ ist definiert wie in Anspruch 1.

**8.** Organische elektrolumineszierende Vorrichtung nach Anspruch 6 oder 7, wobei $R^3$ und $R^6$ bei jedem Auftreten H sind.

**9.** Organische elektrolumineszierende Vorrichtung nach Anspruch 1 bis 8, wobei die lichtemittierende Schicht aufweist:

(i) 5-99 Gew%, insbesondere 30-94,9 Gew%, vorzugsweise 40-89 Gew% von mindestens einer Hostverbindung H;
(ii) 1-50 Gew%, insbesondere 5-40 Gew%, vorzugsweise 10-30 Gew%, der mindestens einen Emitterverbindung E; und optional
(iii) 0-94 Gew%, insbesondere 0,1-65 Gew%, vorzugsweise 1-50 Gew%, von mindestens einer weiteren Host-

verbindung $D^1$ mit einer Struktur die nicht gemäß der Formel (I) ist; und optional

(iv) 0-30 Gew%, insbesondere 0-20 Gew%, vorzugsweise 0-5 Gew%, von mindestens einer weiteren Emitterverbindung.

**10.** Organische elektrolumineszierende Vorrichtung nach Anspruch 9, wobei die Hostverbindung H ein höchstes besetztes Molekülorbital HOMO(H) aufweist und die mindestens eine weitere Hostverbindung $D^1$ ein höchstes besetztes Molekülorbital HOMO($D^1$) aufweist, das eine Energie $E^{HOMO}(D^1)$ aufweist, wobei $E^{HOMO}(H) > E^{HOMO}(D^1)$.

**11.** Organische elektrolumineszierende Vorrichtung nach Anspruch 9 oder 10, wobei die mindestens eine Hostverbindung H ein niedrigstes unbesetztes Molekülorbital aufweist, das eine Energie $E^{LUMO}(H)$ aufweist und die mindestens eine weitere Hostverbindung $D^1$ ein niedrigstes unbesetztes Molekülorbital aufweist, das eine Energie $E^{LUMO}(D^1)$ aufweist, wobei $E^{LUMO}(H) > E^{LUMO}(D^1)$.

**12.** Organische elektrolumineszierende Vorrichtung nach Anspruch 9 bis 11, wobei die mindestes eine Hostverbindung H ein höchstes besetztes Molekülorbital HOMO(H) aufweist, das eine Energie $E^{HOMO}(H)$ aufweist und ein niedrigstes unbesetztes Molekülorbital LUMO(H) aufweist, das eine Energie $E^{LUMO}(H)$ aufweist und
die mindestens eine weitere Hostverbindung $D^1$ ein höchstes besetztes Molekülorbital HOMO($D^1$) aufweist, das eine Energie $E^{HOMO}(D^1)$ aufweist und ein niedrigstes unbesetztes Molekülorbital LUMO($D^1$), das eine Energie $E^{LUMO}(D^1)$ aufweist,
die mindestens eine Emitterverbindung E ein höchstes besetztes Molekülorbital HOMO(E) aufweist, das eine Energie $E^{HOMO}(E)$ aufweist und ein niedrigstes unbesetztes Molekülorbtial LUMO(E), das eine Energie $E^{LUMO}(E)$ aufweist, wobei $E^{HOMO}(H) > E^{HOMO}(D^1)$ und der Unterschied zwischen dem Energielevel des höchsten besetzten Molekülorbitals HOMO(E) der mindestens einen Emitterverbindung E ($E^{HOMO}(E)$) und des Energielevels des höchsten besetzten Molekülorbitals HOMO(H) der mindestens einen Hostverbindung H ($E^{HOMO}(H)$) zwischen -0,5 eV und 0,5 eV, mehr bevorzugt zwischen -0,3 eV Und 0,3 eV, noch mehr bevorzugt zwischen -0,2 eV und 0,2 eV oder sogar zwischen -0,1 eV und 0,1 eV ist.

**13.** Organische elektrolumineszierende Vorrichtung nach Anspruch 9 bis 12, wobei die mindestens eine weitere Hostverbindung $D^1$ eine Struktur der Formel VII aufweist oder daraus besteht:

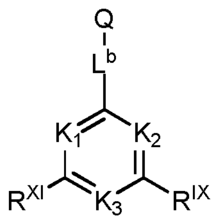

Formel VII

wobei:

jeder $K_1$, $K_2$ und $K_3$ ist unabhängig voneinander ausgewählt ist aus der Gruppe bestehend aus CH, $CR^k$, und N; wobei mindestens einer der Reste $K_1$, $K_2$ und $K_3$ gleich N ist;
wobei $R^k$ bei jedem Auftreten gleich oder verschieden und unabhängig ausgewählt ist aus der Gruppe bestehend aus
$C_1$-$C_{20}$-Alkyl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_3$-$C_{17}$-Heteroaryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl und
$Si(R^m)_3$;
jeder $R^{IX}$ und $R^{XI}$ ist unabhängig voneinander ausgewählt aus der Gruppe bestehend aus
Wasserstoff,
$C_1$-$C_{20}$-Alkyl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,

$C_6$-$C_{18}$-Aryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_3$-$C_{17}$-Heteroaryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl und
$Si(R^m)_3$;
$R^m$ ist bei jedem Auftreten gleich oder verschieden und unabhängig voneinander ausgewählt aus der Gruppe bestehend auf
Wasserstoff,
$C_1$-$C_{20}$-Alkyl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
$C_6$-$C_{18}$-Aryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl und
$C_3$-$C_{17}$-Heteroaryl, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl;
$L^b$ ist ausgewählt aus der Gruppe bestehend aus einer Einfachbindung und $C_6$-$C_{18}$-Arylen, welches optional substituiert ist mit einer oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl und $C_3$-$C_{17}$-Heteroaryl,
Q ist eine Gruppe aufweisend oder bestehend aus einer Struktur einer der Formeln VIII bis XI

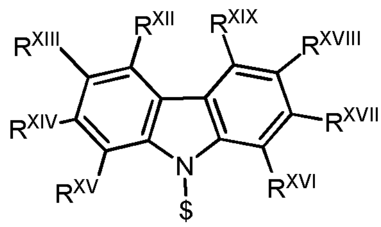

Formel VIII

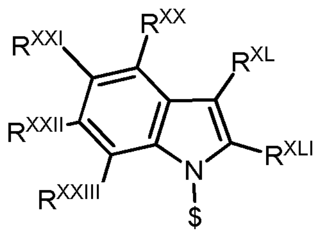

Formel IX

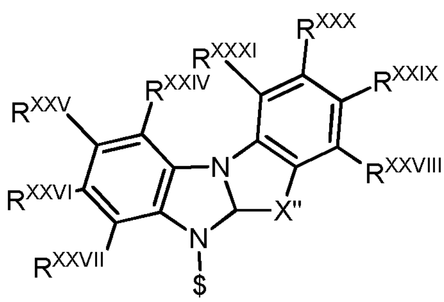

Formel X

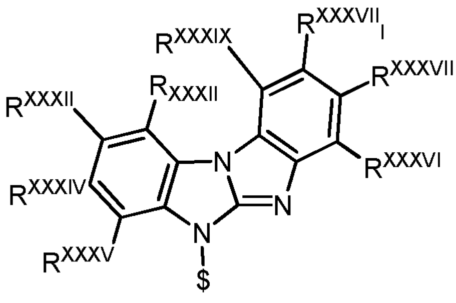

Formel XI

wobei

$ die Bindungsstelle von $L^b$ ist;
X" ausgewählt ist aus der Gruppe bestehend aus O und S;

jeder $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$ $R^{XXII}$, $R^{XXIII}$, $R^{XXIV}$, $R^{XXVI}$, $R^{XXVI}$, $R^{XXVII}$, $R^{XXVIII}$, $R^{XXIX}$, $R^{XXX}$, $R^{XXXI}$, $R^{XXXII}$, $R^{XXXIII}$, $R^{XXXIV}$, $R^{XXXV}$, $R^{XXXVI}$, $R^{XXXVII}$, $R^{XXXVIII}$ und $R^{XXXIX}$ unabhängig voneinander ausgewählt ist aus der Gruppe bestehend aus Wasserstoff,
Cl,
Br,
I,
CN,
$CF_3$,
$C_1$-$C_{20}$-Alkyl, welches optional substituiert ist mit einem oder mehreren Resten ausgewählt aus der Gruppe bestehend aus Cl, Br, I, CN, $CF_3$, $C_1$-$C_{20}$-Alkyl, $C_6$-$C_{18}$-Aryl, $C_3$-$C_{17}$-Heteroaryl und $Si(R^m)_3$,
$C_6$-$C_{18}$-Aryl, welches optional substituiert ist mit einem oder mehreren Resten ausgewählt aus der Gruppe bestehend aus Cl, Br, I, CN, $CF_3$, $C_1$-$C_{20}$-Alkyl, $C_6$-$C_{18}$-Aryl, $C_3$-$C_{17}$-Heteroaryl und $Si(R^m)_3$,
$C_3$-$C_{17}$-Heteroaryl, welches optional substituiert ist mit einem oder mehreren Resten ausgewählt aus der Gruppe bestehend aus Cl, Br, I, CN, $CF_3$, $C_1$-$C_{20}$-Alkyl, $C_6$-$C_{18}$-Aryl, $C_3$-$C_{17}$-Heteroaryl und $Si(R^m)_3$ und
$Si(R^m)_3$;
jedes $R^{XL}$ und $R^{XLI}$ unabhängig voneinander ausgewählt ist aus der Gruppe bestehend aus:
Wasserstoff;
$C_1$-$C_{20}$-Alkyl, welches optional substituiert ist mit einem oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl, und $C_3$-$C_{17}$-Heteroaryl,
$C_6$-$C_{18}$-Aryl, welches optional substituiert ist mit einem oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl, und $C_3$-$C_{17}$-Heteroaryl;
$C_3$-$C_{17}$-Heteroaryl, welches optional substituiert ist mit einem oder mehreren Resten ausgewählt aus der Gruppe bestehend aus $C_6$-$C_{18}$-Aryl, $C_1$-$C_{20}$-Alkyl, $C_1$-$C_{20}$-Heteroalkyl, und $C_3$-$C_{17}$-Heteroaryl; und
$Si(R^m)_3$.

## Revendications

**1.** Dispositif électroluminescent organique, comprenant

- une couche émettrice de lumière B, comprenant

a) au moins un composé hôte H comprenant ou constitué d'une structure de formule I :

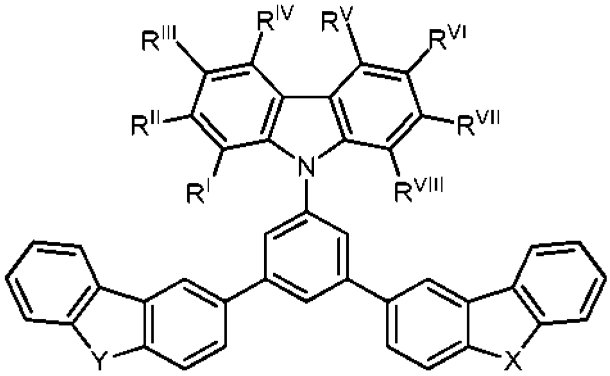

Formule I

dans lequel

X est O ou S ;
Y est O ou S ;
chacun de $R^{I}$, $R^{II}$, $R^{III}$, $R^{IV}$, $R^{V}$, $R^{VI}$, $R^{VII}$ et $R^{VIII}$ est, indépendamment des autres, choisi dans le groupe constitué de
hydrogène,
CN,
$CF_3$,
alkyle en $C_1$-$C_{20}$, qui est facultativement substitué par un ou plusieurs $R^z$,
aryle en $C_6$-$C_{18}$, qui est facultativement substitué par un ou plusieurs $R^z$,
hétéroaryle en $C_3$-$C_{17}$, qui est facultativement substitué par un ou plusieurs $R^z$, et $Si(R^y)_3$;
chacun de $R^y$ et $R^z$ est, à chaque occurrence indépendamment l'un de l'autre, choisi dans le groupe constitué de
hydrogène,
CN,
$CF_3$,
alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ; et
hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ; et

b) au moins un composé émetteur E comprenant ou constitué de

- un premier fragment chimique comprenant ou constitué d'une structure de formule II,

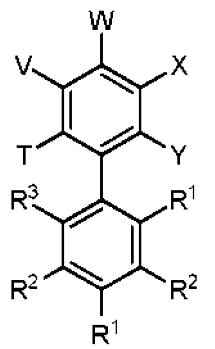

Formule II

et

- deux deuxièmes fragments chimiques, indépendamment l'un de l'autre, comprenant ou constitués d'une structure de formule III,

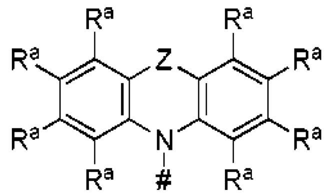

Formule III

dans lequel le premier fragment chimique est lié à chacun des deux deuxièmes fragments chimiques par l'intermédiaire d'une simple liaison ;

dans lequel

T est le site de liaison d'une simple liaison reliant le premier fragment chimique et l'un des deux deuxièmes fragments chimiques, ou est hydrogène ;
V est le site de liaison d'une simple liaison reliant le premier fragment chimique et l'un des deux deuxièmes fragments chimiques, ou est hydrogène ;
W est le site de liaison d'une simple liaison reliant le premier fragment chimique et l'un des deux deuxièmes fragments chimiques, ou est choisi dans le groupe constitué d'hydrogène, CN et $CF_3$ ;
X est le site de liaison d'une simple liaison reliant le premier fragment chimique et l'un des deux deuxièmes fragments chimiques, ou est choisi dans le groupe constitué d'hydrogène, CN et $CF_3$ ;
Y est le site de liaison d'une simple liaison reliant le premier fragment chimique et un des deux deuxièmes fragments chimiques, ou est choisi dans le groupe constitué d'hydrogène, CN et $CF_3$ ;
# représente le site de liaison d'une simple liaison reliant le premier fragment chimique et l'un des deux deuxièmes fragments chimiques ;
Z est, à chaque occurrence indépendamment d'une autre, choisi dans le groupe constitué d'une liaison directe, $CR^4R^5$, $C=CR^4R^5$, C=O, $C=NR^4$, $NR^4$, O, $SiR^4R^5$, S, S(O) et $S(O)_2$ ;
chacun de $R^1$ et $R^2$ est, à chaque occurrence indépendamment l'un de l'autre, choisi dans le groupe constitué de
hydrogène,
deutérium,
alkyle en $C_1$-$C_5$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et
$CF_3$ ;
$R^3$ est choisi dans le groupe constitué de
hydrogène,
deutérium,
alkyle en $C_1$-$C_5$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et
hétéroaryle en $C_3$-$C_{17}$, qui est facultativement substitué par un ou plusieurs résidus choisis dans le groupe d'aryle en $C_6$-$C_{18}$, alkyle en $C_1$-$C_{20}$, hétéroalkyle en $C_1$-$C_{20}$ et hétéroaryle en $C_3$-$C_{17}$ ;
chacun de $R^a$, $R^4$ et $R^5$ est, à chaque occurrence, indépendamment les uns des autres, choisi dans le groupe constitué de
hydrogène, CN, $CF_3$,
alkyle en $C_1$-$C_{20}$, qui est facultativement substitué par un ou plusieurs $R^x$,
aryle en $C_6$-$C_{18}$, qui est facultativement substitué par un ou plusieurs $R^x$,
hétéroaryle en $C_3$-$C_{17}$, qui est facultativement substitué par un ou plusieurs $R^x$,

$Si(R^t)3$,
$N(R^s)_2$,
et $OR^s$ ;
$R^x$ est, à chaque occurrence indépendamment d'une autre, choisi dans le groupe constitué de
hydrogène,
Cl,
Br,
I,
CN,
$CF_3$,
alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;
chacun de $R^s$ et $R^t$ est, à chaque occurrence indépendamment l'un de l'autre, choisi dans le groupe constitué de
hydrogène,
alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et
hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$;
dans lequel chacun des résidus $R^a$, $R^4$, $R^5$, $R^s$, $R^t$ ou $R^x$ forment facultativement un système cyclique mono- ou polycyclique, aliphatique, aromatique et/ou benzanilé avec un ou plusieurs résidus $R^a$, $R^4$, $R^5$, $R^s$, $R^t$ ou $R^x$ ;
dans lequel
exactement un résidu choisi dans le groupe constitué de W, X et Y est CN ou $CF_3$, et exactement deux résidus choisis dans le groupe constitué de T, V, W, X et Y sont le site de liaison d'une simple liaison reliant le premier fragment chimique et l'un des deux deuxièmes fragments chimiques, et les deux résidus $R^1$ ou les deux résidus $R^2$ sont $CF_3$.

2. Dispositif électroluminescent organique selon la revendication 1, choisi dans le groupe constitué d'une diode électroluminescente organique, une cellule électrochimique électroluminescente et un transistor électroluminescent.

3. Dispositif électroluminescent organique selon la revendication 1 ou 2, dans lequel X et Y sont chacun O.

4. Dispositif électroluminescent organique selon la revendication 1 ou 2, dans lequel X et Y sont chacun S.

5. Dispositif électroluminescent organique selon l'une quelconque des revendications 1 à 4, dans lequel l'ensemble des résidus $R^I$, $R^{II}$, $R^{III}$, $R^{IV}$, $R^V$, $R^{VI}$, $R^{VII}$ et $R^{VIII}$ sont chacun hydrogène.

6. Dispositif électroluminescent organique selon la revendication 1 à 5, dans lequel l'au moins un composé émetteur E comprend ou est constitué d'une structure de formule IV

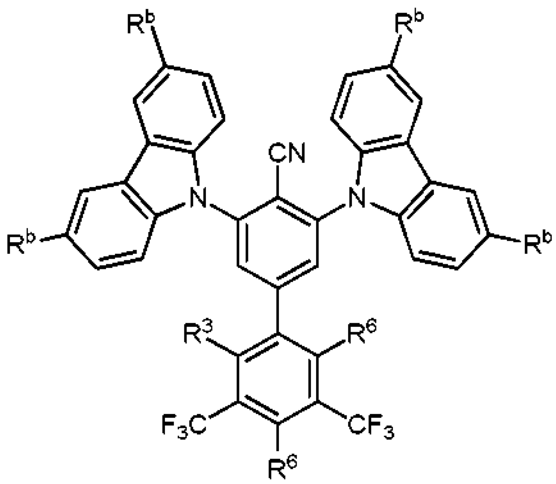

Formule IV

dans laquelle

$R^b$ est, à chaque occurrence, indépendamment d'une autre, choisi dans le groupe constitué de
hydrogène,
CN,
$CF_3$,
méthyle (Me),
isopropyle ($^i$Pr),
tert-butyle ($^t$Bu),
phényle (Ph), qui est facultativement substitué par un ou plusieurs résidus choisis dans le groupe constitué de Me, $^i$Pr, $^t$Bu, CN, $CF_3$ et Ph,
pyridinyle, qui est facultativement substitué par un ou plusieurs résidus choisis dans le groupe constitué de Me, $^i$Pr, $^t$Bu, CN, $CF_3$ et Ph,
pyrimidinyle, qui est facultativement substitué par un ou plusieurs résidus choisis dans le groupe constitué de Me, $^i$Pr, $^t$Bu, CN, $CF_3$ et Ph,
1,3,5-triazinyle, qui est facultativement substitué par un ou plusieurs résidus choisis dans le groupe constitué de Me, $^i$Pr, $^t$Bu, CN, $CF_3$ et Ph, et
carbazolyle, qui est facultativement substitué par un ou plusieurs résidus choisis dans le groupe constitué de Me, $^i$Pr, $^t$Bu, CN, $CF_3$ et Ph ;
$R^6$ est choisi dans le groupe constitué de
hydrogène,
deutérium,
alkyle en $C_1$-$C_5$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et
hétéroaryle en $C_3$-$C_{17}$, qui est facultativement substitué par un ou plusieurs résidus choisis dans le groupe constitué d'aryle en $C_3$-$C_{18}$, alkyle en $C_1$-$C_{20}$, hétéroalkyle en $C_1$-$C_{20}$ et hétéroaryle en $C_3$-$C_{17}$ ;
et $R^3$ est tel que défini dans la revendication 1.

**7.** Dispositif électroluminescent organique selon la revendication 1 à 5, dans lequel l'au moins un composé émetteur comprend ou est constitué d'une structure de formule V

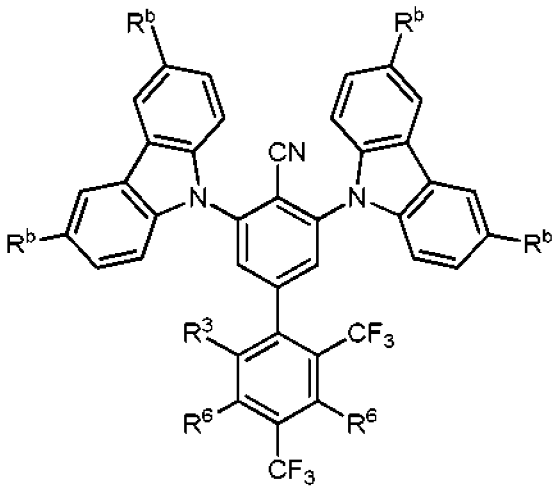

Formule V

dans laquelle

$R^b$ est, à chaque occurrence indépendamment d'une autre, choisi dans le groupe constitué de
hydrogène,
CN,
$CF_3$,
Me,
$^iPr$,
$^tBu$,
Ph, qui est facultativement substitué par un ou plusieurs résidus choisis dans le groupe constitué de Me, $^iPr$, $^tBu$, CN, $CF_3$ et Ph,
pyridinyle, qui est facultativement substitué par un ou plusieurs résidus choisis dans le groupe constitué de Me, $^iPr$, $^tBu$, CN, $CF_3$ et Ph,
pyrimidinyle, qui est facultativement substitué par un ou plusieurs résidus choisis dans le groupe constitué de Me, $^iPr$, $^tBu$, CN, $CF_3$ et Ph,
1,3,5-triazinyle, qui est facultativement substitué par un ou plusieurs résidus choisis dans le groupe constitué de Me, $^iPr$, $^tBu$, CN, $CF_3$ et Ph, et
carbazolyle, qui est facultativement substitué par un ou plusieurs résidus choisis dans le groupe constitué de Me, $^iPr$, $^tBu$, CN, $CF_3$ et Ph ;
$R^6$ est choisi dans le groupe constitué de
hydrogène,
deutérium,
alkyle en $C_1$-$C_5$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et
hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;
et $R^3$ est tel que défini dans la revendication 1.

**8.** Dispositif électroluminescent organique selon la revendication 6 ou 7, dans lequel $R^3$ et $R^6$ est H à chaque occurrence.

**9.** Dispositif électroluminescent organique selon les revendications 1 à 8, dans lequel la couche électroluminescente comprend :

(i) 5 à 99 % en poids, en particulier 30 à 94,9 % en poids, de préférence 40 à 89 % en poids, d'au moins un composé hôte H ;
(ii) 1 à 50 % en poids, en particulier 5 à 40 % en poids, de préférence 10 à 30 % en poids, de l'au moins un composé émetteur E ; et facultativement

(iii) 0 à 94 % en poids, en particulier 0,1 à 65 % en poids, de préférence 1 à 50 % en poids, d'au moins un composé hôte supplémentaire $D^1$ ayant une structure qui n'est pas selon la formule (I) ; et facultativement
(iv) 0 à 30 % en poids, en particulier 0 à 20 % en poids, de préférence 0 à 5 % en poids, d'au moins un composé émetteur supplémentaire.

**10.** Dispositif électroluminescent organique selon la revendication 9, dans lequel le composé hôte H a une orbitale moléculaire occupée de plus haute énergie HOMO(H) et l'au moins un composé hôte supplémentaire $D^1$ a une orbitale moléculaire occupée de plus haute énergie HOMO($D^1$) ayant une énergie $E^{HOMO}(D^1)$, où $E^{HOMO}(H) > E^{HOMO}(D^1)$.

**11.** Dispositif électroluminescent organique selon la revendication 9 ou 10, dans lequel l'au moins un composé hôte H a une orbitale moléculaire vacante de plus basse énergie LUMO(H) ayant une énergie $E^{LUMO}(H)$ et l'au moins un composé hôte supplémentaire $D^1$ a une orbitale moléculaire vacante de plus basse énergie LUMO($D^1$) ayant une énergie $E^{LUMO}(D^1)$, où $E^{LUMO}(H) > E^{LUMO}(D^1)$.

**12.** Dispositif électroluminescent organique selon la revendication 9 à 11, dans lequel
l'au moins un composé hôte H a une orbitale moléculaire occupée de plus haute énergie HOMO(H) ayant une énergie $E^{HOMO}(H)$ et une orbitale moléculaire vacante de plus basse énergie LUMO(H) ayant une énergie $E^{LUMO}(H)$, et
l'au moins un composé hôte supplémentaire $D^1$ a une orbitale moléculaire occupée de plus haute énergie HOMO($D^1$) ayant une énergie $E^{HOMO}(D^1)$ et une orbitale moléculaire vacante de plus basse énergie LUMO($D^1$) ayant une énergie $E^{LUMO}(D^1)$,
l'au moins un composé émetteur E a une orbitale moléculaire occupée de plus haute énergie HOMO(E) ayant une énergie $E^{HOMO}(E)$ et une orbitale moléculaire vacante de plus basse énergie LUMO(E) ayant une énergie $E^{LUMO}(E)$,
où $E^{HOMO}(H) > E^{HOMO}(D^1)$ et la différence entre le niveau d'énergie de l'orbitale moléculaire occupée de plus haute énergie HOMO(E) de l'au moins un composé émetteur E ($E^{HOMO}(E)$) et le niveau d'énergie de l'orbitale moléculaire occupée de plus haute énergie HOMO(H) de l'au moins un composé hôte H ($E^{HOMO}(H)$) est compris entre -0,5 eV et 0,5 eV, plus préférablement entre -0,3 eV et 0,3 eV, encore plus préférablement entre -0,2 eV et 0,2 eV ou même entre -0,1 eV et 0,1 eV ; et
$E^{LUMO}(H) > E^{LUMO}(D^1)$ et la différence entre le niveau d'énergie de l'orbitale moléculaire vacante de plus basse énergie LUMO(E) de l'au moins un composé émetteur E ($E^{LUMO}(E)$) et l'orbitale moléculaire vacante de plus basse énergie LUMO($D^1$) de l'au moins un composé hôte supplémentaire $D^1$ ($E^{LUMO}(D^1)$) est comprise entre -0,5 eV et 0,5 eV, plus préférablement entre -0,3 eV et 0,3 eV, encore plus préférablement entre -0,2 eV et 0,2 eV ou même entre -0,1 eV et 0,1 eV.

**13.** Dispositif électroluminescent organique selon les revendications 9 à 12, dans lequel l'au moins un composé hôte supplémentaire $D^1$ comprend ou est constitué d'une structure de formule VII :

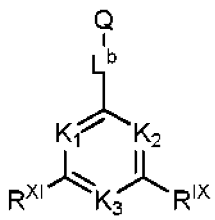

Formule VII

dans laquelle :

chacun de $K_1$, $K_2$ et $K_3$ est, indépendamment les uns des autres, choisi dans le groupe constitué de CH, $CR^k$ et N ; dans laquelle au moins un des résidus $K_1$, $K_2$ et $K_3$ est N ;
dans laquelle $R^k$ est, à chaque occurrence, identique ou différent et indépendamment choisi dans le groupe constitué de
alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,
aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,

hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ ou hétéroaryle en $C_3$-$C_{17}$, et $Si(R^m)_3$ ;

chacun de $R^{IX}$ et $R^{XI}$ est, indépendamment l'un de l'autre, choisi dans le groupe constitué d'hydrogène,

alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,

aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,

hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et $Si(R^m)_3$ ;

$R^m$ est, à chaque occurrence, identique ou différent et, indépendamment d'une autre, choisi dans le groupe constitué de

hydrogène,

alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$,

aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$, et

hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;

$L^b$ est choisi dans le groupe constitué d'une simple liaison et arylène en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;

Q est un groupe comprenant ou constitué d'une structure de l'une des formules VIII à XI

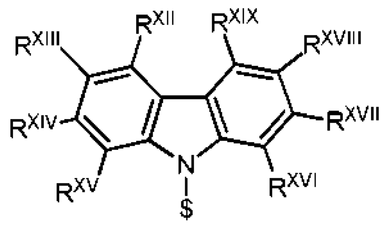

Formule VIII

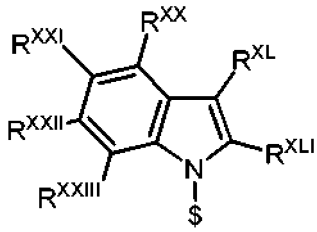

Formule IX

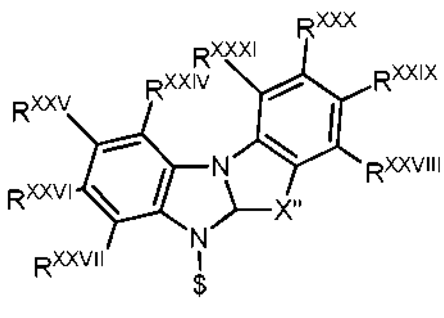

Formule X

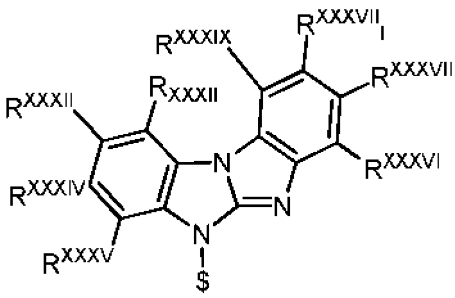

Formule XI

dans lesquelles

$ est le site de liaison à $L^b$ ;

X" est choisi dans le groupe constitué de O et S ;

chacun de $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, $R^{XXIII}$, $R^{XXIV}$, $R^{XXV}$, $R^{XXVI}$, $R^{XXVII}$, $R^{XXVIII}$, $R^{XXIX}$, $R^{XXX}$, $R^{XXXI}$, $R^{XXXII}$, $R^{XXXIII}$, $R^{XXXIV}$, $R^{XXXV}$, $R^{XXXVI}$, $R^{XXXVII}$, $R^{XXXVIII}$ et $R^{XXXIV}$, est indépendamment les uns des autres, choisi dans le groupe constitué de

hydrogène,

Cl,

Br,

I,

CN,

$CF_3$,

alkyle en $C_1$-$C_{20}$, qui est facultativement substitué par un ou plusieurs résidus choisis dans le groupe constitué de Cl, Br, I, CN, $CF_3$, alkyle en $C_1$-$C_{20}$, aryle en $C_6$-$C_{18}$, hétéroaryle en $C_3$-$C_{17}$ et $Si(R^m)3$,

aryle en $C_6$-$C_{18}$, qui est facultativement substitué par un ou plusieurs résidus choisis dans le groupe constitué de Cl, Br, I, CN, $CF_3$, alkyle en $C_1$-$C_{20}$, aryle en $C_6$-$C_{18}$, hétéroaryle en $C_3$-$C_{17}$ et $Si(R^m)3$,

hétéroaryle en $C_3$-$C_{17}$, qui est facultativement substitué par un ou plusieurs résidus choisis dans le groupe constitué de Cl, Br, I, CN, $CF_3$, alkyle en $C_1$-$C_{20}$, aryle en $C_6$-$C_{18}$, hétéroaryle en $C_3$-$C_{17}$ et $Si(R^m)3$, et

$Si(R^m)_3$;

chacun de $R^{XL}$ et $R^{XLI}$ est, indépendamment de l'autre, choisi dans le groupe constitué de :

hydrogène ;

alkyle en $C_1$-$C_{20}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;

aryle en $C_6$-$C_{18}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ;

hétéroaryle en $C_3$-$C_{17}$, qui est facultativement substitué par un ou plusieurs résidus choisis dans le groupe constitué d'aryle en $C_6$-$C_{18}$, alkyle en $C_1$-$C_{20}$, hétéroalkyle en $C_1$-$C_{20}$ et hétéroaryle en $C_3$-$C_{17}$ ; et

$Si(R^m)_3$.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2012097937 A1